# EUROPEAN PATENT SPECIFICATION

(11) **EP 4 072 110 B1**
(45) Date of publication and mention of the grant of the patent: **19.06.2024**
(21) Application number: 20905073.1
(22) Date of filing: 28.12.2020
(51) Int. Cl.: H04M 1/02, G09F 9/30, F16C 11/04, G06F 1/16, H05K 5/02, F16C 11/12, H04M 1/18

(54) **ELECTRONIC DEVICE**
ELEKTRONISCHE VORRICHTUNG
DISPOSITIF ÉLECTRONIQUE

(30) Priority: 27.12.2019 CN 201911378915; 19.01.2020 CN 202010059260; 20.01.2020 CN 202010066036; 18.03.2020 CN 202010191182; 23.04.2020 CN 202010327242; 01.07.2020 CN 202010619631; 30.09.2020 CN 202011062457; 31.10.2020 CN 202011198925; 28.11.2020 CN 202011368621; 25.12.2020 CN 202011568879; 25.12.2020 CN 202011568881; 25.12.2020 CN 202011568886
(43) Date of publication of application: 12.10.2022
(60) Divisional application: 24157331.0
(73) Proprietor: Huawei Technologies Co., Ltd., Shenzhen, Guangdong 518129 (CN)
(72) Inventor: XU, Zhixiao, Shenzhen, Guangdong 518129 (CN); HUANG, Bo, Shenzhen, Guangdong 518129 (CN); XING, Chong, Shenzhen, Guangdong 518129 (CN); DING, Qiaoying, Shenzhen, Guangdong 518129 (CN); MA, Chunjun, Shenzhen, Guangdong 518129 (CN); LIU, Yu, Shenzhen, Guangdong 518129 (CN); LIAO, Li, Shenzhen, Guangdong 518129 (CN); CHEN, Bo, Shenzhen, Guangdong 518129 (CN); CHEN, Bowen, Shenzhen, Guangdong 518129 (CN); NIU, Linhui, Shenzhen, Guangdong 518129 (CN); SUN, Yong, Shenzhen, Guangdong 518129 (CN); SUN, Changyu, Shenzhen, Guangdong 518129 (CN); LI, Zheng, Shenzhen, Guangdong 518129 (CN); ZHU, Xu, Shenzhen, Guangdong 518129 (CN); LI, Wei, Shenzhen, Guangdong 518129 (CN); WANG, Gangchao, Shenzhen, Guangdong 518129 (CN); DAI, Xiaotao, Shenzhen, Guangdong 518129 (CN); XU, Jia, Shenzhen, Guangdong 518129 (CN); LI, Yin, Shenzhen, Guangdong 518129 (CN); WU, Weifeng, Shenzhen, Guangdong 518129 (CN); HUANG, Tao, Shenzhen, Guangdong 518129 (CN); ZHAN, Qiang, Shenzhen, Guangdong 518129 (CN); TIAN, Haiqiang, Shenzhen, Guangdong 518129 (CN); HU, Yuehua, Shenzhen, Guangdong 518129 (CN); ZHAO, Feng, Shenzhen, Guangdong 518129 (CN); WANG, Gang, Shenzhen, Guangdong 518129 (CN); WANG, Changyong, Shenzhen, Guangdong 518129 (CN); ZHANG, Hui, Shenzhen, Guangdong 518129 (CN); LI, Xia, Shenzhen, Guangdong 518129 (CN); ZHONG, Ding, Shenzhen, Guangdong 518129 (CN); WANG, Shangyun, Shenzhen, Guangdong 518129 (CN)
(74) Representative: Gill Jennings & Every LLP
(86) International application number: PCT/CN2020/140445
(87) International publication number: WO 2021/129882

(56) References cited:
- WO-A1-2019/151839
- CN-A- 110 557 481
- CN-U- 209 545 628
- CN-U- 209 593 488

## Description

### TECHNICAL FIELD

This application relates to the field of foldable electronic product technologies, and in particular, to an electronic device.

### BACKGROUND

In recent years, flexible displays have been widely used in various foldable electronic devices because the flexible displays have features such as lightness, thinness, and non-fragility. The foldable electronic device further includes a housing apparatus configured to bear the flexible display. The housing apparatus generally includes two housings and a hinge assembly connected between the two housings. The two housings are folded or unfolded relative to each other through deformation of the hinge assembly, and drive the flexible display to be folded or unfolded.

In a conventional inward-folding electronic device, when the electronic device is folded, a flexible display is folded on an inner side of a housing apparatus, and a bendable part of the flexible display is likely to be damaged due to excessive squeezing by the housing apparatus. Consequently, reliability of the flexible display is poor, and a service life of the electronic device is short.
CN-A-209545628 describes an electronic device, comprising a flexible display screen which comprises a first part, a second part and a transition part located between the first part and the second part; the first bearing piece is used for bearing the first part; the second bearing piece is used for bearing the second part; the base is rotationally connected with the first bearing piece and the second bearing piece, and a containing groove is formed in the base; the movable plate is connected with the base in a sliding manner, and is connected with the first bearing piece and the second bearing piece; the traction piece is fixedly connected with the transition part and the movable plate, when the first bearing piece and the second bearing piece rotate relatively, the first bearing piece and the second bearing piece drive the movable plate to slide in the storage groove, and the movable plate pulls the transition part to be bent through the traction piece.
CN-A-209593488 describes a folding device and electronic equipment, the folding device is used for bearing a flexible display screen, the flexible display screen comprises a first part, a second part and a bendable part connected between the first part and the second part, and the folding device comprises a first bearing assembly used for bearing the first part; the second bearing assembly is used for bearing the second part; the base is rotationally connected between the first bearing assembly and the second bearing assembly; the antenna radiator is arranged on one side, close to the base,of the first bearing assembly or/and one side, close to the base, of the second bearing assembly; the antenna radiator is provided with a feeding point, the feeding point is used for feeding in an excitation signal so as to excite the antenna radiator to generate resonance through the excitation signal, and then the antenna radiator receives and transmits a wireless communication signal in the direction deviating from the bendable part. The antenna radiator is fed through the feed source, so that the antenna radiator resonates in the direction deviating from the flexible display screen, and the folding device can generate effective antenna signals.

### SUMMARY

This application is to provide an electronic device. A housing apparatus of the electronic device can automatically perform avoidance in a folding process to form water drop-shaped or approximately water drop-shaped screen accommodation space, so that a folding action performed by the housing apparatus on a screen is stable and has small squeezing force. This helps reduce a risk that the screen is damaged due to excessive squeezing by the housing apparatus, so that reliability of the screen and the electronic device is high, and a service life of the screen and the electronic device is long.

The invention provides a foldable electronic device as defined in claim 1.

This specification also describes an electronic device having an open state and a closed state. The electronic device includes a housing apparatus and a screen. The housing apparatus includes a first housing, a second housing, and a hinge assembly. The hinge assembly is connected between the first housing and the second housing. The first housing and the second housing can be unfolded or folded relative to each other by using the hinge assembly, to enable the housing apparatus to be unfolded or folded. The hinge assembly includes a shaft, a first support plate, and a second support plate.

The screen includes a first non-bendable part, a first bendable part, a second non-bendable part, a second bendable part, a third non-bendable part, a third bendable part, and a fourth non-bendable part that are sequentially arranged. The first non-bendable part is fastened to the first housing. The fourth non-bendable part is fastened to the second housing. The first bendable part is disposed corresponding to a part of the first housing and a part of the first support plate and can be relatively moved. The second non-bendable part is fastened to the first support plate. The second bendable part is disposed corresponding to a part of the first support plate, the shaft, and a part of the second support plate and can be relatively moved. The third non-bendable part is fastened to the second support plate. The third bendable part is disposed corresponding to a part of the second support plate and a part of the second housing and can be relatively moved.

When the electronic device is in the open state, the housing apparatus is flattened, the first support plate and the second support plate are respectively located on two sides of the shaft, and the screen is flattened. When the electronic device is in the closed state, the housing apparatus is folded, and the first support plate and the second support plate are located on a same side of the shaft and are away from each other in a direction close to the shaft. The first support plate, the shaft, and the second support plate jointly form screen accommodation space. The screen is folded on an inner side of the housing apparatus, and the screen is partially located in the screen accommodation space. The first bendable part, the second bendable part, and the third bendable part are bent.

In some possible implementations, the hinge assembly further includes a first fixing bracket, a first connection arm, a first swing arm, a second fixing bracket, a second connection arm, and a second swing arm. The first fixing bracket is fixedly connected to the first housing, and the second fixing bracket is fixedly connected to the second housing. The first connection arm includes a first end and a second end. The first end of the first connection arm is rotatably connected to the shaft, the second end of the first connection arm is rotatably connected to the first fixing bracket. The first swing arm includes a rotating end and a sliding end. The rotating end of the first swing arm is rotatably connected to the shaft, and the sliding end of the first swing arm is slidably connected to the shaft. The second connection arm includes a first end and a second end. The first end of the second connection arm is rotatably connected to the shaft, and the second end of the second connection arm is rotatably connected to the first fixing bracket. The second swing arm includes a rotating end and a sliding end. The rotating end of the second swing arm is rotatably connected to the shaft, and the sliding end of the second swing arm is slidably connected to the shaft. The first support plate is rotatably connected to the first fixing bracket and slidably connected to the sliding end of the first swing arm. The second support plate is rotatably connected to the second fixing bracket and slidably connected to the sliding end of the second swing arm.

In some possible implementations, the first fixing bracket includes a first arc-shaped slot. A bottom rotating shaft is inserted into the sliding end of the first swing arm. The first support plate includes a first support plate plate, a first arc-shaped arm, and a first guide arm. The first arc-shaped arm and the first guide arm are fastened below the first support plate plate. The first guide arm is provided with a first guide chute. The first arc-shaped arm is installed in the first arc-shaped slot. The bottom rotating shaft is installed in the first guide chute.

In some possible implementations, the first guide chute has a proximal end and a distal end. The proximal end is close to the shaft and the first support plate plate relative to the distal end. When the electronic device is in the open state, the bottom rotating shaft is slid to the distal end. When the electronic device is in the closed state, the bottom rotating shaft is slid to the proximal end.

In some possible implementations, the hinge assembly further includes a damping assembly. The damping assembly is installed on the shaft, the damping assembly is connected to the rotating end of the first swing arm and the rotating end of the second swing arm, and the damping assembly is configured to provide damping force in a process in which the first swing arm and the second swing arm are rotated relative to each other.

In some possible implementations, the hinge assembly further includes a plurality of synchronization gears. Each synchronization gear is rotatably connected to the shaft. The rotating end of the first swing arm is engaged with the rotating end of the second swing arm by using the plurality of synchronization gears.

In some possible implementations, the first swing arm further includes a connection section. The connection section of the first swing arm is connected to the rotating end of the first swing arm and the sliding end of the first swing arm. The second swing arm further includes a connection section. The connection section of the second swing arm is connected to the rotating end of the second swing arm and the sliding end of the second swing arm. When the electronic device is in the closed state, the first support plate plate, the connection section of the first swing arm, the shaft, the connection section of the second swing arm, and a second support plate plate jointly form the screen accommodation space.

In some possible implementations, the electronic device further includes a back cover. The back cover is fastened to the shaft. When the electronic device is in the open state, the first housing and the second housing block the back cover. When the electronic device is in the closed state, the back cover is exposed relative to the first housing and the second housing.

In some possible implementations, when the screen is in a closed state, an end part that is of the second bendable part and that is connected to the second non-bendable part forms a first arc section, a middle part of the second bendable part forms a second arc section, and an end part that is of the second bendable part and that is connected to the third non-bendable part forms a third arc section. The first arc section, the second arc section, and the third arc section smoothly transit, and all circle centers are located on an inner side of the screen. The first bendable part forms a fourth arc section, and the third bendable part forms a fifth arc section. Both circle centers of the fourth arc section and the fifth arc section are located on an outer side of the screen. The first non-bendable part, the second non-bendable part, the third non-bendable part, and the fourth bendable part are straight sections.

In some possible implementations, the electronic device further includes a first adhesive layer, a second adhesive layer, a third adhesive layer, and a fourth adhesive layer. The first adhesive layer connects the first housing and the first non-bendable part of the screen. The second adhesive layer connects the second housing and the fourth non-bendable part of the screen. The third adhesive layer connects the first support plate and the first bendable part. The fourth adhesive layer connects the second support plate and the third bendable part. Rigidity of the third adhesive layer and rigidity of the fourth adhesive layer are greater than rigidity of the first adhesive layer and rigidity of the second adhesive layer.

In some possible implementations, the third adhesive layer and the fourth adhesive layer are strong adhesive layers. The first adhesive layer and the second adhesive layer are weak adhesive layers. A modulus of the strong adhesive layer is greater than a modulus of the weak adhesive layer, and/or the strong adhesive layer is in a continuous elongated shape, and/or the weak adhesive layer includes one or more hollow regions, to form a patterned structure.

In some possible implementations, the electronic device further includes a rotating shaft connection assembly. The rotating shaft connection assembly includes a first connector and a second connector. The first connector is fixedly connected to the first support plate and the second non-bendable part of the screen. The second connection assembly is fixedly connected to the second support plate and the third non-bendable part of the screen.

In some possible implementations, the first connector includes a first substrate layer, a first bonding layer, a first insulation layer, a second bonding layer, and a second insulation layer. The first substrate layer is a metal sheet. Both the first bonding layer and the first insulation layer are fastened to a lower surface of the first substrate layer. The first bonding layer is bonded to the first support plate. The first insulation layer is located on one side that is of the first bonding layer and that is close to the shaft, and the first insulation layer is made of an insulation material. Both the second bonding layer and the second insulation layer are fastened to an upper surface of the first substrate layer. The second bonding layer is bonded to the second non-bendable part of the screen. The second insulation layer is located on one side that is of the first bonding layer and that is close to the shaft, and the second insulation layer is made of an insulation material.

In some possible implementations, the first connector further includes at least one reinforcement layer. The at least one reinforcement layer is fastened to the lower surface of the first substrate layer, and a substrate layer of the reinforcement layer is a metal sheet.

In some possible implementations, the electronic device further includes a rotating shaft connection assembly. The rotating shaft connection assembly includes a soft rubber member. Two sides of the soft rubber member are respectively slidably connected to the first support plate and the second support plate. The soft rubber member is connected to a bendable region of the screen.

In some possible implementations, the rotating shaft connection assembly further includes a first rigid strip, a second rigid strip, a plurality of first drag hooks, a plurality of first sliding hooks, a plurality of second drag hooks, and a plurality of second sliding hooks. The first rigid strip is fastened to one side of the soft rubber member. The plurality of first drag hooks and the plurality of first sliding hooks are fastened to the first rigid strip. The plurality of first drag hooks are connected to the first support plate, so that the first rigid strip and the first support plate are fastened to each other in a thickness direction of the first support plate. The plurality of first sliding hooks are slidably connected to the first support plate, so that the first rigid strip can be slid relative to the first support plate in a direction perpendicular to an extension direction of the shaft. The second rigid strip is fastened to another side of the soft rubber member. The plurality of second drag hooks and the plurality of second sliding hooks are fastened to the second rigid strip. The plurality of second drag hooks are connected to the second support plate, so that the second rigid strip and the second support plate are fastened to each other in a thickness direction of the second support plate. The plurality of second sliding hooks are slidably connected to the second support plate, so that the second rigid strip can be slid relative to the second support plate in the direction perpendicular to the extension direction of the shaft.

In some possible implementations, the screen includes a flexible display and a bearing plate. The bearing plate is fastened to a non-display side of the flexible display, and rigidity of the bearing plate is greater than rigidity of the flexible display.

In some possible implementations, the bearing plate includes a first plate part, a second plate part, a third plate part, a fourth plate part, and a fifth plate part that are sequentially arranged in a fourth direction. The third plate part is provided with a plurality of first through holes and a plurality of second through holes. The plurality of first through holes are located at the bottom of the third metal plate and penetrate the third plate part, and the plurality of first through holes are arranged at intervals in the fourth direction. The first through hole is in an elongated shape and extends in a third direction. The third direction is perpendicular to the fourth direction. One end of the first through hole extends to a bottom end surface of the third metal plate. The plurality of second through holes are located at the top of the third metal plate and penetrate the third plate part, and the plurality of second through holes are arranged at intervals in the fourth direction. The second through hole is in an elongated shape and extends in the third direction, and the second through hole extends to a top end surface of the third metal plate. The second plate part is provided with a plurality of first elongated grooves. Openings of the plurality of first elongated grooves are located on a lower surface of the bearing plate. The plurality of first elongated grooves are arranged at intervals in the fourth direction. Each first elongated groove extends in the third direction, and two ends of each first elongated groove respectively extend to a bottom end surface and a top end surface of the second plate part. The fourth plate part is provided with a plurality of second elongated grooves. Openings of the plurality of second elongated grooves are located on the lower surface of the bearing plate. The plurality of second elongated grooves are arranged at intervals in the fourth direction. Each second elongated groove extends in the third direction, and two ends of each second elongated groove respectively extend to a bottom end surface and a top end surface of the fourth plate part.

In some possible implementations, the bearing plate includes a first plate part, a second plate part, a third plate part, a fourth plate part, and a fifth plate part that are sequentially arranged in a fourth direction. The third plate part is provided with a plurality of elongated through hole groups. The plurality of elongated through hole groups are arranged in a third direction. The third direction is perpendicular to the fourth direction. Each elongated through hole group includes a plurality of elongated through holes arranged at intervals in the fourth direction. Each elongated through hole is approximately in a strip shape and extends in the third direction, and each elongated through hole penetrates the third plate part. The second plate part is provided with a plurality of first elongated grooves. Openings of the plurality of first elongated grooves are located on a lower surface of the bearing plate. The plurality of first elongated grooves are arranged at intervals in the fourth direction. Each first elongated groove extends in the third direction, and two ends of each first elongated groove respectively extend to a bottom end surface and a top end surface of the second plate part. The fourth plate part is provided with a plurality of second elongated grooves. Openings of the plurality of second elongated grooves are located on the lower surface of the bearing plate. The plurality of second elongated grooves are arranged at intervals in the fourth direction. Each second elongated groove extends in the third direction, and two ends of each second elongated groove respectively extend to a bottom end surface and a top end surface of the fourth plate part.

In some possible implementations, a plurality of elongated through holes of two adjacent elongated through hole groups are staggered.

In some possible implementations, the plurality of first elongated grooves are located on one side that is of the second plate part and that is close to the first plate part. The plurality of second elongated grooves are located on one side that is of the fourth plate part and that is close to the fifth plate part.

In some possible implementations, the bearing plate is made of an aluminum matrix composite material or a magnesium matrix composite material. The aluminum matrix composite material or the magnesium matrix composite material includes reinforcing particles. The bearing plate has material density that is less than or equal to 4.0 g/cm³, an elastic modulus that is greater than or equal to 80 GPa, yield strength that is greater than or equal to 300 MPa, and a thermal conductivity that is greater than or equal to 90 W/(m·°C).

In some possible implementations, the reinforcing particle is made of silicon carbide, aluminum oxide, boron carbide, a carbon nanotube, graphene, chromium carbide, silicon boride, titanium boride, or titanium carbide.

In some possible implementations, the screen includes a flexible display and a soft rubber support. The soft rubber support is located on a non-display side of the flexible display and fastened to a bendable region of the flexible display.

In some possible implementations, the soft rubber support is provided with a plurality of elongated grooves arranged at intervals. An arrangement direction of the plurality of elongated grooves is perpendicular to an extension direction of each elongated groove.

In some possible implementations, the soft rubber support includes a soft rubber member and a stiffener. The soft rubber member is fixedly connected to the flexible display. The stiffener is fastened to or embedded into one side that is of the soft rubber member and that backs onto the flexible display. Rigidity of the stiffener is greater than rigidity of the soft rubber member.

In some possible implementations, the stiffener is a metal sheet, and the stiffener is provided with a through hole structure and/or a groove structure.

In some possible implementations, an end part of the soft rubber support is connected to the first housing and the second housing in an interference fit manner.

In some possible implementations, the electronic device includes a screen support. The screen support includes a first rigid plate, a second rigid plate, and a soft rubber member connected between the first rigid plate and the second rigid plate. The first rigid plate is fixedly connected to the first housing. The second rigid plate is fixedly connected to the second housing. The soft rubber member is disposed corresponding to the hinge assembly. The screen is fastened to one side that is of the screen support and that backs onto the hinge assembly.

In some possible implementations, two sides of the soft rubber member are respectively provided with a first handle part and a second handle part. One side that is of the first rigid plate and that is close to the soft rubber member is provided with a first positioning block. The first positioning block is embedded into the first handle part. One side that is of the second rigid plate and that is close to the soft rubber member is provided with a second positioning block. The second positioning block is embedded into the second handle part.

In some possible implementations, the hinge assembly further includes a first protector, a second protector, a first protection housing, and a second protection housing. The first protector and the second protector are respectively installed at two ends of the hinge assembly. The first protection housing is installed on an edge of the first housing. The second protection housing is installed on an edge of the second housing. The first protector, the first protection housing, the second protector, and the second protection housing are disposed around the screen and jointly block an edge of the screen.

In some possible implementations, the first protector includes a rigid member, a connector, and a soft rubber member. The rigid member is connected to the soft rubber member by using the connector, and the rigid member is inserted into the shaft. The soft rubber member blocks a part of the edge of the screen and can be bent with the screen.

In some possible implementations, the first protection housing includes a blocking frame part and an installation frame part connected to the blocking frame part. The installation frame part is installed on the edge of the first housing. The blocking frame part blocks a part of the edge of the screen, one end of the first protector, and one end of the second protector.

In some possible implementations, the soft rubber member includes a protection part, a first position-limiting part, and a second position-limiting part. The first position-limiting part and the second position-limiting part are respectively connected to two ends of the protection part. The protection part blocks a part of the edge of the screen. The first position-limiting part is located between the hinge assembly and the first housing. The first protection housing blocks the first position-limiting part. The second position-limiting part is located between the hinge assembly and the second housing. The second protection housing blocks the second position-limiting part.

In some possible implementations, when the electronic device is in the open state, a thickness of the electronic device is reduced in a direction from one end to another end. When the electronic device is in the closed state, a thickness of the electronic device is reduced in a direction from a proximal end to a distal end.

### BRIEF DESCRIPTION OF DRAWINGS

FIG. 1A is a schematic diagram of a structure of an electronic device according to an embodiment of this application in an open state;
FIG. 1B is a schematic diagram of a structure of the electronic device shown in FIG. 1A in a closed state;
FIG. 2 is a schematic diagram of a partial decomposition structure of the electronic device shown in FIG. 1A;
FIG. 3A is a schematic diagram of a structure of the electronic device shown in FIG. 1A from another perspective;
FIG. 3B is a schematic diagram of a structure of the electronic device shown in FIG. 1B from another perspective;
FIG. 4A is a schematic diagram of a structure of the electronic device shown in FIG. 1B in some other embodiments;
FIG. 4B is a schematic diagram of a structure of the electronic device shown in FIG. 1B in some other embodiments;
FIG. 4C is a schematic diagram of a structure of the electronic device shown in FIG. 1B in some other embodiments;
FIG. 4D is a schematic diagram of a structure of the electronic device shown in FIG. 1B in some other embodiments;
FIG. 4E is a schematic diagram of a structure of the electronic device shown in FIG. 1B in some other embodiments;
FIG. 4F is a schematic diagram of a structure of the electronic device shown in FIG. 1B in some other embodiments;
FIG. 4G is a schematic diagram of a structure of the electronic device shown in FIG. 1B in some other embodiments;
FIG. 5A is a schematic diagram of a structure of a hinge assembly shown in FIG. 2 in an open state;
FIG. 5B is a schematic diagram of a structure of the hinge assembly shown in FIG. 5A in a closed state;
FIG. 6 is a schematic diagram of a partial decomposition structure of the hinge assembly shown in FIG. 5A;
FIG. 7A is a schematic diagram of a structure of a shaft shown in FIG. 5A from another perspective;
FIG. 7B is a schematic diagram of a structure of the shaft shown in FIG. 7A from another perspective;
FIG. 8A is a schematic diagram of a decomposition structure of the shaft shown in FIG. 7A;
FIG. 8B is a schematic diagram of a structure of the shaft shown in FIG. 8A from another perspective;
FIG. 9A is a schematic diagram of a cross-sectional structure of the shaft that is cut along a cross section A1-A1 and that is shown in FIG. 7A;
FIG. 9B is a schematic diagram of a cross-sectional structure of the shaft that is cut along a cross section B 1-B 1 and that is shown in FIG. 7A;
FIG. 10A is a schematic diagram of a cross-sectional structure of the shaft that is cut along a cross section C1-C1 and that is shown in FIG. 7A;
FIG. 10B is a schematic diagram of a cross-sectional structure of the shaft that is cut along a cross section D1-D1 and that is shown in FIG. 7A;
FIG. 11 is an enlarged schematic diagram of a structure of the shaft shown in FIG. 7A at a position E;
FIG. 12 is a schematic diagram of structures of a plurality of connection assemblies shown in FIG. 6;
FIG. 13 is a schematic diagram of partial decomposition structures of the plurality of connection assemblies shown in FIG. 12;
FIG. 14 is a schematic diagram of a structure of a first fixing bracket shown in FIG. 13 from another perspective;
FIG. 15 is a schematic diagram of a structure of a second fixing bracket shown in FIG. 13 from another perspective;
FIG. 16 is a schematic diagram of a structure of a first connection arm shown in FIG. 13 from another perspective;
FIG. 17 is a schematic diagram of a structure of a second connection arm shown in FIG. 13 from another perspective;
FIG. 18 is a schematic diagram of a structure of a first swing arm shown in FIG. 13 from another perspective;
FIG. 19 is a schematic diagram of a structure of a second swing arm shown in FIG. 13 from another perspective;
FIG. 20 is a schematic diagram of a structure of a first damping assembly shown in FIG. 13 from another perspective;
FIG. 21A is a schematic diagram of a decomposition structure of the first damping assembly shown in FIG. 20;
FIG. 21B is a schematic diagram of a structure of the first damping assembly shown in FIG. 21A from another perspective;
FIG. 22 is a schematic diagram of a partial structure of a bottom connection assembly shown in FIG. 12;
FIG. 23 is a schematic diagram of an assembled structure of a bottom connection assembly shown in FIG. 6 and a bottom casing body of a shaft;
FIG. 24A is a schematic diagram of a cross-sectional structure of an assembled structure, that is cut along a cross section A2-A2, of a bottom connection assembly and a shaft shown in FIG. 6;
FIG. 24B is a schematic diagram of the structure shown in FIG. 24A in a closed state;
FIG. 25A is a schematic diagram of a cross-sectional structure of an assembled structure, that is cut along a cross section B2-B2, of a bottom connection assembly and a shaft shown in FIG. 6;
FIG. 25B is a schematic diagram of the structure shown in FIG. 25A in a closed state;
FIG. 26A is a schematic diagram of a cross-sectional structure of an assembled structure, that is cut along a cross section G-G, of a bottom connection assembly and a shaft shown in FIG. 6;
FIG. 26B is a schematic diagram of the structure shown in FIG. 26A in a closed state;
FIG. 27 is a schematic diagram of a structure of a third fixing bracket shown in FIG. 13 from another perspective;
FIG. 28 is a schematic diagram of a structure of a fourth fixing bracket shown in FIG. 13 from another perspective;
FIG. 29 is a schematic diagram of a structure of a third connection arm shown in FIG. 13 from another perspective;
FIG. 30 is a schematic diagram of a structure of a fourth connection arm shown in FIG. 13 from another perspective;
FIG. 31 is a schematic diagram of a structure of a third swing arm shown in FIG. 13 from another perspective;
FIG. 32 is a schematic diagram of a structure of a fourth swing arm shown in FIG. 13 from another perspective;
FIG. 33 is a schematic diagram of an assembled structure of a middle connection assembly shown in FIG. 6 and a bottom casing body of a shaft;
FIG. 34A is a schematic diagram of a cross-sectional structure of an assembled structure, that is cut along a cross section C2-C2 and that is shown in FIG. 6, of a middle connection assembly and a shaft;
FIG. 34B is a schematic diagram of the structure shown in FIG. 34A in a closed state;
FIG. 35A is a schematic diagram of a cross-sectional structure of an assembled structure, that is cut along a cross section D2-D2, of a middle connection assembly and a shaft shown in FIG. 6;
FIG. 35B is a schematic diagram of the structure shown in FIG. 35A in a closed state;
FIG. 36A is a schematic diagram of a cross-sectional structure of an assembled structure, that is cut along a cross section H-H, of a middle connection assembly and a shaft shown in FIG. 6;
FIG. 36B is a schematic diagram of the structure shown in FIG. 36A in a closed state;
FIG. 37 is a schematic diagram of an assembled structure of a top connection assembly shown in FIG. 6 and a top casing body of a shaft;
FIG. 38A is a schematic diagram of a structure of a first support plate shown in FIG. 6;
FIG. 38B is a schematic diagram of a structure of the first support plate shown in FIG. 38A from another perspective;
FIG. 39A is a schematic diagram of a decomposition structure of the first support plate shown in FIG. 38A;
FIG. 39B is a schematic diagram of a decomposition structure of the first support plate shown in FIG. 38B;
FIG. 40A is a schematic diagram of a structure of a second support plate shown in FIG. 6;
FIG. 40B is a schematic diagram of a structure of the second support plate shown in FIG. 40A from another perspective;
FIG. 41A is a schematic diagram of a cross-sectional structure of the hinge assembly that is cut along a cross section J-J and that is shown in FIG. 5A;
FIG. 41B is a schematic diagram of the structure shown in FIG. 41A in a closed state;
FIG. 42A is a schematic diagram of a cross-sectional structure of the hinge assembly that is cut along a cross section K-K and that is shown in FIG. 5A;
FIG. 42B is a schematic diagram of the structure shown in FIG. 42A in a closed state;
FIG. 43A is a schematic diagram of a cross-sectional structure of the hinge assembly that is cut along a cross section B3-B3 and that is shown in FIG. 5A;
FIG. 43B is a schematic diagram of the structure shown in FIG. 43A in a closed state;
FIG. 44A is a schematic diagram of a cross-sectional structure of the hinge assembly that is cut along a cross section L-L and that is shown in FIG. 5A;
FIG. 44B is a schematic diagram of the structure shown in FIG. 44A in a closed state;
FIG. 45A is a schematic diagram of a cross-sectional structure of the hinge assembly that is cut along a cross section M-M and that is shown in FIG. 5A;
FIG. 45B is a schematic diagram of the structure shown in FIG. 45A in a closed state;
FIG. 46A is a schematic diagram of a cross-sectional structure of the hinge assembly that is cut along a cross section D3-D3 and that is shown in FIG. 5A;
FIG. 46B is a schematic diagram of the structure shown in FIG. 46A in a closed state;
FIG. 47 is a schematic diagram of a structure of a back cover shown in FIG. 2 from another perspective;
FIG. 48 is a schematic diagram of a decomposition structure of the back cover shown in FIG. 47;
FIG. 49A is a schematic diagram of a structure of the hinge assembly shown in FIG. 5A from another perspective;
FIG. 49B is a schematic diagram of a structure obtained after a hinge assembly and a back cover that are shown in FIG. 2 are assembled;
FIG. 50A is a schematic diagram of a structure obtained after a first housing, a second housing, a hinge assembly, and a back cover that are shown in FIG. 2 are assembled;
FIG. 50B is a schematic diagram of the structure shown in FIG. 50A in a closed state;
FIG. 51A is a schematic diagram of a cross-sectional structure of the structure that is cut along a cross section N-N and that is shown in FIG. 49B;
FIG. 51B is a schematic diagram of a cross-sectional structure of the structure that is cut along a cross section P-P and that is shown in FIG. 49B;
FIG. 52A is a schematic diagram of a structure of a rotating shaft connection assembly shown in FIG. 2 from another perspective;
FIG. 52B is a schematic diagram of a structure of the rotating shaft connection assembly shown in FIG. 52A from another perspective;
FIG. 53 is a schematic diagram of a decomposition structure of the rotating shaft connection assembly shown in FIG. 52A;
FIG. 54 is a schematic diagram of a decomposition structure of a first reinforcement layer shown in FIG. 53;
FIG. 55 is a schematic diagram of a structure obtained after a rotating shaft connection assembly and a hinge assembly that are shown in FIG. 2 are assembled;
FIG. 56 is a schematic diagram of a partial structure of the assembled structure shown in FIG. 55;
FIG. 57A is a schematic diagram of the structure shown in FIG. 55 in a closed state;
FIG. 57B is a schematic diagram of a partial structure of the structure shown in FIG. 56;
FIG. 58A is a schematic diagram of a structure of a rotating shaft connection assembly shown in FIG. 2 in some other embodiments;
FIG. 58B is a schematic diagram of a structure of the rotating shaft connection assembly shown in FIG. 58A from another perspective;
FIG. 59A is a schematic diagram of a structure of a rotating shaft connection assembly shown in FIG. 2 in some other embodiments;
FIG. 59B is a schematic diagram of a structure of the rotating shaft connection assembly shown in FIG. 59A from another perspective;
FIG. 60A is a schematic diagram of a structure of a rotating shaft connection assembly shown in FIG. 2 in some other embodiments;
FIG. 60B is a schematic diagram of a structure of the rotating shaft connection assembly shown in FIG. 60A from another perspective;
FIG. 61A is a schematic diagram of a structure of a rotating shaft connection assembly shown in FIG. 2 in some other embodiments;
FIG. 61B is a schematic diagram of a structure of the rotating shaft connection assembly shown in FIG. 61A from another perspective;
FIG. 62 is a schematic diagram of a structure of a rotating shaft connection assembly shown in FIG. 2 in some other embodiments;
FIG. 63A is a schematic diagram of a structure of a rotating shaft connection assembly shown in FIG. 2 in some other embodiments;
FIG. 63B is a schematic diagram of a structure of the rotating shaft connection assembly shown in FIG. 63A from another perspective;
FIG. 64A is a schematic diagram of a structure of a rotating shaft connection assembly shown in FIG. 2 in some other embodiments;
FIG. 64B is a schematic diagram of a structure of the rotating shaft connection assembly shown in FIG. 64A from another perspective;
FIG. 65 is a schematic diagram of a structure obtained after a first housing, a hinge assembly, a second housing, and a rotating shaft connection assembly that are shown in FIG. 2 are assembled;
FIG. 66 is a schematic diagram of a partial structure of the electronic device shown in FIG. 1A;
FIG. 67 is a schematic diagram of a partial structure of the structure shown in FIG. 66;
FIG. 68 is a schematic diagram of an internal structure of the structure shown in FIG. 66 in a closed state;
FIG. 69 is a schematic diagram of an internal structure of a screen of an electronic device shown in FIG. 68;
FIG. 70A shows a structure of a weak adhesive layer according to an embodiment of this application in some embodiments;
FIG. 70B shows a structure of a weak adhesive layer according to an embodiment of this application in some other embodiments;
FIG. 70C shows a structure of a weak adhesive layer according to an embodiment of this application in some other embodiments;
FIG. 70D shows a structure of a weak adhesive layer according to an embodiment of this application in some other embodiments;
FIG. 70E shows a structure of a weak adhesive layer according to an embodiment of this application in some other embodiments;
FIG. 70F shows a structure of a weak adhesive layer according to an embodiment of this application in some other embodiments;
FIG. 71 is a schematic diagram of the structure shown in FIG. 67 in some other embodiments;
FIG. 72A is a schematic diagram of a structure of a screen shown in FIG. 2 from another perspective;
FIG. 72B is a schematic diagram of a partial decomposition structure of the screen shown in FIG. 72A;
FIG. 73 is a schematic diagram of a structure of a bearing plate shown in FIG. 72B from another perspective;
FIG. 74 is a schematic diagram of a structure of the bearing plate shown in FIG. 73 in a closed state;
FIG. 75 is a schematic diagram of a structure obtained after a bearing plate and a protection film that are shown in FIG. 72B are assembled;
FIG. 76A is a schematic diagram of a structure of a bearing plate shown in FIG. 72A in some other embodiments;
FIG. 76B is a schematic diagram of a structure of the bearing plate shown in FIG. 76A from another perspective;
FIG. 77 is a schematic diagram of a structure of the bearing plate shown in FIG. 76A in a closed state;
FIG. 78 is a schematic diagram of a structure of a bearing plate shown in FIG. 72A in some other embodiments;
FIG. 79 is a partial scanning electron microscopy diagram of a bearing plate according to an embodiment of this application;
FIG. 80 is a partial schematic flowchart of a production method of a bearing plate according to an embodiment of this application;
FIG. 81 is a schematic diagram of another structure of the electronic device shown in FIG. 1A;
FIG. 82 is a schematic diagram of a partial structure of the structure shown in FIG. 66;
FIG. 83A is a schematic diagram of a structure of a first protector shown in FIG. 81 from another perspective;
FIG. 83B is a schematic diagram of a structure of the first protector shown in FIG. 83A from another perspective;
FIG. 84A is a schematic diagram of a decomposition structure of the first protector shown in FIG. 83A;
FIG. 84B is a schematic diagram of a structure of the first protector shown in FIG. 83A from another perspective;
FIG. 85 is a schematic diagram of a cross-sectional structure of the first protector that is cut along a cross section Q-Q and that is shown in FIG. 83B;
FIG. 86 is a schematic diagram of a partial structure of the electronic device shown in FIG. 1A;
FIG. 87 is a schematic diagram of a cross-sectional structure of the structure that is cut along a cross section R1-R1 and that is shown in FIG. 86;
FIG. 88 is a schematic diagram of a structure when a screen and a first protector that are shown in FIG. 86 in a closed state;
FIG. 89A is a schematic diagram of a structure of a first protection housing shown in FIG. 2;
FIG. 89B is a schematic diagram of a structure of a first protector shown in FIG. 89A from another perspective;
FIG. 90 is a schematic diagram of a structure of the electronic device shown in FIG. 1A;
FIG. 91 is a schematic diagram of a cross-sectional structure of the structure that is cut along a cross section R2-R2 and that is shown in FIG. 90;
FIG. 92 is a schematic diagram of a structure when a first protector, a first protection housing, a second protection housing, and a screen that are shown in FIG. 91 are in a closed state;
FIG. 93 is a schematic diagram of a structure of a screen according to an embodiment of this application in some other embodiments;
FIG. 94A is a schematic diagram of a structure of a soft rubber support shown in FIG. 93;
FIG. 94B is a schematic diagram of a structure of the soft rubber support shown in FIG. 94A from another perspective;
FIG. 95 is a schematic diagram of a partial structure of an electronic device according to an embodiment of this application in some other embodiments;
FIG. 96 is a schematic diagram of a cross-sectional structure of the electronic device that is cut along a cross section S-S and that is shown in FIG. 95;
FIG. 97A is a schematic diagram of a structure of the soft rubber support shown in FIG. 94A in some other embodiments;
FIG. 97B is a schematic diagram of a structure of the soft rubber support shown in FIG. 97A from another perspective;
FIG. 98 is a schematic diagram of a decomposition structure of the soft rubber support shown in FIG. 97A;
FIG. 99 is a schematic diagram of a partial structure of a stiffener shown in FIG. 98;
FIG. 100A is a schematic diagram of a structure of a rotating shaft connection assembly according to an embodiment of this application in some other embodiments;
FIG. 100B is a schematic diagram of the structure shown in FIG. 100A from another perspective;
FIG. 101 is a schematic diagram of a decomposition structure of the rotating shaft connection assembly shown in FIG. 100A;
FIG. 102 is a schematic diagram of a partial structure of a hinge assembly according to an embodiment of this application in some other embodiments;
FIG. 103A is a schematic diagram of a connection structure of the rotating shaft connection assembly shown in FIG. 100A and the hinge assembly shown in FIG. 102.
FIG. 103B is a schematic diagram of a partial structure of the structure shown in FIG. 103A from another perspective;
FIG. 104A shows a screen support according to an embodiment of this application;
FIG. 104B is a schematic diagram of a structure of the screen support shown in FIG. 104A from another perspective; and
FIG. 105 is a schematic diagram of a decomposition structure of the screen support shown in FIG. 104A.

### DESCRIPTION OF EMBODIMENTS

The following describes the following various embodiments of this application with reference to the accompanying drawings in embodiments of this application.

In descriptions of embodiments of this application, it should be noted that, unless otherwise expressly specified and limited, terms "installation" and "connection" should be understood in a broad sense. For example, a "connection" may be a detachable connection, an undetachable connection, a direct connection, or an indirect connection by using an intermediate medium. A "fixed connection" means that components are connected to each other and a relative position relationship remains unchanged after the connection. It should be understood that, when a component A is fixedly connected to a component C by using a component B, a change that is of a relative position relationship and that is generated due to deformation of the component A, the component B, and the component C is allowed. A "rotatable connection" means that components are connected to each other and can be rotated relative to each other after the connection. A "slidable connection" means that components are connected to each other and can be slid relative to each other after the connection. That an integrated structure of two components is obtained by using an integrated molding technology means that, in a process of forming one of two components, the component is connected to the other component, and the two components do not need to be connected in a manner of reprocessing (for example, bonding, welding, a snap-fit connection, or a screw connection).

For orientation words mentioned in embodiments of this application, for example, "upper", "lower", "side surface", "top", and "bottom", reference is made only to directions in the accompanying drawings. Therefore, the orientation words are used to better and more clearly describe and understand embodiments of this application, instead of indicating or implying that a specified apparatus or element needs to have a specific orientation and be constructed and operated in a specific orientation. Therefore, the orientation words cannot be understood as a limitation on embodiments of this application.

The term "a plurality of" means at least two. The term "above" includes the modified number. The term "and/or" describes an association relationship for describing associated objects and represents that three relationships may exist. For example, A and/or B may represent the following three cases: Only A exists, both A and B exist, and only B exists. Terms "first", "second", and the like are merely intended for a purpose of description, and shall not be understood as an indication or implication of relative importance or implicit indication of a quantity of indicated technical features. Therefore, a feature limited by "first" or "second" may explicitly indicate or implicitly include one or more such features.

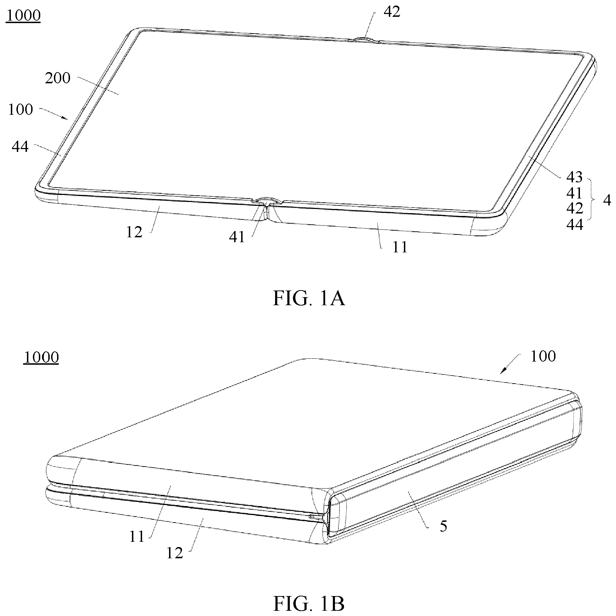

Refer to FIG. 1A and FIG. 1B. FIG. 1A is a schematic diagram of a structure of an electronic device 1000 according to an embodiment of this application in an open state. FIG. 1B is a schematic diagram of a structure of the electronic device 1000 shown in FIG. 1A in a closed state.

In some embodiments, the electronic device 1000 includes a housing apparatus 100 and a screen 200. The screen 200 is installed on the housing apparatus 100. As shown in FIG. 1A, the housing apparatus 100 may be unfolded to an open state. As shown in FIG. 1B, the housing apparatus 100 may be alternatively folded to a closed state. The housing apparatus 100 may be alternatively unfolded or folded to an intermediate state, and the intermediate state may be any state between the open state and the closed state. The screen 200 is moved with the housing apparatus 100. The housing apparatus 100 may drive the screen 200 to be unfolded or folded, so that the electronic device 1000 can be unfolded to an open state or folded to a closed state. When the electronic device 1000 is in the closed state, the screen 200 is located on an inner side of the housing apparatus 100.

In this embodiment, when the electronic device 1000 is in the open state, the screen 200 is flattened, and the screen 200 can perform full-screen display, so that the electronic device 1000 has a larger display area, to improve viewing experience and operation experience of a user. When the electronic device 1000 is in the closed state, the electronic device 1000 has a smaller planar size, and is convenient for carrying and storage by the user.

In some embodiments, the screen 200 may integrate a display function and a touch sensing function. The display function of the screen 200 is used to display an image, a video, and the like. The touch sensing function of the screen 200 is used to sense a touch action of the user, to implement human-machine interaction. For example, the screen 200 includes a flexible display that can be bent. The flexible display may be a liquid crystal display (liquid crystal display, LCD), an organic light-emitting diode (organic light-emitting diode, OLED) display, an active-matrix organic light-emitting diode (active-matrix organic light-emitting diode, AMOLED) display, a flexible light-emitting diode (flexible light-emitting diode, FLED) display, a mini-LED display, a micro-LED display, a micro-OLED display, a quantum dot light emitting diodes (quantum dot light emitting diodes, QLEDs) display, or the like.

In some embodiments, the electronic device 1000 may further include a plurality of components (not shown in the figure). The plurality of components are installed inside the housing apparatus 100. The plurality of components may include, for example, a processor, an internal memory, an external memory interface, a universal serial bus (universal serial bus, USB) interface, a charging management module, a power management module, a battery, antennas, a communication module, a camera, an audio module, a speaker, a receiver, a microphone, a headset jack, a sensor module, a button, a motor, an indicator, a subscriber identification module (subscriber identification module, SIM) card interface, and the like.

The processor may include one or more processing units. For example, the processor may include an application processor (application processor, AP), a modem processor, a graphics processing unit (graphics processing unit, GPU), an image signal processor (image signal processor, ISP), a controller, a video codec, a digital signal processor (digital signal processor, DSP), a baseband processor, and/or a neural-network processing unit (neural-network processing unit, NPU). Different processing units may be independent components, or may be integrated into one or more processors.

A memory may be further disposed in the processor, and is configured to store instructions and data. In some embodiments, the memory in the processor is a cache memory. The memory may store instructions or data just used or cyclically used by the processor. If the processor needs to use the instructions or the data again, the processor may directly invoke the instructions or the data from the memory. This avoids repeated access and reduces a waiting time of the processor, thereby improving system efficiency. In some embodiments, the processor may include one or more interfaces.

The charging management module is configured to receive a charging input from a charger. The charger may be a wireless or wired charger. In some embodiments of wired charging, the charging management module may receive a charging input from a wired charger through the USB interface. In some embodiments of wireless charging, the charging management module may receive a wireless charging input through a wireless charging coil of the electronic device 1000. When charging the battery, the charging management module may further supply power to the electronic device 1000 by using the power management module. There may be one or more batteries.

The power management module is configured to connect the battery, the charging management module, and the processor. The power management module receives an input from the battery and/or an input from the charging management module, and supplies power to another component. The power management module may be further configured to monitor parameters such as a battery capacity, a battery cycle count, and a battery health status (electric leakage or impedance). In some other embodiments, the power management module may be alternatively disposed in the processor. In some other embodiments, the power management module and the charging management module may be alternatively disposed in a same component.

A wireless communication function of the electronic device 1000 may be implemented by using the antenna, the communication module, the processor, and the like. The antenna is configured to transmit and receive electromagnetic wave signals. There are a plurality of antennas. The plurality of antennas may work independently of each other, or may work in combination. Each antenna in the electronic device 1000 may be configured to cover one or more communication frequency bands. Different antennas may be further multiplexed to improve antenna utilization.

The antenna and the communication module of the electronic device 1000 are coupled, so that the electronic device 1000 can communicate with a network and another device by using a wireless communication technology. The communication module may be one or more components integrating at least one communication processor module. The communication module receives an electromagnetic wave through the antenna, performs frequency modulation and filtering processing on an electromagnetic wave signal, and sends a processed signal to the processor. The wireless communication module may further receive a to-be-sent signal from the processor, perform frequency modulation and amplification on the signal, and convert a processed signal into an electromagnetic wave for radiation through the antenna. In some embodiments, at least some function modules of the communication module may be disposed in the processor. In some embodiments, at least some function modules of the communication module and at least some modules of the processor may be disposed in a same component.

The wireless communication technology may include a global system for mobile communications (global system for mobile communications, GSM), a general packet radio service (general packet radio service, GPRS), code division multiple access (code division multiple access, CDMA), wideband code division multiple access (wideband code division multiple access, WCDMA), time-division code division multiple access (time-division code division multiple access, TD-SCDMA), long term evolution (long term evolution, LTE), Bluetooth (Bluetooth, BT), a global positioning system (global positioning system, GPS), a global navigation satellite system (global navigation satellite system, GNSS), a wireless local area network (wireless local area network, WLAN) (for example, a wireless fidelity (wireless fidelity, Wi-Fi) network), a near field communication (near field communication, NFC) technology, frequency modulation (frequency modulation, FM), an infrared (infrared, IR) technology, and/or the like.

The electronic device 1000 may implement a photographing function by using the camera and the processor. The camera is configured to capture an image or a video. An optical image of an object is generated through a lens, and is projected onto a photosensitive element. The photosensitive element is configured to convert an optical signal into an electrical signal. The photosensitive element may be a charge-coupled device (charge-coupled device, CCD) or a complementary metal-oxide-semiconductor (complementary metal-oxide-semiconductor, CMOS) phototransistor. In some embodiments, the electronic device 1000 may include one or more cameras. The processor is configured to control the camera to perform photographing or video recording, and is further configured to convert an electrical signal output by the camera into an image signal. The camera may implement an automatic focusing function, an optical image stabilization function, and the like.

The electronic device 1000 may implement an audio function, for example, music playing or recording, by using the audio module, the speaker, the receiver, the microphone, the headset jack, the processor, and the like.

The audio module is configured to convert digital audio information into an analog audio signal output, and is also configured to convert an analog audio input into a digital audio signal. The audio module may be further configured to encode and decode an audio signal. In some embodiments, the audio module may be disposed in the processor, or some function modules in the audio module are disposed in the processor.

The speaker, also referred to as a "loudspeaker", is configured to convert an audio electrical signal into a sound signal. The electronic device 1000 may be used to listen to music or answer a call in a hands-free mode through the speaker.

The receiver, also referred to as an "earpiece", is configured to convert an audio electrical signal into a sound signal. When a call is answered or voice information is listened to by using the electronic device 1000, the receiver may be put close to a human ear to listen to a voice.

The microphone, also referred to as a "mike" or a "mic", is configured to convert a sound signal into an electrical signal. When making a call or sending voice information, the user may make a sound near the microphone through the mouth of the user, to input a sound signal to the microphone. At least one microphone may be disposed in the electronic device 1000. In some other embodiments, two microphones may be disposed in the electronic device 1000, to collect a sound signal and implement a noise reduction function. In some other embodiments, three, four, or more microphones may be alternatively disposed in the electronic device 1000, to collect a sound signal, implement noise reduction, and identify a sound source, so as to implement a directional recording function and the like.

The headset jack is configured to connect to a wired headset. The headset jack may be a USB interface, or may be a 3.5 mm open mobile terminal 1000 platform (open mobile terminal platform, OMTP) standard interface or a cellular telecommunications industry association of the USA (cellular telecommunications industry association of the USA, CTIA) standard interface.

The internal memory may be configured to store computer-executable program code. The executable program code includes instructions. The processor runs the instructions stored in the internal memory, to perform various function applications of the electronic device 1000 and data processing. The internal memory may include a program storage region and a data storage region. The program storage region may store an operating system, an application required by at least one function (for example, a sound playing function or an image playing function), and the like. The data storage region may store data (for example, audio data or a phone book) created in a process of using the electronic device 1000, and the like. In addition, the internal memory may include a high-speed random access memory, and may further include a non-volatile memory, for example, at least one magnetic disk storage component, a flash component, or a universal flash storage (universal flash storage, UFS).

The external memory interface may be configured to connect to an external memory card, for example, a micro SD card, to extend a storage capability of the electronic device 1000. The external memory card communicates with the processor through the external memory interface, to implement a data storage function. For example, files such as music and a video are stored in the external memory card.

The sensor module may include a pressure sensor, a gyro sensor, a barometric pressure sensor, a magnetic sensor, an acceleration sensor, a distance sensor, an optical proximity sensor, a fingerprint sensor, a temperature sensor, a touch sensor, an ambient light sensor, a bone conduction sensor, and the like.

The pressure sensor is configured to sense a pressure signal, and can convert the pressure signal into an electrical signal. In some embodiments, the pressure sensor may be disposed on the screen 200. When a touch operation is performed on the screen 200, the electronic device 1000 detects intensity of the touch operation through the pressure sensor. The electronic device 1000 may also calculate a touch position based on a detection signal of the pressure sensor. In some embodiments, touch operations that are performed at a same touch position but have different touch operation intensity may correspond to different operation instructions. For example, when a touch operation whose touch operation intensity is less than a first pressure threshold is performed on an icon of a messaging application, an instruction for viewing an SMS message is executed. When a touch operation whose touch operation intensity is greater than or equal to the first pressure threshold is performed on the icon of the messaging application, an instruction for creating an SMS message is executed.

The gyro sensor may be configured to determine a motion posture of the electronic device 1000. In some embodiments, angular velocities of the electronic device 1000 around three axes may be determined through the gyro sensor. The gyro sensor may be used for image stabilization during photographing. For example, when a shutter is pressed, the gyro sensor B detects an angle at which the electronic device 1000 jitters, calculates, based on the angle, a distance for which a lens module needs to compensate, and allows the lens to cancel the jitter of the electronic device 1000 through reverse motion, to implement image stabilization. The gyro sensor may be also used in navigation and somatic game scenarios.

The barometric pressure sensor is configured to measure barometric pressure. In some embodiments, the electronic device 1000 calculates an altitude based on a barometric pressure value measured by the barometric pressure sensor, to assist in positioning and navigation.

The magnetic sensor includes a Hall sensor. The electronic device 1000 may detect opening and closing of a flip cover by using the magnetic sensor. In some embodiments, when the electronic device 1000 is a flip phone, the electronic device 1000 may detect opening and closing of a flip cover by using the magnetic sensor. Further, a feature, for example, automatic unlocking upon opening of the flip cover is set based on a detected opening or closing state of the flip cover.

The acceleration sensor may detect magnitude of accelerations of the electronic device 1000 in various directions (generally on three axes), and may detect magnitude and a direction of gravity when the electronic device 1000 is static. The acceleration sensor may be further configured to identify a posture of the electronic device 1000, and is used in an application, for example, switching between a landscape mode and a portrait mode or a pedometer.

The distance sensor is configured to measure a distance. The electronic device 1000 may measure a distance in an infrared or laser manner. In some embodiments, in a photographing scenario, the electronic device 1000 may measure a distance by using the distance sensor, to implement quick focusing.

The optical proximity sensor may include, for example, a light-emitting diode and an optical detector, for example, a photodiode. The light-emitting diode may be an infrared light-emitting diode. The electronic device 1000 emits infrared light by using the light-emitting diode. The electronic device 1000 detects infrared reflected light from a nearby object by using the photodiode. When sufficient reflected light is detected, it may be determined that there is an object near the electronic device 1000. When insufficient reflected light is detected, the electronic device 1000 may determine that there is no object near the electronic device 1000. The electronic device 1000 may detect, by using the optical proximity sensor, that the user holds the electronic device 1000 close to an ear for a call, to automatically turn off the screen 200 for power saving. The optical proximity sensor may be also used in a smart cover mode or a pocket mode to automatically perform screen unlocking or locking.

The ambient light sensor is configured to sense ambient light brightness. The electronic device 1000 may adaptively adjust brightness of the screen 200 based on the sensed ambient light brightness. The ambient light sensor may be also configured to automatically adjust a white balance during shooting. The ambient light sensor may further cooperate with the optical proximity sensor to detect whether the electronic device 1000 is in a pocket, to avoid an accidental touch.

The fingerprint sensor is configured to collect a fingerprint. The electronic device 1000 may implement fingerprint-based unlocking, application lock access, fingerprint-based shooting, fingerprint-based call answering, and the like by using a feature of the collected fingerprint.

The temperature sensor is configured to detect a temperature. In some embodiments, the electronic device 1000 executes a temperature processing policy based on the temperature detected by the temperature sensor. For example, when the temperature reported by the temperature sensor exceeds a threshold, the electronic device 1000 lowers performance of a processor located near the temperature sensor, to reduce power consumption to implement thermal protection. In some other embodiments, when the temperature is less than another threshold, the electronic device 1000 heats the battery to prevent the electronic device 1000 from being shut down abnormally due to a low temperature. In some other embodiments, when the temperature is less than still another threshold, the electronic device 1000 boosts an output voltage of the battery to avoid abnormal shutdown due to a low temperature.

The touch sensor is also referred to as a "touch panel". The touch sensor may be disposed on the screen 200, and the touch sensor and the screen 200 constitute a touchscreen, which is also referred to as a "touch screen". The touch sensor is configured to detect a touch operation performed on or near the touch sensor. The touch sensor may transfer the detected touch operation to the processor to determine a type of a touch event. A visual output related to the touch operation may be provided through the screen 200. In some other embodiments, the touch sensor may be alternatively disposed on a surface of the electronic device 1000 at a position different from that of the screen 200.

The bone conduction sensor may obtain a vibration signal. In some embodiments, the bone conduction sensor may obtain a vibration signal of a vibration bone of a human vocal part. The bone conduction sensor may be also in contact with a body pulse to receive a blood pressure beating signal. In some embodiments, the bone conduction sensor may be also disposed in a headset, to obtain a bone conduction headset. The audio module may obtain a voice signal through parsing based on the vibration signal that is of the vibration bone of the vocal-cord part and that is obtained by the bone conduction sensor, to implement a voice function. The processor may parse heart rate information based on the blood pressure beating signal obtained by the bone conduction sensor, to implement a heart rate detection function.

The button includes a power button, a volume button, and the like. The button may be a mechanical button, or a touch button. The electronic device 1000 may receive a button input, and generate a button signal input related to user settings and function control of the electronic device 1000.

The motor may generate a vibration prompt. The motor may be used for an incoming call vibration prompt, or may be used for a touch vibration feedback. For example, touch operations performed on different applications (for example, shooting and audio playing) may correspond to different vibration feedback effects. For touch operations performed on different regions of the screen 200, the motor may also correspond to different vibration feedback effects. Different application scenarios (for example, a time reminder, information receiving, an alarm clock, and a game) may also correspond to different vibration feedback effects. A touch vibration feedback effect may be further customized.

The indicator may be an indicator light, and may be configured to indicate a charging status and a power change, or may be configured to indicate a message, a missed call, a notification, and the like.

The SIM card interface is configured to connect to a SIM card. The SIM card may be inserted into the SIM card interface or removed from the SIM card interface, to implement contact with or separation from the electronic device 1000. The electronic device 1000 may support one or more SIM card interfaces. The SIM card interface may support a nano-SIM card, a micro-SIM card, a SIM card, and the like. A plurality of cards may be simultaneously inserted into a same SIM card interface. The plurality of cards may be of a same type or different types. The SIM card interface may be also compatible with different types of SIM cards. The SIM card interface may be also compatible with an external storage card. The electronic device 1000 interacts with a network through the SIM card, to implement functions such as calling and data communication. In some embodiments, the electronic device 1000 uses an eSIM, namely, an embedded SIM card. The eSIM card may be embedded into the electronic device 1000, and cannot be separated from the electronic device 1000.

The electronic device 1000 may have more or fewer components than those described above, two or more components may be combined, or there may be a different component configuration. Various components may be implemented in hardware that includes one or more signal processing and/or application-specific integrated circuits, software, or a combination of hardware and software.

It should be understood that, in this embodiment, an example in which the electronic device 1000 is of a structure with two folds is used for description. To be specific, the electronic device 1000 includes two flat panel parts and a bendable part connected between the two flat panel parts. The two flat panel parts may be oppositely rotated to be stacked (which corresponds to the foregoing closed state), so that the electronic device 1000 presents a form of two layers. The two flat panel parts may be alternatively rotated back to back to be flattened (which corresponds to the foregoing open state). In some other embodiments, the electronic device 1000 may alternatively be of a structure with more than three folds, or the like. To be specific, the electronic device 1000 includes more than three flat panel parts. Two adjacent flat panel parts are connected by using a bendable part, and two adjacent flat panel parts may be rotated relative to each other until being stacked or rotated back to back until being flattened. When the electronic device 1000 is of a structure with more than three folds, for an adaptive design of the structure of the electronic device 1000, refer to the descriptions of the structure with the two folds in this embodiment. Details are not described in this application again.

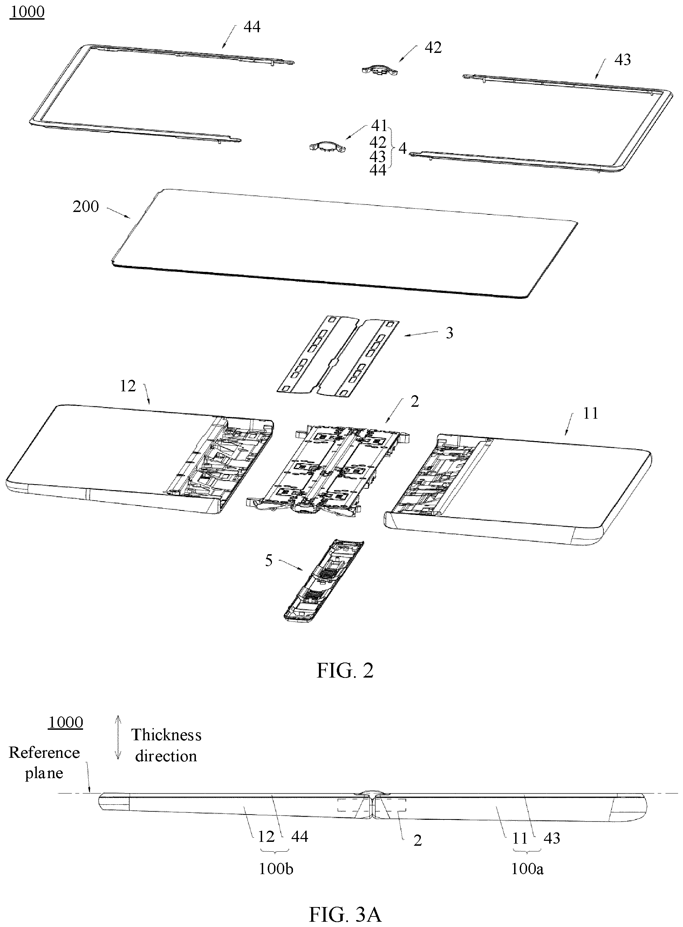

Refer to FIG. 1A, FIG. 1B, and FIG. 2. FIG. 2 is a schematic diagram of a partial decomposition structure of the electronic device 1000 shown in FIG. 1A.

In some embodiments, the housing apparatus 100 includes a first housing 11, a second housing 12, a hinge assembly 2, a rotating shaft connection assembly 3, a first protector 41, a second protector 42, a first protection housing 43, a second protection housing 44, and a back cover 5.

The hinge assembly 2 is connected between the first housing 11 and the second housing 12. The hinge assembly 2 may be moved, so that the first housing 11 and the second housing 12 can be unfolded relative to each other to an open state or folded relative to each other to a closed state. It should be understood that, when the electronic device 1000 is in the open state, the screen 200, the housing apparatus 100, and each component of the housing apparatus 100 are correspondingly in an open state, or when the electronic device 1000 is in the closed state, the screen 200, the housing apparatus 100, and each component of the housing apparatus 100 are correspondingly in a closed state.

The rotating shaft connection assembly 3 is located above the hinge assembly 2 and fixedly connected to the hinge assembly 2. The screen 200 is located above the first housing 11, the rotating shaft connection assembly 3, and the second housing 12 and fixedly connected to the first housing 11, the rotating shaft connection assembly 3, and the second housing 12. The rotating shaft connection assembly 3 is not only configured to connect the hinge assembly 2 and the screen 200, but also configured to provide a supporting environment with better flatness for the screen 200, to improve reliability of the screen 200. In this embodiment of this application, an orientation that is the same as a light output direction of the screen 200 is defined as an "up" direction, and an orientation that is opposite to the light output direction of the screen 200 is defined as a "down" direction. The screen 200 can be moved along with the first housing 11, the hinge assembly 2, and the second housing 12, to be unfolded or folded.

The first protector 41 and the second protector 42 are respectively installed at two ends of the hinge assembly 2. A part of a structure of the first protector 41 is located above an edge of a part of the screen 200, and a part of a structure of the second protector 42 is located above another part of the edge of the screen 200. The part of the structure of the first protector 41 and the part of the structure of the second protector 42 can adaptively deform as the screen 200 is moved. The first protection housing 43 is approximately in a "[" shape, and the first protection housing 43 is installed on an edge of the first housing 11 and moved along with the first housing 11. A part of a structure of the first protection housing 43 is located above the another part of the edge of the screen 200. The second protection housing 44 is approximately in a "]" shape, and the second protection housing 44 is installed in the second housing 12 and moved along with the second housing 12. A part of a structure of the second protection housing 44 is located above the another part of the edge of the screen 200. The first protector 41, the first protection housing 43, the second protector 42, and the second protection housing 44 jointly form a protection assembly 4. The protection assembly 4 is disposed around an edge of the screen 200 and configured to jointly protect the edge of the screen 200, to reduce damage, for example, a tilt, to the screen 200, and improve reliability of the screen 200.

When the electronic device 1000 is in the open state, an included angle between the first housing 11 and the second housing 12 may be approximately 180°, the first housing 11 and the second housing 12 are flattened, the first protection housing 43 is moved along with the first housing 11, the second protection housing 44 is moved along with the second housing 12, the first protection housing 43 and the second protection housing 44 are flattened, and the screen 200 is flattened. In some other embodiments, when the electronic device 1000 is in the open state, an angle between the first housing 11 and the second housing 12 may alternatively have a slight deviation relative to 180°, for example, be 165°, 177°, or 185°. In this case, it is also considered that the first housing 11 and the second housing 12 are flattened. The included angle between the first housing 11 and the second housing 12 is defined as an included angle between the upper side of the first housing 11 and the upper side of the second housing 12.

When the electronic device 1000 is in the closed state, an included angle between the first housing 11 and the second housing 12 may be approximately 0°, the first housing 11 and the second housing 12 are folded, the first protection housing 43 is moved along with the first housing 11, the second protection housing 44 is moved along with the second housing 12, the first protection housing 43 and the second protection housing 44 are folded to a closed state, and the screen 200 is folded. For example, when being in the closed state, the first protection housing 43 and the second protection housing 44 may be in contact with each other to implement positioning. In some other embodiments, when being in the closed state, the first protection housing 43 and the second protection housing 44 may be alternatively close to each other, and there is a tiny gap between the first protection housing 43 and the second protection housing 44. This is not strictly limited in this application.

The back cover 5 is located below the hinge assembly 2 and fixedly connected to the hinge assembly 2. When the electronic device 1000 is in the open state, the first housing 11 and the second housing 12 jointly cover the back cover 5, and the back cover 5 is hidden between the hinge assembly 2, the first housing 11, and the second housing 12. When the electronic device 1000 is in the closed state, the back cover 5 is exposed relative to the first housing 11 and the second housing 12, the back cover 5 forms a part of an exterior member of the electronic device 1000, and the back cover 5 can block the hinge assembly 2, to improve appearance consistency and aesthetics of the electronic device 1000, and also help the user hold the electronic device 1000.

It may be understood that the first housing 11 and the second housing 12 are housing members, are configured to install and fasten another component of the electronic device 1000, and have diversified structures. In this embodiment of this application, only some structures of the first housing 11 and the second housing 12 are briefly described as examples, and are also briefly shown in the accompanying drawings. Specific structures of the first housing 11 and the second housing 12 are not strictly limited in this embodiment of this application.

In some embodiments, the first housing 11 may include a first middle frame and a first rear cover. The first middle frame is connected to one side of the hinge assembly 2. The first rear cover is located below the first middle frame and fixedly connected to the first middle frame. The first rear cover forms a part of the exterior member of the electronic device 1000. For example, the first rear cover may be a protection cover plate, configured to protect a component located inside the first housing 11, and also configured to present a part of an appearance of the electronic device 1000. In some other embodiments, the first rear cover may alternatively include a transparent cover plate and a display, to implement a display function and/or a touch function.

The second housing 12 may include a second middle frame and a second rear cover. The second middle frame is connected to another side of the hinge assembly 2. The second rear cover is located below the second middle frame and fixedly connected to the second middle frame. The second rear cover forms a part of the exterior member of the electronic device 1000. For example, the second rear cover may be a protection cover plate, configured to protect a component located inside the second housing 12, and also configured to present a part of the appearance of the electronic device 1000. In some other embodiments, the second rear cover may alternatively include a transparent cover plate and a display, to implement a display function and/or a touch function.

The first middle frame and/or the second middle frame may include a metal part and a plastic part, and be integrally formed in an in-mold decoration (in-mold decoration, IMD) forming manner. When being a protection cover plate, the first rear cover and/or the second rear cover may be made of a glass material or a metal material. This is not strictly limited in this application.

The first middle frame and the second middle frame each include a border part and a middle plate part. The border part forms a part of the exterior member of the electronic device 1000. The middle plate part is located on an inner side of the border part, and the middle plate part may be provided with a plurality of installation structures such as a protrusion and a groove and configured to fit another component of the electronic device 1000, so that another part is installed in the first housing 11 and/or the second housing 12.

The exterior member (including the border part of the first middle frame, the first rear cover, the border part of the second middle frame, and the second rear cover) of the electronic device 1000 may be provided with a plurality of through holes. The plurality of through holes are configured to enable a plurality of components installed in the housing apparatus 100 to interact with the outside of the electronic device 1000. The plurality of through holes may include but are not limited to a USB jack corresponding to the USB interface, a camera hole corresponding to the camera, a speaker hole corresponding to the speaker, a receiver hole corresponding to the receiver, a microphone hole corresponding to the microphone, a headset hole corresponding to the headset jack, a button hole corresponding to the button, an indicator light hole corresponding to the indicator, and a SIM card slot corresponding to the SIM card interface. There may be one or more through holes of each type. The exterior member may alternatively include fewer or more types of through holes. The exterior member of the electronic device 1000 may further include a plurality of non-signal shielding regions, so that the antenna can receive and send an electromagnetic wave through the non-signal shielding regions.

In this application, the first housing 11 and the first protection housing 43 may jointly form a first housing part of the housing apparatus 100, and the second housing 12 and the second protection housing 44 may jointly form a second housing part of the housing apparatus 100. An appearance structure of the first housing part and an appearance structure of the second housing part present a part of an appearance structure of the electronic device 1000.

The following provides an example for description.

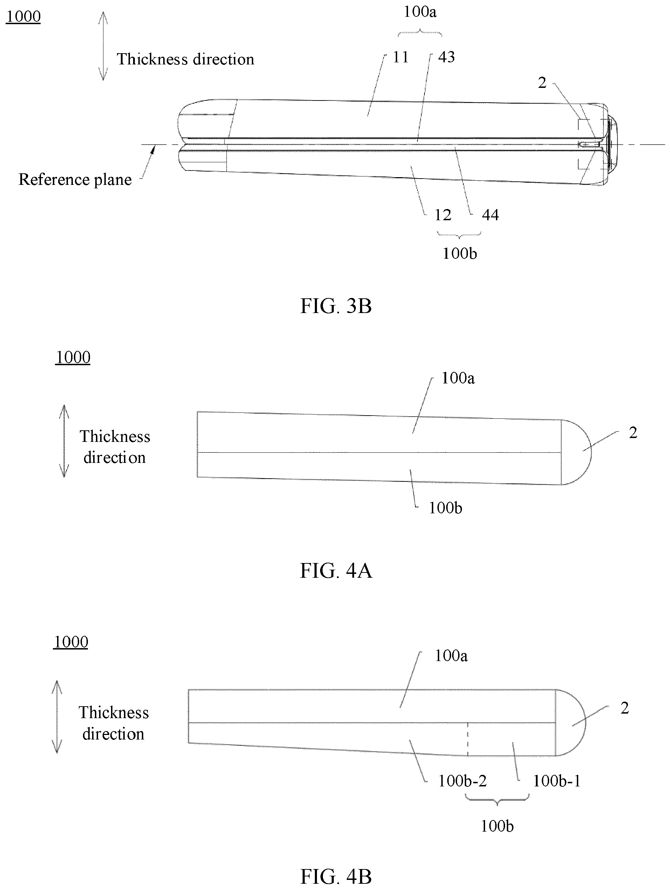

Refer to FIG. 3A and FIG. 3B. FIG. 3A is a schematic diagram of a structure of the electronic device 1000 shown in FIG. 1A from another perspective. FIG. 3B is a schematic diagram of a structure of an electronic device 1000 shown in FIG. 1B from another perspective.

In some embodiments, a plane on which an upper end that is of the first protection housing 43 and that backs onto the first housing 11 is located is defined as a reference plane, and a direction perpendicular to the reference plane is defined as a thickness direction of the electronic device 1000. The upper end that is of the first protection housing 43 and that backs onto the first housing 11 may be an endpoint of a convex edge structure or a flat upper surface. When the electronic device 1000 is in the open state, an upper end that is of the second protection housing 44 and that backs onto the second housing 12 is flush with the upper end of the first protection housing 43, and the upper end of the second protection housing 44 is also located on the reference plane. When the electronic device 1000 is in the closed state, the upper end of the second protection housing 44 may be in contact with the upper end of the first protection housing 43. In this case, the upper end of the second protection housing 44 is also located on the reference plane.

Refer to FIG. 3A and FIG. 3B. In this application, one end that is of a component and that is close to the hinge assembly 2 is defined as a proximal end, and one end that is of the component and that is away from the hinge assembly 2 is defined as a distal end. When the electronic device 1000 is in the open state, a proximal end of a first housing part 100a and a proximal end of a second housing part 100b are located between a distal end of the first housing part 100a and a distal end of the second housing part 100b. When the electronic device 1000 is in the closed state, the proximal end of the first housing part 100a and the proximal end of the second housing part 100b are disposed on a same side, and the distal end of the first housing part 100a and the distal end of the second housing 12 are disposed on a same side.

For example, when the electronic device 1000 is in the open state, a thickness of the electronic device 1000 is reduced in a direction from the distal end of the first housing part 100a to the distal end of the second housing part 100b. When the electronic device 1000 is in the closed state, a thickness of the electronic device 1000 is reduced in a direction from a proximal end to a distal end. A thickness of the distal end of the first housing part 100a is greater than a thickness of the proximal end of the first housing part 100a. The thickness of the proximal end of the first housing part 100a is slightly greater than a thickness of the proximal end of the second housing part 100b. The thickness of the proximal end of the second housing part 100b is greater than a thickness of the distal end of the second housing part 100b. For example, a thickness change of the first housing part 100a and a thickness change of the second housing part 100b may be gradual.

In this embodiment, the electronic device 1000 presents a form of a thickness change, to facilitate lightening and thinning, and provide better appearance experience of the electronic device 1000. In addition, when the electronic device 1000 is in the closed state, the distal end of the electronic device 1000 has a smaller thickness, to facilitate holding by the user, so as to improve user experience.

It should be understood that, to facilitate holding and improve an appearance perception, a smooth curved-surface transition structure is designed for both an end part of the first housing part 100a and an end part of the second housing part 100b. The foregoing thickness design solutions of the first housing part 100a and the second housing part 100b do not exclude a solution of a thickness change caused by the transition structure.

It may be understood that a maximum thickness of an electronic device is usually limited to components with a larger thickness in the entire electronic device, for example, a camera and a hinge assembly. It is difficult to make these thicker components thin. However, in a folded state, a thickness of one end that is of a conventional electronic device and that is close to a hinge apparatus is substantially the same as a thickness of one end that is of the conventional electronic device and that is away from the hinge apparatus. This causes a large overall thickness of the conventional electronic device.

In some embodiments, as shown in FIG. 3A and FIG. 3B, a thickness of the first protection housing 43 remains unchanged, and a thickness of the second protection housing 44 remains unchanged. A thickness of a distal end of the first housing 11 is greater than a thickness of a proximal end of the first housing 11. The thickness of the proximal end of the first housing 11 is slightly greater than a thickness of a proximal end of the second housing 12. The thickness of the proximal end of the second housing 12 is greater than a thickness of a distal end of the second housing 12. In other words, the thickness change of the first housing part 100a and the thickness change of the second housing part 100b are mainly reflected on the first housing 11 and the second housing 12.

In the solution of this application, the distal end of the first housing 11, the proximal end of the first housing 11, the proximal end of the second housing 12, and the distal end of the second housing 12 are gradually thinned in thickness. Components of the electronic device 1000 may be flexibly arranged based on a thickness of a specific region of a housing. For example, a component with a larger thickness (for example, the camera or the battery) or a component with a larger volume is arranged in a housing region with a larger thickness, and a component with a smaller thickness (for example, the fingerprint sensor) or a component with a smaller volume is arranged in a housing region with a smaller thickness. In this way, a thickness of a thickest region of the housing of the electronic device 1000 may be substantially equal to a thickness of a housing of the conventional electronic device, and another region may be thinned. Compared with the conventional electronic device, the electronic device 1000 in this embodiment visually appears thinner and lighter. In addition, the user feels better in holding. In this embodiment of this application, arrangement positions of a plurality of components of the electronic device 1000 in the first housing 11 and/or the second housing 12 are not strictly limited.

In some embodiments, the electronic device 1000 may further include one or more flexible circuit boards (not shown in the figure). The flexible circuit board crosses (or passes through) the hinge assembly 2. Two ends of the flexible circuit board are respectively located in the first housing 11 and the second housing 12. The flexible circuit board is configured to electrically connect a component located in the first housing 11 and a component located in the second housing 12, to facilitate power supply and signal transmission of an internal component of the electronic device 1000. Large components are placed in a same housing as much as possible, to effectively reduce a transmission requirement of the flexible circuit board, so as to improve communication reliability of the electronic device 1000.

In some other embodiments, the thickness change of the first housing part 100a and the thickness change of the second housing part 100b may be alternatively reflected by a thickness change of the first protection housing 43 and a thickness change of the second protection housing 44. For example, a thickness of the first housing 11 and a thickness of the second housing 12 remain unchanged, a thickness of a distal end of the first protection housing 43 is greater than a thickness of a proximal end, a thickness of a proximal end of the second protection housing 44 is greater than a thickness of a distal end, and the thickness of the proximal end of the first protection housing 43 is slightly greater than or equal to that of the proximal end of the second protection housing 44.

In the solution of this application, thickness distribution of the first housing part 100a and thickness distribution of the second housing part 100b determine thickness distribution of the entire electronic device 1000. The thickness distribution of the first housing part 100a and the thickness distribution of the second housing part 100b may be flexibly combined based on a requirement, including but not limited to: A thickness of the first housing part 100a remains unchanged or changes; and/or a thickness of the second housing part 100b remains unchanged or changes; and/or the thickness of the proximal end of the second housing part 100b is equal to or unequal to the thickness of the proximal end of the first housing part 100a.

The following provides an example for description. In the following FIG. 4A to FIG. 4G, the first housing 100a, the second housing 100b, and the hinge assembly 2 of the electronic device 1000 are shown by using brief diagrams, and other components of the electronic device 1000 are not shown.

FIG. 4A is a schematic diagram of a structure of the electronic device 1000 shown in FIG. 1B in some other embodiments.

In some other embodiments, the thickness of the first housing part 100a progressively decreases in a direction close to the hinge assembly 2, and the thickness of the second housing part 100b progressively decreases in a direction away from the hinge assembly 2. When the electronic device 1000 is in the open state, a thickness of the electronic device 1000 progressively decreases in a direction from the first housing part 100a to the second housing part 100b. When the electronic device 1000 is in the closed state, a thickness of the electronic device 1000 remains unchanged.

FIG. 4B is a schematic diagram of a structure of the electronic device 1000 shown in FIG. 1B in some other embodiments.

In some other embodiments, the thickness of the first housing part 100a remains unchanged. The second housing part 100b includes a first part 100b-1 close to the hinge assembly 2 and a second part 100b-2 away from the hinge assembly 2. A thickness of the first part 100b-1 remains unchanged and is equal to the thickness of the first housing part 100a. A thickness of the second part 100b-2 progressively decreases in a direction away from the hinge assembly 2. When the electronic device 1000 is in the closed state, a thickness of the proximal end of the electronic device 1000 is greater than a thickness of the distal end.

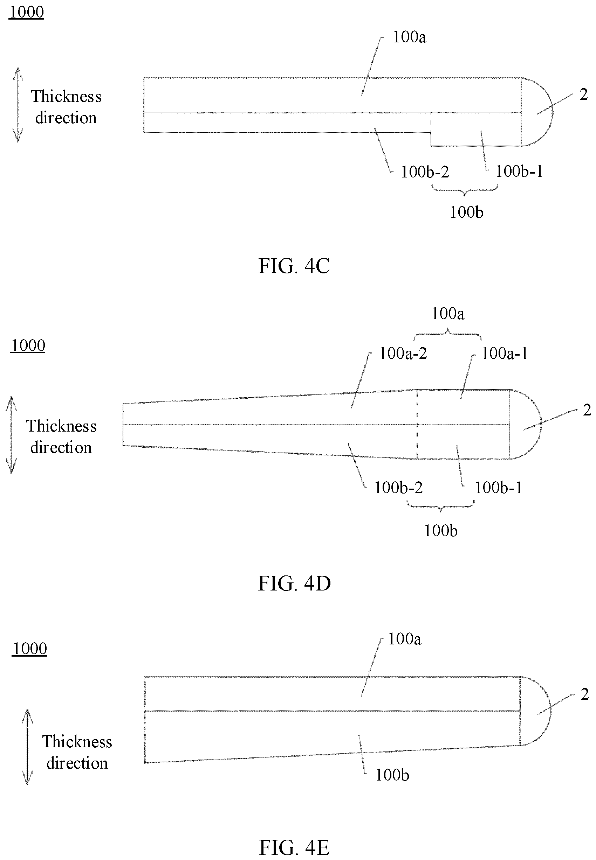

FIG. 4C is a schematic diagram of a structure of the electronic device 1000 shown in FIG. 1B in some other embodiments.

In some other embodiments, the thickness of the first housing part 100a remains unchanged. The second housing part 100b includes a first part 100b-1 close to the hinge assembly 2 and a second part 100b-2 away from the hinge assembly 2. A thickness of the first part 100b-1 remains unchanged and is equal to the thickness of the first housing part 100a. A thickness of the second part 100b-2 remains unchanged and is less than the thickness of the first part 100b-1. When the electronic device 1000 is in the closed state, a thickness of the proximal end of the electronic device 1000 is greater than a thickness of the distal end.

FIG. 4D is a schematic diagram of a structure of the electronic device 1000 shown in FIG. 1B in some other embodiments.

In some other embodiments, the first housing part 100a includes a first part 100a-1 close to the hinge assembly 2 and a second part 100a-2 away from the hinge assembly 2. A thickness of the first part 100a-1 remains unchanged. A thickness of the second part 100a-2 progressively decreases in a direction away from the hinge assembly 2. The second housing part 100b includes a first part 100b-1 close to the hinge assembly 2 and a second part 100b-2 away from the hinge assembly 2. A thickness of the first part 100b-1 remains unchanged. A thickness of the second part 100b-2 progressively decreases in the direction away from the hinge assembly 2. The second housing part 100b and the first housing part 100a are symmetrical. When the electronic device 1000 is in the closed state, a thickness of the proximal end of the electronic device 1000 is greater than a thickness of the distal end.

FIG. 4E is a schematic diagram of a structure of the electronic device 1000 shown in FIG. 1B in some other embodiments.

In some other embodiments, the thickness of the first housing part 100a remains unchanged, and the thickness of the second housing part 100b progressively increases in a direction away from the hinge assembly 2. When the electronic device 1000 is in the closed state, a thickness of the proximal end of the electronic device 1000 is less than a thickness of the distal end.

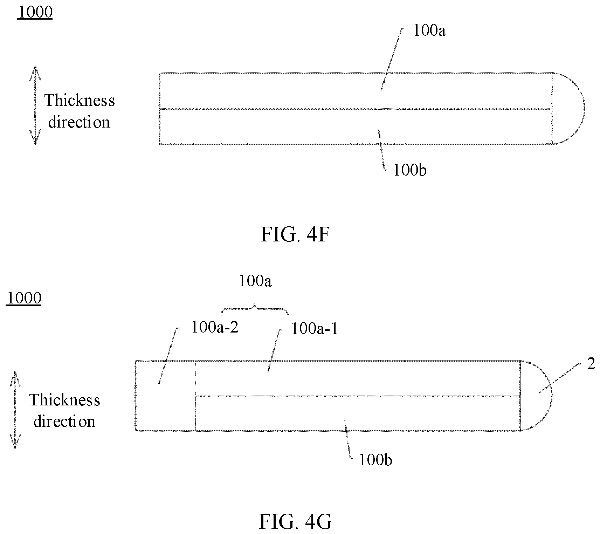

FIG. 4F is a schematic diagram of a structure of the electronic device 1000 shown in FIG. 1B in some other embodiments.

In some other embodiments, the thickness of the first housing part 100a remains unchanged. The thickness of the second housing part 100b remains unchanged. An overall thickness of the electronic device 1000 also remains unchanged when the electronic device 1000 is in the open state or the closed state.

FIG. 4G is a schematic diagram of a structure of the electronic device 1000 shown in FIG. 1B in some other embodiments.

In some other embodiments, the first housing part 100a includes a first part 100a-1 close to the hinge assembly 2 and a second part 100a-2 away from the hinge assembly 2. A thickness of the first part 100a-1 remains unchanged. A thickness of the second part 100a-2 remains unchanged and is greater than the thickness of the first part 100a-1. The thickness of the second housing part 100b remains unchanged. When the electronic device 1000 is in the closed state, the second housing part 100b and the first part 100a-1 of the first housing part 100a are stacked. A sum of the thickness of the second housing part 100b and the thickness of the first part 100a-1 of the first housing part 100a is equal to the thickness of the second part 100a-2 of the first housing part 100a. A thickness of the electronic device 1000 remains unchanged.

It should be understood that the embodiments shown in FIG. 4A to FIG. 4G are merely examples for describing possible variant solutions of the electronic device 1000 in this application and constitute no limitation on a specific form of the electronic device 1000 in this application.

In this application, the hinge assembly 2 is connected to the first housing 11 and the second housing 12. By using a structural design of the hinge assembly 2, the first housing 11 and the second housing 12 can be flattened when the electronic device 1000 is in the open state, provide a flat supporting environment for the screen 200 together with the hinge assembly 2, can be further folded when the electronic device 1000 is in the closed state, and provide good screen accommodation space for the screen 200 together with the hinge assembly 2, so that the screen 200 of the electronic device 1000 can meet both a large screen display requirement and a folding storage requirement. In addition, the screen 200 has a low damage risk and high reliability.

The following describes an implementation structure of the hinge assembly 2 by using an example.

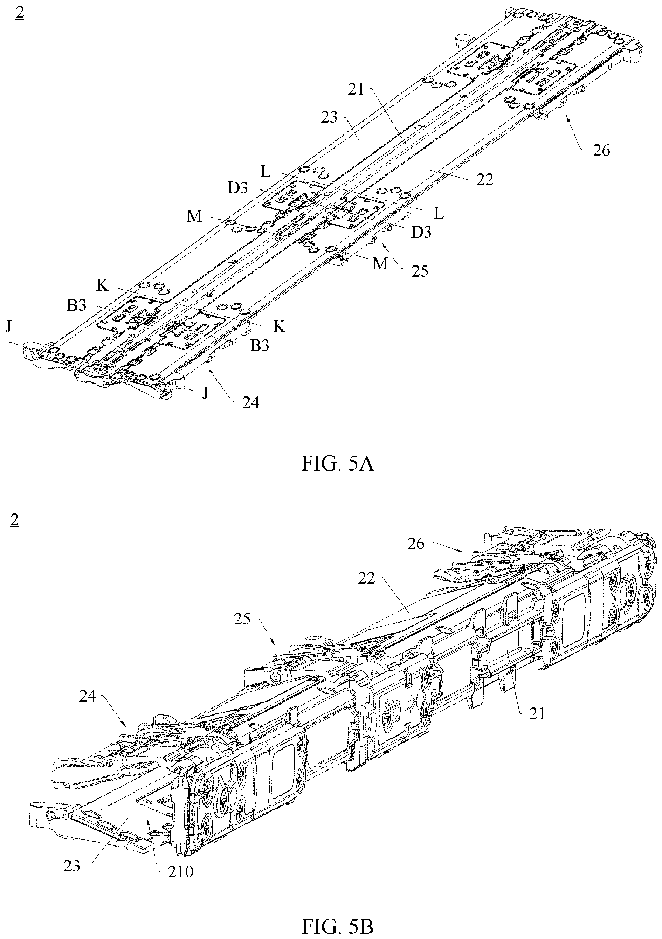

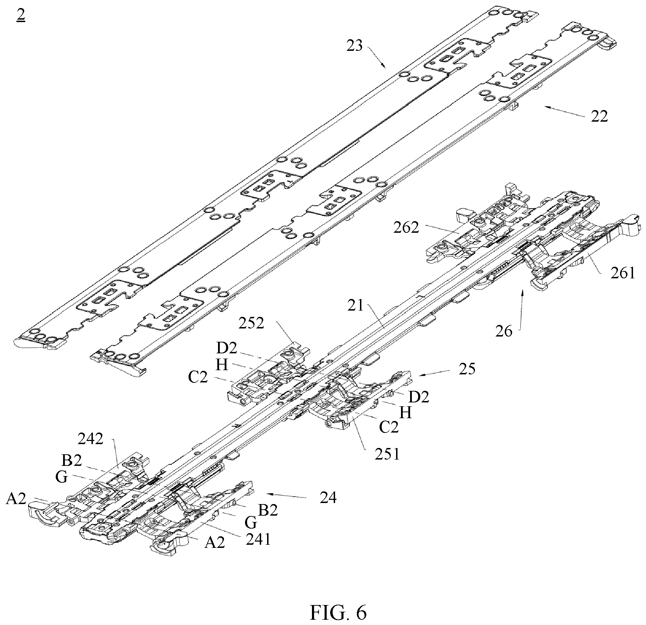

Refer to FIG. 5A, FIG. 5B, and FIG. 6. FIG. 5A is a schematic diagram of a structure of the hinge assembly 2 shown in FIG. 2 in an open state. FIG. 5B is a schematic diagram of a structure of the hinge assembly 2 shown in FIG. 5A in a closed state. FIG. 6 is a schematic diagram of a partial decomposition structure of the hinge assembly 2 shown in FIG. 5A.

In some embodiments, the hinge assembly 2 includes a shaft 21, a first support plate 22, a second support plate 23, a bottom connection assembly 24, a middle connection assembly 25, and a top connection assembly 26. The shaft 21 and a plurality of connection assemblies (24, 25, and 26) jointly form a main movement mechanism of the hinge assembly 2. In this embodiment of this application, two ends close to the shaft 21 are respectively defined as a top end and a bottom end, and a direction from the top end to the bottom end of the shaft 21 is defined as an extension direction of the shaft 21. An orientation close to the top end of the shaft 21 is defined as a "top", and an orientation close to the bottom end of the shaft 21 is defined as a "bottom".

For example, the plurality of connection assemblies (24, 25, and 26) are all connected to the shaft 21, and the plurality of connection assemblies (24, 25, and 26) can be all moved, to be unfolded or folded relative to the shaft 21. The plurality of connection assemblies (24, 25, and 26) each are further connected between the first housing 11 and the second housing 12 (refer to FIG. 2). When the plurality of connection assemblies (24, 25, and 26) are moved relative to the shaft 21, the first housing 11 and the second housing 12 are moved relative to the shaft 21, to be unfolded or folded relative to each other.

Both the first support plate 22 and the second support plate 23 are connected to the plurality of connection assemblies (24, 25, and 26). The first support plate 22 and the second support plate 23 are moved with the plurality of connection assemblies (24, 25, and 26), to implement a relative unfolding action or a relative folding action. As shown in FIG. 5A, when the hinge assembly 2 is in the open state, the first support plate 22 and the second support plate 23 are unfolded relative to each other, and the first support plate 22 and the second support plate 23 are respectively located on two sides of the shaft 21. The first support plate 22, the shaft 21, and the second support plate 23 are configured to jointly provide a flat supporting environment. As shown in FIG. 5B, when the hinge assembly 2 is in the folded state, the first support plate 22 and the second support plate 23 are folded relative to each other, and the first support plate 22 and the second support plate 23 are located on a same side of the shaft 21. A spacing between the first support plate 22 and the second support plate 23 progressively increases in a direction close to the shaft 21. The first support plate 22, the second support plate 23, and the shaft 21 jointly form screen accommodation space 210. In this case, a shape of the screen accommodation space 210 may be in a water drop form or a water drop-similar form.

In this embodiment of this application, an example in which the hinge assembly 2 has three connection assemblies is used for description. It should be understood that, in some other embodiments, the hinge assembly 2 may alternatively have more or fewer connection assemblies, the connection assemblies may be split or combined, and structures of the plurality of connection assemblies (24, 25, and 26) may be the same or different. This is not strictly limited in this embodiment of this application.

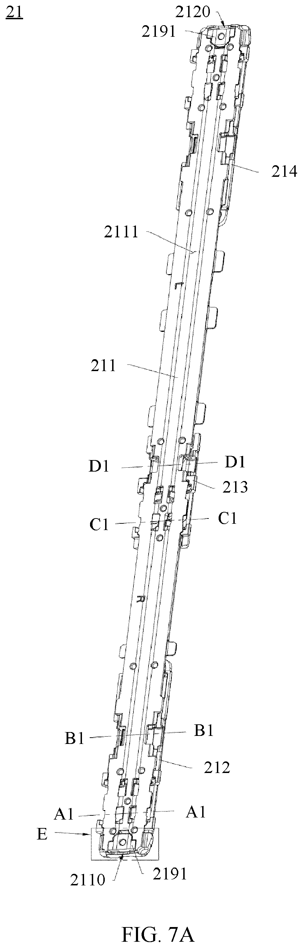

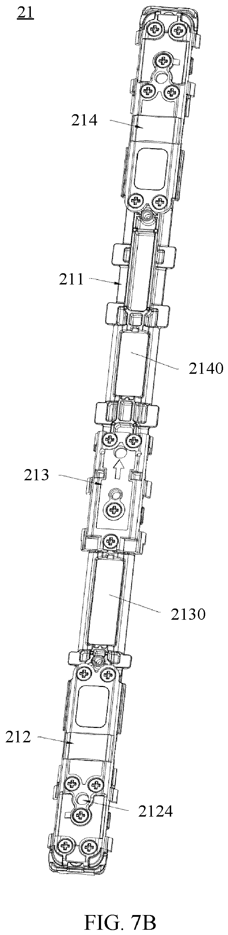

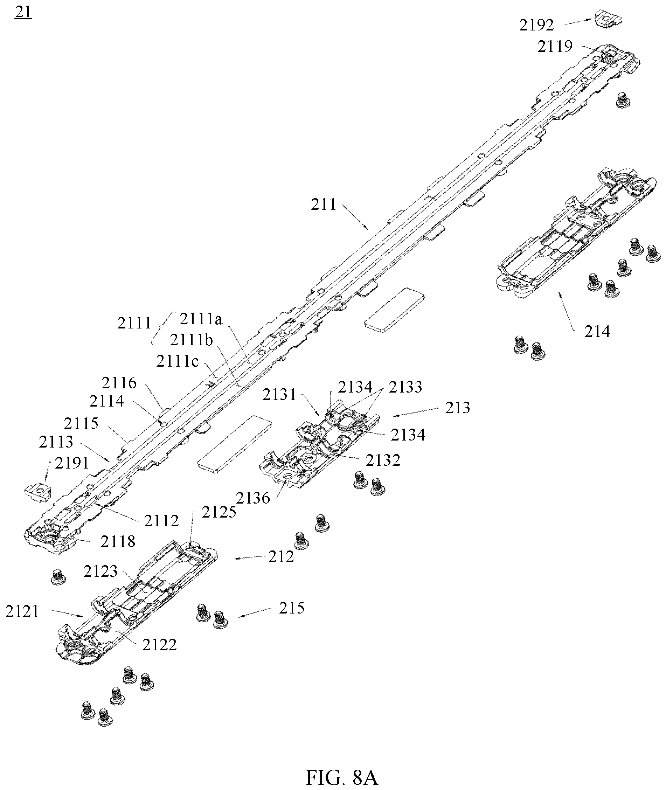

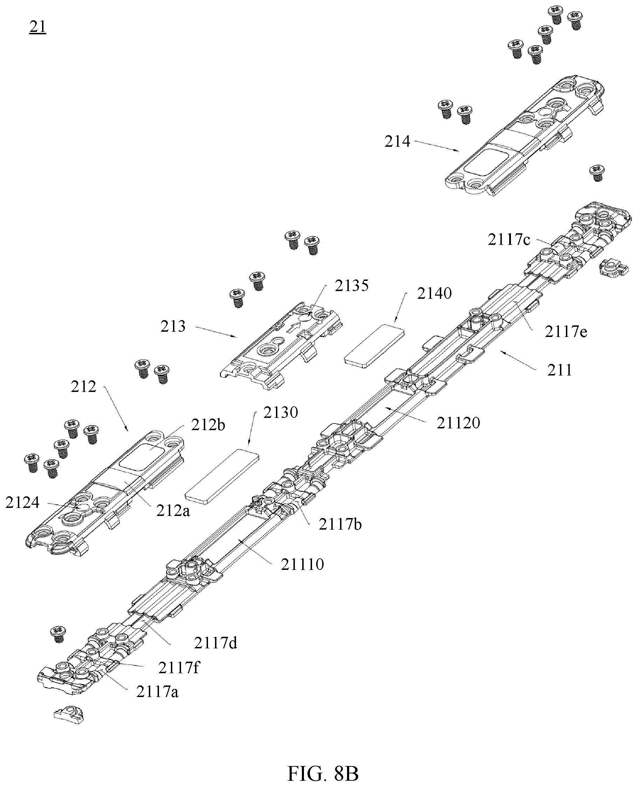

Refer to FIG. 7A, FIG. 7B, FIG. 8A, and FIG. 8B. FIG. 7A is a schematic diagram of a structure of the shaft 21 shown in FIG. 5A from another perspective. FIG. 7B is a schematic diagram of a structure of the shaft 21 shown in FIG. 7A from another perspective. FIG. 8A is a schematic diagram of a decomposition structure of the shaft 21 shown in FIG. 7A. FIG. 8B is a schematic diagram of a structure of the shaft 21 shown in FIG. 8A from another perspective. An angle of view in FIG. 7B horizontally flips relative to an angle of view in FIG. 7A. An angle of view in FIG. 8B horizontally flips relative to an angle of view in FIG. 8A.

In some embodiments, the shaft 21 includes a main support plate 211 and a plurality of casing bodies. The plurality of casing bodies include a bottom casing body 212, a middle casing body 213, and a top casing body 214. The bottom casing body 212, the middle casing body 213, and the top casing body 214 are all located below the main support plate 211. The bottom casing body 212 is fastened to the bottom part of the main support plate 211. Bottom space used to install the bottom connection assembly 24 is formed between the bottom casing body 212 and the main support plate 211. The middle casing body 213 is fastened to the middle part of the main support plate 211. Middle space used to install the middle connection assembly 25 is formed between the middle casing body 213 and the main support plate 211. The top casing body 214 is fastened to the top part of the main support plate 211. Top space used to install the top connection assembly 26 is formed between the top casing body 214 and the main support plate 211. In this embodiment, quantities, structures, positions, and the like of the plurality of casing bodies (212, 213, and 214) are all set corresponding to those of the plurality of connection assemblies (24, 25, and 26).

For example, as shown in FIG. 7A and FIG. 8A, a support surface 2111 is formed on the upper side that is of the main support plate 211 and that backs onto the plurality of casing bodies (212, 213, and 214). As shown in FIG. 8A, the support surface 2111 of the main support plate 211 may include a concave cambered-surface region 2111a located at the middle part and planar regions (2111b and 2111c) located on two sides. The concave cambered-surface region 2111a may form a part of a contour of the screen accommodation space 210 in a closed state. The planar regions (2111b and 2111c) may provide a flat supporting environment in an open state. In some other embodiments, the support surface 2111 of the main support plate 211 may be alternatively in a concave cambered-surface shape or a planar shape as a whole. This is not strictly limited in this embodiment of this application.

For example, as shown in FIG. 8A, the main support plate 211 may be provided with a plurality of avoidance holes 2112, a plurality of avoidance notches 2113, and a plurality of fastening holes 2114. All the foregoing structures penetrate the support surface 2111 of the main support plate 211. The plurality of avoidance holes 2112 are located in the middle region of the main support plate 211. The plurality of avoidance notches 2113 are located on two sides of the main support plate 211. The plurality of avoidance holes 2112 and the plurality of avoidance notches 2113 are configured to avoid mechanical members of the plurality of connection assemblies (24, 25, and 26) in a process in which the hinge assembly 2 is moved. The plurality of fastening holes 2114 are configured to allow a fastener to pass through. The plurality of avoidance holes 2112, the plurality of avoidance notches 2113, and the plurality of fastening holes 2114 are all arranged at the bottom part, the middle part, and at the top part of the main support plate 211 in a distributed manner.

For example, as shown in FIG. 8A, the main support plate 211 may further include a plurality of extension blocks 2115 and a plurality of support blocks 2116. The plurality of extension blocks 2115 are located on the two sides of the main support plate 211. Upper surfaces of the plurality of extension blocks 2115 form a part of the support surface 2111 of the main support plate 211. When the hinge assembly 2 is in the open state, the plurality of extension blocks 2115 may be embedded into notches corresponding to the first support plate 22 and the second support plate 23, to help the hinge assembly 2 provide a more complete supporting environment. The plurality of support blocks 2116 are located on the two sides of the main support plate 211. When the hinge assembly 2 is in the open state, the plurality of support blocks 2116 may be configured to support the first support plate 22 and the second support plate 23.

As shown in FIG. 8B, the lower side that is of the main support plate 211 and that faces the plurality of casing bodies (212, 213, and 214) is provided with a plurality of fitting structures. The plurality of fitting structures are configured to fit the plurality of casing bodies (212, 213, and 214), to form a plurality of pieces of space used to install the plurality of connection assemblies (24, 25, and 26). The plurality of fitting structures may include structures such as a groove, an aperture, and a protrusion. For example, the main support plate 211 includes first cambered surfaces 2117a, second cambered surfaces 2117b, a third cambered surface 2117c, a first wavy surface 2117d, and a second wavy surface 2117e. The first cambered surface 2117a and the first wavy surface 2117d are located at the bottom part of the main support plate 211. There are two first cambered surfaces 2117a. The two first cambered surfaces 2117a are respectively disposed oppositely close to the two sides of the main support plate 211. The first cambered surface 2117a is a raised cambered surface. A concave region may be formed at the middle part of the first cambered surface 2117a. The first cambered surface 2117a may be divided into two parts by a connection rib 2117f. The connection rib 2117f can increase structural strength of the main support plate 211. The first wavy surface 2117d may include a bottom region, a middle region, and a top region that are arranged in the extension direction of the shaft 21. The middle region is concavely disposed relative to the bottom region and the top region. Each region includes a plurality of concave cambered surfaces. An arrangement direction of the plurality of cambered surfaces is perpendicular to the extension direction of the shaft 21. The second cambered surface 2117b is located at the middle part of the main support plate 211. For a structural design of the second cambered surface 2117b, refer to the first cambered surface 2117a. Details are not described herein again. The third cambered surface 2117c and the second wavy surface 2117e are located at the top part of the main support plate 211. For a structural design of the third cambered surface 2117c, refer to the first cambered surface 2117a. For a structural design of the second wavy surface 2117e, refer to the first wavy surface 2117d. Details are not described herein again. For example, arrangement positions of the third cambered surface 2117c and the second wavy surface 2117e may be symmetric to those of the first cambered surface 2117a and the first wavy surface 2117d. It should be understood that, in this embodiment of this application, when one component is designed with reference to another component, structures of the two components may be completely the same, or core structures of the two components may be the same, and a few structures may be different. This is not strictly limited in this application.

For example, the main support plate 211 may be made of a metal material through injection molding. For example, the main support plate 211 may be made of an amorphous material, so that a shrinkage rate of the main support plate 211 in an injection molding process is only several in a thousand, the shrinkage rate is quite low, and the main support plate 211 has a precise size and a high machining yield. As a core component of the hinge assembly 2, the main support plate 211 has a precise machining size, which helps improve reliability of the hinge assembly 2. For example, the amorphous material may be but is not limited to an amorphous alloy material, for example, an iron-based amorphous alloy (Fe-based amorphous alloy). Certainly, the main support plate 211 may be alternatively made of another material. A specific material of the main support plate 211 is not strictly limited in this application.

For example, as shown in FIG. 8A, the bottom casing body 212 may be approximately of a casing body structure whose middle part is concave and two sides are tilted. The two sides of the bottom casing body 212 may be provided with a plurality of avoidance notches 2121. The upper side that is of the bottom casing body 212 and that faces the main support plate 211 is provided with a plurality of fitting structures. The plurality of fitting structures are configured to fit the main support plate 211, to form bottom space used to install the bottom connection assembly 24. The plurality of fitting structures may include structures such as a groove, an aperture, and a protrusion. For example, the bottom casing body 212 may include fourth cambered surfaces 2122 and a third wavy surface 2123. There are two fourth cambered surfaces 2122. The two fourth cambered surfaces 2122 are respectively disposed close to the two sides of the bottom casing body 212. The fourth cambered surface 2122 is a concave cambered surface. The third wavy surface 2123 includes a plurality of regions. Each region includes a plurality of concave cambered surfaces.

As shown in FIG. 8A, the bottom casing body 212 may be fixedly connected to the main support plate 211 by using a plurality of fasteners 215. The bottom casing body 212 may be further provided with a plurality of fastening holes 2125. The plurality of fastening holes 2125 of the bottom casing body 212 are aligned with some fastening holes 2114 of the main support plate 211. The plurality of fasteners 215 stretch into the fastening holes 2125 of the bottom casing body 212 and the fastening holes 2114 of the main support plate 211, to lock the bottom casing body 212 and the main support plate 211.

As shown in FIG. 8B, the bottom casing body 212 may be further provided with a fixing hole 2124. The fixing hole 2124 forms an opening on a lower surface of the bottom casing body 212, and the fixing hole 2124 is configured to allow another component to be connected to the bottom casing body 212 in a fastening manner.

As shown in FIG. 8B, the bottom casing body 212 may include a main body member 212a and a fitting member 212b. Density of the fitting member 212b is less than density of the main body member 212a. A large-surface region of the main body member 212a may be provided with a hole. The fitting member 212b is installed in the hole, so that the bottom casing body 212 has a complete structure and a lighter weight, which facilitates weight lightening of the hinge assembly 2 and the electronic device 1000. A main body part of the bottom casing body 212 may be formed by using a metal injection molding (metal injection molding, MIM) technology. In some other embodiments, the bottom casing body 212 may be alternatively integrally formed by using a metal injection molding technology and of an integrated structure. This is not strictly limited in this embodiment of this application. The fitting member 212b may be made of a material with low density and specific rigidity, for example, polyethylene terephthalate (polyethylene terephthalate, PET). The fitting member 212b may be fastened to the bottom casing body 212 in a manner, for example, bonding or clamping.

For example, as shown in FIG. 8A, the middle casing body 213 may be approximately of a casing body structure whose middle part is concave and two sides are tilted. The two sides of the middle casing body 213 may be provided with a plurality of avoidance notches 2131. The upper side that is of the middle casing body 213 and that faces the main support plate 211 is provided with a plurality of fitting structures. The plurality of fitting structures are configured to fit the main support plate 211, to form middle space. The plurality of fitting structures may include structures such as a groove, an aperture, and a protrusion. For example, the middle casing body 213 may include fifth cambered surfaces 2132 and rotatable connection protrusions 2133. There are two fifth cambered surfaces 2132. The two fifth cambered surfaces 2132 are respectively disposed close to the two sides of the middle casing body 213. The fifth cambered surface 2132 is a concave cambered surface. There are two rotatable connection protrusions 2133. The two rotatable connection protrusions 2133 are respectively close to the two sides of the middle casing body 213. The rotatable connection protrusion 2133 includes two parts disposed at an interval. Each part is provided with a rotating shaft hole 2134.

The middle casing body 213 may be fixedly connected to the main support plate 211 by using a plurality of fasteners 215. The middle casing body 213 may be further provided with a plurality of fastening holes 2136. The plurality of fastening holes 2136 of the middle casing body 213 are aligned with some fastening holes 2114 of the main support plate 211. The plurality of fasteners 215 stretch into the fastening holes 2136 of the middle casing body 213 and the fastening holes 2114 of the main support plate 211, to lock the middle casing body 213 and the main support plate 211.

As shown in FIG. 8B, the middle casing body 213 may be further provided with a fixing hole 2135. The fixing hole 2135 forms an opening on a lower surface of the middle casing body 213, and the fixing hole 2135 is configured to allow another component to be connected to the bottom casing body 212 in a fastening manner. The middle casing body 213 may be integrally formed by using the metal injection molding technology and of an integrated structure.

For example, a structure and a molding technology of the top casing body 214 may be designed with reference to those of the bottom casing body 212, and a connection structure between the top casing body 214 and the main support plate 211 may be designed with reference to that between the bottom casing body 212 and the main support plate 211. Details are not described herein again.

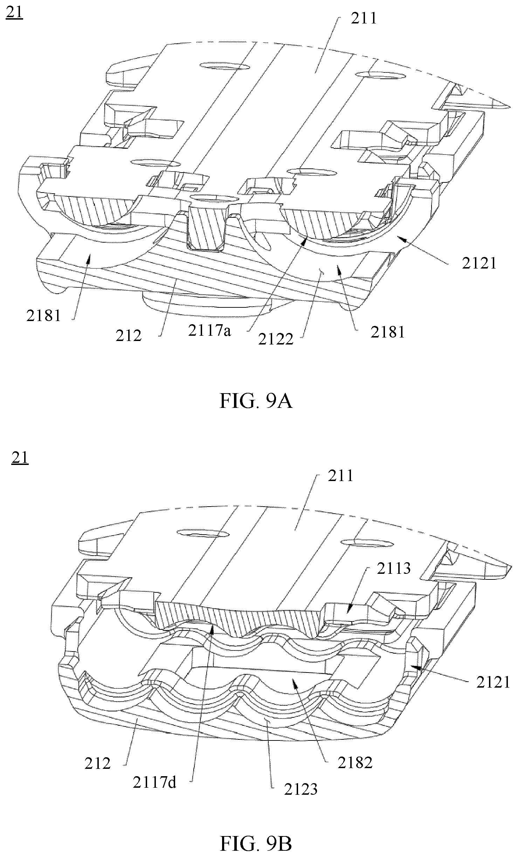

Refer to FIG. 8A, FIG. 8B, and FIG. 9A. FIG. 9A is a schematic diagram of a cross-sectional structure of the shaft 21 that is cut along a cross section A1-A1 and that is shown in FIG. 7A. A cross section obtained by the cutting along the cross section A1-A1 passes through the main support plate 211 and the bottom casing body 212. For example, the two first cambered surfaces 2117a of the main support plate 211 are respectively disposed opposite to the two fourth cambered surfaces 2122 of the bottom casing body 212, and first arc-shaped space is formed between the corresponding first cambered surfaces 2117a and fourth cambered surfaces 2122. To be specific, the shaft 21 has two pieces of first arc-shaped space 2181, and the two pieces of first arc-shaped space 2181 are respectively disposed close to the two sides of the shaft 21. For example, the two pieces of first arc-shaped space 2181 may be respectively connected to space on the two sides of the shaft 21 through two avoidance notches 2121 of the bottom casing body 212. The two pieces of first arc-shaped space 2181 are a part of the bottom space, and are used to install a part of a structure of the bottom connection assembly 24.

Refer to FIG. 8A, FIG. 8B, and FIG. 9B. FIG. 9B is a schematic diagram of a cross-sectional structure of the shaft 21 that is cut along a cross section B1-B 1 and that is shown in FIG. 7A. A cross section obtained by the cutting along the cross section B1-B1 passes through the main support plate 211 and the bottom casing body 212. For example, the first wavy surface 2117d of the main support plate 211 and the third wavy surface 2123 of the bottom casing body 212 are disposed opposite to each other, to form first installation space 2182 between the first wavy surface 2117d and the third wavy surface 2123. Two ends of the first installation space 2182 are respectively connected to the space on the two sides of the shaft 21. The first installation space 2182 may be connected to space on an outer side of the shaft 21 through the avoidance notch 2113 of the main support plate 211 and the avoidance notch 2121 of the bottom casing body 212. The first installation space 2182 is another part of the bottom space and used to install another part of the structure of the bottom connection assembly 24.

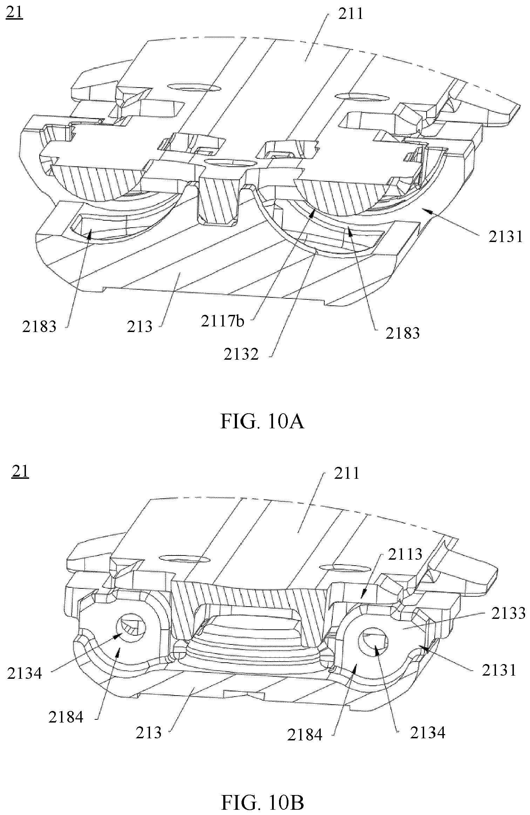

Refer to FIG. 8A, FIG. 8B, and FIG. 10A. FIG. 10A is a schematic diagram of a cross-sectional structure of the shaft 21 that is cut along a cross section C1-C1 and that is shown in FIG. 7A. A cross section obtained by the cutting along the cross section C1-C1 passes through the main support plate 211 and the middle casing body 213. For example, two second cambered surfaces 2117b of the main support plate 211 are respectively disposed opposite to the two fifth cambered surfaces 2132 of the middle casing body 213, and second arc-shaped space 2183 is formed between the corresponding second cambered surfaces 2117b and fifth cambered surfaces 2132. To be specific, the shaft 21 has two pieces of second arc-shaped space 2183, and the two pieces of second arc-shaped space 2183 are respectively disposed close to the two sides of the shaft 21. For example, the two pieces of second arc-shaped space 2183 may be respectively connected to the space on the two sides of the shaft 21 through two avoidance notches 2131 of the middle casing body 213. The two pieces of second arc-shaped space 2183 are a part of the middle space, and are used to install a part of a structure of the middle connection assembly 25.

Refer to FIG. 8A, FIG. 8B, and FIG. 10B. FIG. 10B is a schematic diagram of a cross-sectional structure of the shaft 21 that is cut along a cross section D1-D1 and that is shown in FIG. 7A. A cross section obtained by the cutting along the cross section D1-D1 passes through the main support plate 211 and the middle casing body 213. For example, two pieces of rotation space 2184 are formed between the main support plate 211 and the middle casing body 213, and the rotation space 2184 are located between the two parts that are of the rotatable connection protrusion 2133 and that are disposed at the interval. The rotating shaft hole of the rotatable connection protrusion 2133 is connected to the rotation space 2184. The two pieces of rotation space 2184 are a part of the middle space, and the two pieces of rotation space 2184 may be respectively connected to the space on the two sides of the shaft 21. The rotation space 2184 may be connected to the space on the outer side of the shaft 21 through the avoidance notch 2113 of the main support plate 211 and the avoidance notch 2131 of the middle casing body 213.

Refer to FIG. 8A. For example, for a structural design of top space between the top casing body 214 and the main support plate 211, refer to that of the bottom space. Details are not described herein again.

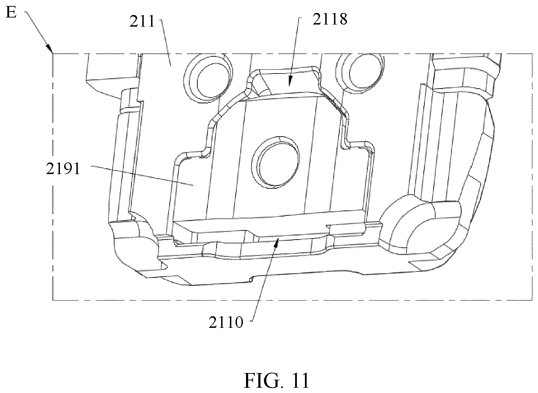

Refer to FIG. 7A, FIG. 8A, and FIG. 11. FIG. 11 is an enlarged schematic diagram of a structure of the shaft 21 shown in FIG. 7A at a position E. For example, the bottom end of the main support plate 211 is provided with a first groove 2118. A fastening hole connected to the first groove 2118 is disposed below the first groove 2118. The top end of the main support plate 211 is provided with a second groove 2119. A fastening hole connected to the second groove 2119 is disposed below the second groove 2119. The shaft 21 further includes a first position-limiting block 2191 and a second position-limiting block 2192. The first position-limiting block 2191 and the second position-limiting block 2192 each is provided with a fastening hole. The first position-limiting block 2191 is installed in the first groove 2118 and fixedly connected to the main support plate 211. The second position-limiting block 2192 is installed in the second groove 2119 and fixedly connected to the main support plate 211. For example, the fastener may pass through the fastening hole of the main support plate 211 and the fastening hole of the position-limiting block, and the position-limiting block and the main support plate 211 are locked by using the fastener. In some other embodiments, the first position-limiting block 2191 and/or the second position-limiting block 2192 may be alternatively fastened to the main support plate 211 in a manner, for example, bonding or a snap-fit connection. In some other embodiments, the first position-limiting block 2191 and/or the second position-limiting block 2192 and the main support plate 211 may be alternatively of an integrated structure.

A first clamping slot 2110 may be formed at the bottom end of the shaft 21, the first clamping slot 2110 is a part of the first groove 2118, and the first clamping slot 2110 is formed between a groove wall of the first groove 2118 and the first position-limiting block 2191. For example, the first clamping slot 2110 may be a T-shaped slot. A second clamping slot 2120 may be formed at the top end of the shaft 21, the second clamping slot 2120 is a part of the second groove 2119, and the second clamping slot 2120 is formed between a groove wall of the second groove 2119 and the second position-limiting block 2192. For example, the second clamping slot 2120 may be a T-shaped slot. The first clamping slot 2110 is configured to install the first protector 41. The second clamping slot 2120 is configured to install the second protector 42. A specific connection structure is described below.

It may be understood that, when injection molding is performed on the amorphous material of the main support plate 211, the first groove 2118 and the second groove 2119 can be configured to implement fixture positioning, so that the main support plate 211 is formed by using a mold. When the main support plate 211 is made of another material, the main support plate 211 may be alternatively provided with no first groove 2118 and second groove 2119, and the shaft 21 may alternatively include no first position-limiting block 2191 and second position-limiting block 2192. Instead, the first clamping slot 2110 and the second clamping slot 2120 are directly formed by the main support plate 211 in an injection molding process or another technological process. Certainly, the first clamping slot 2110 and the second clamping slot 2120 may be alternatively obtained in another manner. This is not strictly limited in this application.

Refer to FIG. 7B and FIG. 8B. In some embodiments, the lower side of the main support plate 211 further has a first recessed slot 21110 and a second recessed slot 21120. The first recessed slot 21110 is located between the bottom casing body 212 and the middle casing body 213. The second recessed slot 21120 is located between the middle casing body 213 and the top casing body 214. In this embodiment, the first recessed slot 21110 and the second recessed slot 21120 are disposed to reduce a weight of the main support plate 211. In some other embodiments, the main support plate 211 may be alternatively provided with no first recessed slot 21110 and second recessed slot 21120.

For example, the shaft 21 may further include a first gasket 2130 and a second gasket 2140. The first gasket 2130 is located in the first recessed slot 21110 and fixedly connected to the main support plate 211. The second gasket 2140 is located in the second recessed slot 21120 and fixedly connected to the main support plate 211. Density of the first gasket 2130 and density of the second gasket 2140 are less than density of the main support plate 211. The first gasket 2130 and the second gasket 2140 are configured to implement padding, so that a component (for example, a flexible circuit board mentioned below) located above the first recessed slot 21110 and the second recessed slot 21120 can be supported and are unlikely to recess or collapse.

As shown in FIG. 8B, the support plate 211 may further include a first retaining slot 21130 and a second retaining slot 21140. The first retaining slot 21130 and the second retaining slot 21140 are configured to fasten and position the flexible circuit board. For example, the first retaining slot 21130 is located on one side or two sides of the first recessed slot 21110 and may be connected to the first recessed slot 21110. The second retaining slot 21140 is located on one side or two sides of the second recessed slot 21120 and may be connected to the second recessed slot 21120.

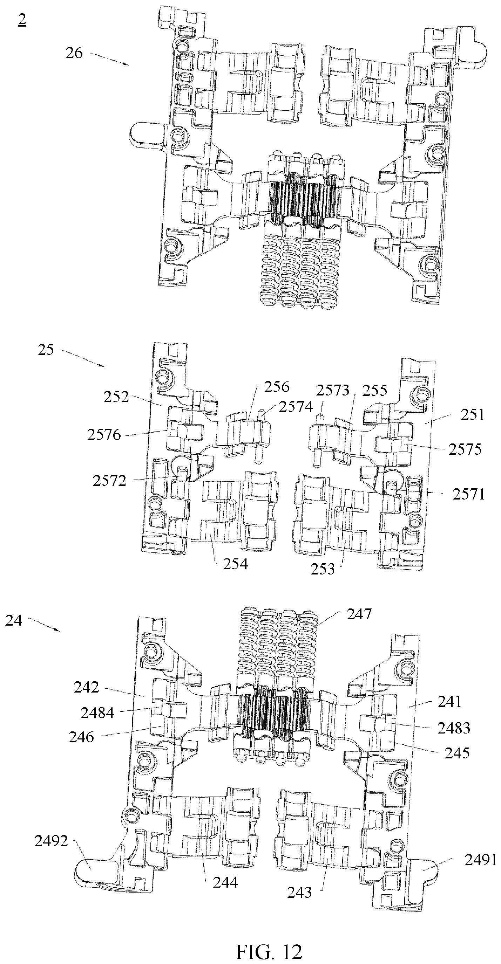

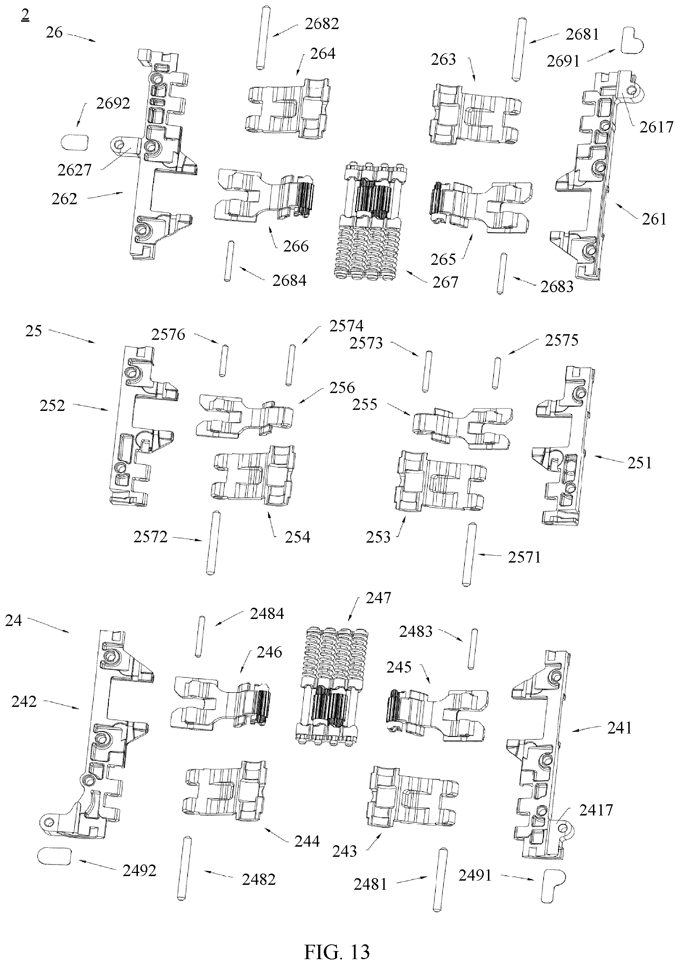

Refer to FIG. 6, FIG. 12, and FIG. 13. FIG. 12 is a schematic diagram of structures of the plurality of connection assemblies (24, 25, and 26) shown in FIG. 6. FIG. 13 is a schematic diagram of partial decomposition structures of the plurality of connection assemblies (24, 25, and 26) shown in FIG. 12.

In some embodiments, the bottom connection assembly 24 includes a first fixing bracket 241, a second fixing bracket 242, a first connection arm 243, a second connection arm 244, a first swing arm 245, a second swing arm 246, and a first damping assembly 247. Two ends of the first connection arm 243 are respectively connected to the shaft 21 and the first fixing bracket 241. Two ends of the first swing arm 245 are respectively connected to the shaft 21 and the first fixing bracket 241. Two ends of the second connection arm 244 are respectively connected to the shaft 21 and the second fixing bracket 242. Two ends of the second swing arm 246 are respectively connected to the shaft 21 and the second fixing bracket 242. The first damping assembly 247 is installed on the shaft 21 and connected to the first swing arm 245 and the second swing arm 246.

The bottom connection assembly 24 may further include a plurality of bottom rotating shafts (2481, 2482, 2483, and 2484). The plurality of bottom rotating shafts (2481, 2482, 2483, and 2484) are configured to be inserted into another component of the bottom connection assembly 24. A specific connection structure is described below. The bottom connection assembly 24 further includes two bottom blocking gaskets (2491 and 2492). The two bottom blocking gaskets (2491 and 2492) are respectively fastened to the first fixing bracket 241 and the second fixing bracket 242.

For example, the middle connection assembly 25 includes a third fixing bracket 251, a fourth fixing bracket 252, a third connection arm 253, a fourth connection arm 254, a third swing arm 255, and a fourth swing arm 256. Two ends of the third connection arm 253 are respectively connected to the shaft 21 and the third fixing bracket 251. Two ends of the third swing arm 255 are respectively connected to the shaft 21 and the third fixing bracket 251. Two ends of the fourth connection arm 254 are respectively connected to the shaft 21 and the fourth fixing bracket 252. Two ends of the fourth swing arm 256 are respectively connected to the shaft 21 and the fourth fixing bracket 252.

The middle connection assembly 25 further includes a plurality of middle rotating shafts (2571, 2572, 2573, 2574, 2575, and 2576). The plurality of middle rotating shafts (2571, 2572, 2573, 2574, 2575, and 2576) are configured to be inserted into another component of the middle connection assembly 25. A specific connection structure is described below.

For example, the top connection assembly 26 includes a fifth fixing bracket 261, a sixth fixing bracket 262, a fifth connection arm 263, a sixth connection arm 264, a fifth swing arm 265, a sixth swing arm 266, and a second damping assembly 267. Two ends of the fifth connection arm 263 are respectively connected to the shaft 21 and the fifth fixing bracket 261. Two ends of the fifth swing arm 265 are respectively connected to the shaft 21 and the fifth fixing bracket 261. Two ends of the sixth connection arm 264 are respectively connected to the shaft 21 and the sixth fixing bracket 262. Two ends of the sixth swing arm 266 are respectively connected to the shaft 21 and the sixth fixing bracket 262. The second damping assembly 267 is installed on the shaft 21 and connected to the fifth swing arm 265 and the sixth swing arm 266.

The top connection assembly 26 further includes a plurality of top rotating shafts (2681, 2682, 2683, and 2684). The plurality of top rotating shafts (2681, 2682, 2683, and 2684) are configured to be inserted into another component of the top connection assembly. A specific connection structure is described below. The top connection assembly 26 further includes two top blocking gaskets (2691 and 2692). The two top blocking gaskets (2691 and 2692) are respectively fastened to the fifth fixing bracket 261 and the sixth fixing bracket 262.

The following specifically describes a structure of each component of the bottom connection assembly 24 and a connection structure between the bottom connection assembly 24 and the shaft 21 with reference to the accompanying drawings.

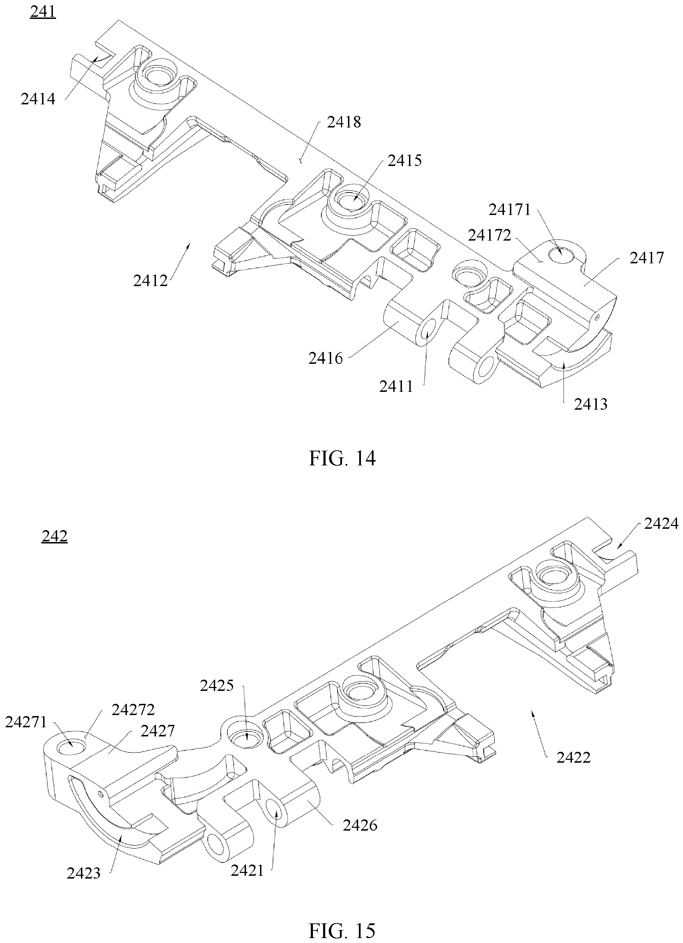

FIG. 14 is a schematic diagram of a structure of the first fixing bracket 241 shown in FIG. 13 from another perspective.

In some embodiments, the first fixing bracket 241 has a first rotating shaft hole 2411, a first sliding slot 2412, a first arc-shaped slot 2413, a second arc-shaped slot 2414, and a plurality of fastening holes 2415. The first fixing bracket 241 includes at least one first rotatable connection block 2416. The first rotating shaft hole 2411 is formed on the first rotatable connection block 2416. For example, the first sliding slot 2412 has two side walls disposed opposite to each other. The two side walls disposed opposite to each other are recessed to jointly form guide space of the first sliding slot 2412. To be specific, the side walls of the first sliding slot 2412 may have the recessed guide space, to guide a sliding direction of a mechanical member installed in the first sliding slot 2412, so that a relative sliding action between the first fixing bracket 241 and the corresponding mechanical remember is more easily implemented and has higher control precision. The first arc-shaped slot 2413 is formed at the bottom end of the first fixing bracket 241. The second arc-shaped slot 2414 is formed at the top end of the first fixing bracket 241. One side of the first arc-shaped slot 2413 may extend to a surface of the bottom end of the first fixing bracket 241. One side of the second arc-shaped slot 2414 may extend to a surface of the top end of the first fixing bracket 241.

For example, the first fixing bracket 241 includes a first retaining block 2417. The first retaining block 2417 is disposed in a protruding manner and configured to be clamped into the first housing 11. The first retaining block 2417 may be provided with a fastening hole 24171. In this application, the first fixing bracket 241 may pass through a plurality of fastening holes 24171 by using a plurality of fasteners, to be fastened to the first housing 11 (refer to FIG. 2). Refer to FIG. 12 and FIG. 14. The bottom blocking gasket 2491 may be located above the first retaining block 2417 and fixedly connected to the first retaining block 2417, and the bottom blocking gasket 2491 blocks the fastening hole 24171 on the first retaining block 2417.

The first fixing bracket 241 has a first fitting surface 2418. The first fitting surface 2418 may be a plane. An opening at one end of the first arc-shaped slot 2413 is located on the first fitting surface 2418. An opening at one end of the second arc-shaped slot 2414 is located on the first fitting surface 2418. The first fitting surface 2418 is obliquely disposed relative to an upper surface 24172 of the first retaining block 2417.

FIG. 15 is a schematic diagram of a structure of the second fixing bracket 242 shown in FIG. 13 from another perspective.

In some embodiments, the second fixing bracket 242 has a second rotating shaft hole 2421, a second sliding slot 2422, a third arc-shaped slot 2423, a fourth arc-shaped slot 2424, and a plurality of fastening holes 2425. The second fixing bracket 242 includes at least one second rotatable connection block 2426. The second rotating shaft hole 2421 is formed on the second rotatable connection block 2426. For example, the second sliding slot 2422 has two side walls disposed opposite to each other. The two side walls disposed opposite to each other are recessed to jointly form guide space of the second sliding slot 2422. To be specific, the side walls of the second sliding slot 2422 may have the recessed guide space, to guide a sliding direction of a mechanical member installed in the second sliding slot 2422, so that a relative sliding action between the second fixing bracket 242 and the corresponding mechanical remember is more easily implemented and has higher control precision. The third arc-shaped slot 2423 is formed at the bottom end of the second fixing bracket 242. The fourth arc-shaped slot 2424 is formed at the top end of the second fixing bracket 242. One side of the third arc-shaped slot 2423 may extend to a surface of the bottom end of the second fixing bracket 242. One side of the fourth arc-shaped slot 2424 may extend to a surface of the top end of the second fixing bracket 242.

For example, the second fixing bracket 242 includes a second retaining block 2427. The second retaining block 2427 is disposed in a protruding manner and configured to be clamped into the second housing 12. The second retaining block 2427 may be provided with a fastening hole 24271. In this application, the second fixing bracket 242 may pass through a plurality of fastening holes 24271 by using a plurality of fasteners, to be fastened to the second housing 12 (refer to FIG. 2). Refer to FIG. 12 and FIG. 15. The bottom blocking gasket 2492 may be located above the second retaining block 2427 and fixedly connected to the second retaining block 2427, and the bottom blocking gasket 2492 blocks the fastening hole 24271 on the second retaining block 2427.

The second fixing bracket 242 has a second fitting surface 2428. The second fitting surface 2428 may be a plane. An opening at one end of the third arc-shaped slot 2423 is located on the second fitting surface 2428. An opening at one end of the fourth arc-shaped slot 2424 is located on the second fitting surface 2428. The second fitting surface 2428 is obliquely disposed relative to an upper surface 24272 of the second retaining block 2427.

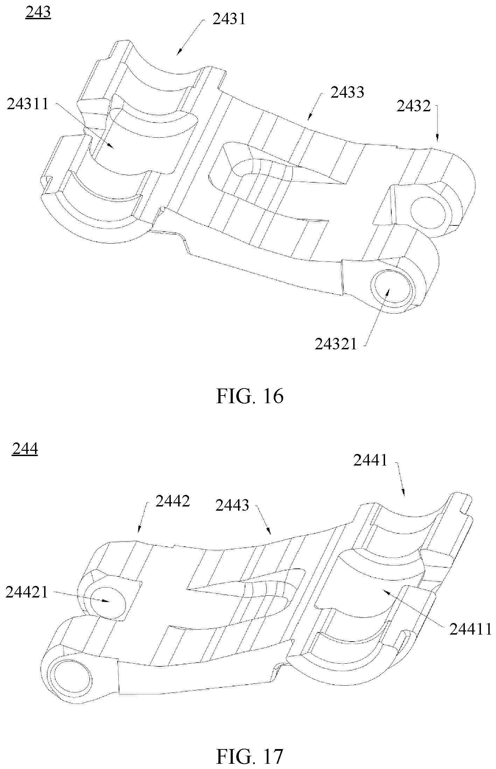

FIG. 16 is a schematic diagram of a structure of the first connection arm 243 shown in FIG. 13 from another perspective.

In some embodiments, the first connection arm 243 includes a first end 2431 and a second end 2432. Both the first end 2431 and the second end 2432 are rotating ends. For example, the first end 2431 of the first connection arm 243 is an arc-shaped arm, and the second end 2432 of the first connection arm 243 is provided with a rotating shaft hole 24321. The middle part of the first end 2431 of the first connection arm 243 is provided with avoidance space 24311. The avoidance space 24311 is disposed in a recessed manner and extends to an end surface of the first end 2431 of the first connection arm 243.

The first connection arm 243 further includes a connection section 2433 connected between the first end 2431 and the second end 2432. For example, an upper surface of the connection section 2433 may be bent relative to an upper surface of the second end 2432 of the first connection arm 243. The connection section 2433 is disposed so that a structural design of the first connection arm 243 is more flexible, to better meet connection requirements and shape requirements of the bottom connection assembly 24 and the hinge assembly 2.

The first connection arm 243 may be an integrated mechanical member, to have high structural strength. For example, the first connection arm 243 may be formed by using a computer numerical control (computer numerical control, CNC) milling technology. In some other embodiments, the first connection arm 243 may be alternatively formed by using a metal injection molding technology. This is not strictly limited in this embodiment of this application.

FIG. 17 is a schematic diagram of a structure of the second connection arm 244 shown in FIG. 13 from another perspective.

In some embodiments, the second connection arm 244 includes a first end 2441 and a second end 2442. Both the first end 2441 and the second end 2442 are rotating ends. For example, the first end 2441 of the second connection arm 244 is an arc-shaped arm, and the second end 2442 of the second connection arm 244 is provided with a rotating shaft hole 24421. The middle part of the first end 2441 of the second connection arm 244 is provided with avoidance space 24411. The avoidance space 24411 is disposed in a recessed manner and extends to an end surface of the first end 2441 of the second connection arm 244.

The second connection arm 244 further includes a connection section 2443 connected between the first end 2441 and the second end 2442. For example, an upper surface of the connection section 2443 may be bent relative to an upper surface of the second end 2442 of the second connection arm 244. The connection section 2443 is disposed so that a structural design of the second connection arm 244 is more flexible, to better meet connection requirements and shape requirements of the bottom connection assembly 24 and the hinge assembly 2.

The second connection arm 244 may be an integrated mechanical member, to have high structural strength. For example, the second connection arm 244 may be formed by using a computer numerical control (computer numerical control, CNC) milling technology. In some other embodiments, the second connection arm 244 may be alternatively formed by using a metal injection molding technology. This is not strictly limited in this embodiment of this application.

In some embodiments, a shape of the first connection arm 243 may be the same as a shape of the second connection arm 244, to use a same material. This reduces a type of a material of the hinge assembly 2 and reduces costs of the hinge assembly 2. In some other embodiments, a shape of the first connection arm 243 may be alternatively different from a shape of the second connection arm 244. This is not strictly limited in this embodiment of this application.

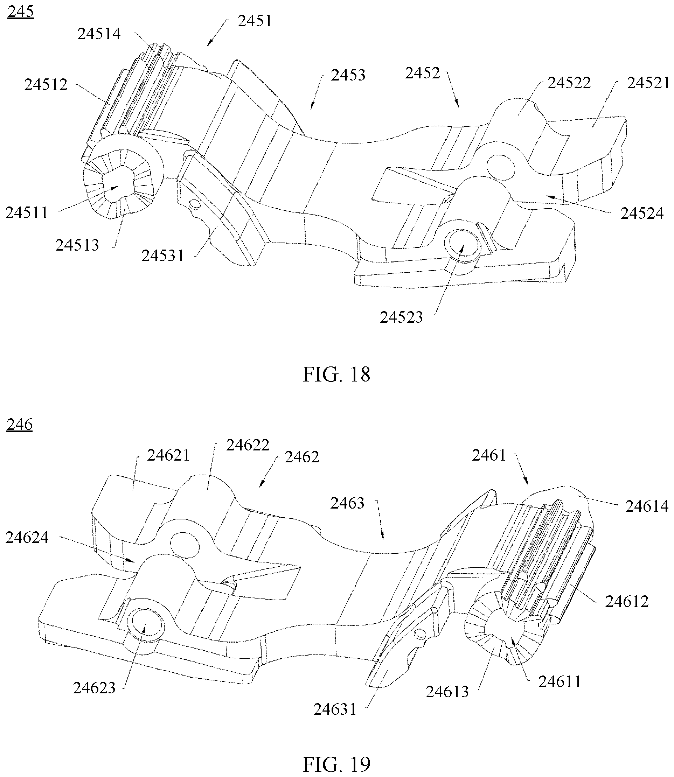

FIG. 18 is a schematic diagram of a structure of the first swing arm 245 shown in FIG. 13 from another perspective.

In some embodiments, the first swing arm 245 includes a rotating end 2451 and a sliding end 2452. The rotating end 2451 of the first swing arm 245 is provided with a rotating shaft hole 24511. The rotating shaft hole 24511 penetrates the rotating end 2451 of the first swing arm 245. The rotating end 2451 of the first swing arm 245 may be provided with a structure configured to fit the first damping assembly 247. For example, the rotating end 2451 of the first swing arm 245 may include a plurality of engagement teeth 24512, a plurality of first protrusions 24513, and a plurality of second protrusions 24514. The plurality of engagement teeth 24512 may be located at the middle part of the rotating end 2451 of the first swing arm 245 and located on one side that is of the sliding end 2452 and that backs onto the first swing arm 245. The plurality of first protrusions 24513 and the plurality of second protrusions 24514 are disposed backing onto each other and located at two ends of the rotating end 2451 of the first swing arm 245. The plurality of first protrusions 24513 are arranged in an annular shape and are spaced apart from each other, and the plurality of first protrusions 24513 are disposed around the rotating shaft hole 24511 of the rotating end 2451 of the first swing arm 245. The plurality of second protrusions 24514 are arranged in an annular shape and are spaced apart from each other, and the plurality of second protrusions 24514 are disposed around the rotating shaft hole 24511 of the rotating end 2451 of the first swing arm 245.

The sliding end 2452 of the first swing arm 245 includes a sliding block 24521 and a rotatable connection block 24522. The rotatable connection block 24522 is located above the sliding block 24521 and fixedly connected to the sliding block 24521. The sliding end 2452 of the first swing arm 245 is provided with a first shaft insertion hole 24523. In some embodiments, the first shaft insertion hole 24523 is located on the rotatable connection block 24522. In some other embodiments, the first shaft insertion hole 24523 may be partially located on the rotatable connection block 24522 and partially located on the sliding block 24521, to make full use of a thickness of the sliding end 2452 of the first swing arm 245. This facilitates lightening and thinning of the sliding end 2452 of the first swing arm 245. The sliding end 2452 of the first swing arm 245 is further provided with a first avoidance region 24524. The first avoidance region 24524 penetrates the sliding block 24521 and the rotatable connection block 24522, the first avoidance region 24524 further extends to an end surface that is of the sliding end 2452 and that is away from the rotating end 2451, and the first avoidance region 24524 divides the first shaft insertion hole 24523 into two parts.

The first swing arm 245 further includes a connection section 2453 connected between the rotating end 2451 and the sliding end 2452. For example, the connection section 2453 of the first swing arm 245 may be bent relative to the sliding end 2452 of the first swing arm 245, so that a structural design of the first swing arm 245 is more flexible, to better meet connection requirements and shape requirements of the bottom connection assembly 24 and the hinge assembly 2.

For example, the connection section 2453 of the first swing arm 245 may include two extension blocks 24531. The two extension blocks 24531 are respectively located on two sides of the connection section 2453 of the first swing arm 245, and the two extension blocks 24531 can increase structural strength of the first swing arm 245.

The first swing arm 245 may be an integrated mechanical member, to have high structural strength. For example, the first swing arm 245 may be formed by using a metal injection molding technology or another technology. This is not strictly limited in this embodiment of this application.

FIG. 19 is a schematic diagram of a structure of the second swing arm 246 shown in FIG. 13 from another perspective.

In some embodiments, the second swing arm 246 includes a rotating end 2461 and a sliding end 2462. The rotating end 2461 of the second swing arm 246 is provided with a rotating shaft hole 24611. The rotating shaft hole 24611 penetrates the rotating end 2461 of the second swing arm 246. The rotating end 2461 of the second swing arm 246 may be provided with a structure configured to fit the first damping assembly 247. For example, the rotating end 2461 of the second swing arm 246 may include a plurality of engagement teeth 24612, a plurality of first protrusions 24613, and a plurality of second protrusions 24614. The plurality of engagement teeth 24612 may be located at the middle part of the rotating end 2461 of the second swing arm 246 and located on one side that is of the sliding end 2462 and that backs onto the second swing arm 246. The plurality of first protrusions 24613 and the plurality of second protrusions 24614 are disposed backing onto each other and located at two ends of the rotating end 2461 of the second swing arm 246. The plurality of first protrusions 24613 are arranged in an annular shape and are spaced apart from each other, and the plurality of first protrusions 24613 are disposed around the rotating shaft hole 24611 of the rotating end 2461 of the second swing arm 246. The plurality of second protrusions 24614 are arranged in an annular shape and are spaced apart from each other, and the plurality of second protrusions 24614 are disposed around the rotating shaft hole 24611 of the rotating end 2461 of the second swing arm 246.

The sliding end 2462 of the second swing arm 246 includes a sliding block 24621 and a rotatable connection block 24622. The rotatable connection block 24622 is located above the sliding block 24621 and fixedly connected to the sliding block 24621. The sliding end 2462 of the second swing arm 246 is provided with a second shaft insertion hole 24623. In some embodiments, the second shaft insertion hole 24623 is located on the rotatable connection block 24622. In some other embodiments, the second shaft insertion hole 24623 may be partially located on the rotatable connection block 24622 and partially located on the sliding block 24621, to make full use of a thickness of the sliding end 2462 of the second swing arm 246. This facilitates lightening and thinning of the sliding end 2462 of the second swing arm 246. The sliding end 2462 of the second swing arm 246 is further provided with a second avoidance region 24624. The second avoidance region 24624 penetrates the sliding block 24621 and the rotatable connection block 24622, the second avoidance region 24624 further extends to an end surface that is of the sliding end 2462 and that is away from the rotating end 2461, and the second avoidance region 24624 divides the second shaft insertion hole 24623 into two parts.

The second swing arm 246 further includes a connection section 2463 connected between the rotating end 2461 and the sliding end 2462. For example, the connection section 2463 of the second swing arm 246 may be bent relative to the sliding end 2462 of the second swing arm 246, so that a structural design of the second swing arm 246 is more flexible, to better meet connection requirements and shape requirements of the bottom connection assembly 24 and the hinge assembly 2.

For example, the connection section 2463 of the second swing arm 246 may include two extension blocks 24631. The two extension blocks 24631 are respectively located on two sides of the connection section 2463 of the second swing arm 246, and the two extension blocks 24631 can increase structural strength of the second swing arm 246.

The second swing arm 246 may be an integrated mechanical member, to have high structural strength. For example, the second swing arm 246 may be formed by using a metal injection molding technology or another technology. This is not strictly limited in this embodiment of this application.

In some embodiments, a shape of the first swing arm 245 may be the same as a shape of the second swing arm 246, to use a same material. This reduces a type of a material of the hinge assembly 2 and reduces costs of the hinge assembly 2. In some other embodiments, a shape of the first swing arm 245 may be alternatively different from a shape of the second swing arm 246. This is not strictly limited in this embodiment of this application.

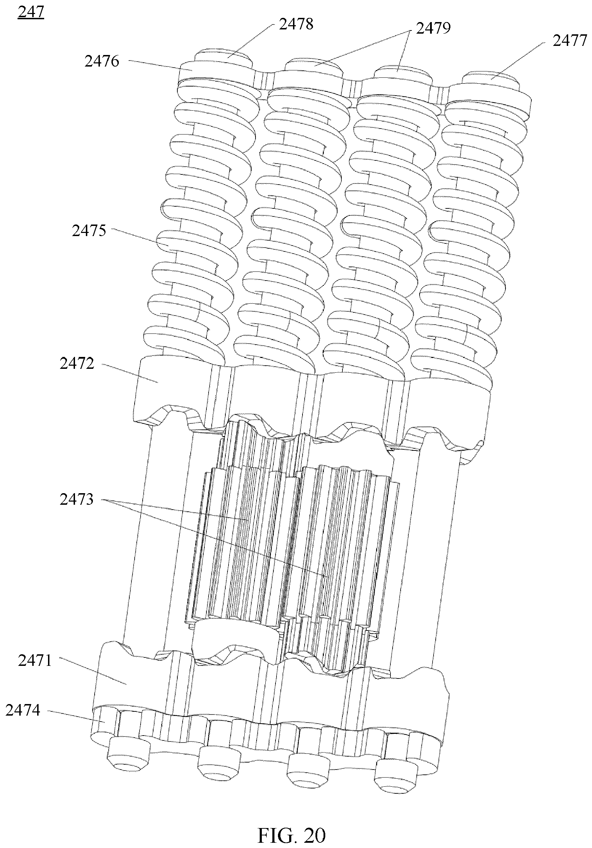

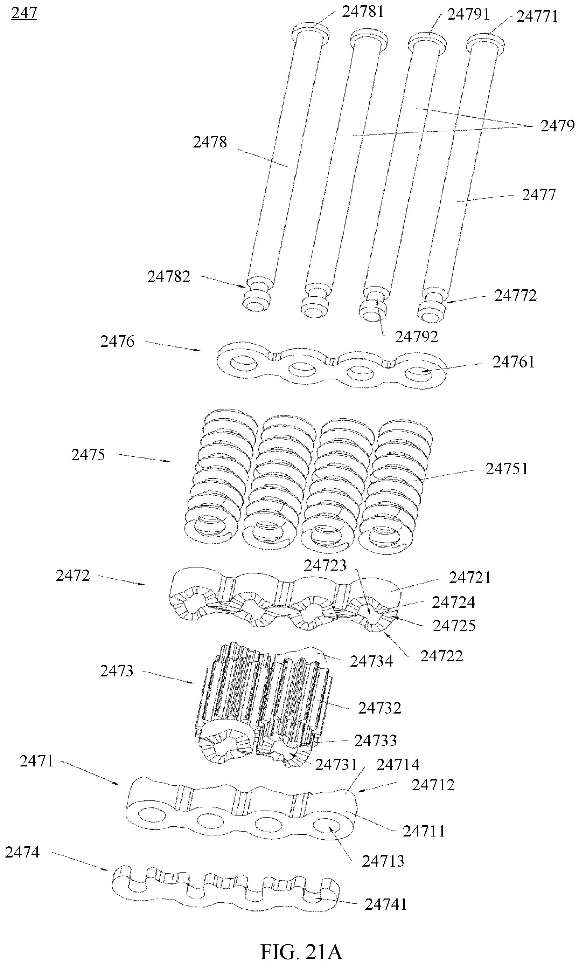

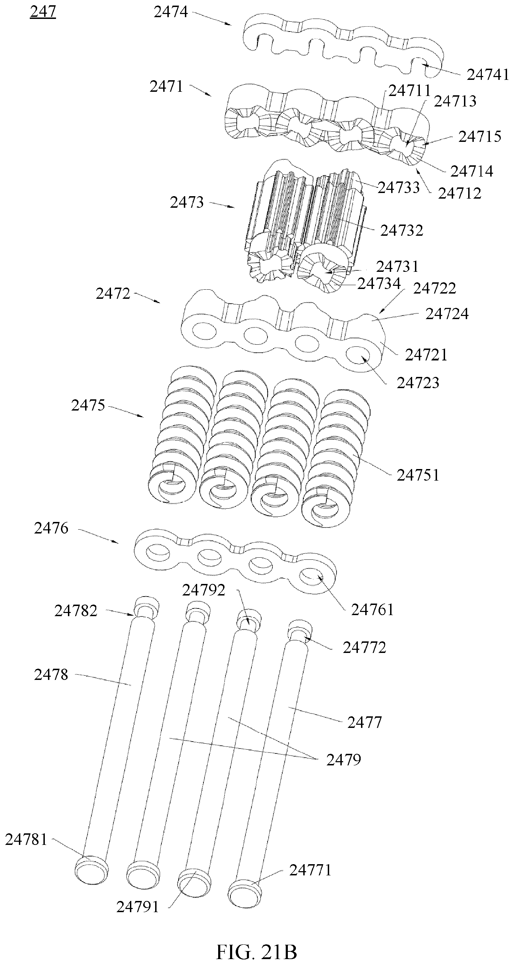

Refer to FIG. 20, FIG. 21A, and FIG. 21B. FIG. 20 is a schematic diagram of a structure of the first damping assembly 247 shown in FIG. 13 from another perspective. FIG. 21A is a schematic diagram of a decomposition structure of the first damping assembly 247 shown in FIG. 20. FIG. 21B is a schematic diagram of a structure of the first damping assembly 247 shown in FIG. 21A from another perspective.

In some embodiments, the first damping assembly 247 includes a first retaining member 2471, a second retaining member 2472, a plurality of synchronization gears 2473, a first fixing plate 2474, an elastic member 2475, a second fixing plate 2476, a first adapter shaft 2477, a second adapter shaft 2478, and a plurality of third adapter shafts 2479. In this embodiment, an example in which "there are two synchronization gears 2473 and two third adapter shafts 2479" is used for description.

For example, the first retaining member 2471 includes a first retaining plate 24711 and a plurality of first bump groups 24712. The plurality of first bump groups 24712 are fastened to a surface of a same side of the first retaining plate 24711. The first retaining plate 24711 includes a plurality of first through holes 24713. The plurality of first through holes 24713 are disposed at intervals. The plurality of first through holes 24713 may present an arrangement rule, for example, a straight-line arrangement, an arc-line arrangement, or a wavy-line arrangement. The plurality of first bump groups 24712 are disposed in a one-to-one correspondence with the plurality of first through holes 24713. There may be four first through holes 24713 and four first bump groups 24712. Each first bump group 24712 may include a plurality of first bumps 24714. The plurality of first bumps 24714 are arranged in an annular shape and spaced apart from each other. The plurality of first bumps 24714 are disposed around the first through hole 24713. A first retaining slot 24715 is formed between two adjacent first bumps 24714. The first retaining member 2471 may be an integrated mechanical member, to have high structural strength.

For example, the second retaining member 2472 includes a second retaining plate 24721 and a plurality of second bump groups 24722. The plurality of second bump groups 24722 are fastened to a surface of a same side of the second retaining plate 24721. The second retaining plate 24721 includes a plurality of second through holes 24723. The plurality of second through holes 24723 are disposed at intervals. The plurality of second bump groups 24722 are disposed in a one-to-one correspondence with the plurality of second through holes 24723. There may be four second through holes 24723 and four second bump groups 24722. Each second bump group 24722 may include a plurality of second bumps 24724. The plurality of second bumps 24724 are arranged in an annular shape and spaced apart from each other. The plurality of second bumps 24724 are disposed around the second through hole 24723. A second retaining slot 24725 is formed between two adjacent second bumps 24724. The second retaining member 2472 may be an integrated mechanical member, to have high structural strength.

A structure of the second retaining member 2472 may be the same as a structure of the first retaining member 2471, to use a same material. This reduces a type of a material of the hinge assembly 2 and reduces costs of the hinge assembly 2. In some other embodiments, a structure of the second retaining member 2472 may be alternatively different from a structure of the first retaining member 2471. This is not strictly limited in this application.

The plurality of first bump groups 24712 of the first retaining member 2471 and the plurality of second bump groups 24722 of the second retaining member 2472 are disposed opposite to each other, and the plurality of first bump groups 24712 are in a one-to-one correspondence with the plurality of second bump groups 24722. For example, in the corresponding first bump group 24712 and second bump group 24722, a position of the first bump 24714 directly faces a position of the second bump 24724. A position of the first retaining slot 24715 directly faces a position of the second retaining slot 24725. In some other embodiments, a position of the first bump 24714 and a position of the second bump 24724 may be alternatively staggered or present another position relationship. A position of the first retaining slot 24715 and a position of the second retaining slot 24725 may be alternatively staggered or present another position relationship. This is not strictly limited in this application.

For example, the plurality of synchronization gears 2473 are located between the first retaining member 2471 and the second retaining member 2472, and the plurality of synchronization gears 2473 are engaged with each other. The synchronization gears 2473 each are provided with a rotating shaft hole 24731. Each synchronization gear 2473 may include a plurality of engagement teeth 24732, a plurality of first protrusions 24733, and a plurality of second protrusions 24734. The plurality of engagement teeth 24732 may be located at the middle part of the synchronization gear 2473. A plurality of engagement teeth 24732 of two adjacent synchronization gears 2473 are engaged with each other. The plurality of first protrusions 24733 and the plurality of second protrusions 24734 are disposed backing onto each other and located at two ends of the synchronization gear 2473. The plurality of first protrusions 24733 are arranged in an annular shape and are spaced apart from each other, and the plurality of first protrusions 24733 are disposed around the rotating shaft hole 24731 of the synchronization gear 2473. The plurality of second protrusions 24734 are arranged in an annular shape and are spaced apart from each other, and the plurality of second protrusions 24734 are disposed around the rotating shaft hole 24731 of the synchronization gear 2473.

In some use states, the plurality of first protrusions 24733 of the synchronization gear 2473 and the plurality of first bumps 24714 of one first bump group 24712 are staggered to form a clamping structure. The plurality of first protrusions 24733 are correspondingly clamped into a plurality of first retaining slots 24715. The plurality of second protrusions 24734 of the synchronization gear 2473 and the plurality of second bumps 24724 of one second bump group 24722 are staggered to form a clamping structure. The plurality of second protrusions 24734 are correspondingly clamped into a plurality of second retaining slots 24725. Shapes and positions of the plurality of first protrusions 24733 of the synchronization gear 2473 adapt to shapes and positions of the plurality of corresponding first retaining slots 24715. Shapes and positions of the plurality of second protrusions 24734 of the synchronization gear 2473 adapt to shapes and positions of the plurality of corresponding second retaining slots 24725.

The synchronization gear 2473 may be an integrated mechanical member, to have high structural strength. The structures of the plurality of synchronization gears 2473 may be the same, to use a same material. This reduces a type of a material of the hinge assembly 2 and reduces costs of the hinge assembly 2. In some other embodiments, structures of the plurality of synchronization gears 2473 may be alternatively different. This is not strictly limited in this application.

For example, the first fixing plate 2474 is located on one side that is of the first retaining member 2471 and that backs onto the second retaining member 2472. The first fixing plate 2474 includes a plurality of necks 24741 disposed at intervals. The neck 24741 extends to a side surface of the first fixing plate 2474, so that the adapter shafts (2477, 2478, and 2479) can be clamped into the neck 24741 from the side surface of the first fixing plate 2474, to clamp the first fixing plate 2474. The first fixing plate 2474 may be approximately in a flat-panel shape.

For example, the elastic member 2475 is located on one side that is of the second retaining member 2472 and that backs onto the first retaining member 2471. The elastic member 2475 includes a plurality of springs 24751. A quantity of the springs 24751 is the same as the quantity of first through holes 24713. There may be four springs 24751. In some other embodiments, the elastic member 2475 may be alternatively made of an elastic material, for example, elastic rubber. This is not strictly limited in this application.

For example, the second fixing plate 2476 is located on one side that is of the elastic member 2475 and that backs onto the second retaining member 2472. The second fixing plate 2476 may be of a plate body structure. The second fixing plate 2476 includes a plurality of third through holes 24761. The plurality of third through holes 24761 are disposed at intervals. For example, quantities, arrangement shapes, and arrangement spacings of the plurality of first through holes 24713, the plurality of second through holes 24723, and the plurality of third through holes 24761 may be the same. There may be four third through holes 24761.

For example, the top end of the first adapter shaft 2477 is provided with a position-limiting flange 24771. An outer diameter of the position-limiting flange 24771 is greater than an outer diameter of a main body part of the first adapter shaft 2477. The bottom end of the first adapter shaft 2477 is provided with a position-limiting neck 24772. The position-limiting neck 24772 shrinks inward relative to an outer surface of the main body part of the first adapter shaft 2477. A diameter of a neck bottom wall of the position-limiting neck 24772 is less than the outer diameter of the main body part of the first adapter shaft 2477.

The first adapter shaft 2477 is inserted into the second fixing plate 2476, one spring 24751, the second retaining member 2472, the first retaining member 2471, and the first fixing plate 2474. The first adapter shaft 2477 passes through one third through hole 24761 of the second fixing plate 2476, space on an inner side of the one spring 24751, one second through hole 24723 of the second retaining member 2472, one first through hole 24713 of the first retaining member 2471, and one neck 24741 of the first fixing plate 2474. In addition, the position-limiting flange 24771 of the first adapter shaft 2477 is located on one side that is of the second fixing plate 2476 and that backs onto the second retaining member 2472, and abuts against the second fixing plate 2476. The first fixing plate 2474 is clamped into the position-limiting neck 24772 of the first adapter shaft 2477, so that the first adapter shaft 2477, the second fixing plate 2476, the one spring 24751, the second retaining member 2472, the first retaining member 2471, and the first fixing plate 2474 can maintain a relatively fixed position relationship, and the spring 24751 is in a compressed state. The bottom end of the first adapter shaft 2477 may be also fixedly connected to the first fixing plate 2474 in a manner, for example, welding or bonding.

For example, the top end of the second adapter shaft 2478 is provided with a position-limiting flange 24781. An outer diameter of the position-limiting flange 24781 is greater than an outer diameter of a main body part of the second adapter shaft 2478. The bottom end of the second adapter shaft 2478 is provided with a position-limiting neck 24782. The position-limiting neck 24782 shrinks inward relative to an outer surface of the main body part of the second adapter shaft 2478. A diameter of a neck bottom wall of the position-limiting neck 24782 is less than the outer diameter of the main body part of the second adapter shaft 2478. The structure of the second adapter shaft 2478 may be the same as the structure of the first adapter shaft 2477, to use a same material. This reduces a type of a material of the hinge assembly 2 and reduces costs of the hinge assembly 2. In some other embodiments, a structure of the second adapter shaft 2478 may be alternatively different from a structure of the first adapter shaft 2477. This is not strictly limited in this application.

The second adapter shaft 2478 is inserted into the second fixing plate 2476, another spring 24751, the second retaining member 2472, the first retaining member 2471, and the first fixing plate 2474. The second adapter shaft 2478 passes through another third through hole 24761 of the second fixing plate 2476, space on an inner side of the another spring 24751, another second through hole 24723 of the second retaining member 2472, another first through hole 24713 of the first retaining member 2471, and another neck 24741 of the first fixing plate 2474. In addition, the position-limiting flange 24781 of the second adapter shaft 2478 is located on the side that is of the second fixing plate 2476 and that backs onto the second retaining member 2472, and abuts against the second fixing plate 2476. The first fixing plate 2474 is clamped into the position-limiting neck 24782 of the second adapter shaft 2478, so that the second adapter shaft 2478, the second fixing plate 2476, the another spring 24751, the second retaining member 2472, the first retaining member 2471, and the first fixing plate 2474 can maintain a relatively fixed position relationship, and the spring 24751 is in a compressed state. The bottom end of the second adapter shaft 2478 may be also fixedly connected to the first fixing plate 2474 in a manner, for example, welding or bonding.

For example, the top end of the third adapter shaft 2479 is provided with a position-limiting flange 24791. An outer diameter of the position-limiting flange 24791 is greater than an outer diameter of a main body part of the third adapter shaft 2479. The bottom end of the third adapter shaft 2479 is provided with a position-limiting neck 24792. The position-limiting neck 24772 shrinks inward relative to an outer surface of the main body part of the third adapter shaft 2479. A diameter of a neck bottom wall of the position-limiting neck 24792 is less than the outer diameter of the main body part of the third adapter shaft 2479. The structure of the third adapter shaft 2479 may be the same as the structure of the first adapter shaft 2477, to use a same material. This reduces a type of a material of the hinge assembly 2 and reduces costs of the hinge assembly 2. In some other embodiments, the structure of the third adapter shaft 2479 may be alternatively different from the structure of the first adapter shaft 2477. This is not strictly limited in this application.

The quantity of the third adapter shafts 2479 is the same as the quantity of the synchronization gears 2473. The third adapter shafts 2479, the synchronization gears 2473, and some springs 24751 in the elastic member 2475 are disposed in a one-to-one correspondence. The third adapter shaft 2479 is inserted into the second fixing plate 2476, another spring 24751, the second retaining member 2472, the synchronization gear 2473, the first retaining member 2471, and the first fixing plate 2474. The third adapter shaft 2479 passes through another third through hole 24761 of the second fixing plate 2476, space on an inner side of the another spring 24751, another second through hole 24723 of the second retaining member 2472, the rotating shaft hole 24731 of the synchronization gear 2473, another first through hole 24713 of the first retaining member 2471, and another neck 24741 of the first fixing plate 2474. In addition, the position-limiting flange 24791 of the third adapter shaft 2479 is located on the side that is of the second fixing plate 2476 and that backs onto the second retaining member 2472, and abuts against the second fixing plate 2476. The first fixing plate 2474 is clamped into the position-limiting neck 24792 of the third adapter shaft 2479, so that the third adapter shaft 2479, the second fixing plate 2476, the another spring 24751, the second retaining member 2472, the first retaining member 2471, and the first fixing plate 2474 can maintain a relatively fixed position relationship, and the spring 24751 is in a compressed state. The bottom end of the third adapter shaft 2479 may be also fixedly connected to the first fixing plate 2474 in a manner, for example, welding or bonding.

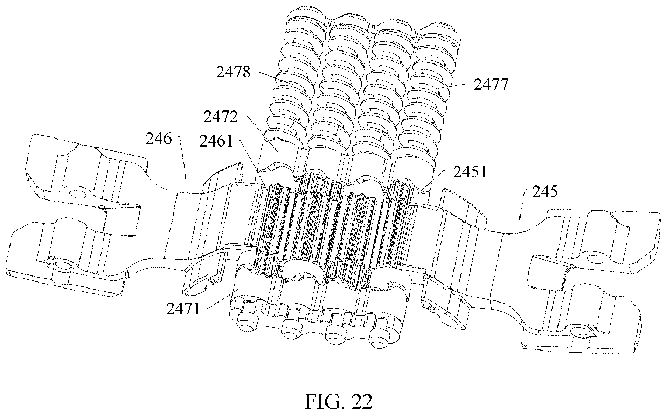

FIG. 22 is a schematic diagram of a partial structure of the bottom connection assembly 24 shown in FIG. 12. Refer to the structure of the first swing arm 245 shown in FIG. 18, the structure of the second swing arm 246 shown in FIG. 19, and the structure of the first damping assembly 247 shown in FIG. 21A.

In some embodiments, the rotating end 2451 of the first swing arm 245 and the rotating end 2461 of the second swing arm 246 are located between the first retaining member 2471 and the second retaining member 2472. The first adapter shaft 2477 further passes through the rotating shaft hole 24511 of the rotating end 2451 of the first swing arm 245, to be inserted into the rotating end 2451 of the first swing arm 245. The second adapter shaft 2478 further passes through the rotating shaft hole 24611 of the rotating end 2461 of the second swing arm 246, to be inserted into the rotating end 2461 of the second swing arm 246.

In some use states, the plurality of first protrusions 24513 of the first swing arm 245 and the plurality of first bumps 24714 of one first bump group 24712 are staggered to form a clamping structure. The plurality of first protrusions 24513 are correspondingly clamped into a plurality of first retaining slots 24715. The plurality of second protrusions of the first swing arm 245 and the plurality of second bumps 24714 of one second bump group 24722 are staggered to form a clamping structure. The plurality of second protrusions 24514 are correspondingly clamped into a plurality of second retaining slots 24715.

The plurality of first protrusions 24613 of the second swing arm 246 and the plurality of first bumps 24714 of another first bump group 24712 are staggered to form a clamping structure. The plurality of first protrusions 24613 are correspondingly clamped into a plurality of first retaining slots 24715. The plurality of second protrusions 24614 of the second swing arm 246 and the plurality of second bumps 24724 of another second bump group 24722 are staggered to form a clamping structure. The plurality of second protrusions 24614 are correspondingly clamped into a plurality of second retaining slots 24725.

Shapes and positions of the plurality of first protrusions (24513 and 24613) of the first swing arm 245 and the second swing arm 246 adapt to shapes and positions of the plurality of corresponding first retaining slots 24715. Shapes and positions of the plurality of second protrusions (24514 and 24614) of the first swing arm 245 and the second swing arm 246 adapt to shapes and positions of the plurality of corresponding second retaining slots 24725.

The rotating end 2451 of the first swing arm 245 is engaged with the rotating end 2461 of the second swing arm 246 by using the plurality of synchronization gears 2473. For example, the plurality of synchronization gears 2473 may be arranged in a string. Two adjacent synchronization gears 2473 are engaged with each other. Two synchronization gears 2473 located at end parts are respectively engaged with the rotating end 2451 of the first swing arm 245 and the rotating end 2461 of the second swing arm 246. The plurality of engagement teeth 24512 of the rotating end 2451 of the first swing arm 245 are engaged with the plurality of engagement teeth 24732 of an adjacent synchronization gear 2473. The plurality of engagement teeth 24612 of the rotating end 2461 of the second swing arm 246 are engaged with the plurality of engagement teeth 24732 of an adjacent synchronization gear 2473.

In this embodiment, the rotating end 2451 of the first swing arm 245, the rotating end 2461 of the second swing arm 246, and the synchronization gear 2473 are all clamped to the first retaining member 2471 and the second retaining member 2472 to form clamping structures, so that the first swing arm 245 and the second swing arm 246 can stay at some positions. In addition, a relative position relationship between various components of the first damping assembly 247 is stable, the elastic member 2475 is in a compressed state, and elastic force generated by the elastic member 2475 drives the first retaining member 2471 and the second retaining member 2472 to fit and tightly press the rotating end 2451 of the first swing arm 245, the synchronization gear 2473, and the rotating end 2461 of the second swing arm 246. Therefore, the clamping structure between the rotating end 2451 of the first swing arm 245, the synchronization gear 2473, the rotating end 2461 of the second swing arm 246 and each of the first retaining member 2471 and the second retaining member 2472 is stable.

When the rotating end 2451 of the first swing arm 245, the rotating end 2461 of the second swing arm 246, and the synchronization gear 2473 are rotated relative to the first retaining member 2471 and the second retaining member 2472, relative positions of the plurality of first protrusions (24513, 24613, and 24733) and the plurality of first bumps 24714 change, to form different clamping structures, and relative positions of the plurality of second protrusions (24514, 24614, and 24734) and the plurality of second bumps 24724 change, to form different clamping structure. For example, in an open state, the rotating end 2451 of the first swing arm 245, the rotating end 2461 of the second swing arm 246, and the synchronization gear 2473 form a first clamping structure relative to the first retaining member 2471 and the second retaining member 2472. In a closed state, the rotating end 2451 of the first swing arm 245, the rotating end 2461 of the second swing arm 246, and the synchronization gear 2473 form a second clamping structure relative to the first retaining member 2471 and the second retaining member 2472.

Specifically, when the first swing arm 245 and the second swing arm 246 are moved relative to each other, the rotating end 2451 of the first swing arm 245, the synchronization gear 2473, and the rotating end 2461 of the second swing arm 246 need to be converted from one clamping structure to another clamping structure with each of the first retaining member 2471 and the second retaining member 2472. To be specific, the first protrusions (24513, 24613, and 24733) need to be separated from one first retaining slot 24715, cross one first bump 24714, and be clamped into another first retaining slot 24715, and the second protrusions (24514, 24614, and 24734) need to be separated from one second retaining slots 24725, cross one second bumps 24724, and be clamped into another second retaining slot 24725. In a process of the conversion between the clamping structures, the first retaining member 2471 is away from the second retaining member 2472, the elastic member 2475 is further compressed, and the elastic force generated by the elastic member 2475 forms damping force and driving force, so that the first swing arm 245 and the second swing arm 246 can be moved relative to each other only by using specific driving force and rotated more easily after being driven. In a process in which the protrusion is separated from the retaining slot and does not cross the bump, the elastic force of the elastic member 2475 forms the damping force. In a process in which the protrusion crosses the bump and is clamped into the another retaining slot, the elastic force of the elastic member 2475 forms the driving force. In short, the first damping assembly 247 can provide the damping force and the driving force for the relative movement between the first swing arm 245 and the second swing arm 246.

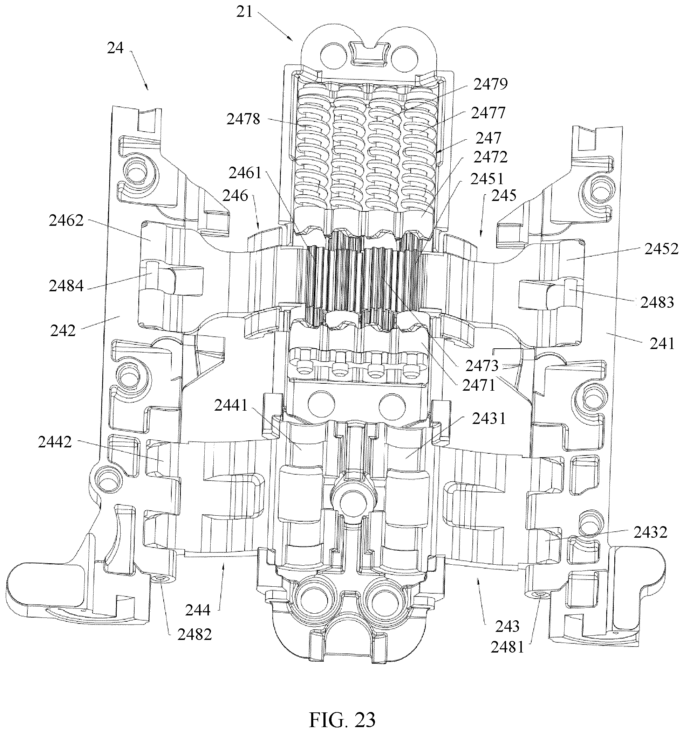

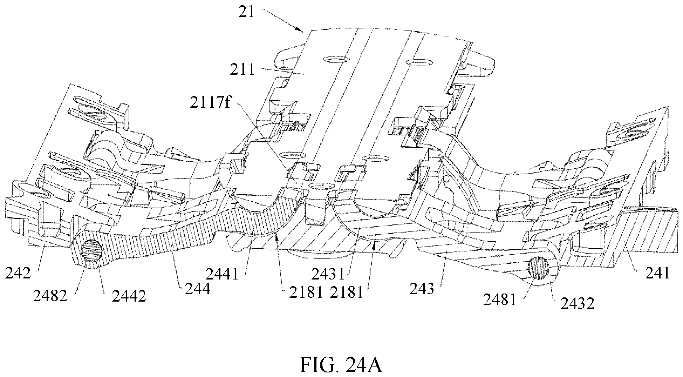

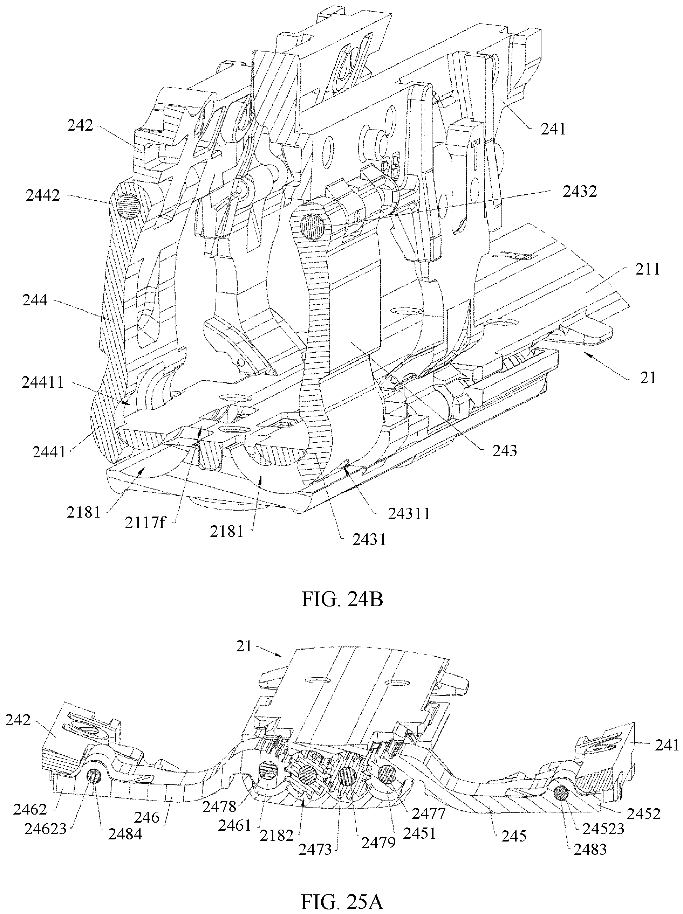

Refer to FIG. 23, FIG. 24A, and FIG. 24B. FIG. 23 is a schematic diagram of an assembled structure of the bottom connection assembly 24 shown in FIG. 6 and the bottom casing body 212 of the shaft 21. FIG. 24A is a schematic diagram of a cross-sectional structure of an assembled structure, that is cut along a cross section A2-A2, of the bottom connection assembly 24 and the shaft 21 shown in FIG. 6. FIG. 24B is a schematic diagram of the structure shown in FIG. 24A in a closed state. A position of the cross section A2-A2 in FIG. 6 corresponds to a position of the cross section A1-A1 in FIG. 7A. A cross section obtained through the cutting along the cross section A2-A2 passes through the first fixing bracket 241, the first connection arm 243, the shaft 21, the second connection arm 244, and the second fixing bracket 242.

In some embodiments, the first end 2431 of the first connection arm 243 is rotatably connected to the shaft 21, and the second end 2432 of the first connection arm 243 is rotatably connected to the first fixing bracket 241. The first end 2441 of the second connection arm 244 is rotatably connected to the shaft 21, and the second end 2442 of the second connection arm 244 is rotatably connected to the second fixing bracket 242.

The first end 2431 of the first connection arm 243 is installed in one piece of first arc-shaped space 2181 of the shaft 21, to be rotatably connected to the shaft 21 in a connection manner of a virtual shaft. The bottom rotating shaft 2481 passes through the rotating shaft hole 24321 of the second end 2432 of the first connection arm 243 and passes through the first rotating shaft hole 2411 of the first fixing bracket 241 (refer to FIG. 14), to be inserted into the second end 2432 of the first connection arm 243 and the first fixing bracket 241, so that the second end 2432 of the first connection arm 243 is rotatably connected to the first fixing bracket 241 in a connection manner of a physical shaft.

The first end 2441 of the second connection arm 244 is installed in the other piece of first arc-shaped space 2181 of the shaft 21, to be rotatably connected to the shaft 21 in a connection manner of a virtual shaft. The bottom rotating shaft 2482 passes through the rotating shaft hole 24421 of the second end 2442 of the second connection arm 244 and passes through the second rotating shaft hole 2421 of the second fixing bracket 242 (refer to FIG. 15), to be inserted into the second end 2442 of the second connection arm 244 and the second fixing bracket 242, so that the second end 2442 of the second connection arm 244 is rotatably connected to the second fixing bracket 242 in a connection manner of a physical shaft.

The avoidance space 24311 of the first end 2431 of the first connection arm 243 and the avoidance space 24411 of the first end 2441 of the second connection arm 244 can be used to avoid the connection rib 2117f of the main support plate 211 of the shaft 21. The first connection arm 243 and the second connection arm 244 may be also position-limited through cooperation between the connection rib 2117f and the avoidance space (24311 and 24411), and a position-limiting direction is parallel to the extension direction of the shaft 21.

It may be understood that, in some other embodiments, the first end 2431 of the first connection arm 243 and/or the first end 2441 of the second connection arm 244 may be alternatively rotatably connected to the shaft 21 in a connection manner of a physical shaft. This is not strictly limited in this application. In some other embodiments, the second end 2432 of the first connection arm 243 may be alternatively rotatably connected to the first fixing bracket 241 in connection manner of a virtual shaft, and/or the second end 2442 of the second connection arm 244 may be alternatively rotatably connected to the second fixing bracket 242 in a connection manner of a virtual shaft. This is not strictly limited in this application.

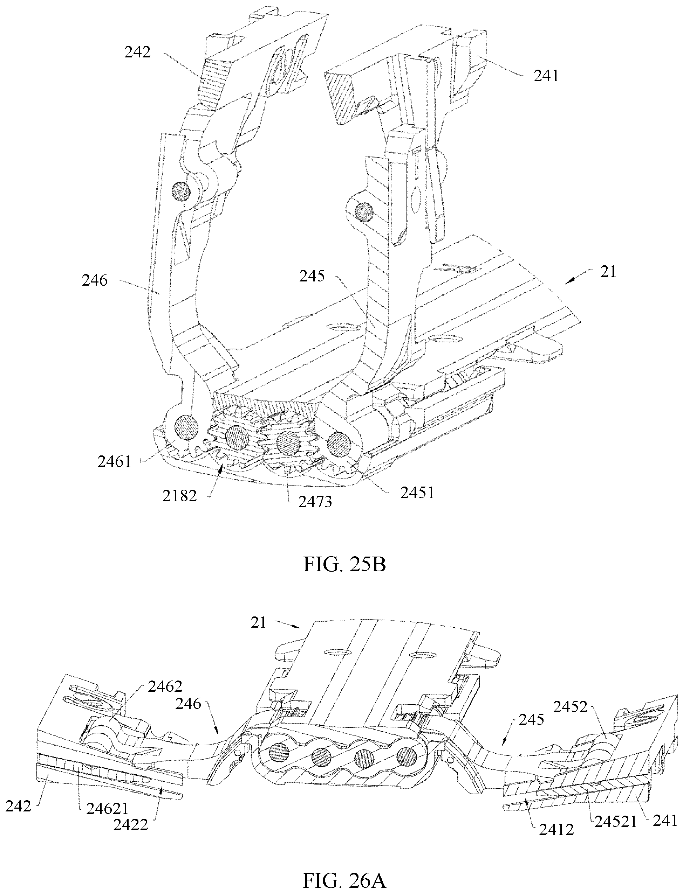

Refer to FIG. 23, FIG. 25A, and FIG. 25B. FIG. 25A is a schematic diagram of a cross-sectional structure of an assembled structure, that is cut along a cross section B2-B2, of the bottom connection assembly 24 and the shaft 21 shown in FIG. 6. FIG. 25B is a schematic diagram of the structure shown in FIG. 25A in a closed state. A position of the cross section B2-B2 in FIG. 6 corresponds to a position of the cross section B 1-B 1 in FIG. 7A. A cross section obtained through the cutting along the cross section B2-B2 passes through the first fixing bracket 241, the first swing arm 245, the shaft 21, the second swing arm 246, and the second fixing bracket 242.

In some embodiments, the rotating end 2451 of the first swing arm 245, the rotating end 2461 of the second swing arm 246, and the first damping assembly 247 are all installed in the first installation space 2182 of the shaft 21. The first retaining member 2471 and the second retaining member 2472 of the first damping assembly 247 are fastened relative to the shaft 21. The rotating end 2451 of the first swing arm 245 is rotatably connected to the first retaining member 2471 and the second retaining member 2472 by using the first adapter shaft 2477, to be rotatably connected to the shaft 21. The rotating end 2461 of the second swing arm 246 is rotatably connected to the first retaining member 2471 and the second retaining member 2472 by using the second adapter shaft 2478, to be rotatably connected to the shaft 21. Each synchronization gear 2473 is rotatably connected to the first retaining member 2471 and the second retaining member 2472 by using the third adapter shaft 2479, to be rotatably connected to the shaft 21.

In this embodiment, the rotating end 2451 of the first swing arm 245 and the rotating end 2461 of the second swing arm 246 are connected by using the plurality of synchronization gears 2473. Therefore, a rotation angle of the rotating end 2451 of the first swing arm 245 and a rotation angle of the rotating end 2461 of the second swing arm 246 are the same in magnitude and reverse in direction, so that rotation actions of the first swing arm 245 and the second swing arm 246 relative to the shaft 21 are synchronized, that is, the first swing arm 245 and the second swing arm 246 are synchronously close to or away from each other.

The bottom rotating shaft 2483 may pass through the first shaft insertion hole 24523 of the sliding end 2452 of the first swing arm 245, to be inserted into the sliding end 2452 of the first swing arm 245, so as to be moved with the sliding end 2452 of the first swing arm 245. The bottom rotating shaft 2484 may pass through the second shaft insertion hole 24623 of the sliding end 2462 of the second swing arm 246, to be inserted into the sliding end 2462 of the second swing arm 246, so as to be moved with the sliding end 2462 of the second swing arm 246.

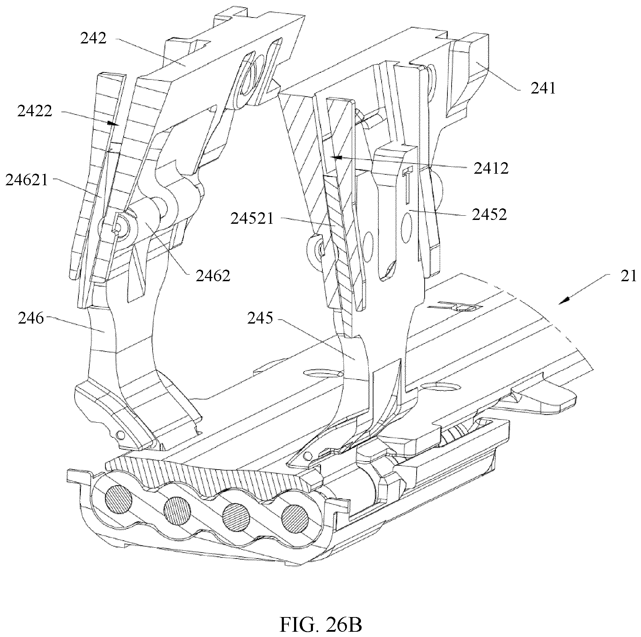

Refer to FIG. 23, FIG. 26A, and FIG. 26B. FIG. 26A is a schematic diagram of a cross-sectional structure of an assembled structure, that is cut along a cross section G-G, of the bottom connection assembly 24 and the shaft 21 shown in FIG. 6. FIG. 26B is a schematic diagram of the structure shown in FIG. 26A in a closed state. A cross section obtained through the cutting along the cross section G-G passes through the first fixing bracket 241, the first swing arm 245, the shaft 21, the second swing arm 246, and the second fixing bracket 242.

In some embodiments, the sliding end 2452 of the first swing arm 245 is slidably installed in the first sliding slot 2412 of the first fixing bracket 241, to be slidably connected to the first fixing bracket 241. The sliding block 24521 of the sliding end 2452 of the first swing arm 245 is partially located in the guide space of the first sliding slot 2412. The sliding block 24521 and the first sliding slot 2412 cooperate with each other to guide a sliding direction of the sliding end 2452 of the first swing arm 245 relative to the first fixing bracket 241. The sliding end 2462 of the second swing arm 246 is slidably installed in the second sliding slot 2422 of the second fixing bracket 242, to be slidably connected to the second fixing bracket 242. The sliding block 24621 of the sliding end 2462 of the second swing arm 246 is partially located in the guide space of the second sliding slot 2422. The sliding block 24621 and the second sliding slot 2422 cooperate with each other to guide a sliding direction of the sliding end 2462 of the second swing arm 246 relative to the second fixing bracket 242.

In this application, the two ends (2431 and 2432) of the first connection arm 243 of the bottom connection assembly 24 are respectively rotatably connected to the shaft 21 and the first fixing bracket 241, to form a connecting rod structure. The rotating end 2451 of the first swing arm 245 is rotatably connected to the shaft 21, and the sliding end 2452 of the first swing arm 245 is slidably connected to the first fixing bracket 241, to form a connecting rod slider structure. The two ends (2441 and 2442) of the second connection arm 244 are respectively rotatably connected to the shaft 21 and the second fixing bracket 242, to form a connecting rod structure. The rotating end 2461 of the second swing arm 246 is rotatably connected to the shaft 21, and the sliding end 2462 of the second swing arm 246 is slidably connected to the second fixing bracket 242, to form a connecting rod slider structure. The first fixing bracket 241 is configured to connect to the first housing 11, and the second fixing bracket 242 is configured to connect to the second housing 12. Therefore, the bottom connection assembly 24 of the hinge assembly 2 implements a connection between the first housing 11 and the shaft 21 and a connection between the second housing 12 and the shaft 21 by using the connecting rod structure and the connecting rod slider structure. The bottom connection assembly 24 has a small quantity of constituent parts, a simple fitting relationship and fitting position, and easily made and assembled components. This facilitates mass production. In addition, the shaft 21 is linked to the first fixing bracket 241 by using the first connection arm 243 and the first swing arm 245 and is linked to the second fixing bracket 242 by using the second connection arm 244 and the second swing arm 246. Therefore, a movement track of the hinge assembly 2 is accurate, and the hinge assembly 2 has a better mechanism tensile capability and mechanism squeezing-resistance capability.

In addition, as shown in FIG. 24A and FIG. 26A, in an open state, the rotating end 2451 of the first swing arm 245 is rotated into the shaft 21, the rotating end 2461 of the second swing arm 246 is rotated into the shaft 21, the sliding end 2452 of the first swing arm 245 is slid into the first fixing bracket 241, the sliding end 2462 of the second swing arm 246 is slid into the second fixing bracket 242, and a distance between the first fixing bracket 241 and the shaft 21 and a distance between the second fixing bracket 242 and the shaft 21 are smaller. As shown in FIG. 24B and FIG. 26B, in the closed state, the rotating end 2451 of the first swing arm 245 is partially rotated out of the shaft 21, the rotating end 2461 of the second swing arm 246 is partially rotated out of the shaft 21, the sliding end 2452 of the first swing arm 245 is partially slid out of the first fixing bracket 241, the sliding end 2462 of the second swing arm 246 is partially slid out of the second fixing bracket 242, and a distance between the first fixing bracket 241 and the shaft 21 and a distance between the second fixing bracket 242 and the shaft 21 are larger. Therefore, in the open state, the hinge assembly 2 can separately pull the first housing 11 and the second housing 12 close by using the first fixing bracket 241 and the second fixing bracket 242, so that the first housing 11 and the second housing 12 are close to the shaft 21. In the closed state, the hinge assembly 2 can separately push the first housing 11 and the second housing 12 away by using the first fixing bracket 241 and the second fixing bracket 242, so that the first housing 11 and the second housing 12 are away from the shaft 21, and the structure of the hinge assembly 2 can better adapt to a variant structure of the screen 200, to reduce a risk of pulling or squeezing the screen 200, and improve reliability of the screen 200 and the electronic device 1000.

In addition, as shown in FIG. 25A and FIG. 25B, the first damping assembly 247 is connected between the first swing arm 245 and the second swing arm 246, and the first damping assembly 247 can provide the damping force and the driving force when the first swing arm 245 and the second swing arm 246 are moved. The first swing arm 245 can be connected to the first housing 11 by using the first fixing bracket 241, and the first swing arm 245 is moved with the first housing 11. The second swing arm 246 can be connected to the second housing 12 by using the second fixing bracket 242, and the second swing arm 246 is moved with the second housing 12. Therefore, in a process of unfolding or folding the first housing 11 and the second housing 12 relative to each other, the first damping assembly 247 can provide the damping force, so that the user can sense resistance and thrust when unfolding or folding the electronic device 1000, to obtain better opening or closing hand feeling experience and improving mechanism operation experience of the electronic device 1000. In addition, the first damping assembly 247 may further enable the first swing arm 245 and the second swing arm 246 to stay at some positions, so that the first housing 11 and the second housing 12 can stay at some positions and can better remain an open state or a closed state, to improve user experience.

In addition, the rotating end 2451 of the first swing arm 245 is engaged with the rotating end 2461 of the second swing arm 246 by using the plurality of synchronization gears 2473, so that the rotation angle of the rotating end 2451 of the first swing arm 245 and the rotation angle of the rotating end 2461 of the second swing arm 246 are the same in magnitude and reverse in direction, and the rotation actions of the first swing arm 245 and the second swing arm 246 relative to the shaft 21 are synchronized, that is, the first swing arm 245 and the second swing arm 246 are synchronously close to or away from each other. The rotation actions of the first housing 11 and the second housing 12 relative to the shaft 21 are synchronized, to improve mechanism operation experience of the user.

It may be understood that the quantity, sizes, and the like of the synchronization gears 2473 may be designed based on a model, for example, a specific product form or size. This is not strictly limited in this application. A larger quantity of synchronization gears 2473 indicates smaller sizes of the synchronization gears 2473 and more space that can be released. A smaller quantity of synchronization gears 2473 indicates larger sizes of the synchronization gears 2473 and a smaller accumulated transmission error of the synchronization gears 2473, to help improve movement accuracy.

It may be understood that the first damping assembly 247 in this application may have a plurality of implementation structures. For example, in some other embodiments, the first damping assembly 247 may indirectly limit a position of the first swing arm 245 and a position of the second swing arm 246 by limiting a position of the synchronization gear 2473. For example, a clamping structure is formed between the synchronization gear 2473 and each of the first retaining member 2471 and the second retaining member 2472, and there is no clamping structure between the rotating end 2451 of the first swing arm 245, the rotating end 2461 of the second swing arm 246, and each of the first retaining member 2471 and the second retaining member 2472. In some other embodiments, the first damping assembly 247 may be alternatively provided with no second retaining member 2472. A clamping structure between the first retaining member 2471 and the synchronization gear 2473, the first swing arm 245, and the second swing arm 246 is used, so that the first swing arm 245 and the second swing arm 246 can stay at some positions. In some other embodiments, the first damping assembly 247 may be alternatively provided with no fixing plate. Two ends of the elastic member 2475 may respectively abut against the first retaining member 2471 and a wall surface of the first installation space 2182. The elastic member 2475 is compressed between the first retaining member 2471 and the shaft 21. In some other embodiments, the first damping assembly 247 may be alternatively provided with no synchronization gear 2473 and third adapter shaft 2479. The rotating end 2451 of the first swing arm 245 is directly engaged with the rotating end 2461 of the second swing arm 246. The foregoing embodiments are example structures of the first damping assembly 247. The first damping assembly 247 may alternatively have another implementation structure. This is not strictly limited in this application.

In some other embodiments, no first damping assembly 247 connected to the first swing arm 245 and the second swing arm 246 may be alternatively disposed between the rotating end 2451 of the first swing arm 245 and the rotating end 2461 of the second swing arm 246. The rotating end 2451 of the first swing arm 245 may be rotatably connected to the shaft 21 by using a rotating shaft. The rotating shaft may be a part of the rotating end 2451 of the first swing arm 245, or may be an independent mechanical member and inserted into the rotating end 2451 of the first swing arm 245. The rotating end 2461 of the second swing arm 246 may be also rotatably connected to the shaft 21 by using a rotating shaft. The rotating shaft may be a part of the rotating end 2461 of the second swing arm 246, or may be an independent mechanical member and inserted into the rotating end 2461 of the second swing arm 246. For example, a damping structure may be disposed in the first fixing bracket 241 and is configured to apply damping force to the sliding end 2452 of the first swing arm 245. A damping structure may be disposed in the second fixing bracket 242 and is configured to apply damping force to the sliding end 2462 of the second swing arm 246.

The following specifically describes a structure of each component of the middle connection assembly 25 and a connection structure between the middle connection assembly 25 and the shaft 21 with reference to the accompanying drawings.

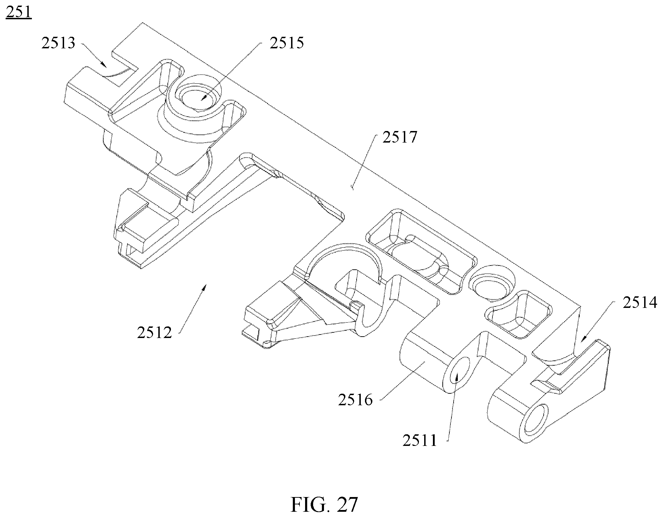

FIG. 27 is a schematic diagram of a structure of the third fixing bracket 251 shown in FIG. 13 from another perspective.

In some embodiments, the third fixing bracket 251 has a third rotating shaft hole 2511, a third sliding slot 2512, a fifth arc-shaped slot 2513, a first fan-shaped slot 2514, and a plurality of fastening holes 2515. The third fixing bracket 251 includes at least one third rotatable connection block 2516. The third rotating shaft hole 2511 is formed on the third rotatable connection block 2516. For example, the third sliding slot 2512 has two side walls disposed opposite to each other. The two side walls disposed opposite to each other are recessed to jointly form guide space of the third sliding slot 2512. To be specific, the side walls of the third sliding slot 2512 may have the recessed guide space, to guide a sliding direction of a mechanical member installed in the third sliding slot 2512, so that a relative sliding action between the third fixing bracket 251 and the corresponding mechanical remember is more easily implemented and has higher control precision. The fifth arc-shaped slot 2513 is formed at the top end of the third fixing bracket 251. The first fan-shaped slot 2514 is formed at the bottom end of the third fixing bracket 251. One side of the fifth arc-shaped slot 2513 may extend to a surface of the top side of the third fixing bracket 251. A slot bottom wall of the first fan-shaped slot 2514 is a cambered surface, and a slot side wall of the first fan-shaped slot 2514 is a fan-shaped surface. In this application, the third fixing bracket 251 may pass through the plurality of fastening holes 2515 by using a plurality of fasteners, to be fixedly connected to the first housing 11 (refer to FIG. 2). The third fixing bracket 251 has a third fitting surface 2517. The third fitting surface 2517 may be a plane. An opening at one end of the fifth arc-shaped slot 2513 is located on the third fitting surface 2517. An opening at one end of the first fan-shaped slot 2514 is located on the third fitting surface 2517.

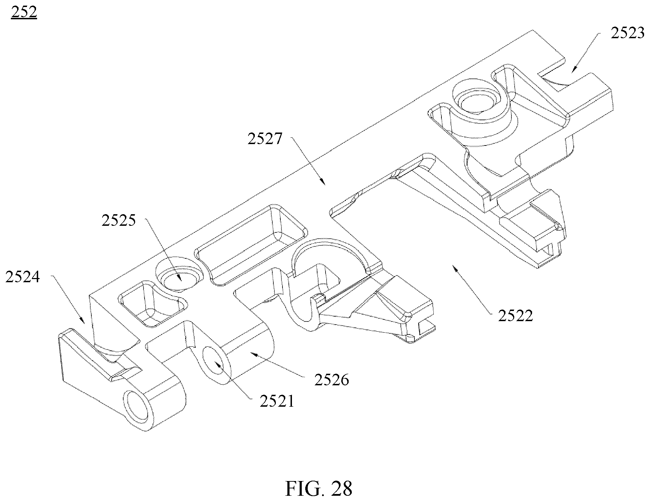

FIG. 28 is a schematic diagram of a structure of the fourth fixing bracket 252 shown in FIG. 13 from another perspective.

In some embodiments, the fourth fixing bracket 252 has a fourth rotating shaft hole 2521, a fourth sliding slot 2522, a seventh arc-shaped slot 2523, a second fan-shaped slot 2524, and a plurality of fastening holes 2525. The fourth fixing bracket 252 includes at least one fourth rotatable connection block 2526. The fourth rotating shaft hole 2521 is formed on the fourth rotatable connection block 2526. For example, the fourth sliding slot 2522 has two side walls disposed opposite to each other. The two side walls disposed opposite to each other are recessed to jointly form guide space of the fourth sliding slot 2522. To be specific, the side walls of the fourth sliding slot 2522 may have the recessed guide space, to guide a sliding direction of a mechanical member installed in the fourth sliding slot 2522, so that a relative sliding action between the second fixing bracket 242 and the corresponding mechanical remember is more easily implemented and has higher control precision. The seventh arc-shaped slot 2523 is formed at the top end of the fourth fixing bracket 252. The second fan-shaped slot 2524 is formed at the bottom end of the fourth fixing bracket 252. One side of the seventh arc-shaped slot 2523 may extend to a surface of the top side of the fourth fixing bracket 252. A slot bottom wall of the second fan-shaped slot 2524 is a cambered surface, and a slot side wall of the second fan-shaped slot 2524 is a fan-shaped surface. In this application, the fourth fixing bracket 252 may pass through the plurality of fastening holes 2525 by using a plurality of fasteners, to be fixedly connected to the second housing 12 (refer to FIG. 2). The third fixing bracket 251 has a fourth fitting surface 2527. The fourth fitting surface 2527 may be a plane. An opening at one end of the seventh arc-shaped slot 2523 is located on the fourth fitting surface 2527. An opening at one end of the second fan-shaped slot 2524 is located on the fourth fitting surface 2527.

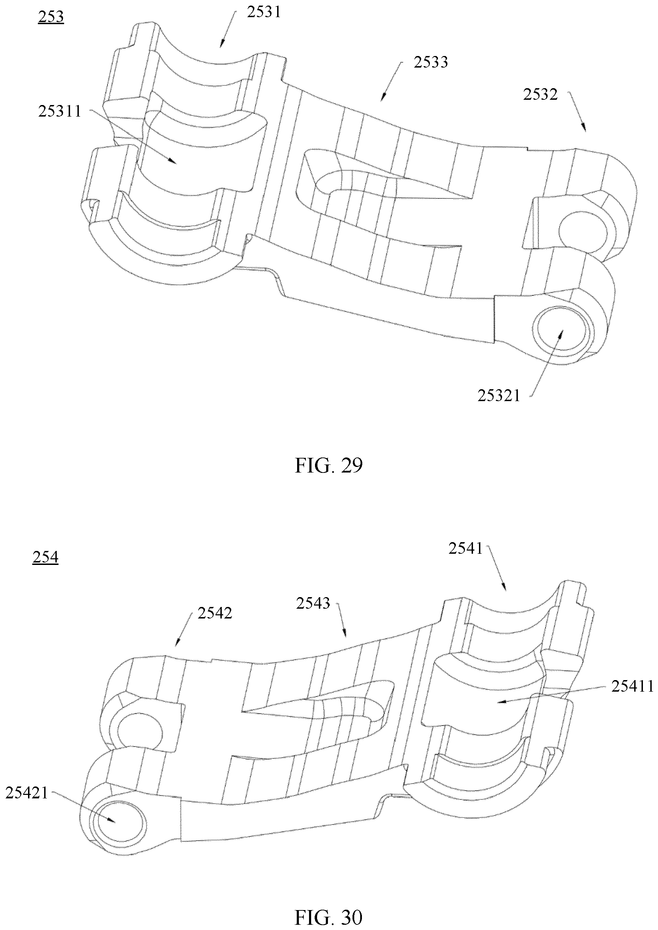

FIG. 29 is a schematic diagram of a structure of the third connection arm 253 shown in FIG. 13 from another perspective.

In some embodiments, the third connection arm 253 includes a first end 2531 and a second end 2532. Both the first end 2531 and the second end 2532 are rotating ends. For example, the first end 2531 of the third connection arm 253 is an arc-shaped arm, and the second end 2532 of the third connection arm 253 is provided with a rotating shaft hole 25321. The middle part of the first end 2531 of the third connection arm 253 is provided with avoidance space 25311. The avoidance space 25311 is disposed in a recessed manner and extends to an end surface of the first end 2531 of the third connection arm 253.

The third connection arm 253 further includes a connection section 2533 connected between the first end 2531 and the second end 2532. For example, an upper surface of the connection section 2533 may be bent relative to an upper surface of the second end 2532 of the third connection arm 253. The connection section 2533 is disposed so that a structural design of the third connection arm 253 is more flexible, to better meet connection requirements and shape requirements of the middle connection assembly 25 and the hinge assembly 2.

The third connection arm 253 may be an integrated mechanical member, to have high structural strength. For example, the third connection arm 253 may be formed by using a computer numerical control (computer numerical control, CNC) milling technology. In some other embodiments, the third connection arm 253 may be alternatively formed by using a metal injection molding technology. This is not strictly limited in this embodiment of this application.

FIG. 30 is a schematic diagram of a structure of the fourth connection arm 254 shown in FIG. 13 from another perspective.

In some embodiments, the fourth connection arm 254 includes a first end 2541 and a second end 2542. Both the first end 2541 and the second end 2542 are rotating ends. For example, the first end 2541 of the fourth connection arm 254 is an arc-shaped arm, and the second end 2542 of the fourth connection arm 254 is provided with a rotating shaft hole 25421. The middle part of the first end 2541 of the fourth connection arm 254 is provided with avoidance space 25411. The avoidance space 25411 is disposed in a recessed manner and extends to an end surface of the first end 2541 of the fourth connection arm 254.

The fourth connection arm 254 further includes a connection section 2543 connected between the first end 2541 and the second end 2542. For example, an upper surface of the connection section 2543 may be bent relative to an upper surface of the second end 2542 of the fourth connection arm 254. The connection section 2543 is disposed so that a structural design of the fourth connection arm 254 is more flexible, to better meet connection requirements and shape requirements of the middle connection assembly 25 and the hinge assembly 2.

The fourth connection arm 254 may be an integrated mechanical member, to have high structural strength. For example, the fourth connection arm 254 may be formed by using a computer numerical control (computer numerical control, CNC) milling technology. In some other embodiments, the fourth connection arm 254 may be alternatively formed by using a metal injection molding technology. This is not strictly limited in this embodiment of this application.

In some embodiments, a shape of the third connection arm 253 and a shape of the fourth connection arm 254 may be the same as a shape of the first connection arm 243, to use a same material. This reduces a type of a material of the hinge assembly 2 and reduces costs of the hinge assembly 2. In some other embodiments, a shape of the third connection arm 253 and a shape of the fourth connection arm 254 may be alternatively different from a shape of the first connection arm 243. This is not strictly limited in this embodiment of this application.

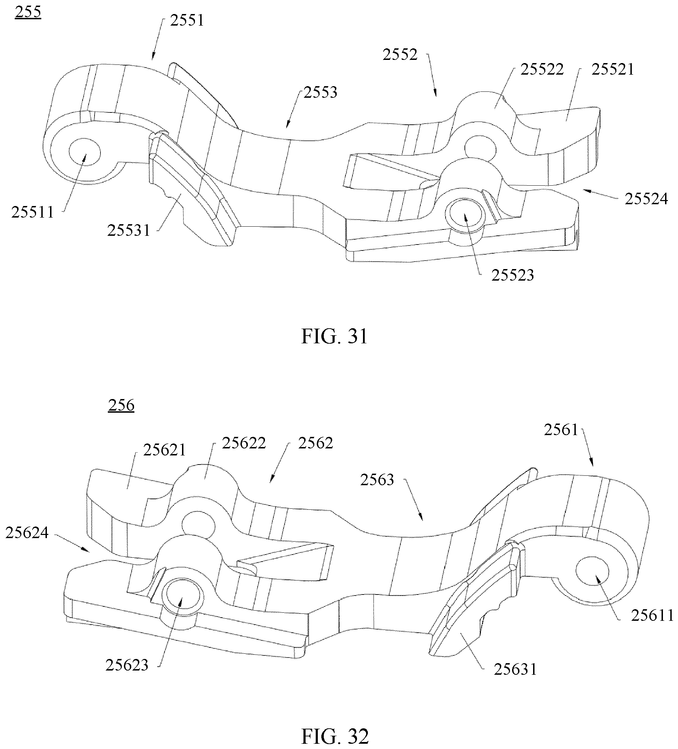

FIG. 31 is a schematic diagram of a structure of the third swing arm 255 shown in FIG. 13 from another perspective.

In some embodiments, the third swing arm 255 includes a rotating end 2551 and a sliding end 2552. The rotating end 2551 of the third swing arm 255 is provided with a rotating shaft hole 25511. The rotating shaft hole 25511 penetrates the rotating end 2551 of the third swing arm 255. The sliding end 2552 of the third swing arm 255 includes a sliding block 25521 and a rotatable connection block 25522. The rotatable connection block 25522 is located above the sliding block 25521 and fixedly connected to the sliding block 25521. The sliding end 2552 of the third swing arm 255 is provided with a third shaft insertion hole 25523. In some embodiments, the third shaft insertion hole 25523 is located on the rotatable connection block 25522. In some other embodiments, the third shaft insertion hole 25523 may be partially located on the rotatable connection block 25522 and partially located on the sliding block 25521, to make full use of a thickness of the sliding end 2552 of the third swing arm 255. This facilitates lightening and thinning of the sliding end 2552 of the third swing arm 255. The sliding end 2552 of the third swing arm 255 is further provided with a third avoidance region 25524. The third avoidance region 25524 penetrates the sliding block 25521 and the rotatable connection block 25522, the third avoidance region 25524 further extends to an end surface that is of the sliding end 2552 and that is away from the rotating end 2551, and the third avoidance region 25524 divides the third shaft insertion hole 25523 into two parts.

The third swing arm 255 further includes a connection section 2553 connected between the rotating end 2551 and the sliding end 2552. For example, the connection section 2553 of the third swing arm 255 may be bent relative to the sliding end 2552 of the third swing arm 255, so that a structural design of the third swing arm 255 is more flexible, to better meet connection requirements and shape requirements of the middle connection assembly 25 and the hinge assembly 2. For example, the connection section 2553 of the third swing arm 255 may include two extension blocks 25531. The two extension blocks are respectively located on two sides of the connection section 2553 of the third swing arm 255, and the two extension blocks can increase structural strength of the third swing arm 255.

The third swing arm 255 may be an integrated mechanical member, to have high structural strength. For example, the third swing arm 255 may be formed by using a metal injection molding technology or another technology. This is not strictly limited in this embodiment of this application.

FIG. 32 is a schematic diagram of a structure of the fourth swing arm 256 shown in FIG. 13 from another perspective.

In some embodiments, the fourth swing arm 256 includes a rotating end 2561 and a sliding end 2562. The rotating end 2561 of the fourth swing arm 256 is provided with a rotating shaft hole 25611. The rotating shaft hole 25611 penetrates the rotating end 2561 of the fourth swing arm 256. The sliding end 2562 of the fourth swing arm 256 includes a sliding block 25621 and a rotatable connection block 25622. The rotatable connection block 25622 is located above the sliding block 25621 and fixedly connected to the sliding block 25621. The sliding end 2562 of the fourth swing arm 256 is provided with a fourth shaft insertion hole 25623. In some embodiments, the fourth shaft insertion hole 25623 is located on the rotatable connection block 25622. In some other embodiments, the fourth shaft insertion hole 25623 may be partially located on the rotatable connection block 25622 and partially located on the sliding block 25621, to make full use of a thickness of the sliding end 2562 of the fourth swing arm 256. This facilitates lightening and thinning of the sliding end 2562 of the fourth swing arm 256. The sliding end 2562 of the fourth swing arm 256 is further provided with a fourth avoidance region 25624. The fourth avoidance region 25624 penetrates the sliding block 25621 and the rotatable connection block 25622, the fourth avoidance region 25624 further extends to an end surface that is of the sliding end 2562 and that is away from the rotating end 2561, and the fourth avoidance region 25624 divides the fourth shaft insertion hole 25623 into two parts.

The fourth swing arm 256 further includes a connection section 2563 connected between the rotating end 2561 and the sliding end 2562. For example, the connection section 2563 of the fourth swing arm 256 may be bent relative to the sliding end 2562 of the fourth swing arm 256, so that a structural design of the fourth swing arm 256 is more flexible, to better meet connection requirements and shape requirements of the middle connection assembly 25 and the hinge assembly 2. For example, the connection section 2563 of the fourth swing arm 256 may include two extension blocks 25631. The two extension blocks 25631 are respectively located on two sides of the connection section 2563 of the fourth swing arm 256, and the two extension blocks 25631 can increase structural strength of the fourth swing arm 256.

The fourth swing arm 256 may be an integrated mechanical member, to have high structural strength. For example, the fourth swing arm 256 may be formed by using a metal injection molding technology or another technology. This is not strictly limited in this embodiment of this application.

In some embodiments, a shape of the third swing arm 255 may be the same as a shape of the fourth swing arm 256, to use a same material. This reduces a type of a material of the hinge assembly 2 and reduces costs of the hinge assembly 2. In some other embodiments, a shape of the third swing arm 255 may be alternatively different from a shape of the fourth swing arm 256. This is not strictly limited in this embodiment of this application.

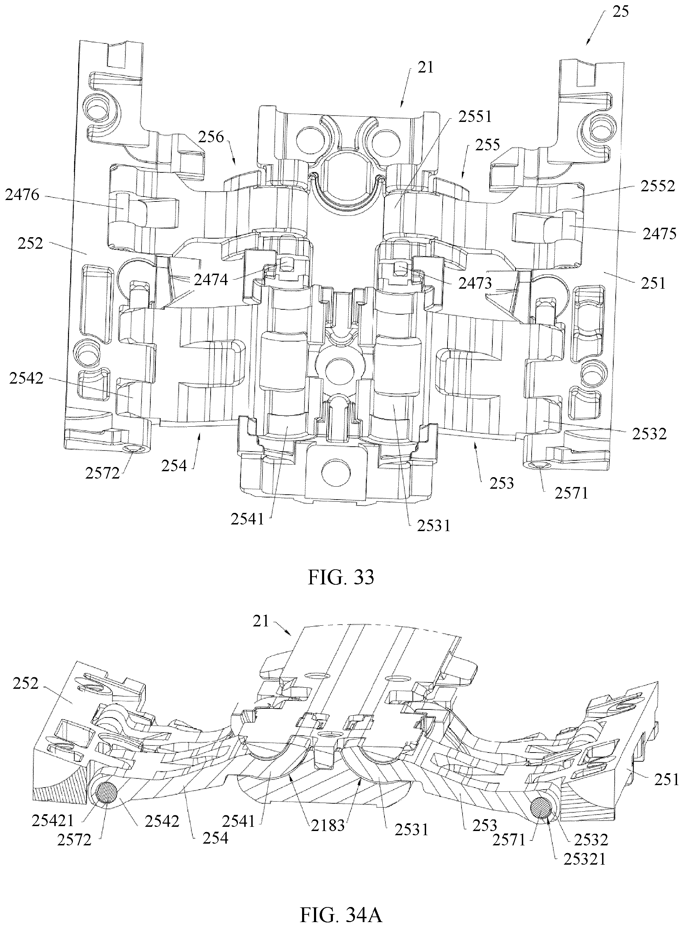

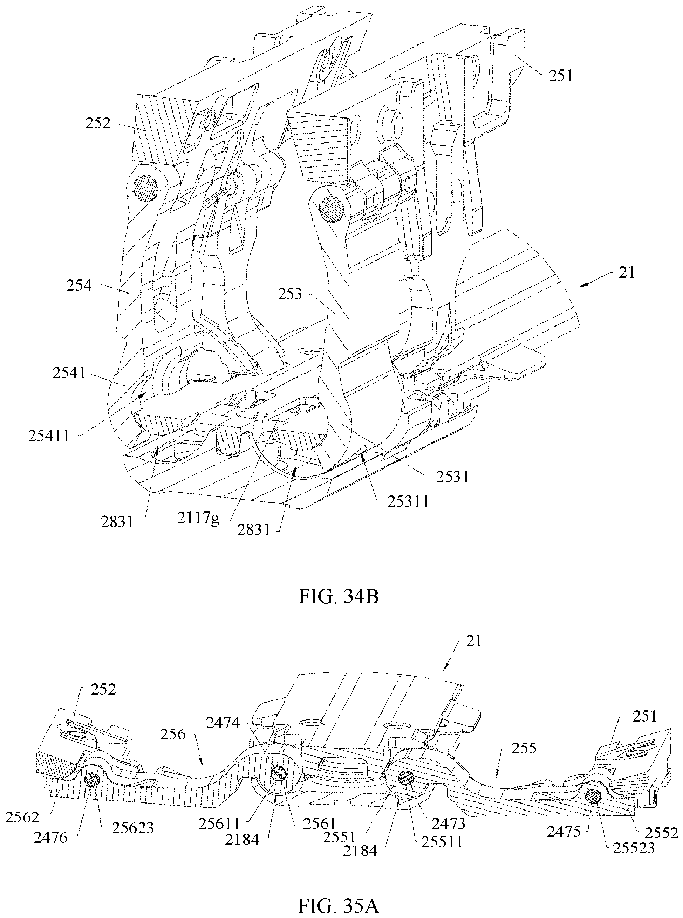

Refer to FIG. 33, FIG. 34A, and FIG. 34B. FIG. 33 is a schematic diagram of an assembled structure of the middle connection assembly 25 shown in FIG. 6 and the bottom casing body 212 of the shaft 21. FIG. 34A is a schematic diagram of a cross-sectional structure of an assembled structure, that is cut along a cross section C2-C2 and that is shown in FIG. 6, of the middle connection assembly 25 and the shaft 21. FIG. 34B is a schematic diagram of the structure shown in FIG. 34A in a closed state. A position of the cross section C2-C2 in FIG. 6 corresponds to a position of the cross section C1-C1 in FIG. 7A. A cross section obtained through the cutting along the cross section C2-C2 passes through the third fixing bracket 251, the third connection arm 253, the shaft 21, the fourth connection arm 254, and the fourth fixing bracket 252.

In some embodiments, the first end 2531 of the third connection arm 253 is rotatably connected to the shaft 21, and the second end 2532 of the third connection arm 253 is rotatably connected to the third fixing bracket 251. The first end 2541 of the fourth connection arm 254 is rotatably connected to the shaft 21, and the second end 2542 of the fourth connection arm 254 is rotatably connected to the fourth fixing bracket 252.

The first end 2531 of the third connection arm 253 is installed in one piece of second arc-shaped space 2183 of the shaft 21, to be rotatably connected to the shaft 21 in a connection manner of a virtual shaft. The middle rotating shaft 2571 passes through the rotating shaft hole 25321 of the second end 2532 of the third connection arm 253 and passes through the third rotating shaft hole 2511 of the third fixing bracket 251 (refer to FIG. 27), to be inserted into the second end 2532 of the third connection arm 253 and the third fixing bracket 251, so that the second end 2532 of the third connection arm 253 is rotatably connected to the third fixing bracket 251 in a connection manner of a physical shaft.

The first end 2541 of the fourth connection arm 254 is installed in the other piece of second arc-shaped space 2183 of the shaft 21, to be rotatably connected to the shaft 21 in a connection manner of a virtual shaft. The middle rotating shaft 2572 passes through the rotating shaft hole 25421 of the second end 2542 of the fourth connection arm 254 and passes through the fourth rotating shaft hole 2521 of the fourth fixing bracket 252 (refer to FIG. 28), to be inserted into the second end 2542 of the fourth connection arm 254 and the fourth fixing bracket 252, so that the second end 2542 of the fourth connection arm 254 is rotatably connected to the fourth fixing bracket 252 in a connection manner of a physical shaft.

The avoidance space 25311 of the first end 2531 of the third connection arm 253 and the avoidance space 25411 of the first end 2541 of the fourth connection arm 254 can be used to avoid a connection rib 2117g of the main support plate 211 of the shaft 21. The third connection arm 253 and the fourth connection arm 254 may be also position-limited through cooperation between the connection rib 2117g and the avoidance space (25311 and 25411), and a position-limiting direction is parallel to the extension direction of the shaft 21.

It may be understood that, in some other embodiments, the first end 2531 of the third connection arm 253 and/or the first end 2541 of the fourth connection arm 254 may be alternatively rotatably connected to the shaft 21 in a connection manner of a physical shaft. This is not strictly limited in this application. In some other embodiments, the second end 2532 of the third connection arm 253 may be alternatively rotatably connected to the third fixing bracket 251 in connection manner of a virtual shaft, and/or the second end 2542 of the fourth connection arm 254 may be alternatively rotatably connected to the fourth fixing bracket 252 in a connection manner of a virtual shaft. This is not strictly limited in this application.

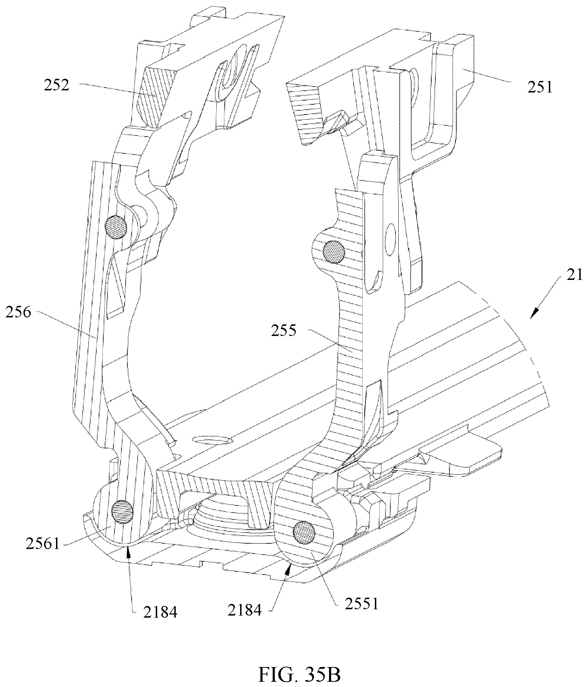

Refer to FIG. 33, FIG. 35A, and FIG. 35B. FIG. 35A is a schematic diagram of a cross-sectional structure of an assembled structure, that is cut along a cross section D2-D2, of the middle connection assembly 25 and the shaft 21 shown in FIG. 6. FIG. 35B is a schematic diagram of the structure shown in FIG. 35A in a closed state. A position of the cross section D2-D2 in FIG. 6 corresponds to a position of the cross section D1-D1 in FIG. 7A. A cross section obtained through the cutting along the cross section D2-D2 passes through the third fixing bracket 251, the third swing arm 255, the shaft 21, the fourth swing arm 256, and the fourth fixing bracket 252. For a related structure of the shaft 21, further refer to FIG. 10B.

In some embodiments, the rotating end 2551 of the third swing arm 255 and the rotating end 2561 of the fourth swing arm 256 are installed in the two pieces of rotation space 2184 of the shaft 21. The middle rotating shaft 2473 passes through the rotating shaft hole 25511 of the rotating end 2551 of the third swing arm 255 and passes through the rotating shaft hole 2134 of one rotatable connection protrusion 2133 of the middle casing body 213, to be inserted into the rotating end 2551 of the third swing arm 255 and the shaft 21, so that the rotating end 2551 of the third swing arm 255 is rotatably connected to the shaft 21. The middle rotating shaft 2474 passes through the rotating shaft hole 25611 of the rotating end 2561 of the fourth swing arm 256 and passes through the rotating shaft hole 2134 of the other rotatable connection protrusion 2133 of the middle casing body 213, to be inserted into the rotating end 2561 of the fourth swing arm 256 and the shaft 21, so that the rotating end 2561 of the fourth swing arm 256 is rotatably connected to the shaft 21.

The middle rotating shaft 2475 may pass through the third shaft insertion hole 25523 of the sliding end 2552 of the third swing arm 255, to be inserted into the sliding end 2552 of the third swing arm 255, so as to be moved with the sliding end 2552 of the third swing arm 255. The middle rotating shaft 2476 may pass through the fourth shaft insertion hole 25623 of the sliding end 2562 of the fourth swing arm 256, to be inserted into the sliding end 2562 of the fourth swing arm 256, so as to be moved with the sliding end 2562 of the fourth swing arm 256.

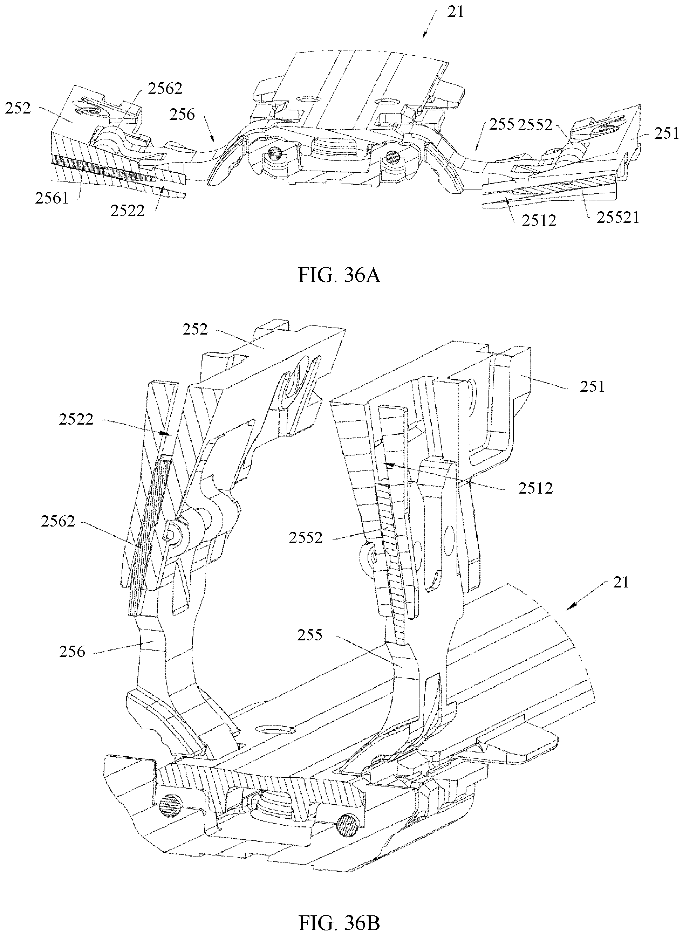

Refer to FIG. 33, FIG. 36A, and FIG. 36B. FIG. 36A is a schematic diagram of a cross-sectional structure of an assembled structure, that is cut along a cross section H-H, of the middle connection assembly 25 and the shaft 21 shown in FIG. 6. FIG. 36B is a schematic diagram of the structure shown in FIG. 36A in a closed state. A cross section obtained through the cutting along the cross section H-H passes through the third fixing bracket 251, the third swing arm 255, the shaft 21, the fourth swing arm 256, and the fourth fixing bracket 252.

In some embodiments, the sliding end 2552 of the third swing arm 255 is slidably installed in the third sliding slot 2512 of the third fixing bracket 251, to be slidably connected to the third fixing bracket 251. The sliding block 25521 of the sliding end 2552 of the third swing arm 255 is partially located in the guide space of the third sliding slot 2512. The sliding block 25521 and the third sliding slot 2512 cooperate with each other to guide a sliding direction of the sliding end 2552 of the third swing arm 255 relative to the third fixing bracket 251. The sliding end 2562 of the fourth swing arm 256 is slidably installed in the fourth sliding slot 2522 of the fourth fixing bracket 252, to be slidably connected to the fourth fixing bracket 252. The sliding block 25621 of the sliding end 2562 of the fourth swing arm 256 is partially located in the guide space of the fourth sliding slot 2522. The sliding block 25621 and the fourth sliding slot 2522 cooperate with each other to guide a sliding direction of the sliding end 2562 of the fourth swing arm 256 relative to the fourth fixing bracket 252.

In this application, the two ends (2531 and 2532) of the third connection arm 253 of the middle connection assembly 25 are respectively rotatably connected to the shaft 21 and the third fixing bracket 251, to form a connecting rod structure. The rotating end 2551 of the third swing arm 255 is rotatably connected to the shaft 21, and the sliding end 2552 of the third swing arm 255 is slidably connected to the third fixing bracket 251, to form a connecting rod slider structure. The two ends (2541 and 2542) of the fourth connection arm 254 are respectively rotatably connected to the shaft 21 and the fourth fixing bracket 252, to form a connecting rod structure. The rotating end 2561 of the fourth swing arm 256 is rotatably connected to the shaft 21, and the sliding end 2562 of the fourth swing arm 256 is slidably connected to the fourth fixing bracket 252, to form a connecting rod slider structure.

In this application, core design elements of the connecting rod structure and the connecting rod slider structure of the middle connection assembly 25 are the same as those of the bottom connection assembly 24, so that an action of the third fixing bracket 251 and an action of the first fixing bracket 241 can be synchronized, and an action of the fourth fixing bracket 252 and an action of the second fixing bracket 242 can be synchronized. In this way, the first housing 11 connected to both the third fixing bracket 251 and the first fixing bracket 241 has a stable movement action, the second housing 12 connected to both the fourth fixing bracket 252 and the second fixing bracket 242 has a stable movement action, and reliability of the housing apparatus 100 of the electronic device 1000 is high.

The same core design elements are mainly embodied in the following: A rotation center of the third connection arm 253 relative to the shaft 21 and a rotation center of the first connection arm 243 relative to the shaft 21 are collinear. A rotation center of the fourth connection arm 254 relative to the shaft 21 and a rotation center of the fourth connection arm 254 relative to the shaft 21 are collinear. A rotation center of the third swing arm 255 relative to the shaft 21 and a rotation center of the first swing arm 245 relative to the shaft 21 are collinear. A rotation center of the fourth swing arm 256 relative to the shaft 21 and a rotation center of the second swing arm 246 relative to the shaft 21 are collinear. A relative position relationship between the third rotating shaft hole 2511 and the third sliding slot 2512 of the third fixing bracket 251 is approximately the same as a relative position relationship between the first rotating shaft hole 2411 and the first sliding slot 2412 of the first fixing bracket 241, and in an extension direction parallel to the shaft 21, a spacing between the third rotating shaft hole 2511 and the third sliding slot 2512 may be the same as or different from a spacing between the first rotating shaft hole 2411 and the first sliding slot 2412. A relative position relationship between the fourth rotating shaft hole 2521 and the fourth sliding slot 2522 of the fourth fixing bracket 252 is approximately the same as a relative position relationship between the second rotating shaft hole 2421 and the second sliding slot 2422 of the second fixing bracket 242, and in an extension direction parallel to the shaft 21, a spacing between the fourth rotating shaft hole 2521 and the fourth sliding slot 2522 may be the same as or different from a spacing between the second rotating shaft hole 2421 and the second sliding slot 2422.

It may be understood that, in some other embodiments, the structure of the component of the middle connection assembly 25 and the connection structure between the middle connection assembly 25 and the shaft 21 may be alternatively implemented in another manner, provided that "the action of the third fixing bracket 251 and the action of the first fixing bracket 241 are synchronized, and the action of the fourth fixing bracket 252 and the action of the second fixing bracket 242 are synchronized".

The following describes a structure of each component of the top connection assembly 26 and a connection structure between the top connection assembly 26 and the shaft 21 with reference to the accompanying drawings. It may be understood that, in this application, the top connection assembly 26 may be designed with reference to the bottom connection assembly 24, and the top space of the shaft 21 may be designed with reference to the bottom space. Therefore, brief descriptions are provided below, and most same content is not described again.

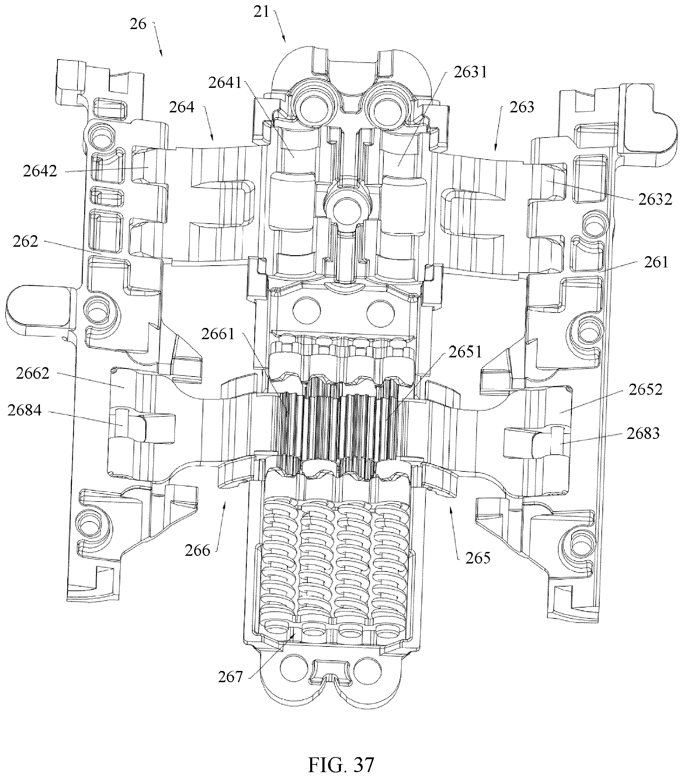

Refer to FIG. 13 and FIG. 37. FIG. 37 is a schematic diagram of an assembled structure of the top connection assembly 26 shown in FIG. 6 and the top casing body 214 of the shaft 21.

In some embodiments, the fifth connection arm 263 includes a first end 2631 and a second end 2632. The first end 2631 of the fifth connection arm 263 may be an arc-shaped arm, and is rotatably connected to the shaft 21 in a connection manner of a virtual shaft. The top rotating shaft 2681 may be inserted into the second end 2632 of the fifth connection arm 263 and the fifth fixing bracket 261, so that the second end 2632 of the fifth connection arm 263 is rotatably connected to the fifth fixing bracket 261. The sixth connection arm 264 includes a first end 2641 and a second end 2642. The first end 2641 of the sixth connection arm 264 may be an arc-shaped arm, and is rotatably connected to the shaft 21 in a connection manner of a virtual shaft. The top rotating shaft 2682 may be inserted into the second end 2642 of the sixth connection arm 264 and the sixth fixing bracket 262, so that the second end 2642 of the sixth connection arm 264 is rotatably connected to the sixth fixing bracket 262.

The fifth swing arm 265 includes a rotating end 2651 and a sliding end 2652. The sixth swing arm 266 includes a rotating end 2661 and a sliding end 2662. The rotating end 2651 of the fifth swing arm 265, the second damping assembly 267, and the rotating end 2661 of the sixth swing arm 266 are installed on the shaft 21. The rotating end 2651 of the fifth swing arm 265 and the rotating end 2661 of the sixth swing arm 266 are both rotatably connected to the shaft 21 in a connection manner of a physical shaft. The second damping assembly 267 is connected to the rotating end 2651 of the fifth swing arm 265 and the rotating end 2661 of the sixth swing arm 266, and is configured to provide damping force and driving force in movement processes of the fifth swing arm 265 and the sixth swing arm 266. The sliding end 2652 of the fifth swing arm 265 is slidably connected to the fifth fixing bracket 261. The top rotating shaft 2683 may be inserted into the sliding end 2652 of the fifth swing arm 265, to be moved with the sliding end 2652 of the fifth swing arm 265. The sliding end 2662 of the sixth swing arm 266 is slidably connected to the sixth fixing bracket 262. The top rotating shaft 2684 may be inserted into the sliding end 2662 of the sixth swing arm 266, to be moved with the sliding end 2662 of the sixth swing arm 266.

For example, for a structure of the fifth fixing bracket 261, refer to a structural design of the first fixing bracket 241. Structures that are of the fifth fixing bracket 261 and that are configured to connect to the fifth connection arm 263 and the fifth swing arm 265 may be the same as those of the first fixing bracket 241, and relative positions of the two structures may be the same as or different from those of the first fixing bracket 241. Two arc-shaped slots of the fifth fixing bracket 261 may be designed with reference to those of the first fixing bracket 241. A structure and a position of a third retaining block 2617 that is of the fifth fixing bracket 261 and that is configured to be clamped into the first housing 11 may be the same as or different from those of the first fixing bracket 241. Similarly, for a structure of the sixth fixing bracket 262, refer to a structural design of the second fixing bracket 242. The sixth fixing bracket 262 includes a fourth retaining block 2627 configured to be clamped into the second housing 12.

A structure of the fifth connection arm 263 and a structure of the sixth connection arm 264 may be the same as the structure of the first connection arm 243, to use a same material. This reduces a type of a material of the hinge assembly 2 and reduces costs. A structure of the fifth swing arm 265 and a structure of the sixth swing arm 266 may be the same as the structure of the first swing arm 245, to use a same material. This reduces a type of a material of the hinge assembly 2 and reduces costs.

A structure of the second damping assembly 267 may be the same as the structure of the first damping assembly 247, and structures of the plurality of top rotating shafts (2681, 2682, 2683, and 2684) may be the same as structures of the plurality of bottom rotating shafts (2481, 2482, 2483, and 2484), to reduce a type of a material of the hinge assembly 2 and reduce costs.

For example, as shown in FIG. 13, arrangement positions of the fifth connection arm 263, the sixth connection arm 264, the fifth swing arm 265, the sixth swing arm 266, and the second damping assembly 267 are symmetrical to arrangement positions of the first connection arm 243, the second connection arm 244, the first swing arm 245, the second swing arm 246, and the first damping assembly 247. In some other embodiments, the foregoing two groups of arrangement positions may be also the same, or present another arrangement relationship. This is not strictly limited in this application.

In this application, the two ends (2631 and 2632) of the fifth connection arm 263 of the top connection assembly 26 are respectively rotatably connected to the shaft 21 and the fifth fixing bracket 261, to form a connecting rod structure. The rotating end 2651 of the fifth swing arm 265 is rotatably connected to the shaft 21, and the sliding end 2652 of the fifth swing arm 265 is slidably connected to the fifth fixing bracket 261, to form a connecting rod slider structure. The two ends (2641 and 2642) of the sixth connection arm 264 are respectively rotatably connected to the shaft 21 and the sixth fixing bracket 262, to form a connecting rod structure. The rotating end 2661 of the sixth swing arm 266 is rotatably connected to the shaft 21, and the sliding end 2662 of the sixth swing arm 266 is slidably connected to the sixth fixing bracket 262, to form a connecting rod slider structure.

In this application, an action of the fifth fixing bracket 261 and an action of the first fixing bracket 241 can be synchronized, and an action of the sixth fixing bracket 262 and an action of the second fixing bracket 242 can be synchronized. In this way, the first housing 11 connected to both the fifth fixing bracket 261 and the first fixing bracket 241 has a stable movement action, the second housing 12 connected to both the sixth fixing bracket 262 and the second fixing bracket 242 has a stable movement action, and reliability of the housing apparatus 100 of the electronic device 1000 is high.

It may be understood that, in some other embodiments, the structure of the component of the top connection assembly 26 and the connection structure between the top connection assembly 26 and the shaft 21 may be alternatively implemented in another manner, provided that "the action of the fifth fixing bracket 261 and the action of the first fixing bracket 241 are synchronized, and the action of the sixth fixing bracket 262 and the action of the second fixing bracket 242 are synchronized".

The following describes a structure of the first support plate 22, a structure of the second support plate 23, and a connection structure between the first support plate 22, the second support plate 23, and the plurality of connection assemblies (24, 25, and 26) with reference to the accompanying drawings.

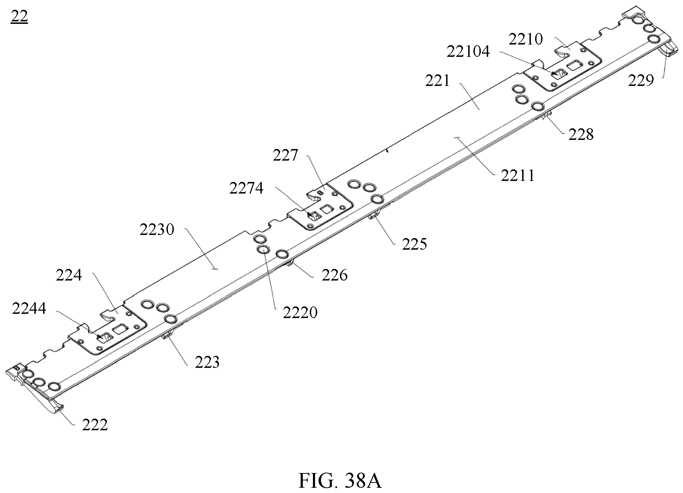

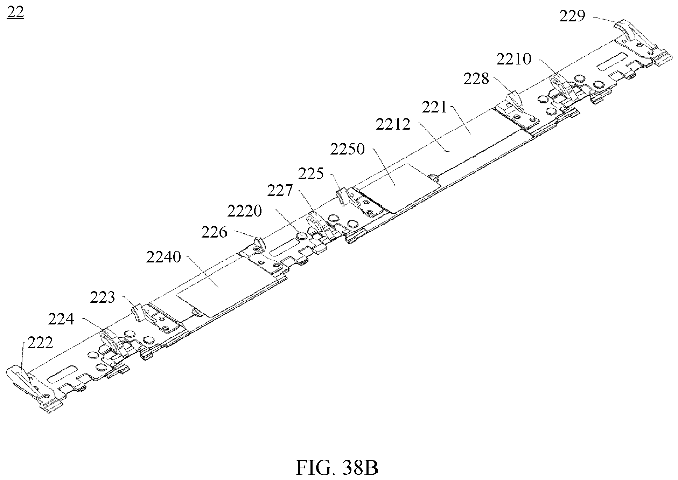

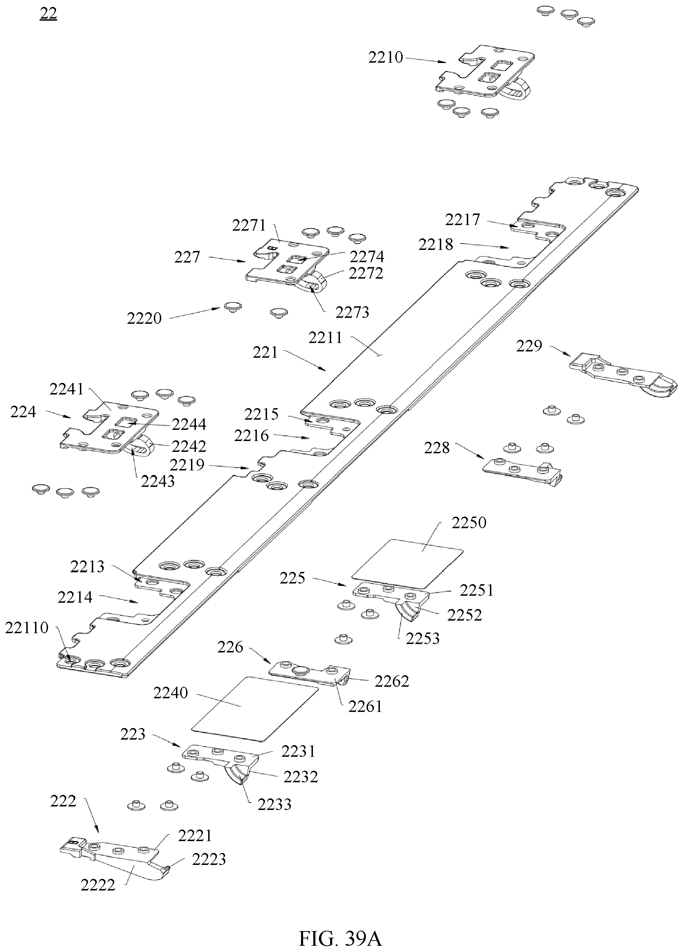

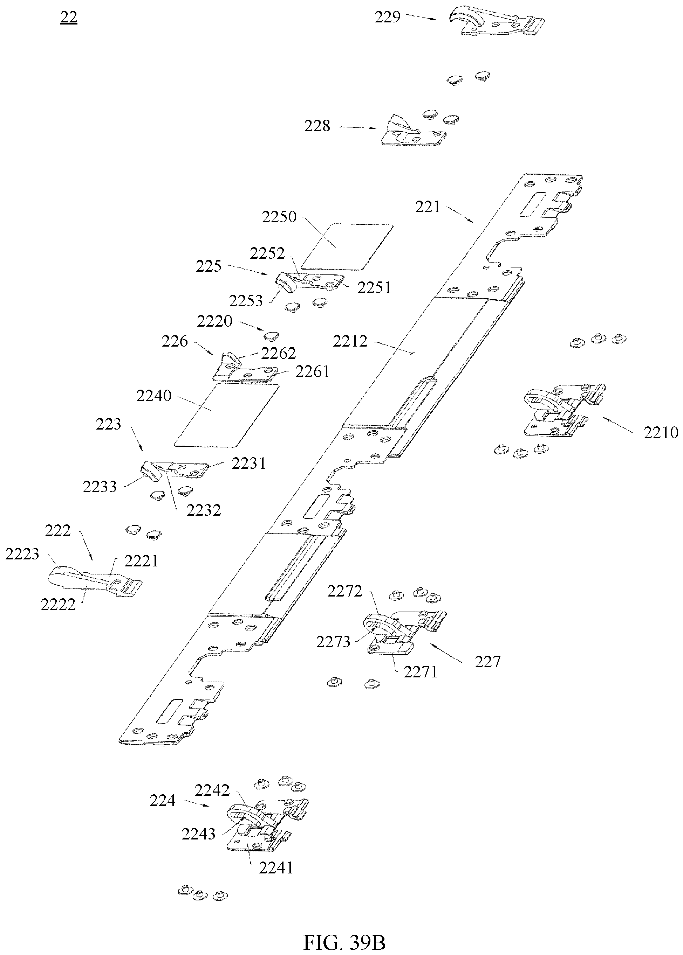

Refer to FIG. 38A, FIG. 38B, FIG. 39A, and FIG. 39B. FIG. 38A is a schematic diagram of a structure of the first support plate 22 shown in FIG. 6. FIG. 38B is a schematic diagram of a structure of the first support plate 22 shown in FIG. 38A from another perspective. FIG. 39A is a schematic diagram of a decomposition structure of the first support plate 22 shown in FIG. 38A. FIG. 39B is a schematic diagram of a decomposition structure of the first support plate 22 shown in FIG. 38B. An angle of view shown in FIG. 38B horizontally flips relative to an angle of view in FIG. 38A.

In some embodiments, the first support plate 22 includes a first support plate plate 221, a bottom connection structure (222, 223, and 224), a middle connection structure (225, 226, and 227), and a top connection structure (228, 229, and 2210). The bottom connection structure (222, 223, and 224) is fastened to the bottom part of the first support plate plate 221. The middle connection structure (225, 226, and 227) is fastened to the middle part of the first support plate plate 221. The top connection structure (228, 229, and 2210) is fastened to the top part of the first support plate plate 221.

For example, the first support plate plate 221 may be made of a material with low density and specific rigidity, for example, a carbon fiber material. In some other embodiments, the first support plate plate 221 may be alternatively made of a stainless steel material. For example, a stainless steel member is formed by using a metal injection molding technology, or a stainless steel board is formed through stamping. Certainly, the first support plate plate 221 may be alternatively made of another rigid material, for example, rigid plastic or aluminum, provided that a support function can be implemented. This is not strictly limited in this application. A mechanical member in the bottom connection structure (222, 223, and 224), the middle connection structure (225, 226, and 227), and the top connection structure (228, 229, and 2210) may use a metal injection molding technology and may be of an integrated structure, to have high structural strength. In some other embodiments, the first support plate plate 221 may be alternatively integrated with a plurality of connection structures. To be specific, the first support plate 22 is an integrated mechanical member. This is not strictly limited in this application.

For example, the first support plate plate 221 includes a support surface 2211 and a fixing surface 2212 disposed backing onto the support surface 2211. The support surface 2211 of the first support plate plate 221 is located on the upper side of the first support plate plate 221, and the fixing surface 2212 of the first support plate plate 221 is located on the lower side of the first support plate plate 221. In other words, the first support plate plate 221 includes two plate surfaces disposed backing onto each other. One plate surface forms the support surface 2211 of the first support plate plate 221, and the other plate surface forms the fixing surface 2212 of the first support plate plate 221.

The first support plate plate 221 forms a plurality of fitting slots and/or a plurality of fitting holes, configured to fit the bottom connection structure (222, 223, and 224), the middle connection structure (225, 226, and 227), and the top connection structure (228, 229, and 2210). For example, the first support plate plate 221 may include a bottom fitting slot 2213 and a bottom fitting hole 2214. An opening of the bottom fitting slot 2213 is located on the support surface 2211 of the first support plate plate 221. The bottom fitting hole 2214 is connected to the bottom fitting slot 2213 and penetrates the first support plate plate 221. The first support plate plate 221 further includes a middle fitting slot 2215 and a middle fitting hole 2216. An opening of the middle fitting slot 2215 is located on the support surface 2211 of the first support plate plate 221. The middle fitting hole 2216 is connected to the middle fitting slot 2215 and penetrates the first support plate plate 221. The first support plate plate 221 further includes a top fitting slot 2217 and a top fitting hole 2218. An opening of the top fitting slot 2217 is located on the support surface 2211 of the first support plate plate 221. The top fitting hole 2218 is connected to the top fitting slot 2217 and penetrates the first support plate plate 221. The plurality of fitting slots and/or the plurality of fitting holes may be located on a same side of the first support plate plate 221.

The first support plate plate 221 may further include a plurality of avoidance notches 2219. The plurality of avoidance notches 2219 may be located at the top part, the middle part, and the bottom part of the first support plate plate 221 in a distributed manner, and are configured to avoid another component. The plurality of avoidance notches 2219 may be located on one side that is of the first support plate plate 221 and that is provided with the plurality of fitting slots and/or the plurality of fitting holes.

The first support plate plate 221 may further include a plurality of fastening holes 22110. The plurality of fastening holes 22110 may be located at the top part, the middle part, and the bottom part of the first support plate plate 221 in a distributed manner, and are configured to lock the bottom connection structure (222, 223, and 224), the middle connection structure (225, 226, and 227), and the top connection structure (228, 229, and 2210) by using a fastener 2220. Certainly, the first support plate plate 221 may be alternatively provided with no fastening hole 22110, but is fastened to the bottom connection structure (222, 223, and 224), the middle connection structure (225, 226, and 227), and the top connection structure (228, 229, and 2210) in another manner, for example, bonding, welding, or a snap-fit connection.

For example, the bottom connection structure (222, 223, and 224) may include a first rotating block 222, a second rotating block 223, and a first guide block 224. The first rotating block 222, the second rotating block 223, and the first guide block 224 each may be an integrated mechanical member, to obtain high structural strength.

The first rotating block 222 may include a plate body 2221, a baffle plate 2222, and a first arc-shaped arm 2223. One side of the first arc-shaped arm 2223 is connected to the plate body 2221, and another side of the first arc-shaped arm 2223 is suspended. The baffle plate 2222 is connected to the first arc-shaped arm 2223 and the plate body 2221, and the baffle plate 2222 is configured to support the first arc-shaped arm 2223, to increase structural strength of the first rotating block 222, and avoid a problem that the hinge assembly 2 fails due to fracture, damage, or the like when the first rotating block 222 cooperates with another structure for movement. The first rotating block 222 is located below the first support plate plate 221. The plate body 2221 of the first rotating block 222 is fastened to the fixing surface 2212 of the first support plate plate 221. The plate body 2221 of the first rotating block 222 and the first support plate plate 221 may be locked and fastened by using at least one fastener 2220.

The second rotating block 223 may include a plate body 2231, a baffle plate 2232, and a second arc-shaped arm 2233. One end of the second arc-shaped arm 2233 is connected to the plate body 2231, and another end of the second arc-shaped arm 2233 is suspended. The baffle plate 2232 is connected to the second arc-shaped arm 2233 and the plate body 2231, and the baffle plate 2232 is configured to support the second arc-shaped arm 2233, to increase structural strength of the second rotating block 223, and avoid a problem that the hinge assembly 2 fails due to fracture, damage, or the like when the second rotating block 223 cooperates with another structure for movement. The second rotating block 223 is located below the first support plate plate 221. The plate body 2231 of the second rotating block 223 is fastened to the fixing surface 2212 of the first support plate plate 221. The plate body 2231 of the second rotating block 223 and the first support plate plate 221 may be locked and fastened by using at least one fastener 2220.

The first guide block 224 may include a plate body 2241 and a first guide arm 2242. The plate body 2241 includes a support surface and a fixing surface that are disposed backing onto each other. One end of the first guide arm 2242 is fastened to the fixing surface of the plate body 2241, and another end of the first guide arm 2242 is suspended. The first guide arm 2242 is provided with a first guide chute 2243. The first guide chute 2243 may form a closed structure, so that a mechanical member installed in the first guide chute 2243 can be slid back and forth in limited movement space in an extension direction of the first guide chute 2243, to limit a position, so as to prevent the mechanical member from accidentally separating from the first guide chute 2243. For example, the extension direction of the first guide chute 2243 may be arc-shaped. Certainly, the extension direction of the first guide chute 2243 may be alternatively designed as one or a combination of a curve, a straight line, or a broken line.

The plate body 2241 of the first guide block 224 is exposed relative to the support surface 2211 of the first support plate plate 221. The first guide arm 2242 protrudes relative to the fixing surface 2212 of the first support plate plate 221. For example, the plate body 2241 of the first guide block 224 may be installed in the bottom fitting slot 2213 of the first support plate plate 221 from a place above the first support plate plate 221. The first guide arm 2242 extends to be below the first support plate plate 221 through the bottom fitting hole 2214. The support surface of the plate body 2241 of the first guide block 224 may be disposed flush with the support surface 2211 of the first support plate plate 221. The plate body 2241 of the first guide block 224 and the first support plate plate 221 may be locked and fastened by using at least one fastener 2220. The plate body 2241 of the first guide block 224 may be further provided with one or more avoidance holes 2244, configured to avoid another mechanical member.

It should be understood that the first rotating block 222 and the second rotating block 223 mainly provide a rotatable connection structure. The first rotating block 222 and the second rotating block 223 may alternatively have another implementation structure. The structures of the first rotating block 222 and the second rotating block 223 may be the same or different. This is not strictly limited in this application. The first guide block 224 mainly provides a guide chute to guide a movement direction of another mechanical member. The first guide block 224 may alternatively have another implementation structure. This is not strictly limited in this application.

For example, the middle connection structure (225, 226, and 227) may include a fifth rotating block 225, a sixth rotating block 226, and a third guide block 227. The fifth rotating block 225, the sixth rotating block 226, and the third guide block 227 each may be an integrated mechanical member, to obtain high structural strength.

The fifth rotating block 225 may include a plate body 2251, a baffle plate 2252, and a fifth arc-shaped arm 2253. One side of the fifth arc-shaped arm 2253 is connected to the plate body 2251, and another side of the fifth arc-shaped arm 2253 is suspended. The baffle plate 2252 is connected to the fifth arc-shaped arm 2253 and the plate body 2251, and the baffle plate 2252 is configured to support the fifth arc-shaped arm 2253, to increase structural strength of the fifth rotating block 225, and avoid a problem that the hinge assembly 2 fails due to fracture, damage, or the like when the fifth rotating block 225 cooperates with another structure for movement. The fifth rotating block 225 is located below the first support plate plate 221. The plate body 2251 of the fifth rotating block 225 is fastened to the fixing surface 2212 of the first support plate plate 221. The plate body 2251 of the fifth rotating block 225 and the first support plate plate 221 may be locked and fastened by using at least one fastener 2220.

The sixth rotating block 226 may include a plate body 2261 and a first fan-shaped arm 2262. One side of the first fan-shaped arm 2262 is connected to the plate body 2261, and another side of the first fan-shaped arm 2262 is suspended. The first fan-shaped arm 2262 includes an arc-shaped outer side surface. The sixth rotating block 226 is located below the first support plate plate 221. The plate body 2261 of the sixth rotating block 226 is fastened to the fixing surface 2212 of the first support plate plate 221. The plate body 2261 of the sixth rotating block 226 and the first support plate plate 221 may be locked and fastened by using at least one fastener 2220.

The third guide block 227 may include a plate body 2271 and a third guide arm 2272. The plate body 2271 includes a support surface and a fixing surface that are disposed backing onto each other. One end of the third guide arm 2272 is fastened to the fixing surface of the plate body 2271, and another end of the third guide arm 2272 is suspended. The third guide arm 2272 is provided with a third guide chute 2273. The third guide chute 2273 may form a closed structure, so that a mechanical member installed in the third guide chute 2273 can be slid back and forth in limited movement space in an extension direction of the third guide chute 2273, to limit a position, so as to prevent the mechanical member from accidentally separating from the third guide chute 2273. For example, the extension direction of the third guide chute 2273 may be arc-shaped. Certainly, the extension direction of the third guide chute 2273 may be alternatively designed as one or a combination of a curve, a straight line, and a broken line.

The plate body 2271 of the third guide block 227 may be exposed relative to the support surface 2211 of the first support plate plate 221. The third guide arm 2272 protrudes relative to the fixing surface 2212 of the first support plate plate 221. For example, the plate body 2271 of the third guide block 227 may be installed in the middle fitting slot 2215 of the first support plate plate 221 from a place above the first support plate plate 221. The third guide arm 2272 extends to be below the first support plate plate 221 through the middle fitting hole 2216. The support surface of the plate body 2271 of the third guide block 227 may be disposed flush with the support surface 2211 of the first support plate plate 221. The plate body 2271 of the third guide block 227 and the first support plate plate 221 may be locked and fastened by using at least one fastener 2220. The plate body 2271 of the third guide block 227 may be further provided with one or more avoidance holes 2274, configured to avoid another mechanical member.

It should be understood that the fifth rotating block 225 and the sixth rotating block 226 mainly provide a rotatable connection structure. The fifth rotating block 225 and the sixth rotating block 226 may alternatively have another implementation structure. The structures of the fifth rotating block 225 and the sixth rotating block 226 may be the same or different. This is not strictly limited in this application. The third guide block 227 mainly provides a guide chute to guide a movement direction of another mechanical member. The third guide block 227 may alternatively have another implementation structure. This is not strictly limited in this application.

For example, the top connection structure (228, 229, and 2210) may be designed with reference to the bottom connection structure (222, 223, and 224). The top connection structure (228, 229, and 2210) may include two rotating blocks (228 and 229) configured to provide a rotatable connection structure, and may further include a fifth guide block 2210 configured to provide a guide chute. Structures of the two rotating blocks (228 and 229) may be the same or different, and may be designed with reference to a structure of another rotating block. A structure of the fifth guide block 2210 may be designed with reference to the structure of the first guide block 224. Details are not described herein again.

A support surface 2230 of the first support plate 22 includes the support surface 2211 of the first support plate plate 221, the support surface of the first guide block 224, the support surface of the third guide block 227, and a support surface of the fifth guide block 2210. The support surface 2211 of the first support plate plate 221 and the support surfaces of the plurality of guide blocks (224, 227, and 2210) may be spliced with each other, so that the support surface 2230 of the first support plate 22 is complete and continuous, and has a large supporting area.

In some embodiments, the first support plate 22 may further include a first insulation Mylar 2240 and a second insulation Mylar 2250. Both the first insulation Mylar 2240 and the second insulation Mylar 2250 are fastened to the fixing surface 2212 of the first support plate plate 221. The first insulation Mylar 2240 is located between the bottom connection structure (222, 223, and 224) and the middle connection structure (225, 226, and 227). The second insulation Mylar 2250 is located between the middle connection structure (225, 226, and 227) and the top connection structure (228, 229, and 2210). The first insulation Mylar 2240 and the second insulation Mylar 2250 can not only achieve an insulation effect but also have a small friction coefficient, so that the first insulation Mylar 2240 and the second insulation Mylar 2250 generate small friction force on another mechanical member when being in contact with the another mechanical member, to prevent the mechanical member from being scratched, and also help avoid scratching abnormal noise generated in a movement process of the hinge assembly 2.

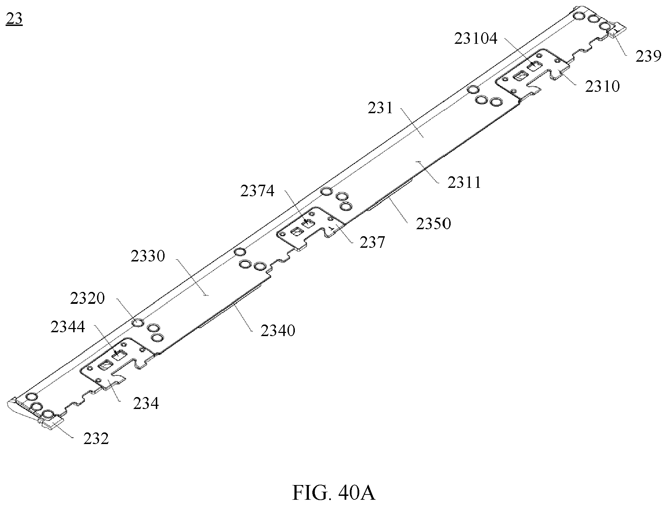

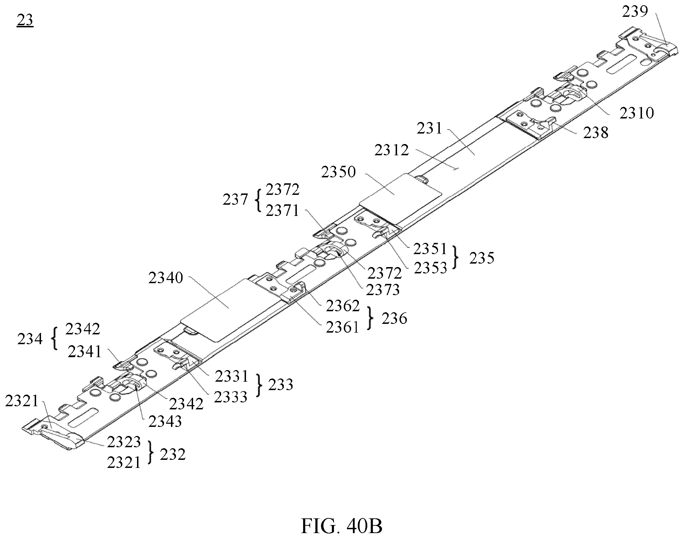

Refer to FIG. 40A and FIG. 40B. FIG. 40A is a schematic diagram of a structure of the second support plate 23 shown in FIG. 6. FIG. 40B is a schematic diagram of a structure of the second support plate 23 shown in FIG. 40A from another perspective. The structure of the second support plate 23 may be designed with reference to the structure of the first support plate 22. The following briefly describes a basic structure of the second support plate 23.

In some embodiments, the second support plate 23 includes a second support plate plate 231, a bottom connection structure (232, 233, and 234), a middle connection structure (235, 236, and 237), and a top connection structure (238, 239, and 2310). The bottom connection structure (232, 233, and 234) is fastened to the bottom part of the second support plate plate 231. The middle connection structure (235, 236, and 237) is fastened to the middle part of the second support plate plate 231. The top connection structure (238, 239, and 2310) is fastened to the top part of the second support plate plate 231. For example, the second support plate plate 231 may be made of a material with low density and specific rigidity, for example, a carbon fiber material. In some other embodiments, the second support plate plate 231 may be alternatively made of a stainless steel material. For example, a stainless steel member is formed by using a metal injection molding technology, or a stainless steel board is formed through stamping. Certainly, the first support plate plate 221 may be alternatively made of another rigid material, for example, rigid plastic or aluminum, provided that a support function can be implemented. This is not strictly limited in this application. A mechanical member in the bottom connection structure (232, 233, and 234), the middle connection structure (235, 236, and 237), and the top connection structure (238, 239, and 2310) may use a metal injection molding technology and may be of an integrated structure, to have high structural strength. In some other embodiments, the second support plate plate 231 may be alternatively integrated with a plurality of connection structures. To be specific, the second support plate 23 is an integrated mechanical member. This is not strictly limited in this application.

For example, the second support plate plate 231 includes a support surface 2311 and a fixing surface 2312 disposed backing onto the support surface 2311. The support surface 2311 of the second support plate plate 231 is located on the upper side of the second support plate plate 231. The second support plate plate 231 forms a plurality of fitting slots and/or a plurality of fitting holes, configured to fit the bottom connection structure (232, 233, and 234), the middle connection structure (235, 236, and 237), and the top connection structure (238, 239, and 2310). The second support plate plate 231 may further include a plurality of avoidance notches. The plurality of avoidance notches may be located at the top part, the middle part, and the bottom part of the second support plate plate 231 in a distributed manner, and are configured to avoid another component. The second support plate plate 231 may further include a plurality of fastening holes. The plurality of fastening holes may be located at the top part, the middle part, and the bottom part of the second support plate plate 231 in a distributed manner, and are configured to lock the bottom connection structure (232, 233, and 234), the middle connection structure (235, 236, and 237), and the top connection structure (238, 239, and 2310) by using a fastener 2320. Certainly, the second support plate plate 231 may be alternatively provided with no fastening hole 2320, but is fastened to the bottom connection structure (232, 233, and 234), the middle connection structure (235, 236, and 237), and the top connection structure (238, 239, and 2310) in another manner, for example, bonding, welding, or a snap-fit connection.

For example, the bottom connection structure (232, 233, and 234) may include a third rotating block 232, a fourth rotating block 233, and a second guide block 234. The third rotating block 232, the fourth rotating block 233, and the second guide block 234 each may be an integrated mechanical member, to obtain high structural strength. The third rotating block 232 includes a plate body 2321 and a third arc-shaped arm 2323 connected to the plate body 2321. The third rotating block 232 is located below the second support plate plate 231. The plate body 2321 of the third rotating block 232 is fastened to the fixing surface 2312 of the second support plate plate 231. The fourth rotating block 233 may include a plate body 2331 and a fourth arc-shaped arm 2333 connected to the plate body 2331. The fourth rotating block 233 is located below the second support plate plate 231. The plate body 2331 of the fourth rotating block 233 is fastened to the fixing surface 2312 of the second support plate plate 231. The second guide block 234 may include a plate body 2341 and a second guide arm 2342 connected to the plate body 2341. The second guide arm 2342 is provided with a second guide chute 2343. For example, an extension direction of the second guide chute 2343 may be arc-shaped. Certainly, the extension direction of the second guide chute 2343 may be alternatively designed as one or a combination of a curve, a straight line, and a broken line. The plate body 2341 of the second guide block 234 is exposed relative to the support surface 2311 of the second support plate plate 231. The second guide arm 2342 protrudes relative to the fixing surface 2312 of the second support plate plate 231. The plate body 2341 of the second guide block 234 may be further provided with one or more avoidance holes 2344, configured to avoid another mechanical member.

It should be understood that the third rotating block 232 and the fourth rotating block 233 mainly provide a rotatable connection structure. The third rotating block 232 and the fourth rotating block 233 may alternatively have another implementation structure. The structures of the third rotating block 232 and the fourth rotating block 233 may be the same or different. This is not strictly limited in this application. The second guide block 234 mainly provides a guide chute to guide a movement direction of another mechanical member. The second guide block 234 may alternatively have another implementation structure. This is not strictly limited in this application.

For example, the middle connection structure (235, 236, and 237) may include a seventh rotating block 235, an eighth rotating block 236, and a fourth guide block 237. The seventh rotating block 235, the eighth rotating block 236, and the fourth guide block 237 each may be an integrated mechanical member, to obtain high structural strength. The seventh rotating block 235 may include a plate body 2351 and a seventh arc-shaped arm 2353 connected to the plate body 2351. The seventh rotating block 235 is located below the second support plate plate 231. The plate body 2353 of the seventh rotating block 235 is fastened to the fixing surface 2312 of the second support plate plate 231. The eighth rotating block 236 may include a plate body 2361 and a second fan-shaped arm 2362 connected to the plate body 2361. The eighth rotating block 236 is located below the second support plate plate 231. The plate body 2361 of the eighth rotating block 236 is fastened to the fixing surface 2312 of the second support plate plate 231. The fourth guide block 237 may include a plate body 2371 and a fourth guide arm 2372 connected to the plate body. The fourth guide arm 2372 is provided with a fourth guide chute 2373. For example, an extension direction of the fourth guide chute 2373 may be arc-shaped. Certainly, the extension direction of the fourth guide chute 2373 may be alternatively designed as one or a combination of a curve, a straight line, and a broken line. The plate body 2371 of the fourth guide block 237 is exposed relative to the support surface 2311 of the second support plate plate 231. The fourth guide arm 2372 protrudes relative to the fixing surface 2312 of the second support plate plate 231. The plate body 2371 of the fourth guide block 237 may be further provided with one or more avoidance holes 2374, configured to avoid another mechanical member.

It should be understood that the seventh rotating block 235 and the eighth rotating block 236 mainly provide a rotatable connection structure. The seventh rotating block 235 and the eighth rotating block 236 may alternatively have another implementation structure. The structures of the seventh rotating block 235 and the eighth rotating block 236 may be the same or different. This is not strictly limited in this application. The fourth guide block 237 mainly provides a guide chute to guide a movement direction of another mechanical member. The fourth guide block 237 may alternatively have another implementation structure. This is not strictly limited in this application.

For example, the top connection structure (238, 239, and 2310) may be designed with reference to the bottom connection structure (232, 233, and 234). The top connection structure (238, 239, and 2310) may include two rotating blocks (238 and 239) configured to provide a rotatable connection structure, and may further include a sixth guide block 2310 configured to provide a guide chute. Structures of the two rotating blocks (238 and 239) may be the same or different, and may be designed with reference to a structure of another rotating block. A structure of the sixth guide block 2310 may be designed with reference to the structure of the second guide block 234. Details are not described herein again.

A support surface 2330 of the second support plate 23 includes the support surface 2311 of the second support plate plate 231 and upper surfaces of the plurality of guide blocks (234, 237, and 2310). The support surface 2311 of the second support plate plate 231 and the upper surfaces of the plurality of guide blocks (234, 237, and 2310) may be spliced with each other, so that the support surface 2330 of the second support plate 23 is complete and continuous, and has a large supporting area.

In some embodiments, the second support plate 23 may further include a third insulation Mylar 2340 and a fourth insulation Mylar 2350. Both the third insulation Mylar 2340 and the fourth insulation Mylar 2350 are fastened to the fixing surface 2312 of the second support plate plate 231. The third insulation Mylar 2340 is located between the bottom connection structure (232, 233, and 234) and the middle connection structure (235, 236, and 237). The fourth insulation Mylar 2350 is located between the middle connection structure (235, 236, and 237) and the top connection structure (238, 239, and 2310). The third insulation Mylar 2340 and the fourth insulation Mylar 2350 can not only achieve an insulation effect but also have a small friction coefficient.

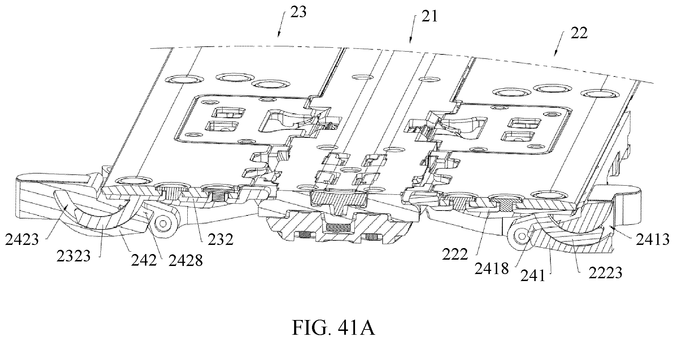

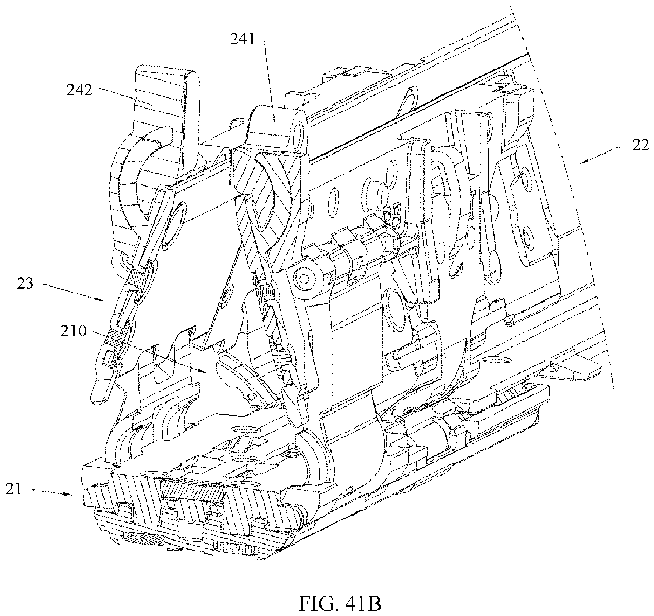

Refer to FIG. 41A and FIG. 41B. FIG. 41A is a schematic diagram of a cross-sectional structure of the hinge assembly 2 that is cut along a cross section J-J and that is shown in FIG. 5A. FIG. 41B is a schematic diagram of the structure shown in FIG. 41A in a closed state. A cross section obtained through the cutting along the cross section J-J passes through the first fixing bracket 241, the first rotating block 222 of the first support plate 22, the shaft 21, the third rotating block 232 of the second support plate 23, and the second fixing bracket 242.

In some embodiments, the first arc-shaped arm 2223 of the first rotating block 222 of the first support plate 22 is installed in the first arc-shaped slot 2413 of the first fixing bracket 241. The first rotating block 222 is rotatably connected to the first fixing bracket 241 in a connection manner of a virtual shaft. To be specific, the first support plate 22 is rotatably connected to the first fixing bracket 241. The third arc-shaped arm 2323 of the third rotating block 232 of the second support plate 23 is installed in the third arc-shaped slot 2423 of the second fixing bracket 242. The third rotating block 232 is rotatably connected to the second fixing bracket 242 in a connection manner of a virtual shaft. To be specific, the second support plate 23 is rotatably connected to the second fixing bracket 242.

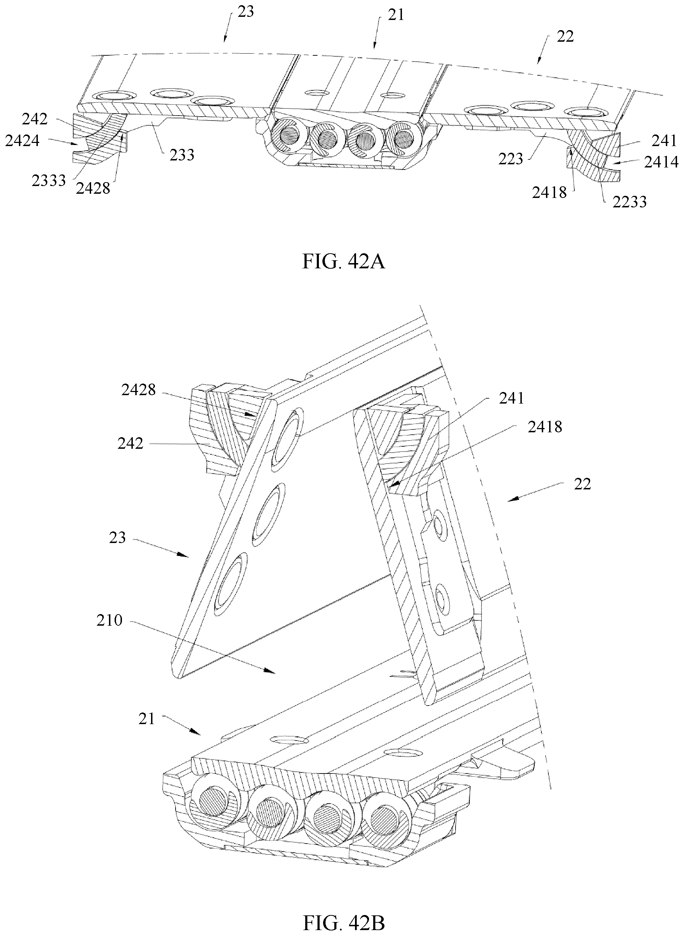

Refer to FIG. 42A and FIG. 42B. FIG. 42A is a schematic diagram of a cross-sectional structure of the hinge assembly 2 that is cut along a cross section K-K and that is shown in FIG. 5A. FIG. 42B is a schematic diagram of the structure shown in FIG. 42A in a closed state. A cross section obtained through the cutting along the cross section K-K passes through the first fixing bracket 241, the second rotating block 223 of the first support plate 22, the shaft 21, the fourth rotating block 233 of the second support plate 23, and the second fixing bracket 242.

In some embodiments, the second arc-shaped arm 2233 of the second rotating block 223 of the first support plate 22 is installed in the second arc-shaped slot 2414 of the first fixing bracket 241. The second rotating block 223 is rotatably connected to the first fixing bracket 241 in a connection manner of a virtual shaft. To be specific, the first support plate 22 is rotatably connected to the first fixing bracket 241. The fourth arc-shaped arm 2333 of the fourth rotating block 233 of the second support plate 23 is installed in the fourth arc-shaped slot 2424 of the second fixing bracket 242. The fourth rotating block 233 is rotatably connected to the second fixing bracket 242 in a connection manner of a virtual shaft. To be specific, the second support plate 23 is rotatably connected to the second fixing bracket 242.

A rotation center of the first rotating block 222 relative to the first fixing bracket 241 coincides with a rotation center of the second rotating block 223 relative to the first fixing bracket 241, so that a rotation action of the first support plate 22 relative to the first fixing bracket 241 is stable and reliable. For example, the center of the first arc-shaped arm 2223 and the center of the second arc-shaped arm 2233 of the first support plate 22 and the center of the first arc-shaped slot 2413 and the center of the second arc-shaped slot 2414 of the first fixing bracket 241 coincide. The center of the third arc-shaped arm 2323 and the center of the fourth arc-shaped arm 2333 of the second support plate 23 and the center of the third arc-shaped slot 2423 and the center of the fourth arc-shaped slot 2424 of the second fixing bracket 242 coincide. Similarly, a rotation center of the third rotating block 232 relative to the second fixing bracket 242 coincides with a rotation center of the fourth rotating block 233 relative to the second fixing bracket 242, so that a rotation action of the second support plate 23 relative to the second fixing bracket 242 is stable and reliable.

It may be understood that the first support plate 22 may be alternatively rotatably connected to the first fixing bracket 241 in a connection manner of a physical shaft, and the second support plate 23 may be alternatively rotatably connected to the second fixing bracket 242 in a connection manner of a physical shaft. This is not strictly limited in this application.

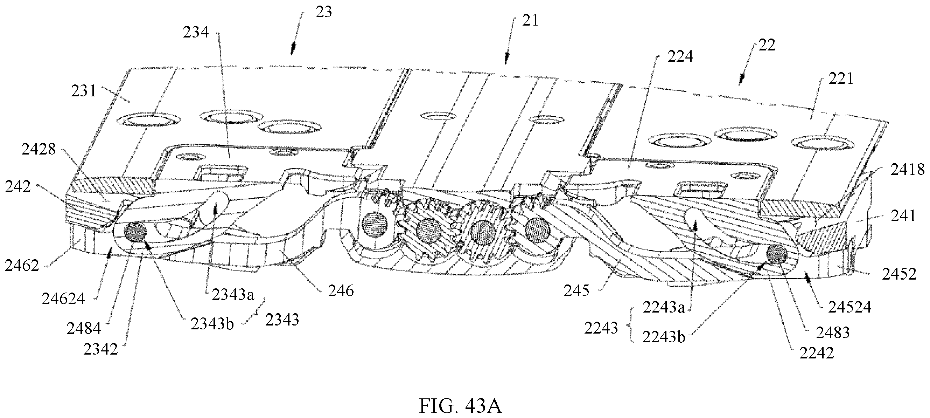

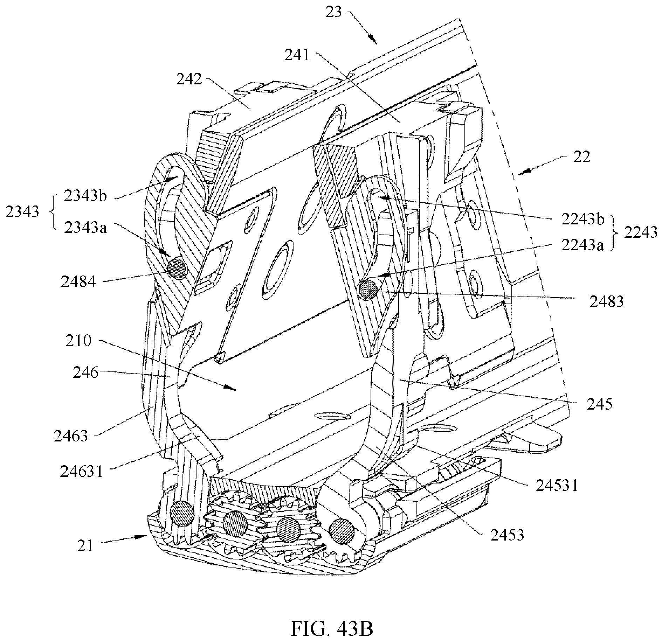

Refer to FIG. 43A and FIG. 43B. FIG. 43A is a schematic diagram of a cross-sectional structure of the hinge assembly 2 that is cut along a cross section B3-B3 and that is shown in FIG. 5A. FIG. 43B is a schematic diagram of the structure shown in FIG. 43A in a closed state. A position at which the cross section B3-B3 is located corresponds to a position at which a cross section B2-B2 in FIG. 6 is located. A cross section obtained through the cutting along the cross section B3-B3 passes through the first fixing bracket 241, the first swing arm 245, the first guide block 224 of the first support plate 22, the shaft 21, the second guide block 234 of the second support plate 23, the second swing arm 246, and the second fixing bracket 242.

In some embodiments, the first guide arm 2242 of the first guide block 224 of the first support plate 22 may be installed in the first avoidance region 24524 of the sliding end 2452 of the first swing arm 245. The bottom rotating shaft 2483 is installed in the first guide chute 2243 of the first guide block 224. The first guide arm 2242 may be slid relative to the sliding end 2452 of the first swing arm 245 by using the first avoidance region 24524. The bottom rotating shaft 2483 can be slid in the first guide chute 2243 in the extension direction of the first guide chute 2243, so that the first support plate 22 is slidably connected to the sliding end 2452 of the first swing arm 245. In this case, the first avoidance region 24524 may provide movement space for the first guide arm 2242, to provide convenience for a connection structure between the first guide block 224 and the sliding end 2452 of the first swing arm 245, reduce space occupied by the hinge assembly 2, and facilitate lightening and thinning of the hinge assembly 2.

The second guide arm 2342 of the second guide block 234 of the second support plate 23 may be installed in the second avoidance region 24624 of the sliding end 2462 of the second swing arm 246. The bottom rotating shaft 2484 is installed in the second guide chute 2343 of the second guide block 234. The second guide arm 2342 may be slid relative to the sliding end 2462 of the second swing arm 246 by using the second avoidance region 24624. The bottom rotating shaft 2484 can be slid in the second guide chute 2343 in the extension direction of the second guide chute 2343, so that the second support plate 23 is slidably connected to the sliding end 2462 of the second swing arm 246. In this case, the second avoidance region 24624 may provide movement space for the second guide arm 2342, to provide convenience for a connection structure between the second guide block 234 and the sliding end 2462 of the second swing arm 246, reduce space occupied by the hinge assembly 2, and facilitate lightening and thinning of the hinge assembly 2.

In this embodiment, the first support plate 22 is slidably connected to the sliding end 2452 of the first swing arm 245 and rotatably connected to the first fixing bracket 241. The sliding end 2452 of the first swing arm 245 and the first fixing bracket 241 jointly limit a movement track of the first support plate 22. The second support plate 23 is slidably connected to the sliding end 2462 of the second swing arm 246 and rotatably connected to the second fixing bracket 242. The sliding end 2462 of the second swing arm 246 and the second fixing bracket 242 jointly limit a movement track of the second support plate 23.

Specifically, in a process of unfolding or folding the hinge assembly 2, the first support plate 22 is moved with the sliding end 2452 of the first swing arm 245 and the first fixing bracket 241 relative to the shaft 21, the first support plate 22 is further moved relative to the sliding end 2452 of the first swing arm 245 and the first fixing bracket 241, the second support plate 23 is moved with the sliding end 2462 of the second swing arm 246 and the second fixing bracket 242 relative to the shaft 21, and the second support plate 23 is further moved relative to the sliding end 2462 of the second swing arm 246 and the second fixing bracket 242.

For example, the first guide chute 2243 includes a proximal end 2243a and a distal end 2243b. The proximal end 2243a is close to the shaft 21 and the first support plate plate 221 relative to the distal end 2243b. The second guide chute 2343 includes a proximal end 2343a and a distal end 2343b. The proximal end 2343a is close to the shaft 21 and the second support plate plate 231 relative to the distal end 2343b.

In an open state, as shown in FIG. 41A, FIG. 42A, and FIG. 43A, the first arc-shaped arm 2223 of the first support plate 22 is partially rotated out of the first arc-shaped slot 2413 of the first fixing bracket 241. The second arc-shaped arm 2233 is partially rotated out of the second arc-shaped slot 2414. A gap is formed between the first fitting surface 2418 of the first fixing bracket 241 and the first support plate 22. The bottom rotating shaft 2483 is slid to the distal end 2243b of the first guide chute 2243 of the first support plate 22. A gap is formed between the connection section of the first swing arm 245 and the first support plate 22. The first support plate 22 is flattened relative to the shaft 21. The third arc-shaped arm 2323 of the second support plate 23 is partially rotated out of the third arc-shaped slot 2423 of the second fixing bracket 242. The fourth arc-shaped arm 2333 is partially rotated out of the fourth arc-shaped slot 2424. A gap is formed between the second fitting surface 2428 of the second fixing bracket 242 and the second support plate 23. The bottom rotating shaft 2484 is slid to the distal end 2343b of the second guide chute 2343 of the second support plate 23. A gap is formed between the connection section 2463 of the second swing arm 246 and the second support plate 23. The second support plate 23 is flattened relative to the shaft 21.

In the closed state, as shown in FIG. 41B, FIG. 42B, and FIG. 43B, the first arc-shaped arm 2223 of the first support plate 22 is rotated into the first arc-shaped slot 2413 of the first fixing bracket 241. The second arc-shaped arm 2233 is rotated into the second arc-shaped slot 2414. The first fitting surface 2418 of the first fixing bracket 241 is close to the first support plate 22. The bottom rotating shaft 2483 is slid to the proximal end 2243a of the first guide chute 2243 of the first support plate 22. The connection section of the first swing arm 245 is close to the first support plate 22. The first support plate 22 is bent relative to the shaft 21. The third arc-shaped arm 2323 of the second support plate 23 is rotated into the third arc-shaped slot 2423 of the second fixing bracket 242. The fourth arc-shaped arm 2333 is rotated into the fourth arc-shaped slot 2424. The second fitting surface 2428 of the second fixing bracket 242 is close to the second support plate 23. The bottom rotating shaft 2484 is slid to the proximal end 2343a of the second guide chute 2343 of the second support plate 23. The connection section 2463 of the second swing arm 246 is close to the second support plate 23. The second support plate 23 is bent relative to the shaft 21.

The first arc-shaped arm 2223 and the second arc-shaped arm 2233 are located on one side that is of the first support plate plate 221 and that is away from the shaft 21. The third arc-shaped arm 2323 and the fourth arc-shaped arm 2333 are located on one side that is of the second support plate plate 231 and that is away from the shaft 21. The proximal end 2243a of the first guide chute 2243 is located at the middle part of the first support plate plate 221 or on one side that is of the first support plate plate 221 and that is close to the shaft 21. The proximal end 2343a of the second guide chute 2343 is located at the middle part of the second support plate plate 231 or on one side that is of the second support plate plate 231 and that is close to the shaft 21. A first spacing is formed between rotation centers of the first arc-shaped slot 2413 and the second arc-shaped slot 2414 of the first fixing bracket 241 and rotation centers of the third arc-shaped slot 2423 and the fourth arc-shaped slot 2424 of the second fixing bracket 242. A second spacing is formed between the bottom rotating shaft 2483 and the bottom rotating shaft 2484. In the closed state, the first spacing is less than the second spacing. Therefore, a spacing between the side that is of the first support plate plate 221 and that is away from the shaft 21 and the side that is of the second support plate plate 231 and that is away from the shaft 21 is less than a spacing between the side that is of the first support plate plate 221 and that is close to the shaft 21 and the side that is of the second support plate plate 231 and that is close to the shaft 21. In other words, the first support plate plate 221 and the second support plate plate 231 are away from each other in the direction close to the shaft 21. Therefore, the first support plate 22 and the second support plate 23 are away from each other in the direction close to the shaft 21.

In the closed state, the first support plate 22, the shaft 21, and the second support plate 23 of the hinge assembly 2 jointly enclose the similarly water drop-shaped screen accommodation space 210. In addition, at some positions of the hinge assembly 2, mechanical members of the plurality of connection assemblies (24, 25, and 26) of the hinge assembly 2 may further cooperate with the first support plate 22, the shaft 21, and the second support plate 23, to jointly encircle the more complete water drop-shaped screen accommodation space 210. As shown in FIG. 43B, the support surface 2230 of the first support plate 22, the upper surface of the connection section of the first swing arm 245, a support surface of the shaft 21, the upper surface of the connection section 2463 of the second swing arm 246, and the support surface 2330 of the second support plate 23 jointly surround the water drop-shaped screen accommodation space 210.

As shown in FIG. 43B, the two extension blocks 24531 (also refer to FIG. 18) on the connection section 2453 of the first swing arm 245 can be further configured to extend the upper surface of the connection section 2453 of the first swing arm 245, to increase a support function of the first swing arm 245 for another structure. The two extension blocks 24631 (also refer to FIG. 19) on the connection section 2463 of the second swing arm 246 can be further configured to extend the upper surface of the connection section 2463 of the second swing arm 246, to increase a support function of the second swing arm 246 for another structure.

FIG. 41A to FIG. 43B mainly show a connection structure between the first support plate 22, the second support plate 23, and the bottom connection assembly 24. The following briefly describes a connection structure between the first support plate 22, the second support plate 23, and the middle connection assembly 25 with reference to the accompanying drawings.

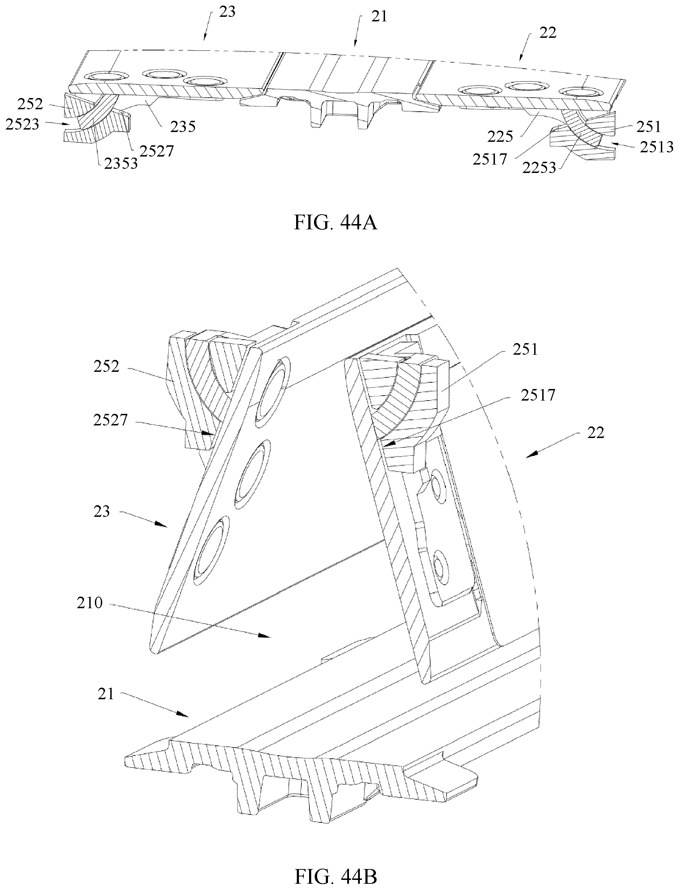

Refer to FIG. 44A and FIG. 44B. FIG. 44A is a schematic diagram of a cross-sectional structure of the hinge assembly 2 that is cut along a cross section L-L and that is shown in FIG. 5A. FIG. 44B is a schematic diagram of the structure shown in FIG. 44A in a closed state. A cross section obtained through the cutting along the cross section L-L passes through the third fixing bracket 251, the fifth rotating block 225 of the first support plate 22, the shaft 21, the seventh rotating block 235 of the second support plate 23, and the fourth fixing bracket 252.

In some embodiments, the fifth arc-shaped arm 2253 of the fifth rotating block 225 of the first support plate 22 is installed in the fifth arc-shaped slot 2513 of the third fixing bracket 251. The fifth rotating block 225 is rotatably connected to the third fixing bracket 251 in a connection manner of a virtual shaft. To be specific, the first support plate 22 is rotatably connected to the third fixing bracket 251. The seventh arc-shaped arm 2353 of the seventh rotating block 235 of the second support plate 23 is installed in the seventh arc-shaped slot 2523 of the fourth fixing bracket 252. The seventh rotating block 235 is rotatably connected to the fourth fixing bracket 252 in a connection manner of a virtual shaft. To be specific, the second support plate 23 is rotatably connected to the fourth fixing bracket 252.

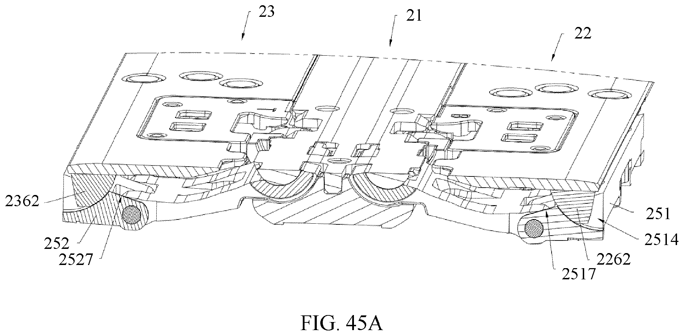

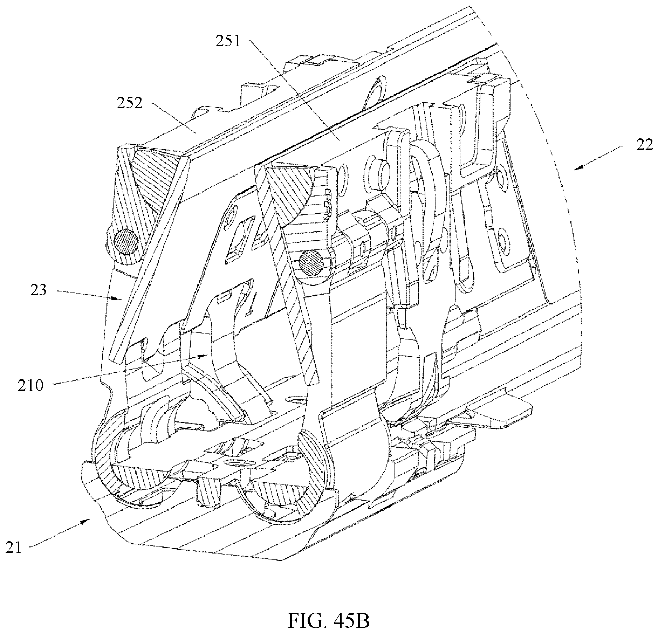

Refer to FIG. 45A and FIG. 45B. FIG. 45A is a schematic diagram of a cross-sectional structure of the hinge assembly 2 that is cut along a cross section M-M and that is shown in FIG. 5A. FIG. 45B is a schematic diagram of the structure shown in FIG. 45A in a closed state. A cross section obtained through the cutting along the cross section M-M passes through the third fixing bracket 251, the sixth rotating block 226 of the first support plate 22, the shaft 21, the eighth rotating block 236 of the second support plate 23, and the fourth fixing bracket 252. For a structure of the first support plate 22, refer to FIG. 39B. For a structure of the second support plate 23, refer to FIG. 40B.

In some embodiments, the first fan-shaped arm 2262 of the sixth rotating block 226 of the first support plate 22 is installed in the first fan-shaped slot 2514 of the third fixing bracket 251. An outer side surface of the first fan-shaped arm 2262 is slidably connected to a slot bottom wall of the first fan-shaped slot 2514. The sixth rotating block 226 is rotatably connected to the third fixing bracket 251 in a connection manner of a virtual shaft. To be specific, the first support plate 22 is rotatably connected to the third fixing bracket 251. The second fan-shaped arm 2362 of the eighth rotating block 236 of the second support plate 23 is installed in the second fan-shaped slot 2524 of the fourth fixing bracket 252. An outer side surface of the second fan-shaped arm 2362 is slidably connected to a slot bottom wall of the second fan-shaped slot 2524. The eighth rotating block 236 is rotatably connected to the fourth fixing bracket 252 in a connection manner of a virtual shaft. To be specific, the second support plate 23 is rotatably connected to the fourth fixing bracket 252.

A rotation center of the fifth rotating block 225 relative to the third fixing bracket 251 coincides with a rotation center of the sixth rotating block 226 relative to the third fixing bracket 251, so that a rotation action of the first support plate 22 relative to the third fixing bracket 251 is stable and reliable. A rotation center of the seventh rotating block 235 relative to the fourth fixing bracket 252 coincides with a rotation center of the eighth rotating block 236 relative to the fourth fixing bracket 252, so that a rotation action of the second support plate 23 relative to the fourth fixing bracket 252 is stable and reliable.

It may be understood that the first support plate 22 may be alternatively rotatably connected to the third fixing bracket 251 in a connection manner of a physical shaft, and the second support plate 23 may be alternatively rotatably connected to the fourth fixing bracket 252 in a connection manner of a physical shaft. This is not strictly limited in this application.

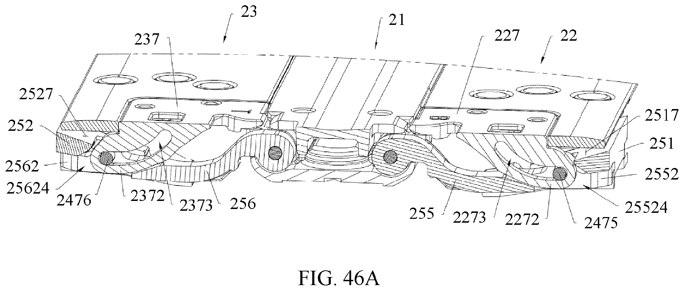

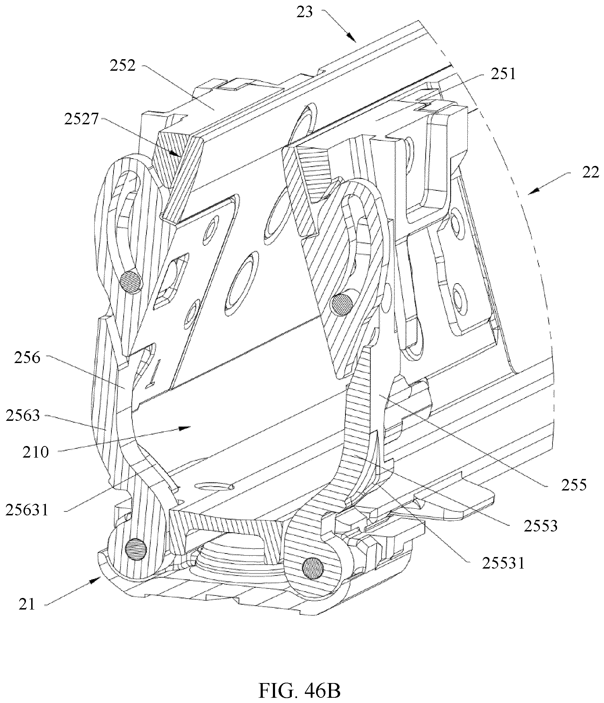

Refer to FIG. 46A and FIG. 46B. FIG. 46A is a schematic diagram of a cross-sectional structure of the hinge assembly 2 that is cut along a cross section D3-D3 and that is shown in FIG. 5A. FIG. 46B is a schematic diagram of the structure shown in FIG. 46A in a closed state. A position at which the cross section D3-D3 is located corresponds to a position at which a cross section D2-D2 in FIG. 6 is located. A cross section obtained through the cutting along the cross section D3-D3 passes through the third fixing bracket 251, the third swing arm 255, the third guide block 227 of the first support plate 22, the shaft 21, the fourth guide block 237 of the second support plate 23, the fourth swing arm 256, and the fourth fixing bracket 252.

In some embodiments, the third guide arm 2272 of the third guide block 227 of the first support plate 22 may be installed in the third avoidance region 25524 of the sliding end 2552 of the third swing arm 255. The middle rotating shaft 2475 is installed in the third guide chute 2273 of the third guide block 227. The third guide arm 2272 may be slid relative to the sliding end 2552 of the third swing arm 255 by using the third avoidance region 25524. The middle rotating shaft 2475 can be slid in the third guide chute 2273 in the extension direction of the third guide chute 2273, so that the first support plate 22 is slidably connected to the sliding end 2552 of the third swing arm 255. In this case, the third avoidance region 25524 may provide movement space for the third guide arm 2272, to provide convenience for a connection structure between the third guide block 227 and the sliding end 2552 of the third swing arm 255, reduce space occupied by the hinge assembly 2, and facilitate lightening and thinning of the hinge assembly 2.

The fourth guide arm 2372 of the fourth guide block 237 of the second support plate 23 may be installed in the fourth avoidance region 25624 of the sliding end 2562 of the fourth swing arm 256. The middle rotating shaft 2476 is installed in the fourth guide chute 2373 of the fourth guide block 237. The fourth guide arm 2372 may be slid relative to the sliding end 2562 of the fourth swing arm 256 by using the fourth avoidance region 25624. The middle rotating shaft 2476 can be slid in the fourth guide chute 2373 in the extension direction of the fourth guide chute 2373, so that the second support plate 23 is slidably connected to the sliding end 2562 of the fourth swing arm 256. In this case, the fourth avoidance region 25624 may provide movement space for the fourth guide arm 2372, to provide convenience for a connection structure between the fourth guide block 237 and the sliding end 2562 of the fourth swing arm 256, reduce space occupied by the hinge assembly 2, and facilitate lightening and thinning of the hinge assembly 2.

In this embodiment, the first support plate 22 is slidably connected to the sliding end 2552 of the third swing arm 255 and rotatably connected to the third fixing bracket 251. The sliding end 2552 of the third swing arm 255 and the third fixing bracket 251 jointly limit a movement track of the first support plate 22. The second support plate 23 is slidably connected to the sliding end 2562 of the fourth swing arm 256 and rotatably connected to the fourth fixing bracket 252. The sliding end 2562 of the fourth swing arm 256 and the fourth fixing bracket 252 jointly limit a movement track of the second support plate 23. In a process of unfolding or folding the hinge assembly 2, the first support plate 22 is moved with the sliding end 2552 of the third swing arm 255 and the third fixing bracket 251 relative to the shaft 21, the first support plate 22 is further moved relative to the sliding end 2552 of the third swing arm 255 and the third fixing bracket 251, the second support plate 23 is moved with the sliding end 2562 of the fourth swing arm 256 and the fourth fixing bracket 252 relative to the shaft 21, and the second support plate 23 is further moved relative to the sliding end 2562 of the fourth swing arm 256 and the fourth fixing bracket 252.

In an open state, as shown in FIG. 44A, FIG. 45A, and FIG. 46A, the fifth arc-shaped arm 2253 of the first support plate 22 is partially rotated out of the fifth arc-shaped slot 2513 of the third fixing bracket 251. The first fan-shaped arm 2262 is partially rotated out of the first fan-shaped slot 2514. A gap is formed between the third fitting surface 2517 of the third fixing bracket 251 and the first support plate 22. The middle rotating shaft 2475 is slid to the distal end of the third guide chute 2273 of the first support plate 22. A gap is formed between the connection section 2553 of the third swing arm 255 and the first support plate 22. The first support plate 22 is flattened relative to the shaft 21. The seventh arc-shaped arm 2353 of the second support plate 23 is partially rotated out of the seventh arc-shaped slot 2523 of the fourth fixing bracket 252. The second fan-shaped arm 2362 is partially rotated out of the second fan-shaped slot 2524. A gap is formed between the fourth fitting surface 2527 of the fourth fixing bracket 252 and the second support plate 23. The middle rotating shaft 2476 is slid to the distal end of the fourth guide chute 2373 of the second support plate 23. A gap is formed between the connection section 2563 of the fourth swing arm 256 and the second support plate 23. The second support plate 23 is flattened relative to the shaft 21.

In the closed state, as shown in FIG. 44B, FIG. 45B, and FIG. 46B, the fifth arc-shaped arm 2253 of the first support plate 22 is rotated into the fifth arc-shaped slot 2513 of the third fixing bracket 251. The first fan-shaped arm 2262 is rotated into the first fan-shaped slot 2514. The third fitting surface 2517 of the third fixing bracket 251 is close to the first support plate 22. The middle rotating shaft 2475 is slid to the proximal end of the third guide chute 2273 of the first support plate 22. The connection section 2553 of the third swing arm 255 is close to the first support plate 22. The first support plate 22 is bent relative to the shaft 21. The seventh arc-shaped arm 2353 of the second support plate 23 is rotated into the seventh arc-shaped slot 2523 of the fourth fixing bracket 252. The second fan-shaped arm 2362 is rotated into the second fan-shaped slot 2524. The fourth fitting surface 2527 of the fourth fixing bracket 252 is close to the second support plate 23. The middle rotating shaft 2476 is slid to the proximal end of the fourth guide chute 2373 of the second support plate 23. The connection section 2563 of the fourth swing arm 256 is close to the second support plate 23. The second support plate 23 is bent relative to the shaft 21.

The fifth arc-shaped arm 2253 and the first fan-shaped arm 2262 are located on one side that is of the first support plate plate 221 and that is away from the shaft 21. The seventh arc-shaped arm 2353 and the second fan-shaped arm 2362 are located on one side that is of the second support plate plate 231 and that is away from the shaft 21. The proximal end of the third guide chute 2273 is located at the middle part of the first support plate plate 221 or on one side that is of the first support plate plate 221 and that is close to the shaft 21. The proximal end of the fourth guide chute 2373 is located at the middle part of the second support plate plate 231 or on one side that is of the second support plate plate 231 and that is close to the shaft 21. A third spacing is formed between rotation centers of the fifth arc-shaped slot 2513 and the first fan-shaped slot 2514 of the third fixing bracket 251 and rotation centers of the seventh arc-shaped slot 2523 and the second fan-shaped slot 2524 of the fourth fixing bracket 252. A fourth spacing is formed between the middle rotating shaft 2475 and the middle rotating shaft 2476. In the closed state, the third spacing is less than the fourth spacing. Therefore, a spacing between the side that is of the first support plate plate 221 and that is away from the shaft 21 and the side that is of the second support plate plate 231 and that is away from the shaft 21 is less than a spacing between the side that is of the first support plate plate 221 and that is close to the shaft 21 and the side that is of the second support plate plate 231 and that is close to the shaft 21. In other words, the first support plate plate 221 and the second support plate plate 231 are away from each other in the direction close to the shaft 21. Therefore, the first support plate 22 and the second support plate 23 are away from each other in the direction close to the shaft 21.

In the closed state, the first support plate 22, the shaft 21, and the second support plate 23 of the hinge assembly 2 jointly enclose the similarly water drop-shaped screen accommodation space 210. In addition, at some positions of the hinge assembly 2, mechanical members of the plurality of connection assemblies (24, 25, and 26) of the hinge assembly 2 may further cooperate with the first support plate 22, the shaft 21, and the second support plate 23, to jointly encircle the more complete water drop-shaped screen accommodation space 210. As shown in FIG. 46B, the support surface 2230 of the first support plate 22, the upper surface of the connection section 2553 of the third swing arm 255, the support surface 2111 of the shaft 21, the upper surface of the connection section 2563 of the fourth swing arm 256, and the support surface 2330 of the second support plate 23 jointly surround the water drop-shaped screen accommodation space 210.

As shown in FIG. 46B, the two extension blocks 25531 (also refer to FIG. 31) on the connection section 2553 of the third swing arm 255 can be further configured to extend the upper surface of the connection section 2553 of the third swing arm 255, to increase a support function of the third swing arm 255 for another structure. The two extension blocks 25631 (also refer to FIG. 32) on the connection section 2563 of the fourth swing arm 256 can be further configured to extend the upper surface of the connection section 2563 of the fourth swing arm 256, to increase a support function of the fourth swing arm 256 for another structure.

In this application, a rotation center of the first support plate 22 relative to the third fixing bracket 251 coincides with a rotation center of the first support plate 22 relative to the first fixing bracket 241. A rotation center of the second support plate 23 relative to the fourth fixing bracket 252 coincides with a rotation center of the second support plate 23 relative to the second fixing bracket 242. The extension direction of the third guide chute 2273 of the third guide block 227 is the same as the extension direction of the first guide chute 2243 of the first guide block 224. The extension direction of the fourth guide chute 2373 of the fourth guide block 237 is the same as the extension direction of the second guide chute 2343 of the second guide block 234, so that actions of the first support plate 22 and the second support plate 23 relative to the bottom connection assembly 24 and the middle connection assembly 25 are coordinated and stable, to improve reliability of the hinge assembly 2.

In this application, for a connection structure between the first support plate 22, the second support plate 23, and the top connection assembly 26, refer to the connection structure between the first support plate 22, the second support plate 23, and the bottom connection assembly 24. For example, in the top connection structure (228, 229, and 2210) of the first support plate 22, the rotating blocks (228 and 229) are rotatably connected to the fifth fixing bracket 261, and the fifth guide block 2210 is slidably connected to the sliding end 2652 of the fifth swing arm 265. In the top connection structure (238, 239, and 2310) of the second support plate 23, the rotating blocks (238 and 239) are rotatably connected to the sixth fixing bracket 262, and the sixth guide block 2310 is slidably connected to the sliding end 2662 of the sixth swing arm 266. Details are not described herein again.

In this application, the first support plate 22 and the second support plate 23 are moved with a main movement mechanism of the hinge assembly 2, and are accurate in movement track. Therefore, the first support plate 22 and the second support plate 23 can implement automatic avoidance in a closed state, to form the water drop-shaped screen accommodation space 210. The screen accommodation space 210 is used to accommodate the screen 200, so that a folding action of the hinge assembly 2 on the screen 200 is stable, and is small in squeezing force. This helps reduce a risk that the screen 200 is damaged due to excessive squeezing by the hinge assembly 2, so that reliability of the screen 200 and the electronic device 1000 is high.

In this application, structures, sizes, and a relative position relationship of various components of the main movement mechanism, the first support plate 22, and the second support plate 23 may be designed based on a track form required by the screen 200 to perform folding movement and unfolding movement, including but not limited to a radius and a circle center position of an arc-shaped slot, a position and an extension direction of a rotating shaft hole, and an extension direction and a position of a sliding slot of each fixing bracket, structures of two ends, a rotation center position, and a structure of a connection section of each connection arm, a structure and a rotation center position of a rotating end, a structure and a sliding direction of a sliding end, structures and positions of a rotating shaft hole and an avoidance region of the sliding end, and a structure of a connection section of each swing arm, a structure of each damping assembly, an installation position of each of the foregoing components relative to the shaft 21, a radius and a circle center position of an arc-shaped arm or a fan-shaped arm of each rotating block and an extension direction of a guide chute of each guide block of the first support plate 22 and the second support plate 23, and the like. In this way, in a process of unfolding or folding the electronic device 1000, a motion track of each component of the hinge assembly 2 is high in control precision and small in return difference, to reduce a risk of pulling or squeezing the screen 200, avoid an occurrence of a problem of excessive stress in a local region of the screen 200, effectively improve stress distribution of the screen 200, and help improve reliability of the screen 200.

The following describes a structure of the back cover 5 and a connection structure between the back cover 5 and the hinge assembly 2 with reference to the accompanying drawings.

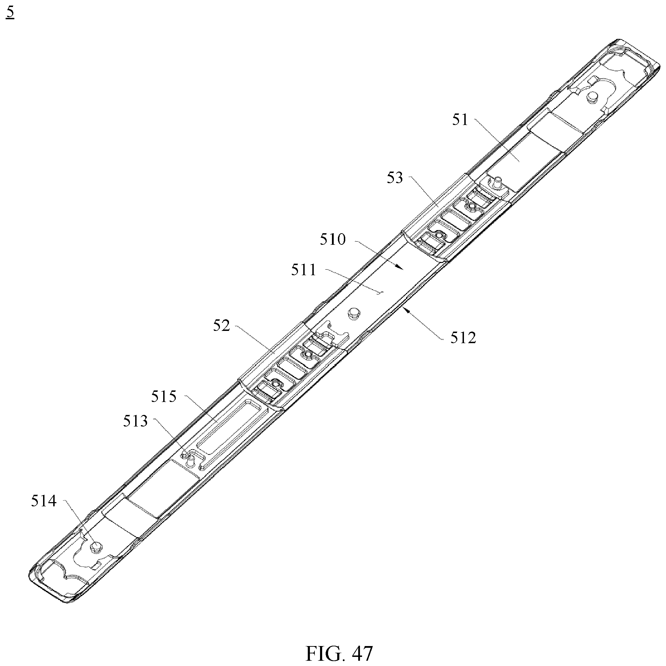

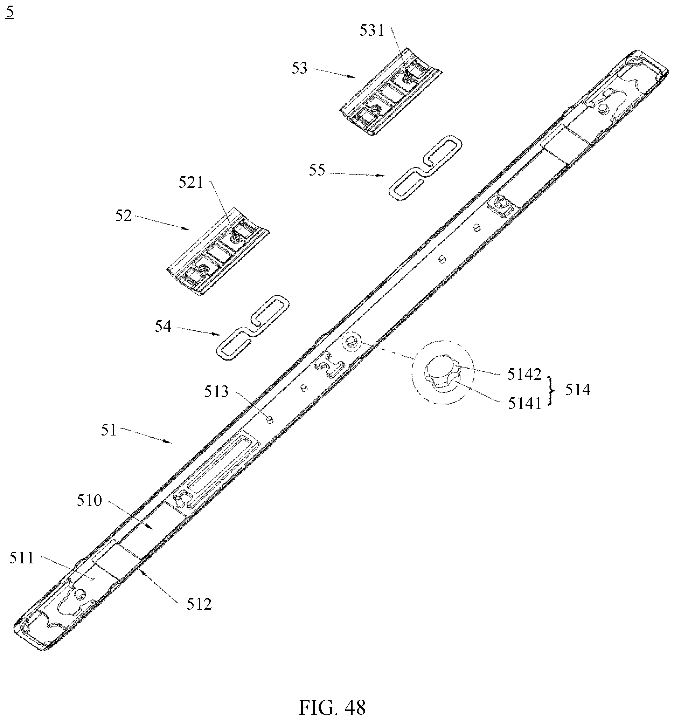

Refer to FIG. 47 and FIG. 48. FIG. 47 is a schematic diagram of a structure of the back cover 5 shown in FIG. 2 from another perspective. FIG. 48 is a schematic diagram of a decomposition structure of the back cover 5 shown in FIG. 47.

In some embodiments, the back cover 5 includes a main cover body 51, a first protection cover 52, a second protection cover 53, a first bonding member 54, and a second bonding member 55.

For example, the main cover body 51 may be approximately a casing body structure whose middle part is concave and two sides are tilted. An upper surface 511 of the main cover body 51 is recessed to form accommodation space 510, and a lower surface of the main cover body 51 forms an appearance surface 512 of the back cover 5. In other words, the appearance surface 512 of the back cover 5 is disposed backing onto the accommodation space 510. The main cover body 51 may include a plurality of positioning pins 513, a plurality of fixing pins 514, and a plurality of stiffening ribs 515 that are located in the accommodation space 510. For example, the plurality of positioning pins 513 are erected on the upper surface 511 of the main cover body 51. The fixing pin 514 may be formed into an inverted fastening structure. For example, the fixing pin 514 may include a pin body 5141 and a flange 5142. The pin body 5141 is erected on the upper surface 511 of the main cover body 51. The flange 5142 is connected to one end that is of the pin body 5141 and that is away from the upper surface 511 of the main cover body 51, and the flange 5142 is disposed around a periphery of the pin body 5141, that is, the pin body 5141 is located on an inner side the flange 5142. The flange 5142 may be a continuous annular flange, or may include a plurality of protrusion blocks. The plurality of protrusion blocks are arranged in a ring shape. The plurality of stiffening ribs 515 are convexly disposed on the upper surface 511 of the main cover body 51, and are configured to increase structural strength of the main cover body 51. The main cover body 51 may be formed into an integrated mechanical member by using a metal injection molding technology, to obtain high structural strength.

For example, the first protection cover 52 may be approximately a casing body structure whose middle part is concave and two sides are tilted. The first protection cover 52 may be provided with at least one positioning hole 521. The first protection cover 52 may be installed in the accommodation space 510 of the main cover body 51. At least one positioning pin 513 is inserted into the at least one positioning hole 521 of the first protection cover 52. The first bonding member 54 is located between the first protection cover 52 and the upper surface 511 of the main cover body 51, to bond and fasten the first protection cover 52 and the main cover body 51. The first bonding member 54 may be an adhesive layer, for example, glue or a double-sided tape. The first bonding member 54 may be in a plurality of shapes. A type, the shape, and the like of the first bonding member 54 are not strictly limited in this application. The first protection cover 52 may be made of a non-metal material, for example, a plastic material or a rubber material. In some embodiments, the material of the first protection cover 52 may further have insulation performance.

For example, the second protection cover 53 may be approximately a casing body structure whose middle part is concave and two sides are tilted. The second protection cover 53 may be provided with at least one positioning hole 531. The second protection cover 53 may be installed in the accommodation space 510 of the main cover body 51. At least one positioning pin 513 is inserted into the at least one positioning hole 531 of the second protection cover 53. The second bonding member 55 is located between the second protection cover 53 and the upper surface 511 of the main cover body 51, to bond and fasten the second protection cover 53 and the main cover body 51. The second bonding member 55 may be an adhesive layer, for example, glue or a double-sided tape. The first bonding member 54 may be in a plurality of shapes. A type, the shape, and the like of the first bonding member 54 are not strictly limited in this application. The second protection cover 53 may be made of a non-metal material, for example, a plastic material or a rubber material. In some embodiments, the material of the second protection cover 53 may further have insulation performance.

In some other embodiments, the first fixing cover 52 and the second fixing cover 53 may be alternatively fixedly connected to the main cover body 51 in another connection manner, for example, fastening, clamping, or welding. In this case, the back cover 5 may be provided with no first bonding member 54 and second bonding member 55. In some other embodiments, the first fixing cover 52, the second fixing cover 53, and the main cover body 51 may be alternatively an integrated mechanical member. Specific structures and connection manners of the main cover body 51, the first fixing cover 52, and the second fixing cover 53 are not strictly limited in this application.

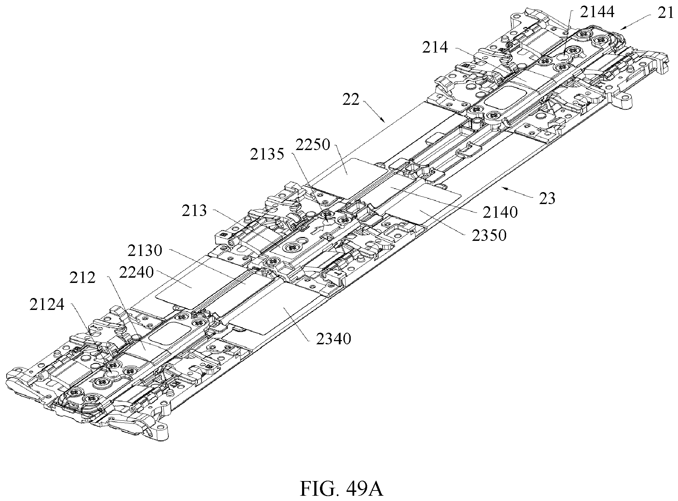

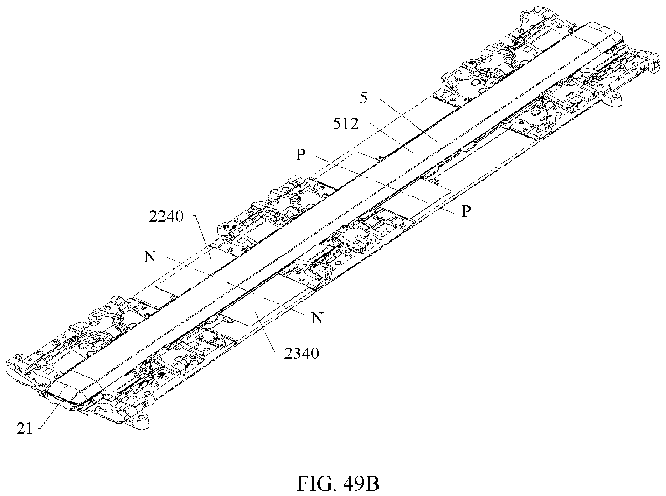

Refer to FIG. 49A and FIG. 49B. FIG. 49A is a schematic diagram of a structure of the hinge assembly 2 shown in FIG. 5A from another perspective. FIG. 49B is a schematic diagram of a structure obtained after the hinge assembly 2 and the back cover 5 that are shown in FIG. 2 are assembled.

In some embodiments, the bottom casing body 212, the middle casing body 213, and the top casing body 214 of the shaft 21 of the hinge assembly 2 are provided with the fixing holes (2124, 2135, and 2144). The plurality of fixing pins 514 on the main cover body 51 of the back cover 5 may be inserted into the fixing holes (2124, 2135, and 2144) of the shaft 21, to be fixedly connected to the shaft 21. In this embodiment, the back cover 5 may cover and protect the shaft 21. The appearance surface 512 of the back cover 5 is exposed. When the fixing pins 514 use the inverted fastening structure, the fixing pin 514 may be inverted-fastened into the fixing holes (2124, 2135, and 2144), to be fixedly connected to the shaft 21.

Certainly, in some other embodiments, the back cover 5 may be alternatively fastened to the shaft 21 through bonding or in another connection manner. In this case, the plurality of casing bodies (212, 213, and 214) of the shaft 21 may be provided with no fixing holes (2124, 2135, and 2144), and the back cover 5 may be provided with no fixing pin 514. A specific connection structure and connection manner between the back cover 5 and the shaft 21 are not strictly limited in this application.

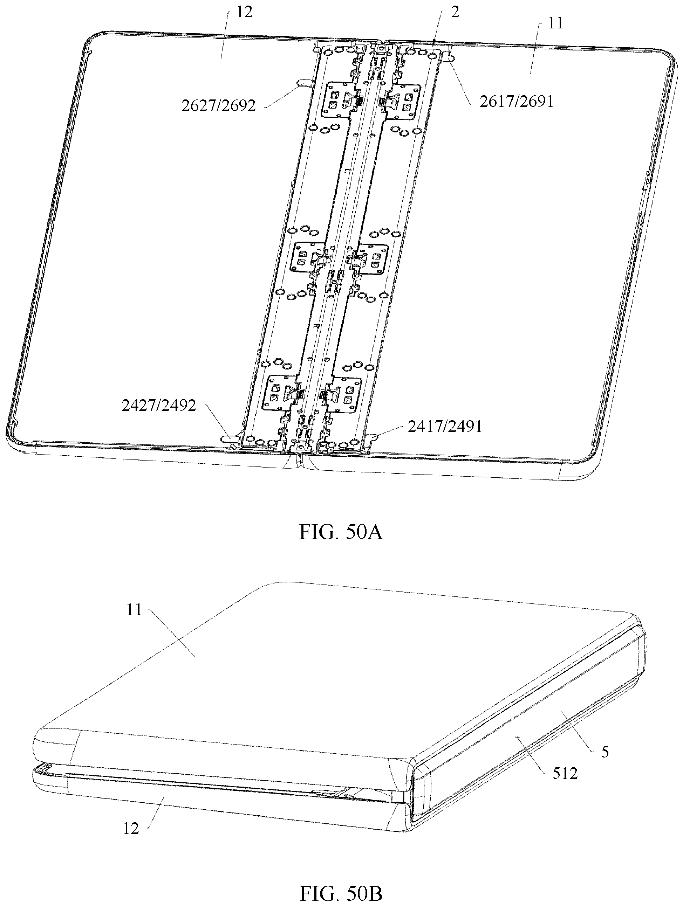

Refer to FIG. 50A and FIG. 50B. FIG. 50A is a schematic diagram of a structure obtained after the first housing 11, the second housing 12, the hinge assembly 2, and the back cover 5 that are shown in FIG. 2 are assembled. FIG. 50B is a schematic diagram of the structure shown in FIG. 50A in a closed state.

In an assembly process of the electronic device 1000, the back cover 5 may be first fastened to the hinge assembly 2, and then two sides of the hinge assembly 2 are respectively fixedly connected to the first housing 11 and the second housing 12. Refer to FIG. 2 and FIG. 6. The first fixing bracket 241, the third fixing bracket 251, and the fifth fixing bracket 261 of the hinge assembly 2 are fixedly connected to the first housing 11, and a fixing manner may be implemented by using a fastener connection or in another manner. The second fixing bracket 242, the fourth fixing bracket 252, and the sixth fixing bracket 262 of the hinge assembly 2 may be fixedly connected to the second housing 12, and a fixing manner may be implemented by using a fastener connection or in another manner. As shown in FIG. 50A and FIG. 50B, the first housing 11 and the second housing 12 may be relatively unfolded and folded by using movement of the hinge assembly 2, to switch between an open state and a closed state.

The first retaining block 2417 and the third retaining block 2617 of the hinge assembly 2 may be clamped (or embedded) into the first housing 11, so that a connection relationship between the hinge assembly 2 and the first housing 11 is more stable. The second retaining block 2427 and the fourth retaining block 2627 of the hinge assembly 2 may be clamped (or embedded) into the second housing 12, so that a connection relationship between the hinge assembly 2 and the second housing 12 is more stable. The plurality of blocking gaskets (2491, 2691, 2492, and 2692) on the hinge assembly 2 block the fastening holes on the plurality of retaining blocks (2417, 2617, 2427, and 2627), so that the plurality of retaining blocks (2417, 2617, 2427, and 2627) can jointly support the screen 200 with the first housing 11 and the second housing 12, to provide a better supporting environment for the screen 200.

In some embodiments, with reference to FIG. 50A and FIG. 50B, when the electronic device 1000 is in an open state, the first housing 11 and the second housing 12 block the back cover 5, that is, the back cover 5 is located inside the electronic device 1000. When the electronic device 1000 is in a closed state, the back cover 5 is exposed relative to the first housing 11 and the second housing 12, and the appearance surface 512 of the back cover 5 is exposed.

In this embodiment, when the electronic device 1000 is in the open state, the first housing 11 and the second housing 12 can block an internal structure, for example, the hinge assembly 2, from a place below the electronic device 1000. When the electronic device 1000 is in the closed state, the first housing 11, the second housing 12, and the back cover 5 are exterior members of the electronic device 1000, and can jointly block an internal structure, for example, the hinge assembly 2. Therefore, the electronic device 1000 can implement self-blocking, and the electronic device 1000 is better in appearance experience and better in waterproof performance and dust-proof performance.

For example, the appearance surface 512 of the back cover 5 may include a first cambered surface part, a planar part, and a second cambered surface part. The first cambered surface part and the second cambered surface part are respectively connected to two sides of the planar part. In some other embodiments, the appearance surface 512 of the back cover 5 may be alternatively a cambered surface or another smooth curved surface.

In this embodiment, the appearance surface 512 of the back cover 5 is formed in a cambered surface-similar or cambered surface shape, to help improve appearance experience and holding experience of the electronic device 1000 in the closed state. In addition, when the middle part of the appearance surface 512 of the back cover 5 is the planar part, a thickness (a size in a direction perpendicular to the planar part) of the back cover 5 can be smaller, and the electronic device 1000 has a smaller overall thickness in the open state and a smaller overall width in the closed state. This facilitates miniaturization, lightening, and thinning of the electronic device 1000.

In some embodiments, as shown in FIG. 49A, the first insulation Mylar 2240 of the first support plate 22 and the third insulation Mylar 2340 of the second support plate 23 are separately located on two sides of the first gasket 2130 of the shaft 21. The second insulation Mylar 2250 of the first support plate 22 and the fourth insulation Mylar 2350 of the second support plate 23 are separately located on two sides of the second gasket 2140 of the shaft 21.

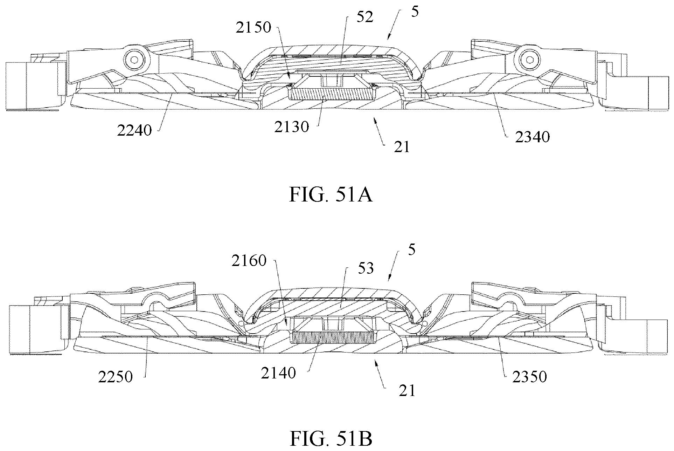

Refer to FIG. 49B and FIG. 51A. FIG. 51A is a schematic diagram of a cross-sectional structure of the structure that is cut along a cross section N-N and that is shown in FIG. 49B. In some embodiments, the first protection cover 52 of the back cover 5 is disposed facing the first gasket 2130 of the shaft 21. A first cabling gap 2150 is formed between the first protection cover 52 and the shaft 21. One flexible circuit board of the electronic device 1000 may span the shaft 21 through the first cabling gap 2150, to extend from the first housing 11 to the second housing 12, so as to implement an electrical connection function.

In this embodiment, the first protection cover 52 may be configured to press a flexible circuit board, and is unlikely to scratch the flexible circuit board, so that the flexible circuit board has a long service life, and reliability of an electrical connection of the electronic device 1000 is high.

Refer to FIG. 49B and FIG. 51B. FIG. 51B is a schematic diagram of a cross-sectional structure of the structure that is cut along a cross section P-P and that is shown in FIG. 49B.

In some embodiments, the second protection cover 53 of the back cover 5 is disposed facing the second gasket 2140 of the shaft 21. A second cabling gap 2160 is formed between the second protection cover 53 and the shaft 21. Another flexible circuit board of the electronic device 1000 may span the shaft 21 through the second cabling gap 2160, to extend from the first housing 11 to the second housing 12, so as to implement an electrical connection function.

In this embodiment, the second protection cover 53 may be configured to press a flexible circuit board, and is unlikely to scratch the flexible circuit board, so that the flexible circuit board has a long service life, and reliability of an electrical connection of the electronic device 1000 is high.

In this application, to meet a movement requirement of a mechanism, the hinge assembly 2 usually has to be provided with some avoiding hole structures on the first support plate 22, the second support plate 23, and the shaft 21. The hole structure may include but is not limited to an avoidance hole, an avoidance slot, an avoidance notch, or the like. When an opening area of the hole structure is large, flatness of a support surface of the hinge assembly 2 is limited, and flatness and an appearance effect of the screen 200 located above the hinge assembly 2 are likely to be affected. In addition, in a use process, the screen 200 is prone to be squeezed by the outside, and a position corresponding to the hole structure is recessed. As a result, the screen 200 fails, and a service life of the electronic device 1000 is shortened.

Refer to FIG. 2. In this application, the rotating shaft connection assembly 3 is disposed, so that the rotating shaft connection assembly 3 is fastened above the hinge assembly 2, and is configured to cover at least some hole structures on the support surface of the hinge assembly 2. The hinge assembly 2 and the rotating shaft connection assembly 3 are configured to jointly provide a better supporting environment with high flatness for the screen 200, to improve flatness and an appearance effect of the screen 200. In addition, the hinge assembly 2 and the rotating shaft connection assembly 3 can also provide more complete and powerful support for the screen 200, to improve reliability of the screen 200.

The following describes a structure of the rotating shaft connection assembly 3 and a connection relationship between the rotating shaft connection assembly 3, the hinge assembly 2, and the screen 200 with reference to the accompanying drawings.

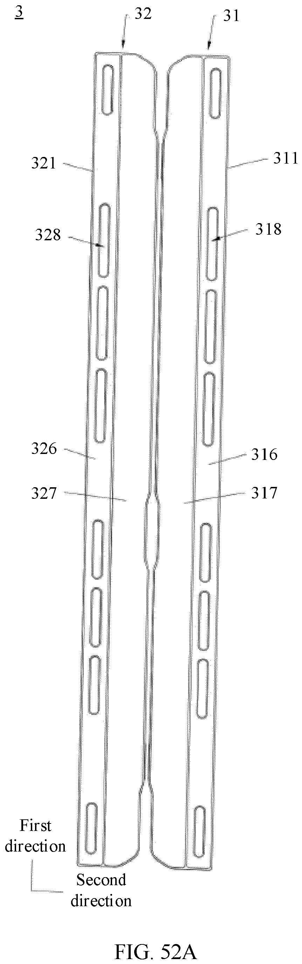

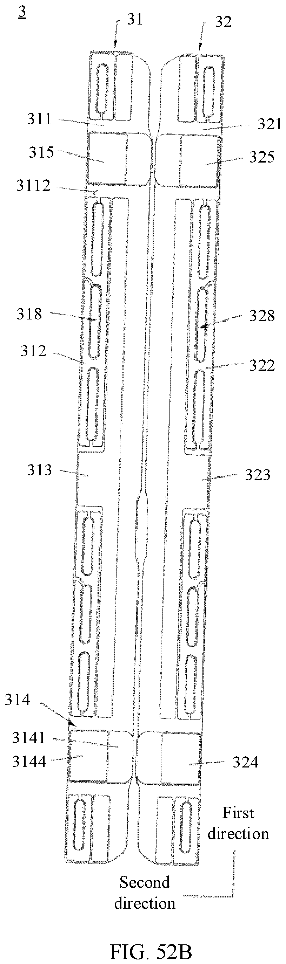

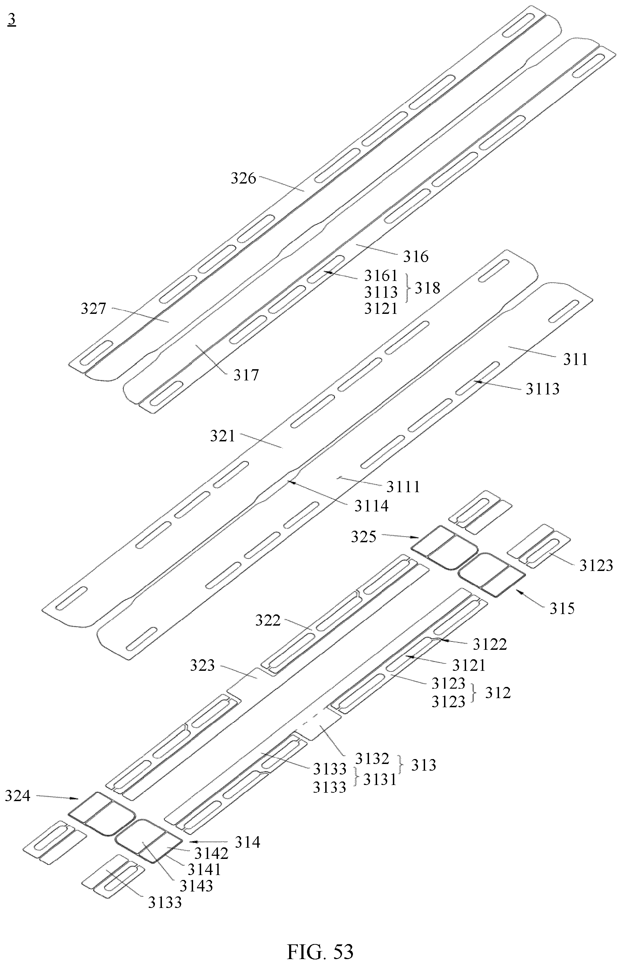

Refer to FIG. 52A, FIG. 52B, and FIG. 53. FIG. 52A is a schematic diagram of a structure of the rotating shaft connection assembly 3 shown in FIG. 2 from another perspective. FIG. 52B is a schematic diagram of a structure of the rotating shaft connection assembly 3 shown in FIG. 52A from another perspective. FIG. 53 is a schematic diagram of a decomposition structure of the rotating shaft connection assembly 3 shown in FIG. 52A.

In some embodiments, the rotating shaft connection assembly 3 includes a first connector 31 and a second connector 32. The first connector 31 and the second connector 32 are mechanical members independent of each other. The first connector 31 may be approximately strip-shaped, and the second connector 32 may be approximately strip-shaped. In this embodiment, an extension direction of the first connector 31 is defined as a first direction. The first connector 31 and the second connector 32 are arranged in a second direction. The second direction is perpendicular to the first direction. A thickness direction of the rotating shaft connection assembly 3 is perpendicular to the first direction and the second direction.

For example, the first connector 31 includes a first substrate layer 311, a first bonding layer 312, a first insulation layer 313, a first reinforcement layer 314, a second reinforcement layer 315, a second bonding layer 316, and a second insulation layer 317.

For example, the first substrate layer 311 may be approximately strip-shaped, and the first substrate layer 311 extends in the first direction. The first substrate layer 311 includes an upper surface 3111 and a lower surface 3112 that are disposed backing onto each other. The first substrate layer 311 is provided with a plurality of glue dispensing holes 3113 arranged in the first direction. The plurality of glue dispensing holes 3113 penetrate the first substrate layer 311. The glue dispensing hole 3113 may be in an elongated shape, a circular shape, a square shape, or another shape. A plurality of avoidance notches 3114 that are spaced apart from each other may be further disposed on one side that is of the first substrate layer 311 and that is close to the second connector 32, and are configured to avoid another structure. The first substrate layer 311 may be made of a material that has specific strength and hardness and that can be bent under an action of external force. For example, the first substrate layer 311 may be a steel sheet, and may have a thickness of approximately 0.03 mm. Certainly, when a support performance requirement is met, the first substrate layer 311 may be alternatively a metal sheet, for example, an aluminum sheet or a stainless steel sheet, or a non-metal sheet, and the first substrate layer 311 may alternatively have another thickness. This is not strictly limited in this application.

The first bonding layer 312 is fastened to the lower surface 3112 of the first substrate layer 311. For example, the entire first bonding layer 312 may be approximately strip-shaped, and extends in the first direction. The first bonding layer 312 is provided with a plurality of glue dispensing holes 3121 arranged in the first direction. The plurality of glue dispensing holes 3121 penetrate the first bonding layer 312. Projections of the plurality of glue dispensing holes 3121 on the lower surface 3112 of the first substrate layer 311 cover the plurality of glue dispensing holes 3113 of the first substrate layer 311 in a one-to-one correspondence. The first bonding layer 312 is further provided with a plurality of notches 3122. The plurality of notches 3122 are disposed in a one-to-one correspondence with the plurality of glue dispensing holes 3121. One end of the notch 3122 is connected to the corresponding glue dispensing hole 3121, and the other end of the notch 3122 is connected to space on an outer side of the first bonding layer 312. The first bonding layer 312 may be divided into a plurality of bonding sections 3123 spaced apart from each other. The first bonding layer 312 may be a back adhesive, and may have a thickness of approximately 0.1 mm. Certainly, the first bonding layer 312 may be alternatively made of a bonding material, for example, a hot melt adhesive film or glue, and the first bonding layer 312 may alternatively have another thickness. This is not strictly limited in this application.

The first insulation layer 313 is fastened to the lower surface 3112 of the first substrate layer 311 and arranged in a staggered manner with the first bonding layer 312. In this application, an insulation layer may be also referred to as an insulation Mylar. For example, the first insulation layer 313 may be approximately in a "T" shape, and includes a long edge 3131 extending in the first direction and a short edge 3132 extending in the second direction. One end of the short edge 3132 is connected to the middle part of the long edge 3131. The long edge 3131 of the first insulation layer 313 is located on one side that is of the first bonding layer 312 and that is close to the second connector 32. The short edge 3132 of the first insulation layer 313 is located between two adjacent bonding sections 3123 of the first bonding layer 312. The long edge 3131 of the first insulation layer 313 may be divided into a plurality of insulation sections 3133 spaced apart from each other. The first insulation layer 313 may be made of an insulation material, for example, a PET material or a polyetherimide (Polyetherimide, PEI) material, and may have a thickness of approximately 0.03 mm. A material and a thickness of the first insulation layer 313 are not strictly limited in this application.

The first reinforcement layer 314 is fastened to the lower surface 3112 of the first substrate layer 311 and arranged in a staggered manner with the first bonding layer 312 and the first insulation layer 313. The first reinforcement layer 314 is configured to increase strength and hardness of one part of a region of the first connector 31. For example, the first reinforcement layer 314 may be located between two adjacent bonding sections 3123 of the first bonding layer 312 and between two adjacent insulation sections 3133 of the first insulation layer 313. A thickness of the first reinforcement layer 314 may be approximately 0.09 mm. This is not strictly limited in this application.

The second reinforcement layer 315 is fastened to the lower surface 3112 of the first substrate layer 311 and arranged in a staggered manner with the first bonding layer 312, the first insulation layer 313, and the first reinforcement layer 314. The second reinforcement layer 315 is configured to increase strength and hardness of another part of the region of the first connector 31. For example, the first reinforcement layer 314 may be located between two adjacent bonding sections 3123 of the first bonding layer 312 and between two adjacent insulation sections 3133 of the first insulation layer 313. For a structural design and a size design of the second reinforcement layer 315, refer to those of the first reinforcement layer 314.

The second bonding layer 316 is fastened to the upper surface 3111 of the first substrate layer 311. For example, the entire second bonding layer 316 may be approximately strip-shaped, and extends in the first direction. The second bonding layer 316 is provided with a plurality of glue dispensing holes 3161 arranged in the first direction. The plurality of glue dispensing holes 3161 penetrate the second bonding layer 316. Projections of the plurality of glue dispensing holes 3161 on the upper surface 3111 of the first substrate layer 311 cover the plurality of glue dispensing holes 3113 of the first substrate layer 311 in a one-to-one correspondence. A corresponding glue dispensing hole 3161 of the second bonding layer 316, a corresponding glue dispensing hole 3113 of the first substrate layer 311, and a corresponding glue dispensing hole 3121 of the first bonding layer 312 jointly form a glue dispensing hole 318 of the first connector 31. The second bonding layer 316 may be a back adhesive, and may have a thickness of approximately 0.05 mm. Certainly, the second bonding layer 316 may be alternatively made of a bonding material, for example, a hot melt adhesive film or glue, and the second bonding layer 316 may alternatively have another thickness. This is not strictly limited in this application.

The second insulation layer 317 is fastened to the upper surface 3111 of the first substrate layer 311 and arranged in a staggered manner with the second bonding layer 316. For example, the second insulation layer 317 may be approximately strip-shaped, and extends in the first direction. The second insulation layer 317 is located on one side that is of the second bonding layer 316 and that is close to the second connector 32. The second insulation layer 317 may be made of an insulation material, for example, a PET material or a PEI material, and may have a thickness of approximately 0.01 mm. A material and a thickness of the second insulation layer 317 are not strictly limited in this application.

For example, the second connector 32 includes a second substrate layer 321, a third bonding layer 322, a third insulation layer 323, a third reinforcement layer 324, a fourth reinforcement layer 325, a fourth bonding layer 326, and a fourth insulation layer 327. The second connector 32 has a plurality of glue dispensing holes 328. The second connector 32 and the first connector 31 may be of a mirror-symmetrical structure. For a design of a structure of each layer of the second connector 32, refer to that of the first connector 31. Details are not described herein again.

In this embodiment, the substrate layers of the first connector 31 and the second connector 32 of the rotating shaft connection assembly 3 are made of a material that has specific strength and hardness and that can be bent under an action of external force. In addition, overall thicknesses of the first connector 31 and the second connector 32 are quite small. Therefore, the rotating shaft connection assembly 3 has better strength and hardness and is likely to be bent under an action of external force, to be better unfolded and folded with the hinge assembly 2. In addition, in a closed state, the rotating shaft connection assembly 3 cooperates with the hinge assembly to form the water drop-shaped screen accommodation space 210.

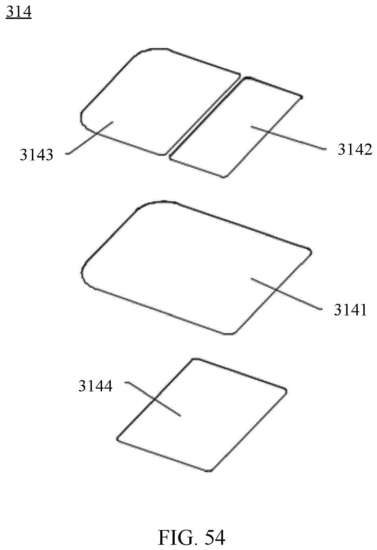

Refer to FIG. 52B, FIG. 53, and FIG. 54. FIG. 54 is a schematic diagram of a decomposition structure of the first reinforcement layer 314 shown in FIG. 53.

In some embodiments, the first reinforcement layer 314 includes a reinforcement substrate layer 3141, an intermediate bonding layer 3142, an intermediate insulation layer 3143, and a reinforcement insulation layer 3144. For example, the reinforcement substrate layer 3141 includes an upper surface and a lower surface that are disposed backing onto each other. The reinforcement substrate layer 3141 may be made of a material that has specific strength and hardness and that can be bent under an action of external force. For example, the reinforcement substrate layer 3141 may be a steel sheet, and may have a thickness of approximately 0.03 mm. Certainly, the reinforcement substrate layer 3141 may be alternatively a metal sheet, for example, an aluminum sheet or a stainless steel sheet, and the reinforcement substrate layer 3141 may alternatively have another thickness. This is not strictly limited in this application.

Surfaces on two sides of the intermediate bonding layer 3142 are respectively fastened to the lower surface 3112 of the first substrate layer 311 and the upper surface of the reinforcement substrate layer 3141. The intermediate bonding layer 3142 may be a hot melt adhesive film, and may have a thickness of approximately 0.05 mm. Certainly, the second bonding layer 316 may be alternatively made of a bonding material, for example, a back adhesive or glue, and the second bonding layer 316 may alternatively have another thickness. This is not strictly limited in this application.

The intermediate insulation layer 3143 is fastened to the upper surface of the reinforcement substrate layer 3141 and arranged in a staggered manner with the intermediate bonding layer 3142. The intermediate insulation layer 3143 may be located on one side that is of the intermediate bonding layer 3142 and that is close to the second connector 32. The intermediate insulation layer 3143 may be made of an insulation material, for example, a PET material or a PEI material, and may have a thickness of approximately 0.01 mm. A material and a thickness of the intermediate insulation layer 3143 are not strictly limited in this application.

The reinforcement insulation layer 3144 is fastened to the lower surface of the reinforcement substrate layer 3141. The reinforcement insulation layer 3144 may be made of an insulation material, for example, a PET material or a PEI material, and may have a thickness of approximately 0.01 mm. A material and a thickness of the reinforcement insulation layer 3144 are not strictly limited in this application.

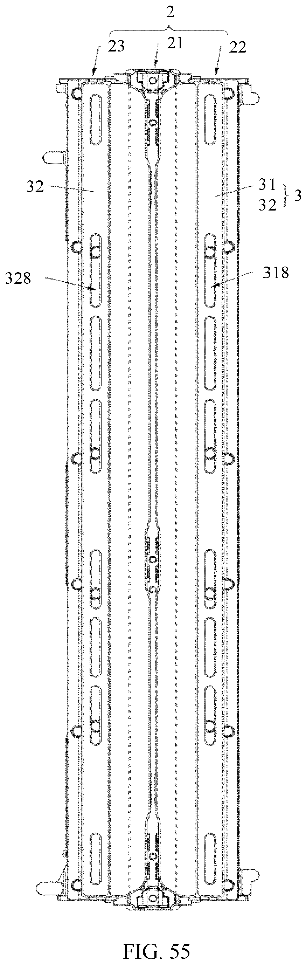

FIG. 55 is a schematic diagram of a structure obtained after the rotating shaft connection assembly 3 and the hinge assembly 2 that are shown in FIG. 2 are assembled.

In some embodiments, in an open state, the first connector 31 of the rotating shaft connection assembly 3 is located above the first support plate 22 and the shaft 21 of the hinge assembly 2, the second connector 32 is located above the second support plate 23 and the shaft 21, and a movable gap is formed between the second connector 32 and the first connector 31. In this case, the first connector 31 can cover a gap between the first support plate 22 and the shaft 21 and the hole structure on the first support plate 22, and the second connector 32 can cover a gap between the second support plate 23 and the shaft 21 and the hole structure on the second support plate 23, so that the rotating shaft connection assembly 3 and the hinge assembly 2 can jointly provide a flat and reliable supporting environment for the screen 200. The first direction of the rotating shaft connection assembly 3 may be parallel to the extension direction of the shaft 21.

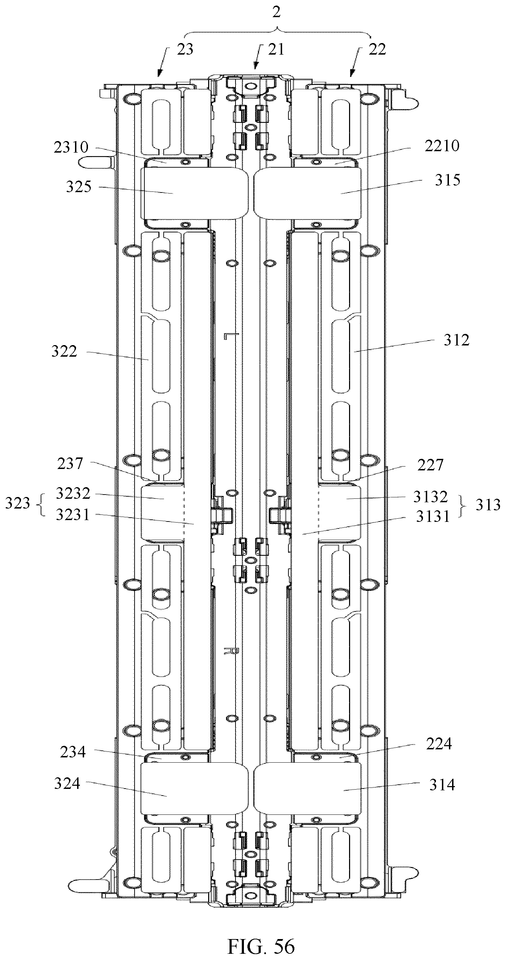

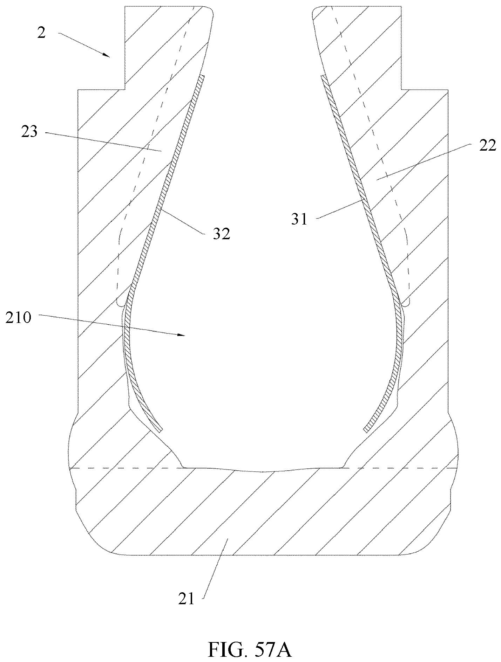

Refer to FIG. 55, FIG. 56, and FIG. 57A. FIG. 56 is a schematic diagram of a partial structure of the assembled structure shown in FIG. 55. FIG. 57A is a schematic diagram of the structure shown in FIG. 55 in a closed state. Both structures of the hinge assembly 2 and the rotating shaft connection assembly 3 in FIG. 57A are briefly shown.

In some embodiments, the first bonding layer 312 of the first connector 31 is located above the first support plate 22 and fixedly connected to the first support plate 22. In addition, the first connector 31 and the first support plate 22 may be further reinforced through glue dispensing. Glue may be dispensed in the glue dispensing hole 318 of the first connector 31, and the dispensed glue (not shown in the figure) connects the first connector 31 and the first support plate 22, so that there is a double connection structure between the first connector 31 and the first support plate 22, and a connection structure between the first connector 31 and the first support plate 22 is firmer. The first bonding layer 312 and the dispensed glue may be further used to bond the screen 200.

The first insulation layer 313 is located above the first support plate 22 and has no direct fixed connection relationship with the first support plate 22. The first insulation layer 313 may be moved relative to the first support plate 22, to be in contact with the first support plate 22 or be separated from the first support plate 22. In this case, there is no direct fixed connection relationship between one side that is of the first support plate 22 and that is close to the second connector 32 and the shaft 21. The side that is of the first support plate 22 and that is close to the second connector 32 may be moved relative to the shaft 21, to be in contact the shaft 21 or be separated from the shaft 21. In other words, a distal end of the first connector 31 is fixedly connected to the first support plate 22, and a proximal end of the first connector 31 is moved relative to the first support plate 22 and the shaft 21.

For example, the third bonding layer 322 of the second connector 32 is located above the second support plate 23 and fixedly connected to the second support plate 23. In addition, the second connector 32 and the second support plate 23 may be further reinforced through glue dispensing. Glue may be dispensed in the glue dispensing hole 328 of the second connector 32, and the dispensed glue (not shown in the figure) connects the second connector 32 and the second support plate 23, so that there is a double connection structure between the second connector 32 and the second support plate 23, and a connection structure between the second connector 32 and the second support plate 23 is firmer. The second bonding layer 316 and the dispensed glue may be further used to bond the screen 200.

The third insulation layer 323 is located above the second support plate 23 and has no direct fixed connection relationship with the second support plate 23. The third insulation layer 323 may be moved relative to the second support plate 23, to be in contact with the second support plate 23 or be separated from the second support plate 23. In this case, there is no direct fixed connection relationship between one side that is of the second connector 32 and that is close to the first connector 31 and the shaft 21. The side that is of the second connector 32 and that is close to the first connector 31 may be moved relative to the shaft 21, to be in contact the shaft 21 or be separated from the shaft 21. In other words, a distal end of the second connector 32 is fixedly connected to the second support plate 23, and a proximal end of the second connector 32 is moved relative to the second support plate 23 and the shaft 21.

In this embodiment, fixed positions and movable positions of the first connector 31, the second connector 32, and the hinge assembly 2 are set, so that the first connector 31 and the second connector 32 can better deform with the hinge assembly 2, to better provide a supporting environment and accommodation space for the screen 200.

Specifically, in the open state, the first support plate 22, the shaft 21, and the second support plate 23 of the hinge assembly 2 are approximately flatted, and the first connector 31 and the second connector 32 are approximately flatted, to provide a flat supporting environment for the screen 200. In the closed state, the first support plate 22 is bent relative to the shaft 21, and the second support plate 23 is bent relative to the shaft 21. The first support plate 22, the second support plate 23, and the shaft 21 jointly form the water drop-shaped screen accommodation space 210. The distal end of the first connector 31 is moved with the first support plate 22. The distal end of the second connector 32 is moved with the second support plate 23. The proximal end of the first connector 31 and the proximal end of the second connector 32 are bent and close to each other under an action of stress. The first connector 31 and the second connector 32 jointly form similarly water drop-shaped inner side space, to provide appropriate accommodation space for the screen 200.

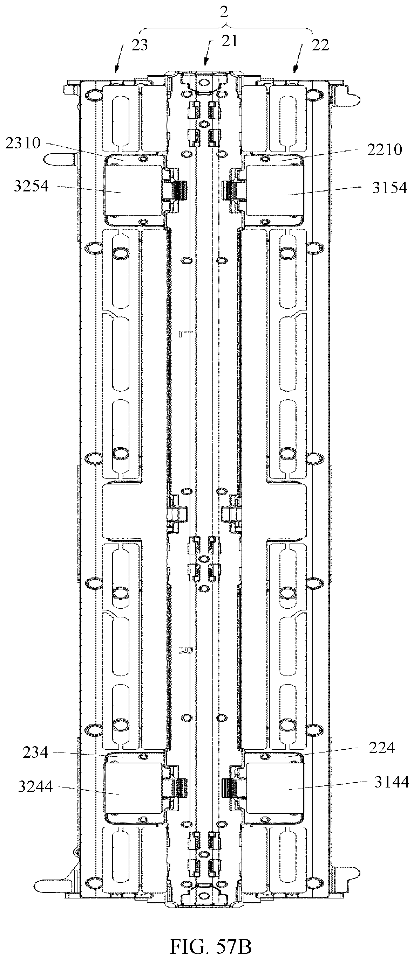

Refer to FIG. 56 and FIG. 57B. FIG. 57B is a schematic diagram of a partial structure of the structure shown in FIG. 56. For a structure of the first support plate 22, refer to FIG. 38A. For a structure of the second support plate 23, refer to FIG. 40A.

In some embodiments, the short edge 3132 of the first insulation layer 313 of the first connector 31 and a part of the long edge 3131 connected to the short edge 3132 may be located above the third guide block 227 of the first support plate 22, and are configured to cover the avoidance hole 2274 on the third guide block 227. The first reinforcement layer 314 may be located above the first guide block 224 of the first support plate 22 and the shaft 21, and is configured to block the avoidance hole 2244 on the first guide block 224 and a gap between the first guide block 224 and the shaft 21. The reinforcement insulation layer 3144 of the first reinforcement layer 314 may be located above the first guide block 224. The second reinforcement layer 315 may be located above the fifth guide block 2210 of the first support plate 22 and the shaft 21, and is configured to block an avoidance hole 22104 on the fifth guide block 2210 and a gap between the fifth guide block 2210 and the shaft 21. A reinforcement insulation layer 3154 of the second reinforcement layer 315 may be located above the fifth guide block 2210.

A short edge 3232 of the third insulation layer 323 of the second connector 32 and a part of a long edge 3231 connected to the short edge 3232 may be located above the fourth guide block 237 of the second support plate 23, and are configured to cover the avoidance hole 2374 on the fourth guide block 237. The third reinforcement layer 324 may be located above the second guide block 234 of the second support plate 23 and the shaft 21, and is configured to block the avoidance hole 2344 on the second guide block 234 and a gap between the second guide block 234 and the shaft 21. A reinforcement insulation layer 3244 of the third reinforcement layer 324 may be located above the second guide block 234. The fourth reinforcement layer 325 may be located above the sixth guide block 2310 of the second support plate 23 and the shaft 21, and is configured to block an avoidance hole 23104 on the sixth guide block 2310 and a gap between the sixth guide block 2310 and the shaft 21. A reinforcement insulation layer 3254 of the fourth reinforcement layer 325 may be located above the sixth guide block 2310.

In this embodiment, positions of the reinforcement layers (314 and 315) of the first connector 31 of the rotating shaft connection assembly 3 are designed based on a position of the hole structure on the support surface 2230 of the first support plate 22. Positions of the reinforcement layers (324 and 325) of the second connector 32 are designed based on a position of the hole structure on the support surface 2330 of the second support plate 23. In this way, the rotating shaft connection assembly 3 and the hinge assembly 2 can provide a more reliable supporting environment for the screen 200. In addition, the rotating shaft connection assembly 3 can also provide buffering and protection functions for the screen 200 when the electronic device 1000 falls or is impacted, to prevent a component of the hinge assembly 2 from damaging the screen when unexpected movement occurs, so as to improve reliability of the screen 200.

It may be understood that, in some other embodiments, if a structure of the first support plate 22 and a structure of the second support plate 23 change, the reinforcement layers (314 and 315) of the first connector 31 and the reinforcement layers (324 and 325) of the second connector 32 are adaptively adjusted.

In conclusion, in this application, the rotating shaft connection assembly 3 can support the screen 200, so that the screen 200 has high flatness and a better appearance. The rotating shaft connection assembly 3 can further cover most hole structures on the hinge assembly 2, to prevent the hinge assembly 2 from excessively squeezing the screen 200 in a movement process, and also prevent the hinge assembly 2 from accidentally damaging the screen 200 in a falling environment or when the hinge assembly 2 is impacted. Therefore, the rotating shaft connection assembly 3 helps improve squeezing-resistance and impact-resistance performance of the screen 200, improves a baseline at which the screen 200 fails due to squeezing, and improves reliability of the screen 200. In addition, the rotating shaft connection assembly 3 is further provided with a bonding region, a non-bonding region, and the gap between the two connectors (31 and 32), so that the rotating shaft connection assembly 3 can be dynamically bent, to meet movement form requirements of the hinge assembly 2 and the screen 200. The rotating shaft connection assembly 3 is moved with the screen 200 and does not push the screen.

In some other embodiments, the first connector 31 may be further located above the first housing 11 at the same time to cover a gap between the first housing 11 and the first support plate 22, and the second connector 32 may be further located above the second housing 12 at the same time to cover a gap between the second housing 12 and the second support plate 23, so that the rotating shaft connection assembly 3 can provide a flat supporting environment for the screen 200 with the first housing 11, the hinge assembly 2, and the second housing 12.

In this application, one implementation structure of the rotating shaft connection assembly 3 is shown in the foregoing embodiment. The following shows several variant implementation structures of the rotating shaft connection assembly 3 with reference to the accompanying drawings.

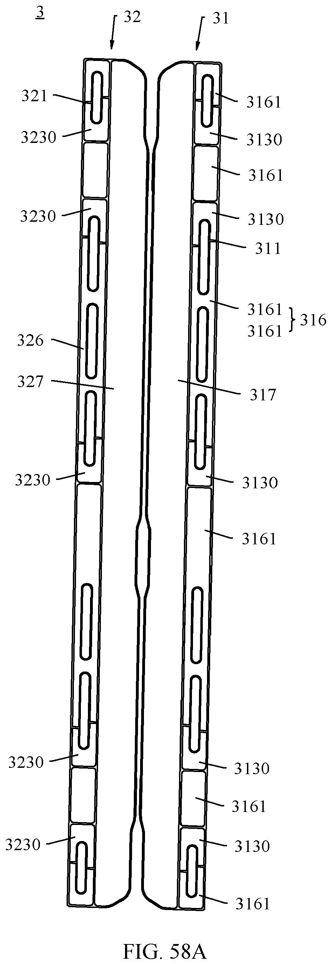

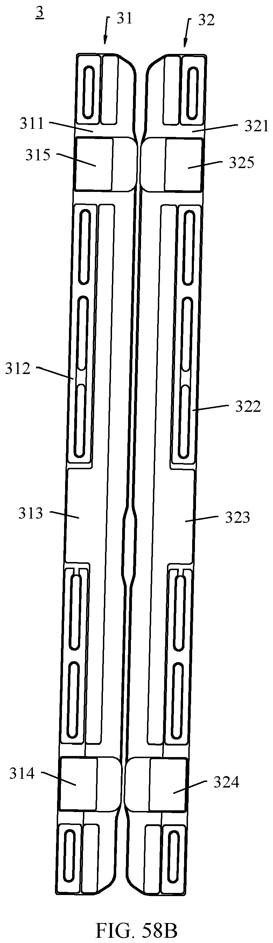

Refer to FIG. 58A and FIG. 58B. FIG. 58A is a schematic diagram of a structure of the rotating shaft connection assembly 3 shown in FIG. 2 in some other embodiments. FIG. 58B is a schematic diagram of a structure of the rotating shaft connection assembly 3 shown in FIG. 58A from another perspective. The rotating shaft connection assembly 3 in this embodiment may include most features of the rotating shaft connection assembly 3 in the foregoing embodiment. The following briefly describes the rotating shaft connection assembly 3 in this embodiment, and most same content is not described again.

In some embodiments, the rotating shaft connection assembly 3 includes a first connector 31 and a second connector 32. The first connector 31 and the second connector 32 are mechanical members independent of each other. The first connector 31 includes a first substrate layer 311, a first bonding layer 312, a first insulation layer 313, a first reinforcement layer 314, a second reinforcement layer 315, a second bonding layer 316, a second insulation layer 317, and a plurality of gasket layers 3130. The first substrate layer 311 may be made of a material that has specific strength and hardness and that can be bent under an action of external force. The first bonding layer 312, the first insulation layer 313, the first reinforcement layer 314, and the second reinforcement layer 315 are fastened to a lower surface of the first substrate layer 311. The first bonding layer 312 may be made of a bonding material, for example, a back adhesive, and may have a thickness of approximately 0.1 mm. The first insulation layer 313 may be made of an insulation material, for example, a PET material or a PEI material, and may have a thickness of approximately 0.03 mm. The first reinforcement layer 314 and the second reinforcement layer 315 are configured to increase strength and hardness of a part of a region of the first connector 31. Substrate layers of the first reinforcement layer 314 and the second reinforcement layer 315 may be made of a material that has specific strength and hardness and that can be bent under an action of external force. The second bonding layer 316 and the second insulation layer 317 are fastened to an upper surface of the first substrate layer 311. The second bonding layer 316 may be made of a bonding material, for example, a back adhesive, and may have a thickness of approximately 0.05 mm. The second bonding layer 316 includes a plurality of bonding sections 3161 disposed at intervals. The plurality of gasket layers 3230 are fastened to the upper surface of the first substrate layer 311. The plurality of gaskets 3230 and the plurality of bonding sections 3161 are alternately arranged, and an arrangement direction is parallel to an extension direction of the first connector 31. A thickness of the gasket 3230 is equal to a thickness of each of the plurality of bonding sections 3161. The plurality of gaskets 3230 have no bonding relationship with the screen 200, and are configured to optimize a light shadow problem of flatness of a display. The second insulation layer 317 may be made of an insulation material, for example, a PET material or a PEI material, and may have a thickness of approximately 0.01 mm.

The second connector 32 includes a second substrate layer 321, a third bonding layer 322, a third insulation layer 323, a third reinforcement layer 324, a fourth reinforcement layer 325, a fourth bonding layer 326, a fourth insulation layer 327, and a plurality of gasket 3230. The second connector 32 and the first connector 31 may be of a mirror-symmetrical structure. For a design of a structure of each layer of the second connector 32, refer to that of the first connector 31. Details are not described herein again.

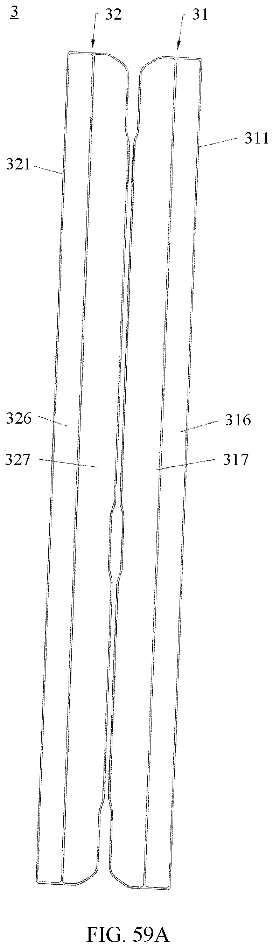

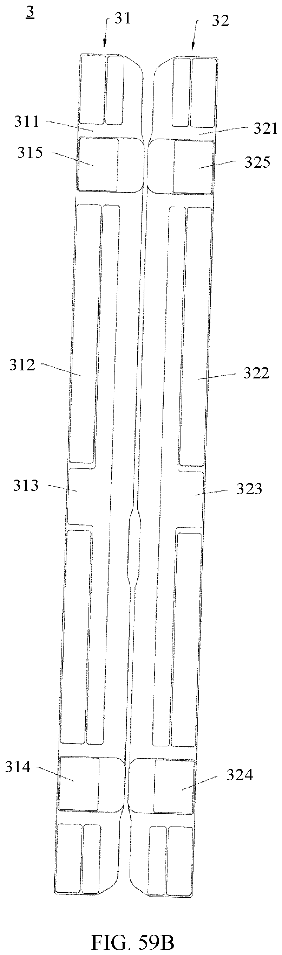

Refer to FIG. 59A and FIG. 59B. FIG. 59A is a schematic diagram of a structure of the rotating shaft connection assembly 3 shown in FIG. 2 in some other embodiments. FIG. 59B is a schematic diagram of a structure of the rotating shaft connection assembly 3 shown in FIG. 59A from another perspective. The rotating shaft connection assembly 3 in this embodiment may include most features of the rotating shaft connection assembly 3 in the foregoing embodiment. The following briefly describes the rotating shaft connection assembly 3 in this embodiment, and most same content is not described again.

In some embodiments, the rotating shaft connection assembly 3 includes a first connector 31 and a second connector 32. The first connector 31 and the second connector 32 are mechanical members independent of each other. The first connector 31 includes a first substrate layer 311, a first bonding layer 312, a first insulation layer 313, a first reinforcement layer 314, a second reinforcement layer 315, a second bonding layer 316, and a second insulation layer 317. The first substrate layer 311 may be made of a material that has specific strength and hardness and that can be bent under an action of external force. The first bonding layer 312, the first insulation layer 313, the first reinforcement layer 314, and the second reinforcement layer 315 are fastened to a lower surface of the first substrate layer 311. The first bonding layer 312 may be made of a bonding material, for example, a back adhesive, and may have a thickness of approximately 0.1 mm. The first insulation layer 313 may be made of an insulation material, for example, a PET material or a PEI material, and may have a thickness of approximately 0.03 mm. The first reinforcement layer 314 and the second reinforcement layer 315 are configured to increase strength and hardness of a part of a region of the first connector 31. Substrate layers of the first reinforcement layer 314 and the second reinforcement layer 315 may be made of a material that has specific strength and hardness and that can be bent under an action of external force. The second bonding layer 316 and the second insulation layer 317 are fastened to an upper surface of the first substrate layer 311. The second bonding layer 316 may be made of a bonding material, for example, a back adhesive, and may have a thickness of approximately 0.05 mm. The second insulation layer 317 may be made of an insulation material, for example, a PET material or a PEI material, and may have a thickness of approximately 0.01 mm. The second connector 32 includes a second substrate layer 321, a third bonding layer 322, a third insulation layer 323, a third reinforcement layer 324, a fourth reinforcement layer 325, a fourth bonding layer 326, and a fourth insulation layer 327. The second connector 32 and the first connector 31 may be of a mirror-symmetrical structure. For a design of a structure of each layer of the second connector 32, refer to that of the first connector 31. Details are not described herein again.

For a specific design (including a structure, a size, a material, and the like) of the rotating shaft connection assembly 3 in this embodiment and a connection structure between the rotating shaft connection assembly 3 and the hinge assembly 2, refer to the embodiments shown in FIG. 52A to FIG. 57B. A difference in this embodiment lies in that the first connector 31 and the second connector 32 are provided with no glue dispensing hole and dispensed glue corresponding to the glue dispensing hole.

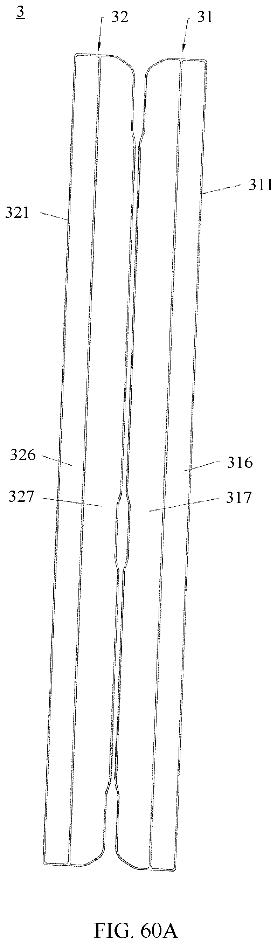

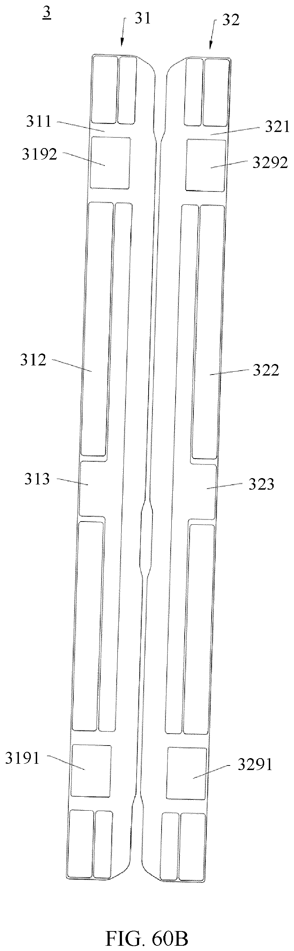

Refer to FIG. 60A and FIG. 60B. FIG. 60A is a schematic diagram of a structure of the rotating shaft connection assembly 3 shown in FIG. 2 in some other embodiments. FIG. 60B is a schematic diagram of a structure of the rotating shaft connection assembly 3 shown in FIG. 60A from another perspective. The rotating shaft connection assembly 3 in this embodiment may include most features of the rotating shaft connection assembly 3 in the foregoing embodiment. The following briefly describes the rotating shaft connection assembly 3 in this embodiment, and most same content is not described again.

In some embodiments, the rotating shaft connection assembly 3 includes a first connector 31 and a second connector 32. The first connector 31 and the second connector 32 are mechanical members independent of each other. The first connector 31 includes a first substrate layer 311, a first bonding layer 312, a first insulation layer 313, a first insulation block 3191, a second insulation block 3192, a second bonding layer 316, and a second insulation layer 317. The first substrate layer 311 may be made of a material that has specific strength and hardness and that can be bent under an action of external force. The first bonding layer 312, the first insulation layer 313, the first insulation block 3191, and the second insulation block 3192 are fastened to a lower surface 3112 of the first substrate layer 311. The first bonding layer 312 may be made of a bonding material, for example, a back adhesive. The first insulation layer 313, the first insulation block 3191, and the second insulation block 3192 may be made of an insulation material, for example, a PET material or a PEI material. The second bonding layer 316 and the second insulation layer 317 are fastened to an upper surface 3111 of the first substrate layer 311. The second bonding layer 316 may be made of a bonding material, for example, a back adhesive. The second insulation layer 317 may be made of an insulation material, for example, a PET material or a PEI material. The second connector 32 includes a second substrate layer 321, a third bonding layer 322, a third insulation layer 323, a third insulation block 3291, a fourth insulation block 3292, a fourth bonding layer 326, and a fourth insulation layer 327. The second connector 32 and the first connector 31 may be of a mirror-symmetrical structure. For a design of a structure of each layer of the second connector 32, refer to that of the first connector 31. Details are not described herein again.

For a specific design (including a structure, a size, a material, and the like) of the rotating shaft connection assembly 3 in this embodiment and a connection structure between the rotating shaft connection assembly 3 and the hinge assembly 2, refer to the embodiments shown in FIG. 59A and FIG. 59B. A difference in this embodiment lies in that the first insulation block 3191 is disposed to replace the first reinforcement layer 314, the second insulation block 3192 is disposed to replace the second reinforcement layer 315, the third insulation block 3291 is disposed to replace the third reinforcement layer 324, and the fourth insulation block 3292 is disposed to replace the fourth reinforcement layer 325.

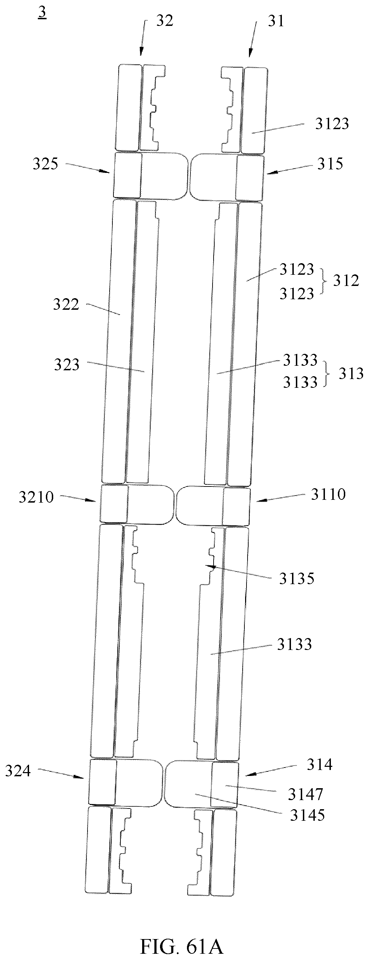

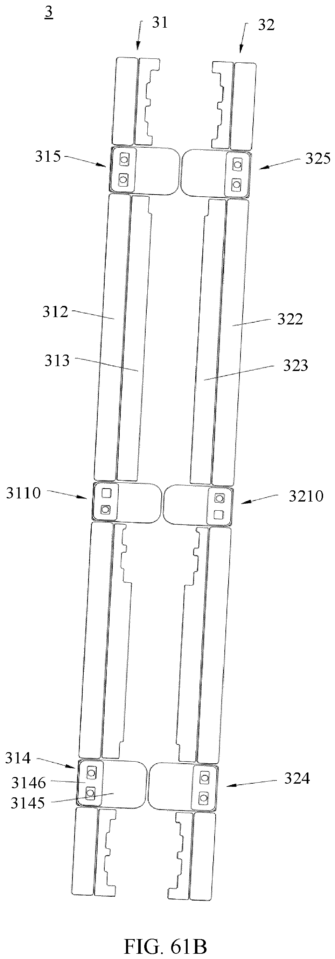

Refer to FIG. 61A and FIG. 61B. FIG. 61A is a schematic diagram of a structure of the rotating shaft connection assembly 3 shown in FIG. 2 in some other embodiments. FIG. 61B is a schematic diagram of a structure of the rotating shaft connection assembly 3 shown in FIG. 61A from another perspective.

In some embodiments, the rotating shaft connection assembly 3 includes a first connector 31 and a second connector 32. The first connector 31 and the second connector 32 are mechanical members independent of each other.

The first connector 31 includes a first bonding layer 312, a first insulation layer 313, a first reinforcement layer 314, a second reinforcement layer 315, and a fifth reinforcement layer 3110. The first bonding layer 312 is approximately strip-shaped and divided into four bonding sections 3123 spaced apart from each other. The first bonding layer 312 may be made of a bonding material, for example, a back adhesive, a hot melt adhesive film, or glue.

The first insulation layer 313 is approximately strip-shaped. The first insulation layer 313 is located on one side of the first bonding layer 312 and disposed side by side with the first bonding layer 312. The first insulation layer 313 is divided into four insulation sections 3133 spaced apart from each other. One side that is of the first insulation layer 313 and that backs onto the first bonding layer 312 is provided with a plurality of notches 3135. The first insulation layer 313 may be made of an insulation material, for example, a PET material or a PEI material.

The first reinforcement layer 314, the fifth reinforcement layer 3110, and the second reinforcement layer 315 are respectively located at the bottom part, the middle part, and the top part of the first connector 31, and are all located between two adjacent bonding sections 3123 and between two adjacent insulation sections 3133. The first reinforcement layer 314 may include a substrate layer 3145, a reinforcement bonding layer 3146, and a reinforcement insulation layer 3147. The reinforcement bonding layer 3146 is fastened to a lower surface of the substrate layer 3145. The reinforcement insulation layer 3147 is located on an upper surface of the substrate layer 3145. Both the reinforcement bonding layer 3146 and the reinforcement insulation layer 3147 may be located between two adjacent bonding sections 3123. The substrate layer 3145 may be made of a material that has specific strength and hardness and that can be bent under an action of external force. For example, the substrate layer 3145 may be a metal sheet, for example, a steel sheet, an aluminum sheet, or a stainless steel sheet. The reinforcement bonding layer 3146 may be made of a bonding material, for example, a back adhesive, a hot melt adhesive film, or glue. The reinforcement insulation layer 3147 may be made of an insulation material, for example, a PET material or a PEI material. The second reinforcement layer 315 and the fifth reinforcement layer 3110 may be designed with reference to the first reinforcement layer 314. Details are not described herein again.

The second connector 32 includes a third bonding layer 322, a third insulation layer 323, a third reinforcement layer 324, a fourth reinforcement layer 325, and a sixth reinforcement layer 3210. For a design of a structure of each layer of the second connector 32, refer to that of the first connector 31. Details are not described herein again. The second connector 32 and the first connector 31 may be of a mirror-symmetrical structure.

For example, when the rotating shaft connection assembly 3 is assembled with the hinge assembly 2 (refer to FIG. 56), the first bonding layer 312 of the first connector 31 is located above the first support plate 22 of the hinge assembly 2 and fixedly connected to the first support plate 22. The first insulation layer 313 is located above the first support plate 22 and located on one side that is of the first bonding layer 312 and that is close to the shaft 21. The first reinforcement layer 314, the fifth reinforcement layer 3110, and the second reinforcement layer 315 are respectively located above the first guide block 224, the third guide block 227, and the fifth guide block 2210 of the first support plate 22. All the reinforcement layers (314, 3110, and 315) are fixedly connected to the corresponding guide blocks (224, 227, and 2210). One end of each of all the reinforcement layers (314, 3110, and 315) may further extend to be above the shaft 21 and can be moved relative to the shaft 21.

When the rotating shaft connection assembly 3 is assembled with the hinge assembly 2 (refer to FIG. 56), the third bonding layer 322 of the second connector 32 is located above the second support plate 23 of the hinge assembly 2 and fixedly connected to the second support plate 23. The third insulation layer 323 is located above the second support plate 23 and located on one side that is of the third bonding layer 322 and that is close to the shaft 21. The third reinforcement layer 324, the sixth reinforcement layer 3210, and the fourth reinforcement layer 325 are respectively located above the second guide block 234, the fourth guide block 237, and the sixth guide block 2310 of the second support plate 23. All the reinforcement layers (324, 3210, and 325) are fixedly connected to the corresponding guide blocks (234, 237, and 2310). One end of each of all the reinforcement layers (324, 3210, and 325) may further extend to be above the shaft 21 and can be moved relative to the shaft 21.

The first bonding layer 312 and the third bonding layer 322 are further configured to bond the screen 200.

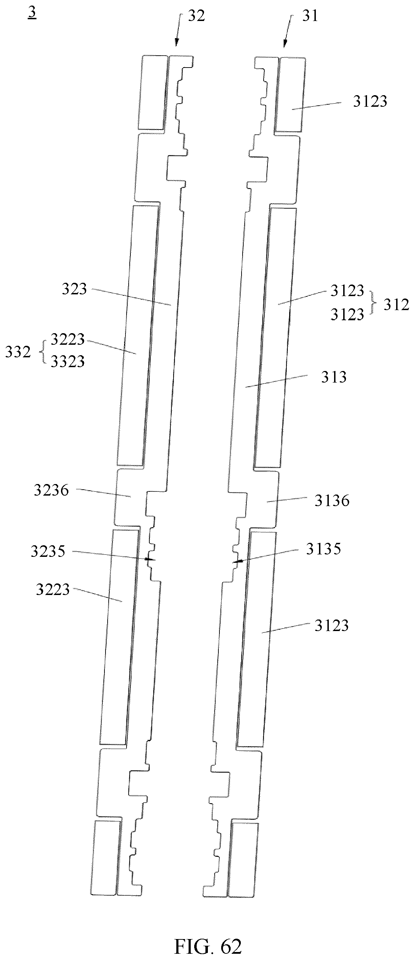

FIG. 62 is a schematic diagram of a structure of the rotating shaft connection assembly 3 shown in FIG. 2 in some other embodiments.

In some embodiments, the rotating shaft connection assembly 3 includes a first connector 31 and a second connector 32. The first connector 31 and the second connector 32 are mechanical members independent of each other. The first connector 31 includes a first bonding layer 312 and a first insulation layer 313. The first bonding layer 312 is approximately strip-shaped and divided into four bonding sections 3123 spaced apart from each other. The first bonding layer 312 may be made of a bonding material, for example, a back adhesive, a hot melt adhesive film, or glue. The first insulation layer 313 is approximately strip-shaped. The first insulation layer 313 is located on one side of the first bonding layer 312 and disposed side by side with the first bonding layer 312. One side that is of the first insulation layer 313 and that backs onto the first bonding layer 312 is provided with a plurality of notches 3135. The first insulation layer 313 includes three protrusion parts 3136. The three protrusion parts 3136 are respectively located at the bottom part, the middle part, and the top part of the first connector 31 and all located between two adjacent bonding sections 3123. The first insulation layer 313 may be made of an insulation material, for example, a PET material or a PEI material.

The second connector 32 includes a third bonding layer 322 and a third insulation layer 323. The third bonding layer 322 is approximately strip-shaped and divided into four bonding sections 3223 spaced apart from each other. The third bonding layer 322 may be made of a bonding material, for example, a back adhesive, a hot melt adhesive film, or glue. The third insulation layer 323 is approximately strip-shaped. The third insulation layer 323 is located on one side of the third bonding layer 322 and disposed side by side with the third bonding layer 322. One side that is of the third insulation layer 323 and that backs onto the third bonding layer 322 is provided with a plurality of notches 3235. The third insulation layer 323 includes three protrusion parts 3236. The three protrusion parts 3236 are respectively located at the bottom part, the middle part, and the top part of the second connector 32 and all located between two adjacent bonding sections 3223. The third insulation layer 323 may be made of an insulation material, for example, a PET material or a PEI material.

For example, when the rotating shaft connection assembly 3 is assembled with the hinge assembly 2 (refer to FIG. 56), the first bonding layer 312 of the first connector 31 is located above the first support plate 22 of the hinge assembly 2 and fixedly connected to the first support plate 22. The first insulation layer 313 is located above the first support plate 22 and located on one side that is of the first bonding layer 312 and that is close to the shaft 21. The three protrusion parts 3136 of the first insulation layer 313 are respectively located above the first guide block 224, the third guide block 227, and the fifth guide block 2210 of the first support plate 22. The third bonding layer 322 of the second connector 32 is located above the second support plate 23 of the hinge assembly 2 and fixedly connected to the second support plate 23. The third insulation layer 323 is located above the second support plate 23 and located on one side that is of the third bonding layer 322 and that is close to the shaft 21. The three protrusion parts 3236 of the third insulation layer 323 are respectively located above the second guide block 234, the fourth guide block 237, and the sixth guide block 2310 of the second support plate 23.

The first bonding layer 312 and the third bonding layer 322 are further configured to bond the screen 200.

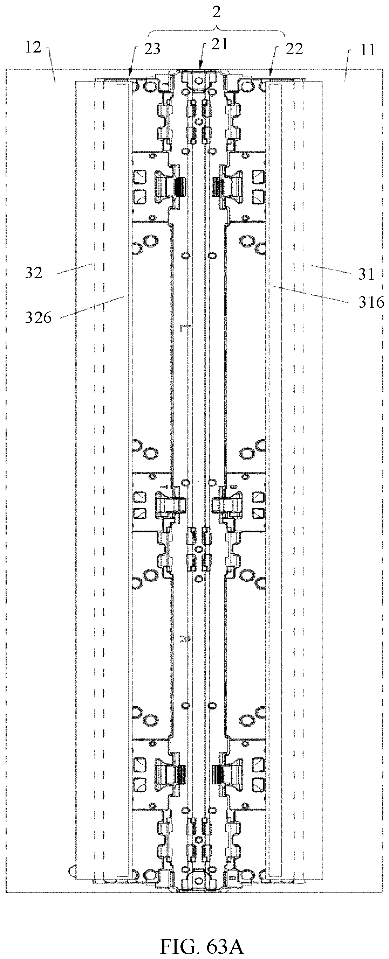

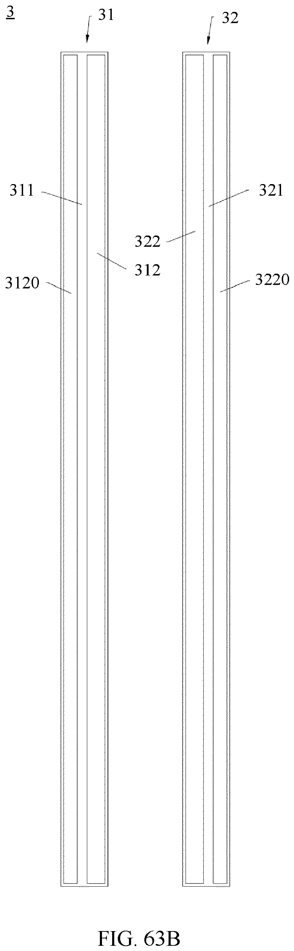

Refer to FIG. 63A and FIG. 63B. FIG. 63A is a schematic diagram of a structure of the rotating shaft connection assembly 3 shown in FIG. 2 in some other embodiments. FIG. 63B is a schematic diagram of a structure of the rotating shaft connection assembly 3 shown in FIG. 63A from another perspective. FIG. 63A shows the hinge assembly 2, the first housing 11, and the second housing 12 at the same time, to show a connection structure between the rotating shaft connection assembly 3 and a component below the rotating shaft connection assembly 3.

In some embodiments, the rotating shaft connection assembly 3 includes a first connector 31 and a second connector 32. The first connector 31 and the second connector 32 are mechanical members independent of each other.

For example, the first connector 31 includes a first substrate layer 311, a first bonding layer 312, a second bonding layer 316, and a fifth bonding layer 3120. The first substrate layer 311 may be approximately strip-shaped. The first substrate layer 311 may be made of a material that has specific strength and hardness and that can be bent under an action of external force, for example, a metal sheet, for example, a steel sheet, an aluminum sheet, or a stainless steel sheet. The first bonding layer 312 and the fifth bonding layer 3120 are both fastened to a lower surface 3112 of the first substrate layer 311 and staggered. The first bonding layer 312 and the fifth bonding layer 3120 may be made of a bonding material, for example, a back adhesive, a hot melt adhesive film, or glue. The second bonding layer 316 is fastened to an upper surface 3111 of the first substrate layer 311. The second bonding layer 316 may be made of a bonding material, for example, a back adhesive, a hot melt adhesive film, or glue.

The first connector 31 is located above the first housing 11 and the first support plate 22, and covers a gap between the first housing 11 and the first support plate 22. The first bonding layer 312 is configured to bond the first support plate 22, and the fifth bonding layer 3120 is configured to bond the first housing 11. The second bonding layer 316 is located above the first support plate 22, and is configured to bond the screen 200.

For example, the second connector 32 includes a second substrate layer 321, a third bonding layer 322, a fourth bonding layer 326, and a sixth bonding layer 3220. The second substrate layer 321 may be approximately strip-shaped. The second substrate layer 321 may be made of a material that has specific strength and hardness and that can be bent under an action of external force, for example, a metal sheet, for example, a steel sheet, an aluminum sheet, or a stainless steel sheet. The third bonding layer 322 and the sixth bonding layer 3220 are both fastened to a lower surface of the second substrate layer 321 and staggered. The third bonding layer 322 and the sixth bonding layer 3220 may be made of a bonding material, for example, a back adhesive, a hot melt adhesive film, or glue. The fourth bonding layer 326 is fastened to an upper surface of the second substrate layer 321. The fourth bonding layer 326 may be made of a bonding material, for example, a back adhesive, a hot melt adhesive film, or glue.

The second connector 32 is located above the second housing 12 and the second support plate 23, and covers a gap between the second housing 12 and the second support plate 23. The third bonding layer 322 is configured to bond the second support plate 23, and the sixth bonding layer 3220 is configured to bond the second housing 12. The fourth bonding layer 326 is located above the second support plate 23, and is configured to bond the screen 200.

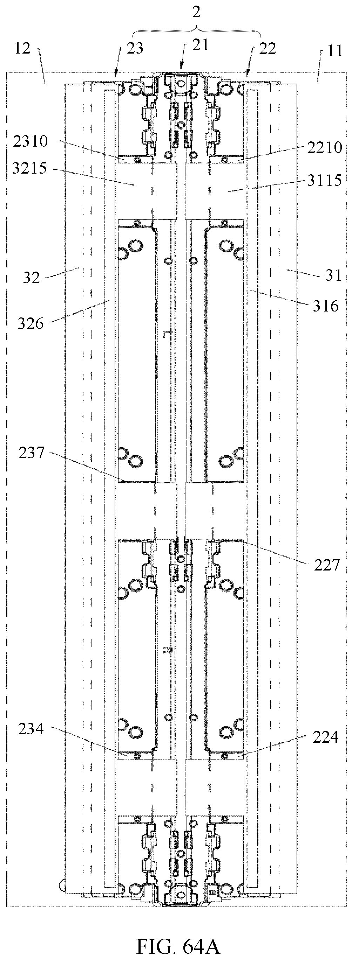

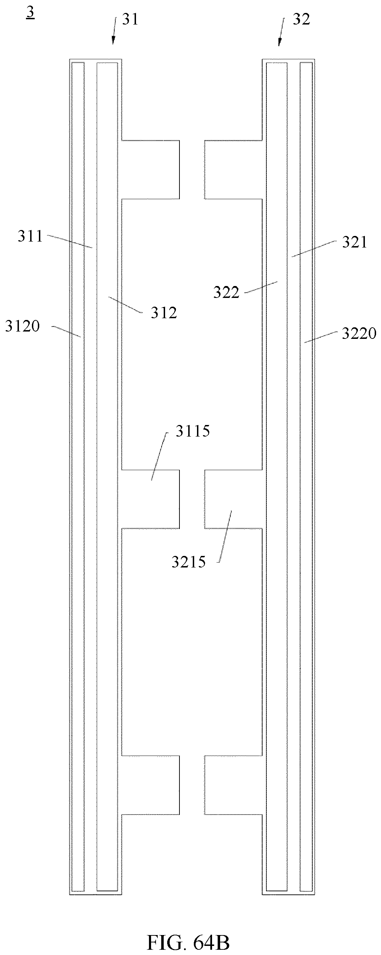

Refer to FIG. 64A and FIG. 64B. FIG. 64A is a schematic diagram of a structure of the rotating shaft connection assembly 3 shown in FIG. 2 in some other embodiments. FIG. 64B is a schematic diagram of a structure of the rotating shaft connection assembly 3 shown in FIG. 64A from another perspective. FIG. 64A shows the hinge assembly 2, the first housing 11, and the second housing 12 at the same time, to show a connection structure between the rotating shaft connection assembly 3 and a component below the rotating shaft connection assembly 3.

In some embodiments, the rotating shaft connection assembly 3 includes a first connector 31 and a second connector 32. The first connector 31 and the second connector 32 are mechanical members independent of each other.

For example, the first connector 31 includes a first substrate layer 311, a first bonding layer 312, a second bonding layer 316, and a fifth bonding layer 3120. The first substrate layer 311 may be approximately strip-shaped, and the first substrate layer 311 may include three convex parts 3115. The first substrate layer 311 may be made of a material that has specific strength and hardness and that can be bent under an action of external force, for example, a metal sheet, for example, a steel sheet, an aluminum sheet, or a stainless steel sheet. The first bonding layer 312 and the fifth bonding layer 3120 are both fastened to a lower surface 3112 of the first substrate layer 311 and staggered. The first bonding layer 312 and the fifth bonding layer 3120 may be made of a bonding material, for example, a back adhesive, a hot melt adhesive film, or glue. The second bonding layer 316 is fastened to an upper surface 3111 of the first substrate layer 311. The second bonding layer 316 may be made of a bonding material, for example, a back adhesive, a hot melt adhesive film, or glue.

The first connector 31 is located above the first housing 11 and the first support plate 22, and covers a gap between the first housing 11 and the first support plate 22. The first bonding layer 312 is configured to bond the first support plate 22, and the fifth bonding layer 3120 is configured to bond the first housing 11. The second bonding layer 316 is located above the first support plate 22, and is configured to bond the screen 200. The three convex parts 3115 of the first substrate layer 311 are respectively located above the first guide block 224, the third guide block 227, and the fifth guide block 2210 of the first support plate 22.

For example, the second connector 32 includes a second substrate layer 321, a third bonding layer 322, a fourth bonding layer 326, and a sixth bonding layer 3220. The second substrate layer 321 may be approximately strip-shaped, and the second substrate layer 321 may include three convex parts 3215. The second substrate layer 321 may be made of a material that has specific strength and hardness and that can be bent under an action of external force, for example, a metal sheet, for example, a steel sheet, an aluminum sheet, or a stainless steel sheet. The third bonding layer 322 and the sixth bonding layer 3220 are both fastened to a lower surface of the second substrate layer 321 and staggered. The third bonding layer 322 and the sixth bonding layer 3220 may be made of a bonding material, for example, a back adhesive, a hot melt adhesive film, or glue. The fourth bonding layer 326 is fastened to an upper surface of the second substrate layer 321. The fourth bonding layer 326 may be made of a bonding material, for example, a back adhesive, a hot melt adhesive film, or glue.

The second connector 32 is located above the second housing 12 and the second support plate 23, and covers a gap between the second housing 12 and the second support plate 23. The third bonding layer 322 is configured to bond the second support plate 23, and the sixth bonding layer 3220 is configured to bond the second housing 12. The fourth bonding layer 326 is located above the second support plate 23, and is configured to bond the screen 200. The three convex parts 3215 of the second substrate layer 321 are respectively located above the second guide block 234, the fourth guide block 237, and the sixth guide block 2310 of the second support plate 23.

It may be understood that the embodiments shown in FIG. 52A to FIG. 64B and features of the embodiments may be combined with each other in the case of no conflict. In addition to the implementation structures described above, the rotating shaft connection assembly 3 may alternatively have more other implementation structures. This is not strictly limited in this application.

The following describes a connection structure between the screen 200, the first housing 11, the second housing 12, and the rotating shaft connection assembly 3 with reference to the accompanying drawings.

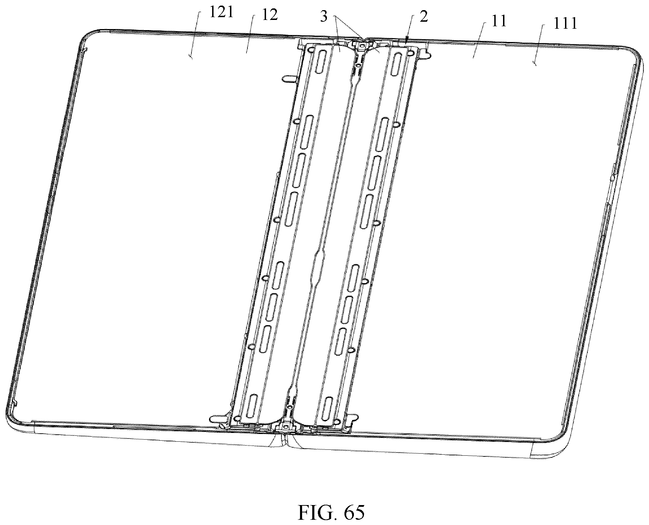

FIG. 65 is a schematic diagram of a structure obtained after the first housing 11, the hinge assembly 2, the second housing 12, and the rotating shaft connection assembly 3 that are shown in FIG. 2 are assembled.

In some embodiments, the first housing 11, the hinge assembly 2, the second housing 12, and the rotating shaft connection assembly 3 jointly provide a supporting environment for the screen 200. The first housing 11 has a first support plate surface 111, and the second housing 12 has a second support plate surface 121. It should be understood that, because the first housing 11 and the second housing 12 are usually provided with a plurality of fitting assembly structures, for example, a groove and a protrusion, both the first support plate surface 111 of the first housing 11 and the second support plate surface 121 of the second housing 12 are usually incomplete planes. A schematic structure is used in the accompanying drawings of this application for ease of understanding.

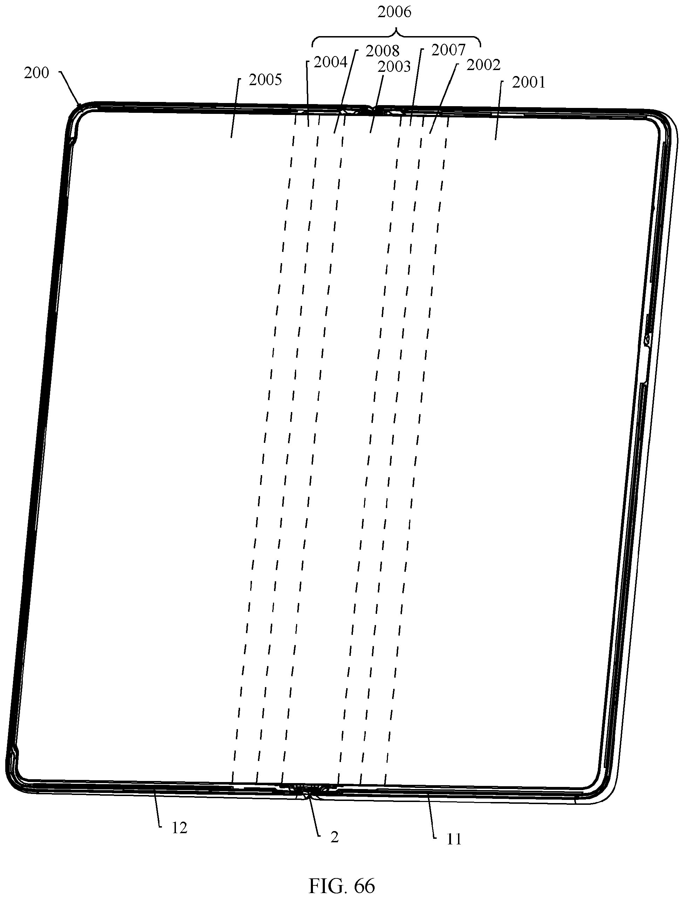

Refer to FIG. 65 and FIG. 66. FIG. 66 is a schematic diagram of a partial structure of the electronic device 1000 shown in FIG. 1.

In some embodiments, the screen 200 includes a first non-bendable part 2001, a first bendable part 2002, a second non-bendable part 2007, a second bendable part 2003, a third non-bendable part 2008, a third bendable part 2004, and a fourth non-bendable part 2005 that are sequentially arranged. The screen 200 is of an integrated structure. The first non-bendable part 2001, the first bendable part 2002, the second non-bendable part 2007, the second bendable part 2003, the third non-bendable part 2008, the third bendable part 2004, and the fourth non-bendable part 2005 are all some regions of the screen 200. This is not limited to that the screen 200 is divided into a plurality of components.

The first non-bendable part 2001 is located above the first housing 11 and connected to the first support plate surface 111 of the first housing 11. The fourth non-bendable part 2005 is located above the second housing 12 and connected to the second support plate surface 121 of the second housing 12. The first bendable part 2002, the second non-bendable part 2007, the second bendable part 2003, the third non-bendable part 2008, and the third bendable part 2004 jointly form a bendable part 2006 of the screen 200. The bendable part 2006 is located above the rotating shaft connection assembly 3 and the hinge assembly 2 and connected to the rotating shaft connection assembly 3. The first bendable part 2002 is partially located above the first housing 11 and partially located above the hinge assembly 2, has no direct fixing relationship with the first housing 11 and the hinge assembly 2, and can be moved relative to the first housing 11 and the hinge assembly 2. The third bendable part 2004 is partially located above the second housing 12 and partially located above the hinge assembly 2, has no direct fixing relationship with the second housing 12 and the hinge assembly 2, and can be moved relative to the second housing 12 and the hinge assembly 2.

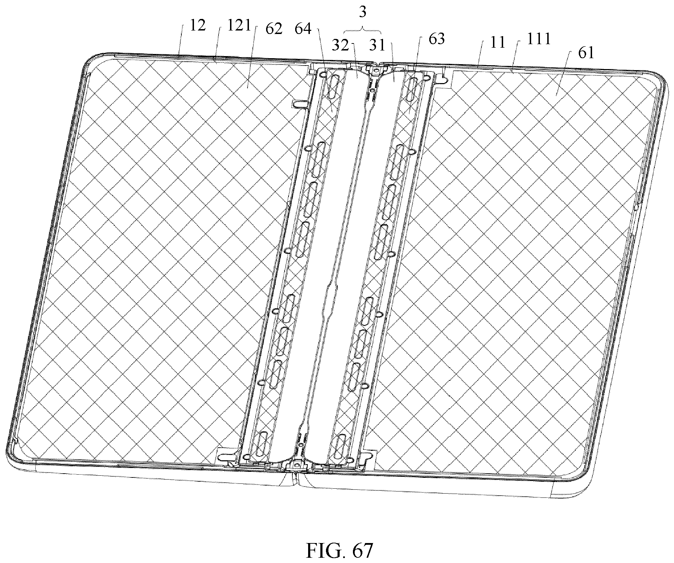

Refer to FIG. 66 and FIG. 67. FIG. 67 is a schematic diagram of a partial structure of the structure shown in FIG. 66. In FIG. 67, to more clearly show a position of an adhesive layer, cross-sectional line filling is shown for the adhesive layer.

In some embodiments, the electronic device 1000 further includes a first adhesive layer 61 and a second adhesive layer 62. The first adhesive layer 61 is located on the first support plate surface 111 of the first housing 11, and is configured to bond the first non-bendable part 2001 of the screen 200. The second adhesive layer 62 is located on the second support plate surface 121 of the second housing 12, and is configured to bond the fourth non-bendable part 2005 of the screen 200. For example, the first adhesive layer 61 and the second adhesive layer 62 may be made of one or more of a double-sided tape, an acrylic adhesive material, a rubber adhesive material, and a silica gel adhesive material. A technology for fixing the first adhesive layer 61 and the second adhesive layer 62 may be an ultraviolet (ultraviolet, UV) curing technology, a moisture curing technology, a heat curing technology, an infrared curing technology, or the like. Specific materials and specific forming technologies of the first adhesive layer 61 and the second adhesive layer 62 are not strictly limited in this application.

The second non-bendable part 2007 of the screen 200 is indirectly bonded to the first support plate 22 by using the first connector 31 of the rotating shaft connection assembly 3. The third non-bendable part 2008 is indirectly bonded to the second support plate 23 by using the second connector 32 of the rotating shaft connection assembly 3. The second bendable part 2003 has no direct fixing relationship with the rotating shaft connection assembly 3, and can be moved relative to the rotating shaft connection assembly 3. The second non-bendable part 2007 and the first support plate 22 may be bonded by the first connector 31 by using one or more bonding layers. For ease of description, the one or more bonding layers are collectively referred to as a third adhesive layer 63 below. The third adhesive layer 63 is configured to present performance of a connection structure between the second non-bendable part 2007 and the first support plate 22. The second bendable part 2003 and the second support plate 23 may be bonded by the second connector 32 by using one or more bonding layers. For ease of description, the one or more bonding layers are collectively referred to as a fourth adhesive layer 64 below. The fourth adhesive layer 64 is configured to present performance of a connection structure between the third non-bendable part 2008 and the second support plate 23.

For example, the third adhesive layer 63 and the fourth adhesive layer 64 are strong adhesive layers, the first adhesive layer 61 and the second adhesive layer 62 are weak adhesive layers, and rigidity of the strong adhesive layer is greater than rigidity of the weak adhesive layer. In this embodiment of this application, "rigidity" is used to indicate a capability of an adhesive layer to resist elastic deformation when force is applied. In other words, a strong adhesive layer is less likely to deform than a weak adhesive layer when external force is applied. It should be understood that, in this embodiment of this application, the weak adhesive layer is lower in rigidity relative to the strong adhesive layer. This is not limited to that the weak adhesive layer has quite low rigidity. Similarly, the strong adhesive layer is higher in rigidity relative to the weak adhesive layer. This is not limited to that the strong adhesive layer has quite high rigidity.

In some embodiments, when the electronic device 1000 is in the open state, the hinge assembly 2 and the rotating shaft connection assembly 3 are flattened, and upper surfaces (namely, surfaces configured to connect to the screen 200) of the first adhesive layer 61, the third adhesive layer 63, the fourth adhesive layer 64, and the second adhesive layer 62 may be flush or approximately flush, to better support the screen 200, so that the screen 200 has a flat display and touch plane. This helps improve viewing experience and touch operation experience of the user.

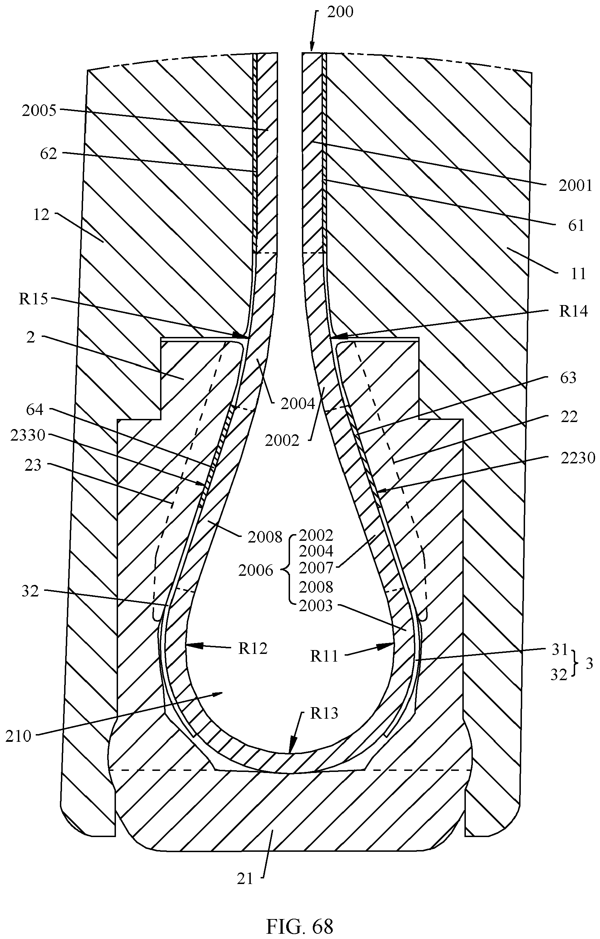

FIG. 68 is a schematic diagram of an internal structure of the structure shown in FIG. 66 in a closed state. Each component shown in FIG. 68 is presented in a manner of a brief schematic diagram. This constitutes no limitation on a specific structure of the component.

In some embodiments, in the closed state, the first support plate 22 and the second support plate 23 of the hinge assembly 2 are away from each other in a direction close to the shaft 21, and the first support plate 22, the second support plate 23, the shaft 21, and another structure of the hinge assembly 2 jointly form the water drop-shaped screen accommodation space 210. The first connector 31 and the second connector 32 of the rotating shaft connection assembly 3 are moved with the hinge assembly 2 to form similarly water drop-shaped inner side space. The screen 200 is moved with the first housing 11, the hinge assembly 2, and the second housing 12. The first bendable part 2002, the second non-bendable part 2007, the second bendable part 2003, the third non-bendable part 2008, and the third bendable part 2004 of the screen 200 are jointly in a water drop shape. In other words, when the electronic device 1000 is in the closed state, the bendable part 2006 of the screen 200 is in the water drop shape.

In this embodiment, the electronic device 1000 enables the bendable part 2006 of the screen 200 to be bent into the water drop shape in the closed state by using the first support plate 22, the second support plate 23, the third adhesive layer 63, and the fourth adhesive layer 64, to disperse stress on the bendable part 2006 of the screen 200, so that the screen 200 evenly bears force in a bending process. Therefore, in a process of folding and unfolding the electronic device 1000, a risk of film layer separation or glue detachment of the screen 200 is low. This improves reliability of the screen 200, helps prolong a service life of the electronic device 1000, and improves user experience.

In addition, because the bendable part 2006 of the screen 200 is in the water drop shape, the first non-bendable part 2001 and the fourth non-bendable part 2005 of the screen 200 can be close to each other, a distance between the first non-bendable part 2001 and the fourth non-bendable part 2005 is small, and the first non-bendable part 2001 and the fourth non-bendable part 2005 may be approximately parallel, so that when the electronic device 1000 is in the closed state, a gap between structures of the two parts that are folded with each other is small, to implement a gap-free or (small-gap) design of an appearance after folding. In this way, the electronic device 1000 is small in overall size, easier to be stored and carried, and better in appearance experience.

In addition, in a process in which the first housing 11 and the second housing 12 are folded relative to each other to drive the screen 200 to fold, the screen 200 is moved in a misalignment manner relative to the housing apparatus 100 due to stress generated by deformation of the bent screen 200. For example, the screen 200 may be moved relative to the housing apparatus 100 in a direction that is close to the first housing 11 and the second housing 12 and that is away from an end part on an outer side of the hinge assembly 2 or in a direction close to the shaft 21. In this case, the second non-bendable part 2007 is bonded to the first support plate 22 by using the third adhesive layer 63 (which is a strong adhesive layer), the third non-bendable part 2008 is bonded to the second support plate 23 by using the fourth adhesive layer 64 (which is a strong adhesive layer), the first non-bendable part 2001 is bonded to the first housing 11 by using the first adhesive layer 61 (which is a weak adhesive layer), the fourth non-bendable part 2005 is bonded to the second housing 12 by using the second adhesive layer 62 (which is a weak adhesive layer), and rigidity of the strong adhesive layer is greater than rigidity of the weak adhesive layer. Therefore, misalignment of the screen 200 relative to the first support plate 22 and the second support plate 23 is slighter, and misalignment of the screen 200 relative to the first housing 11 and the second housing 12 is greater. Therefore, the bendable part 2006 of the screen 200 in the unfolding or folding process has a small length change, to reduce a risk that the bendable part 2006 of the screen 200 arches, delaminates, or deglues due to incomplete restoration in the process of unfolding the electronic device 1000, so as to improve reliability of the screen 200. In addition, stress at a joint between the first bendable part 2002 and the first non-bendable part 2001 of the screen 200 can be smoothly released by using misalignment between the first non-bendable part 2001 and the first housing 11. Stress at a joint between the third bendable part 2004 and the fourth non-bendable part 2005 can be smoothly released by using misalignment between the fourth non-bendable part 2005 and the second housing 12. Therefore, a risk that a joint between the bendable part 2006 and a non-bendable part of the screen 200 arches, delaminates, or deglues due to incomplete restoration in the process of unfolding the electronic device 1000 can be also reduced, to improve reliability of the screen 200.

It may be understood that, when the screen 200 is folded or unfolded with the housing apparatus 100, the screen 200 is slightly moved in the misalignment manner relative to the housing apparatus 100, and a movement direction of the screen 200 is related to specific designs (for example, parameters such as a structure, a size, and a position) of the screen 200, a plurality of adhesive layers, and the housing apparatus 100. For example, the second non-bendable part 2007 of the screen 200 is moved relative to the first support plate 22 towards a direction close to an end part on an outer side of the first housing 11. The third non-bendable part 2008 is moved relative to the second support plate 23 towards a direction close to an end part on an outer side of the second housing 12. The first non-bendable part 2001 is moved relative to the first housing 11 towards the direction close to the end part on the outer side of the first housing 11. The fourth non-bendable part 2005 is moved relative to the second housing 12 towards the direction close to the end part on the outer side of the second housing 12.

For example, an end part that is of the second bendable part 2003 of the screen 200 and that is connected to the second non-bendable part 2007 forms a first arc section R11. An end part that is of the second bendable part 2003 and that is connected to the third non-bendable part 2008 forms a second arc section R12. The middle part of the second bendable part 2003 forms a third arc section R13. The first arc section R11, the third arc section R13, and the second arc section R12 smoothly transit. The first arc sectionR11, the third arc section R13, and the second arc section R12 have circle centers located on an inner side of the screen 200, that is, are inner arc sections. The first bendable part 2002 of the screen 200 forms a fourth arc section R14, and a circle center of the fourth arc section R14 is located on an outer side of the screen 200. The third bendable part 2004 forms a fifth arc section R15, and a circle center of the fifth arc section R15 is located on the outer side of the screen 200. The circle center of the fourth arc section R14 and the circle center of the fifth arc section R15 are respectively located on two sides of the screen 200.

The second non-bendable part 2007 is fixedly connected to the first support plate 22, and the third non-bendable part 2008 is fixedly connected to the second support plate 23. For example, the support surface 2230 that is of the first support plate 22 and that is configured to connect to the screen 200 may be a plane, and the support surface 2330 that is of the second support plate 23 and that is configured to connect to the screen 200 may be a plane.

In some embodiments, the first adhesive layer 61 and the third adhesive layer 63 are arranged at an interval, and the second adhesive layer 62 and the fourth adhesive layer 64 are arranged at an interval. When the first housing 11 and the second housing 12 are folded relative to each other to a closed state, a distance between the two first adhesive layers 61 and the second adhesive layer 62 is less than a distance between the third adhesive layer 63 and the fourth adhesive layer 64. In this case, there is no bonding relationship between the fourth arc section R14 of the screen 200 and the third adhesive layer 63, and there is no bonding relationship between the fifth arc section R15 and the fourth adhesive layer 64, so that a water drop-shaped transition formed by the bendable part 2006 is smoother, to help improve reliability of the screen 200.

In some embodiments, the "water drop-shaped" structure mentioned above has a width and a height on a cross section of the "water drop-shaped" structure, and a height size of the water drop-shaped structure is greater than a width size. For example, a ratio of the height size to the width size may be in a range of 1 to 3, for example, in a range of 1.5 to 2.5. For example, a width size of the water drop-shaped bendable part 2006 of the screen 200 is a maximum spacing between a surface on an outer side of the first arc section R11 and a surface on an outer side of the second arc section R12, and a height size of the bendable part 2006 is a maximum spacing between a surface on an outer side of the third arc section R13 and a line connecting end parts of the fourth arc section R14 and the fifth arc section R15. Certainly, the ratio of the height size to the width size of the "water drop-shaped" structure may be alternatively in another range. A water drop shape presents a structure with a sharp end and a blunt end.

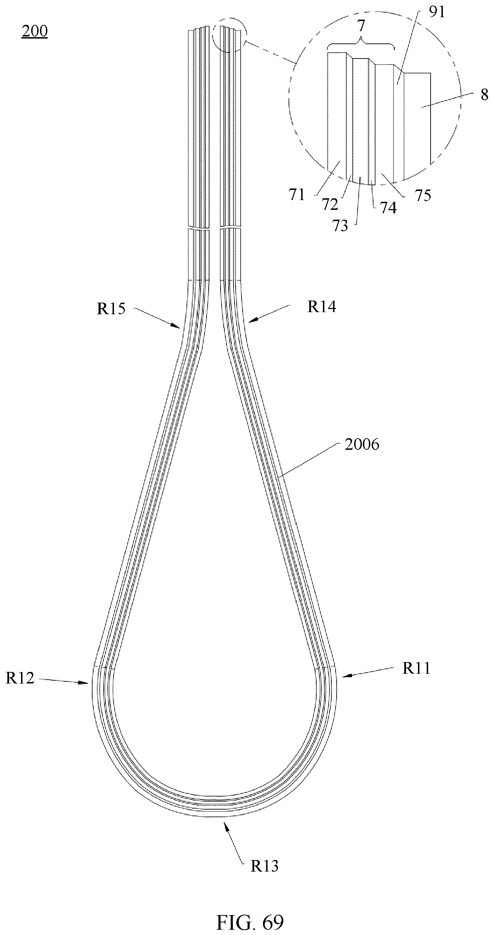

Refer to FIG. 68 and FIG. 69. FIG. 69 is a schematic diagram of an internal structure of a screen 200 of the electronic device 1000 shown in FIG. 68.

In some embodiments, when the electronic device 1000 is in the closed state, the bent screen 200 is slightly misaligned relative to the housing apparatus 100, and structures of a plurality of layers of the screen 200 are also slightly misaligned relative to each other.

In some embodiments, the screen 200 may include a flexible display 7 and a bearing plate 8 configured to support the flexible display 7. The bearing plate 8 is located on a non-display side of the flexible display 7. The flexible display 7 may be bent, and the bearing plate 8 may be bent and has specific structural strength, so that the screen 200 not only can implement an unfolding action and a folding action, but also has specific structural strength, to have high reliability and support a touch action of the user. After the screen 200 is bent, the bearing plate 8 is located on an outer side of the flexible display 7. The bearing plate 8 is configured to bond the first adhesive layer 61, the second adhesive layer 62, the third adhesive layer 63, and the fourth adhesive layer 64.

For example, the flexible display 7 includes a plurality of film layers that are stacked and an intermediate adhesive layer that is located between any two adjacent side film layers and that is configured to implement bonding. The flexible display 7 is further bonded to the bearing plate 8 by using a connection adhesive layer 91. For example, in the embodiment in FIG. 69, the plurality of film layers and a plurality of intermediate adhesive layers are simplified into a first film layer 71, a first intermediate adhesive layer 72, a second film layer 73, a second intermediate adhesive layer 74, and a third film layer 75 that are sequentially laminated.

When the screen 200 is bent, due to different bending radii, layer structures of the screen 200 are misaligned relative to each other, to maintain constant lengths of the layer structures. Misalignment deformation between a plurality of layers of materials is mainly absorbed by a material of a layer (for example, an adhesive layer) with a lower modulus, to reduce a failure of the screen 200 due to separation or degluing between the film layers because a corresponding requirement of misalignment movement or stress strain cannot be met.

In this embodiment in FIG. 69, for example, at an end part of the screen 200, the first film layer 71 protrudes relative to the second film layer 73, the second film layer 73 protrudes relative to the third film layer 75, the third film layer 75 protrudes relative to the bearing plate 8, and the first intermediate adhesive layer 72, the second intermediate adhesive layer 74, and the connection adhesive layer 91 deform. To be specific, a layer structure that is of the screen 200 and that is located on the inner side is misaligned towards a direction close to the end part of the screen 200 relative to a layer structure located on the outer side. A modulus of each of the first intermediate adhesive layer 72, the second intermediate adhesive layer 74, and the connection adhesive layer 91 is less than a modulus of each of the first film layer 71, the second film layer 73, the third film layer 75, and the bearing plate 8. To be specific, rigidity of each of these intermediate adhesive layers is less than rigidity of the film layer and rigidity of the bearing plate 8. Misalignment between a plurality of film layers and between the film layer and the bearing plate 8 is smoothly implemented by using deformation of these intermediate adhesive layers, to reduce a risk that the screen 200 has separation or degluing of the film layers, so as to improve reliability of the screen 200. In addition, because the bearing plate 8 and the flexible display 7 can be misaligned, a misalignment requirement between inner-layer structures of the flexible display 7 can be reduced, so that the flexible display 7 is more easily bent and has higher reliability.

In addition, in this embodiment of this application, the bendable part 2006 of the screen 200 is bent into the water drop shape. The bendable part includes the first arc section R11, the second arc section R12, and the third arc section R13 whose circle centers are on the inner side of the screen 200, and further includes the fourth arc section R14 and the fifth arc section R15 whose circle centers are on the outer side of the display. The water drop shape makes radii of the fourth arc section R14 and the fifth arc section R15 larger. Therefore, a bending radius difference between the inner-side layer structure and the outer-side layer structure of the bendable part can be reduced. This helps reduce a misalignment distance that needs to be implemented by the screen 200, so that the screen 200 is more easily bent and has higher reliability.

In some embodiments, with reference to FIG. 68, the screen 200 and the hinge assembly 2 can be slightly misaligned by using a tiny sliding action of the rotating shaft connection assembly 3 between the screen 200 and the hinge assembly 2. Therefore, the misalignment requirement between the inner-layer structures of the flexible display 7 can be reduced, so that the flexible display 7 is more easily bent and has higher reliability.

It may be understood that, in some other embodiments, positions and shapes of the first support plate 22 and the second support plate 23 may be also designed, so that the bendable part 2006 of the screen 200 is bent into another irregular form when the electronic device 1000 is in the closed state. This is not strictly limited in this embodiment of this application.

In embodiments of this application, there may be a plurality of embodiments for the strong adhesive layer and the weak adhesive layer, and a rigidity requirement may be met by using a material design, a shape design, and/or the like. The following provides an example for description.

In some embodiments, a modulus of the strong adhesive layer is greater than a modulus of the weak adhesive layer. In this embodiment of this application, a "modulus" is used to indicate a capability of a material to resist elastic deformation when force is applied. In this embodiment, the strong adhesive layer is made of a material with a larger modulus, and the weak adhesive layer is made of a material with a smaller modulus, so that rigidity of the strong adhesive layer is greater than rigidity of the weak adhesive layer, to meet a bonding requirement between the screen 200 and the housing apparatus 100.

For example, the strong adhesive layer may be made of a double-sided tape material whose base material is polyethylene terephthalate and whose modulus is larger. Alternatively, the strong adhesive layer may be made of a hot melt adhesive material whose modulus is larger. In some other embodiments, the strong adhesive layer may be alternatively made of another material with a larger modulus.

For example, the weak adhesive layer may be made of a double-sided tape material whose base material is foam and whose modulus is smaller. Alternatively, the weak adhesive layer may be made of a silica gel material. In some other embodiments, the weak adhesive layer may be alternatively made of a double-sided tape material without a base material and with a smaller modulus. In some other embodiments, the weak adhesive layer may be alternatively made of an acrylic adhesive material or a rubber adhesive material with a smaller modulus. In some other embodiments, the weak adhesive layer may be alternatively made of another material with a smaller modulus.

In some embodiments, as shown in FIG. 67, the strong adhesive layers (namely, the third adhesive layer 63 and the fourth adhesive layer 64) are in a continuous elongated shape. In this case, an area of the strong adhesive layer is large, which helps implement higher rigidity, to meet a bonding requirement.

In some embodiments, as shown in FIG. 67, the weak adhesive layers (namely, the first adhesive layer 61 and the second adhesive layer 62) may be also of a continuous whole-surface structure, and a shape of the weak adhesive layer changes with a shape of the first support plate surface 111 of the first housing 11 and a shape of the second support plate surface 121 of the second housing 12. In this case, the weak adhesive layer may be made of a material with a smaller modulus, so that rigidity of the weak adhesive layer is less than rigidity of the strong adhesive layer.

In some other embodiments, the weak adhesive layer may include one or more hollow regions, to form a patterned structure. In this case, rigidity of the weak adhesive layer is lower, and is less than a rigidity of the strong adhesive layer, to meet a bonding requirement. The patterned structure of the weak adhesive layer may include but is not limited to a strip shape, a "square" shape, a "+" shape, a "*" shape, a spiral shape, and the like. This is not strictly limited in this application.

The following describes several patterned structures of the weak adhesive layer by using examples.

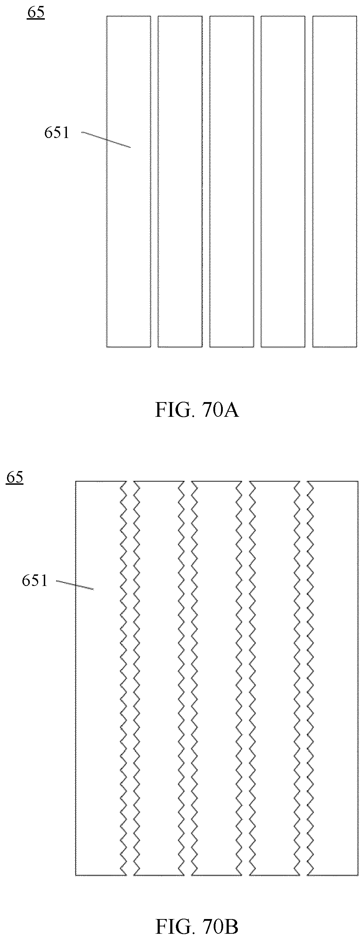

For example, FIG. 70A shows a structure of a weak adhesive layer 65 according to an embodiment of this application in some embodiments. The weak adhesive layer 65 includes a plurality of long adhesive strips 651 distributed at intervals. A hollow region is formed between two adjacent long adhesive strips 651. A long edge of the long adhesive strip 651 is a straight line, to reduce manufacturing difficulty and manufacturing costs of the long adhesive strip 651.

For example, FIG. 70B shows a structure of a weak adhesive layer 65 according to an embodiment of this application in still some embodiments. The weak adhesive layer 65 includes a plurality of long adhesive strips 651 distributed at intervals. A hollow region is formed between two adjacent long adhesive strips 651. Long edges on two sides of each of a plurality of long adhesive strips 651 located in the middle are triangular wavy lines, and a long edge on one side of each of two long adhesive strips 651 located on two sides is a triangular wavy line. In some other embodiments, one or more of four edges of the long adhesive strip 651 may be set as wavy lines. In the plurality of long adhesive strips 651, edges of some long adhesive strips 651 may be set as wavy lines, or edges of all the long adhesive strips 651 may be set as wavy lines. In some other embodiments, a long edge of the long adhesive strip 651 may be alternatively in an arc wavy shape, a rectangular wavy shape, or the like.

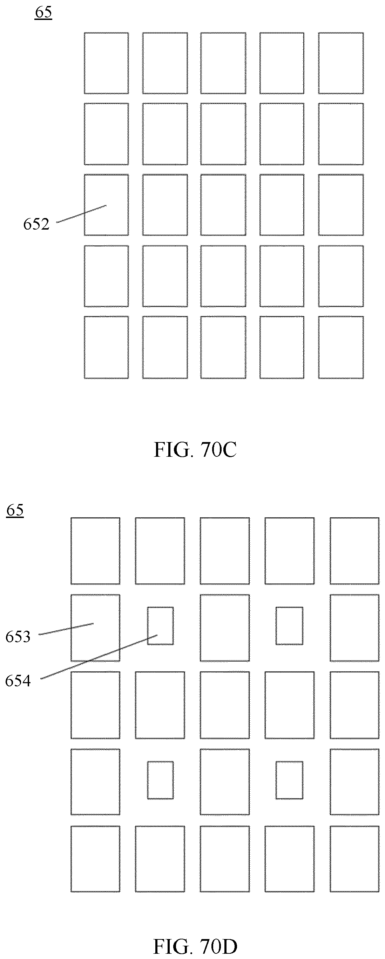

For example, FIG. 70C shows a structure of a weak adhesive layer 65 according to an embodiment of this application in still some embodiments. The weak adhesive layer 65 includes a plurality of adhesive blocks 652 distributed at intervals. A hollow region is formed between two adjacent adhesive blocks 652. In this embodiment, there is one hollow region of the weak adhesive layer 65, and the hollow region is approximately in a grid shape. All the adhesive blocks 652 are separated by the hollow region. A shape of the adhesive block 652 may be a rectangle shown in FIG. 70C, or may be a circle, an ellipse, a triangle, a rhombus, or another regular or irregular pattern. This is not strictly limited in this application. The plurality of adhesive blocks 652 may be arranged in an array. In some other embodiments, alternatively, the plurality of adhesive blocks 652 may have another arrangement rule or be randomly arranged.

For example, FIG. 70D shows a structure of a weak adhesive layer 65 according to an embodiment of this application in still some embodiments. The weak adhesive layer 65 includes a plurality of first adhesive blocks 653 and a plurality of second adhesive blocks 654. An area of the second adhesive block 654 is different from an area of the first adhesive block 653. All the first adhesive blocks 653 and all the second adhesive blocks 654 are distributed at intervals. A hollow region is formed between two adjacent adhesive blocks (653 and 654). In this embodiment, there is one hollow region of the weak adhesive layer 65, and the hollow region is approximately in a grid shape. All the adhesive blocks (653 and 654) are separated by the hollow region.

The first adhesive block 653 and the second adhesive block 654 may be of structures that are the same in shape but different in size, or may be of structures in different shapes. This is not strictly limited in this embodiment of this application. Shapes of the first adhesive block 653 and the second adhesive block 654 may be a rectangle shown in FIG. 70D, or may be a circle, an ellipse, a triangle, a rhombus, or another regular or irregular pattern. This is not strictly limited in this embodiment of this application.

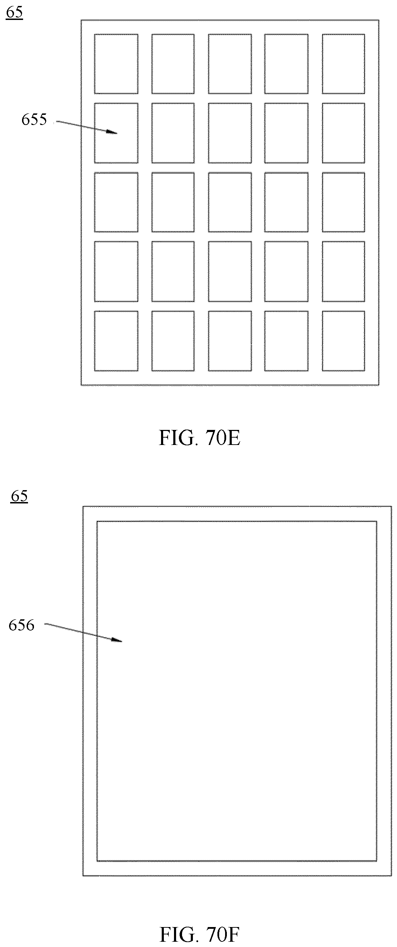

For example, FIG. 70E shows a structure of a weak adhesive layer 65 according to an embodiment of this application in still some embodiments. The weak adhesive layer 65 is of a grille structure. The weak adhesive layer 65 includes a plurality of hollow regions 655 arranged at intervals. The plurality of hollow regions 655 are arranged in an array. A shape of the hollow region 655 may be a rectangle shown in FIG. 70E, or may be a circle, an ellipse, a triangle, a rhombus, or another regular or irregular pattern. This is not strictly limited in this embodiment of this application. In some other embodiments, alternatively, the plurality of hollow regions 655 of the weak adhesive layer 65 may have another arrangement rule or be randomly arranged.

For example, FIG. 70F shows a structure of a weak adhesive layer 65 according to an embodiment of this application in still some embodiments. The weak adhesive layer 65 is of a frame structure. The weak adhesive layer 65 includes a hollow region 656 located at the middle part. A shape of a frame of the weak adhesive layer 65 changes with shapes of the first non-bendable part 2001 and the fourth non-bendable part 2005 (refer to FIG. 66) of the screen 200. For example, if the first non-bendable part 2001 is rectangular, the weak adhesive layer 65 is a rectangular frame.

In still some embodiments, a modulus of the strong adhesive layer is equal to a modulus of the weak adhesive layer, and an arrangement area of the strong adhesive layer is greater than an arrangement area of the weak adhesive layer. In this case, rigidity of the strong adhesive layer is greater than rigidity of the weak adhesive layer. The weak adhesive layer may be provided with a hollow region with a large area, so that an area of the weak adhesive layer is less than an area of the strong adhesive layer.

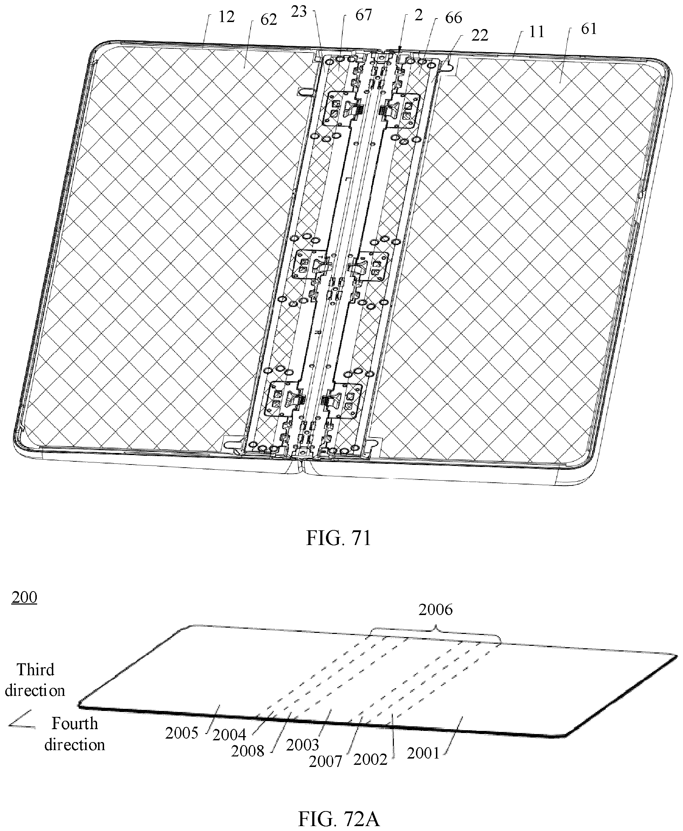

Refer to FIG. 66 and FIG. 71. FIG. 71 is a schematic diagram of the structure shown in FIG. 67 in some other embodiments. In FIG. 71, to more clearly show the position of the adhesive layer, cross-sectional line filling is shown for the adhesive layer.

In some embodiments, the electronic device 1000 may alternatively include no rotating shaft connection assembly 3, and the screen 200 is directly connected to the hinge assembly 2. The first non-bendable part 2001 of the screen 200 is bonded to the first housing 11 by using the first adhesive layer 61 (a weak adhesive layer). The second non-bendable part 2007 is bonded to the first support plate 22 of the hinge assembly 2 by using a fifth adhesive layer 66 (a strong adhesive layer). The third non-bendable part 2008 is bonded to the second support plate 23 of the hinge assembly 2 by using a sixth adhesive layer 67 (a strong adhesive layer). The fourth non-bendable part 2005 is bonded to the second housing 12 by using the second adhesive layer 62 (a weak adhesive layer). For another design of this embodiment, refer to the foregoing embodiments. Details are not described herein again.

The following describes a specific structure of the screen 200 with reference to the accompanying drawings by using an example.

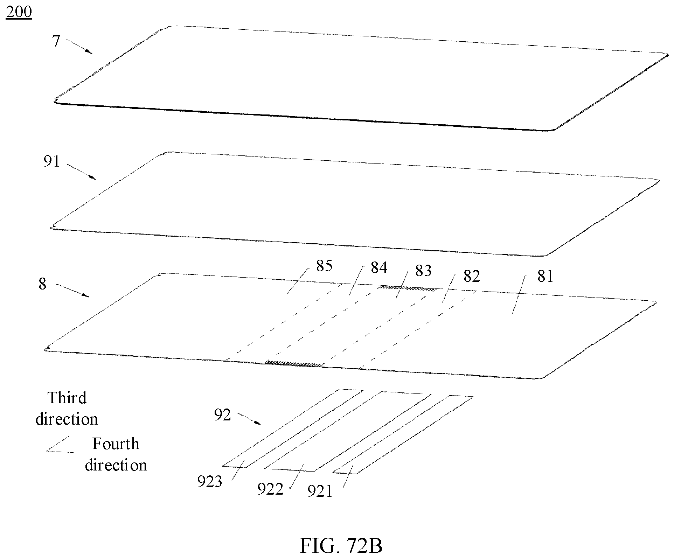

Refer to FIG. 72A and FIG. 72B. FIG. 72A is a schematic diagram of a structure of the screen 200 shown in FIG. 2 from another perspective. FIG. 72B is a schematic diagram of a partial decomposition structure of the screen 200 shown in FIG. 72A. The screen 200 is defined to have a third direction and a fourth direction perpendicular to the third direction. The third direction may be parallel to an extension direction of the shaft 21 of the hinge assembly 2.

In some embodiments, the first non-bendable part 2001, the first bendable part 2002, the second non-bendable part 2007, the second bendable part 2003, the third non-bendable part 2008, the third bendable part 2004, and the fourth non-bendable part 2005 of the screen 200 are sequentially arranged in the third direction.

The screen 200 includes the flexible display 7, the connection adhesive layer 91, the bearing plate 8, and a protection film 92 that are sequentially stacked from top to bottom. The connection adhesive layer 91 is configured to fasten the flexible display 7 and the bearing plate 8. For example, the connection adhesive layer 91 may be a foam adhesive. A main body part of the foam adhesive is foam, and adhesive layers are disposed on surfaces on two sides of the main body part. Certainly, the connection adhesive layer 91 may be alternatively an adhesive material, for example, an optically clear adhesive (optically clear adhesive, OCA) or a polyvinyl butyral (polyvinyl butyral, PVB) adhesive. Rigidity of the bearing plate 8 is greater than rigidity of the flexible display 7. The bearing plate 8 is configured to provide rigid support for the flexible display 7 and can be bent, to improve support strength for the screen 200. The bearing plate 8 is made of a material that has specific strength, hardness, and rigidity and that can be bent under an action of external force. The protection film 92 is fastened to a lower surface 86 of the bearing plate 8, and is configured to protect a part of a region of the bearing plate 8. The following describes a shape and a position of the protection film 92.

For example, the flexible display 7 may include a rear film, a display panel, a polarizer (Polarizer, POL), and a protection cover plate that are sequentially stacked from bottom to top. In other words, the display panel is located between the rear film and the polarizer. The protection cover plate is fastened to a surface that is of the polarizer and that is away from the display panel. The rear film may be configured to support the display panel. The display panel is configured to display an image, a video, and the like. The protection cover plate is configured to protect the polarizer, the display panel, and the like.

In addition, the flexible display 7 further includes an optical adhesive. The optical adhesive is fastened between the polarizer and the protection cover plate. The optical adhesive not only enables display light emitted by the display panel to propagate outside the electronic device 1000, but also improves flexibility of the flexible display 7.

In some embodiments, a thickness of the bearing plate 8 is within a range from 0.1 mm to 0.5 mm, for example, 0.15 mm, 0.2 mm, or 0.25 mm. In this case, the thickness of the bearing plate 8 is moderate, so that it can be ensured that the bearing plate 8 has better rigidity and flexibility, and the bearing plate 8 does not increase a thickness of the screen 200 to a large extent. In another embodiment, a thickness of the bearing plate 8 may be alternatively within another value range.

In some embodiments, the bearing plate 8 includes a first plate part 81, a second plate part 82, a third plate part 83, a fourth plate part 84, and a fifth plate part 85 that are sequentially arranged in the fourth direction. The first plate part 81 is located at the first non-bendable part 2001 of the screen 200. The second plate part 82 is located at the first bendable part 2002 and the second non-bendable part 2007 of the screen 200. The third plate part 83 is located at the second bendable part 2003 of the screen 200. The fourth plate part 84 is located at the third non-bendable part 2008 and the third bendable part 2004 of the screen 200. The fifth plate part 85 is located at the fourth non-bendable part 2005 of the screen 200.

The bearing plate 8 may be of an integrated structure. The plurality of plate parts (81, 82, 83, 84, and 85) of the bearing plate 8 are connected to each other, and each are a part of the bearing plate 8, so that connection firmness between the plurality of plate parts (81, 82, 83, 84, and 85) is better. In the accompanying drawings of this application, for example, the plurality of plate parts (81, 82, 83, 84, and 85) are distinguished by using dashed lines. In some other implementations, the plurality of plate parts (81, 82, 83, 84, and 85) of the bearing plate 8 may be alternatively connected and fastened to each other in a welding or clamping manner.

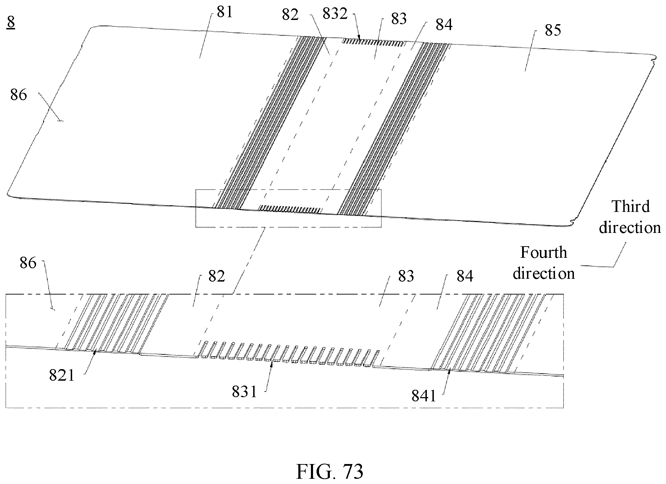

Refer to FIG. 72B and FIG. 73. FIG. 73 is a schematic diagram of a structure of the bearing plate 8 shown in FIG. 72B from another perspective.

In some embodiments, the third plate part 83 is provided with a plurality of through holes 831. The plurality of through holes 831 are arranged in a distributed manner and all penetrate the third plate part 83. The plurality of through holes 831 are configured to reduce rigidity of the third plate part 83, so that the third plate part 83 is easily bent. For example, the plurality of through holes 831 may be divided into a plurality of through hole groups. Each through hole group includes a plurality of through holes 831. The plurality of through hole groups may be arranged at intervals from the top end to the bottom end of the third plate part 83, that is, the plurality of through hole groups are arranged in the third direction.

A width of the through hole 831 in the fourth direction may be within a range of 0.15 mm to 0.30 mm, for example, 0.18 mm or 0.22 mm. A spacing between two adjacent through holes 831 in the fourth direction may be approximately within a range of 0.3 mm to 0.7 mm, for example, 0.4 mm, 0.52 mm, or 0.63 mm. This is not strictly limited in this application. For example, a shape of the through hole 831 may be a rhombus, a square, a dumbbell, a waist circle, or the like. This is not strictly limited in this application.

In some other embodiments, the third plate part 83 may include metal parts located at two ends and a soft rubber part located at the middle part. The metal part is spliced with the soft rubber part. Rigidity of the soft rubber part is less than rigidity of the metal part. The plurality of through holes 831 are formed at the metal part. In some other embodiments, the third plate part 83 may include an end metal part and a middle metal part. The plurality of through holes 831 are formed at the end metal part. A thickness of the middle metal part is less than a thickness of the end metal part.

In other words, the rigidity of the third plate part 83 may be reduced by disposing the through hole and a groove, reducing a thickness, splicing a soft rubber member, and the like, to obtain better bending performance and tensile performance. A specific material and structure of the third plate part 83 are not strictly limited in this application.

For example, the second plate part 82 is provided with a plurality of first elongated grooves 821. Openings of the plurality of first elongated grooves 821 are located on a lower surface 801 of the bearing plate 8. The plurality of first elongated grooves 821 are arranged at intervals in the fourth direction. The first elongated groove 821 extends in the third direction, and two ends of the first elongated groove 821 respectively extend to a bottom end surface and a top end surface of the second plate part 82. The plurality of first elongated grooves 821 are located on one side that is of the second plate part 82 and that is close to the first plate part 81. The plurality of first elongated grooves 821 are disposed at a part that is of the second plate part 82 and that is located at the first bendable part 2002 of the screen 200. A part that is of the second plate part 82 and that is located at the second non-bendable part 2007 of the screen 200 may be of a complete plate body structure.

A size of the opening of the first elongated groove 821 in the fourth direction may be within a range from 0.7 mm to 0.9 mm, for example, 0.75 mm or 0.79 mm. A groove depth of the first elongated groove 821 may be within a range from 0.05 mm to 0.1 mm, for example, 0.075 mm. A spacing between two adjacent first elongated grooves 821 in the fourth direction may be approximately within a range from 0.2 mm to 0.4 mm, for example, 0.3 mm. This is not strictly limited in this application.

For example, the fourth plate part 84 is provided with a plurality of second elongated grooves 841. Openings of the plurality of second elongated grooves 841 are located on the lower surface 86 of the bearing plate 8. The plurality of second elongated grooves 841 are arranged at intervals in the fourth direction. The second elongated groove 841 extends in the third direction, and two ends of the second elongated groove 841 respectively extend to a bottom end surface and a top end surface of the fourth plate part 84. The plurality of second elongated grooves 841 are located on one side that is of the fourth plate part 84 and that is close to the fifth plate part 85. The plurality of second elongated grooves 841 are disposed at a part that is of the fourth plate part 84 and that is located at the third bendable part 2004 of the screen 200. A part that is of the fourth plate part 84 and that is located at the third non-bendable part 2008 of the screen 200 may be of a complete plate body structure.

Sizes of the plurality of second elongated grooves 841 may be designed with reference to those of the plurality of first elongated grooves 821. Certainly, sizes of the plurality of second elongated grooves 841 may be alternatively different from those of the plurality of first elongated grooves 821.

In this embodiment, rigidity of the part that is of the second plate part 82 and that is located at the first bendable part 2002 of the screen 200 is less than rigidity of the part that is of second plate part 82 and that is located at the second non-bendable part 2007. Rigidity of the part that is of the fourth plate part 84 and that is located at the third bendable part 2004 is less than rigidity of the part that is of fourth plate part 84 and that is located at the third non-bendable part 2008. The groove structures on the second plate part 82 and the fourth plate part 84 are configured to reduce rigidity and improve bending performance and tensile performance. The rigidity of the second plate part 82 and the fourth plate part 84 may be alternatively reduced by drilling holes, replacing a material with lower rigidity, locally thinning, or the like. This is not strictly limited in this application.

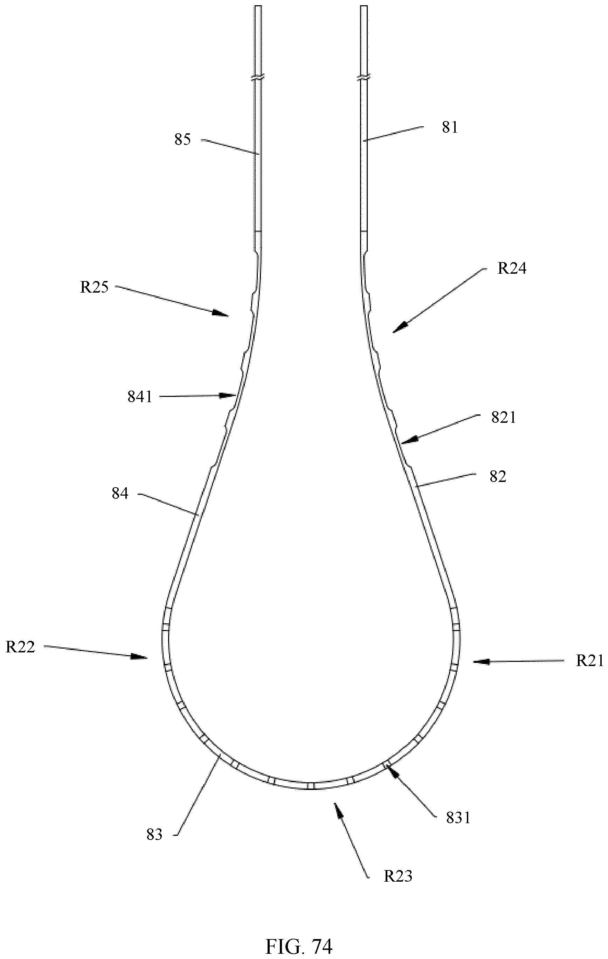

Refer to FIG. 73 and FIG. 74. FIG. 74 is a schematic diagram of a structure of the bearing plate 8 shown in FIG. 73 in a closed state.

In some embodiments, when the bearing plate 8 is in the closed state, an end part that is of the third plate part 83 and that is close to the second plate part 82 forms a first arc section R21. The middle part of the third plate part 83 forms a second arc section R22. An end part that is of the third plate part 83 and that is close to the fourth plate part 84 forms a third arc section R23. An end part that is of the second plate part 82 and that is close to the first plate part 81 forms a fourth arc section R24. An end that is of the fourth plate part 84 and that is close to the fifth plate part 85 forms a fifth arc section R25. Refer to FIG. 69. The first arc section R21, the second arc section R22, the third arc section R23, the fourth arc section R24, and the fifth arc section R25 of the bearing plate 8 are respectively a part of each of the first arc section R11, the second arc section R12, the third arc section R13, the fourth arc section R14, and the fifth arc section R15 of the screen 200.

The plurality of through holes 831 are arranged on the first arc section R21, the second arc section R22, and the third arc section R23 of the bearing plate 8. The plurality of first elongated grooves 821 are arranged on the fourth arc section R24 of the bearing plate 8. The plurality of second elongated grooves 841 are arranged on the fifth arc section R25 of the bearing plate 8.

In this application, the bearing plate 8 may be made of a material that has specific strength and hardness and that can be bent under an action of external force, to provide rigid support for the flexible display 7. In this embodiment, the through hole or groove structures are disposed on the arc sections (R21, R22, R23, R24, and R25) of the bearing plate 8, to reduce stress applied to the arc sections (R21, R22, R23, R24, and R25) of the bearing plate 8, that is, reduce bending stress of a bendable part of the bearing plate 8, so as to improve an elastic deformation capability and a bending life of the bearing plate 8. In this way, the bearing plate 8 can better deform as the screen 200 is unfolded and folded, to reduce a risk that the screen 200 has a display problem, for example, a shadow, and improve reliability of the screen 200.

In addition, both a bending stress problem during folding and a flatness problem during unfolding can be considered by using a structural design of the groove at the second plate part 82, a structural design of the through hole at an end part of the third plate part 83, and a structural design of the groove at the fourth plate part 84 of the bearing plate 8, to provide more reliable support for the flexible display 7, so that reliability of the screen 200 is higher. In addition, the first plate part 81 and the fifth plate part 85 may be complete plate members, to provide large-area and complete rigid support for a non-bendable part of the flexible display 7, so that reliability of the screen 200 is high.

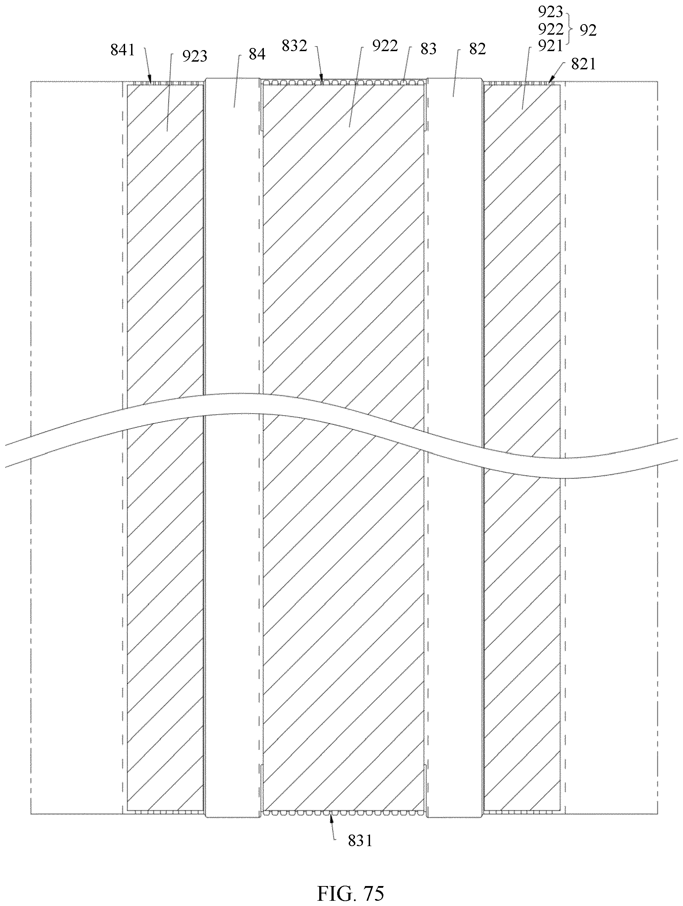

Refer to FIG. 73 and FIG. 75. FIG. 75 is a schematic diagram of a structure obtained after the bearing plate 8 and the protection film 92 that are shown in FIG. 72B are assembled. In FIG. 75, to more clearly present the position of the protection film 92, cross-sectional line filling is shown on a structure of the protection film 92.

In some embodiments, the protection film 92 may include a first part 921, a second part 922, and a third part 923 that are independent of each other. The first part 921 is elongated and is fastened to a lower surface of the second plate part 82, and the first part 921 covers all or some of the first elongated grooves 821. The second part 922 is elongated and is fastened to a lower surface of the third plate part 83, and the second part 922 covers all or some of the through holes 831. The third part 923 is elongated and is fastened to the lower surface of the fourth plate part 84, and the third part 923 covers all or some of the second elongated grooves 841.

For example, the protection film 92 may be made of a polyurethane (polyurethane, PU) material or another material, and the protection film 92 can deform with the bearing plate 8. The protection film 92 is configured to prevent a structure (for example, the rotating shaft connection assembly 3 or the hinge assembly 2) below the bearing plate 8 from directly scraping the bearing plate 8, so that the structure of the bearing plate 8 is stable and has high reliability. A lower surface of the protection film 92 may be provided with a rough surface structure.

In some other embodiments, the protection film 92 may be alternatively made of a material having better flexibility, for example, thermoplastic polyurethane (Thermoplastic polyurethane, TPU), a thermoplastic elastomer (Thermoplastic Elastomer, TPE), or rubber.

In some embodiments, the first part 921 may be further partially embedded into the first elongated groove 821. The second part 922 may be further partially embedded into the through hole 831. The third part 923 may be further partially embedded into the second elongated groove 841.

In some other embodiments, the screen 200 may further include a reinforcement plate. The reinforcement plate is located between the flexible display 7 and the bearing plate 8, and the reinforcement plate is configured to jointly support and protect the flexible display 7 with the bearing plate 8, to improve rigidity of the screen 200, so that reliability of the screen 200 is higher. The reinforcement plate may be a thin metal sheet or non-metal sheet. A shape and a size of the reinforcement plate may match those of the flexible display 7, to present a complete surface structure.

The following describes several variant structures of the bearing plate 8 with reference to the accompanying drawings. The following embodiments may include some features in the foregoing embodiments, and most same content is not described again.

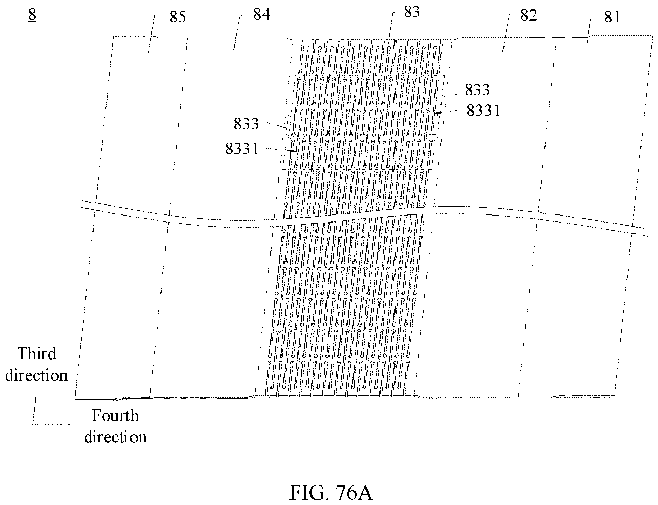

Refer to FIG. 72A and FIG. 76A. FIG. 76A is a schematic diagram of a structure of the bearing plate 8 shown in FIG. 72A in some other embodiments.

In some embodiments, the bearing plate 8 includes a first plate part 81, a second plate part 82, a third plate part 83, a fourth plate part 84, and a fifth plate part 85 that are sequentially arranged in the fourth direction. The first plate part 81 is located at the first non-bendable part 2001 of the screen 200. The second plate part 82 is located at the first bendable part 2002 and the second non-bendable part 2007 of the screen 200. The third plate part 83 is located at the second bendable part 2003 of the screen 200. The fourth plate part 84 is located at the third non-bendable part 2008 and the third bendable part 2004 of the screen 200. The fifth plate part 85 is located at the fourth non-bendable part 2005 of the screen 200.

The bearing plate 8 may be of an integrated structure. The plurality of plate parts (81, 82, 83, 84, and 85) of the bearing plate 8 are connected to each other, so that connection firmness between the plurality of plate parts (81, 82, 83, 84, and 85) is better. In the accompanying drawing of this application, for example, the plurality of plate parts (81, 82, 83, 84, and 85) are distinguished by using dashed lines. In some other implementations, the plurality of plate parts (81, 82, 83, 84, and 85) of the bearing plate 8 may be alternatively connected and fastened to each other in a welding or clamping manner.

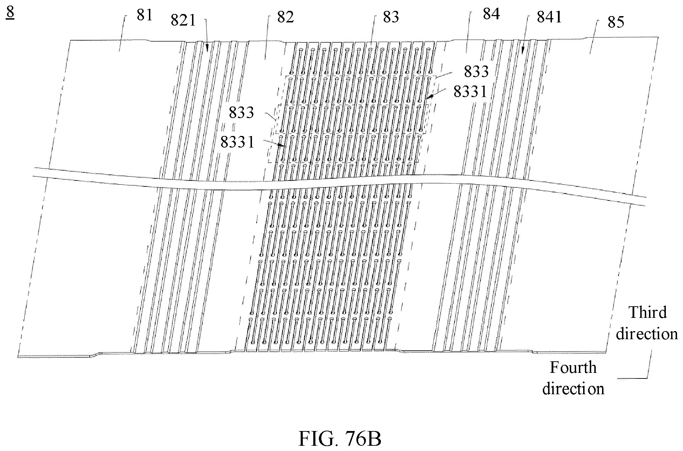

Refer to FIG. 76A and FIG. 76B. FIG. 76B is a schematic diagram of a structure of the bearing plate 8 shown in FIG. 76A from another perspective.

In some embodiments, the third plate part 83 is provided with a plurality of elongated through hole groups 833. The plurality of elongated through hole groups 833 are arranged in the third direction. Each elongated through hole group 833 includes a plurality of elongated through holes 8331 arranged at intervals in the fourth direction. Each elongated through hole 8331 is approximately in a strip shape and extends in the third direction, and each elongated through hole 8331 penetrates the third plate part 83.

For example, the second plate part 82 is provided with a plurality of first elongated grooves 821. The plurality of first elongated grooves 821 are arranged at intervals in the fourth direction. The first elongated groove 821 extends in the third direction, and two ends of the first elongated groove 821 respectively extend to a bottom end surface and a top end surface of the second plate part 82. The plurality of first elongated grooves 821 are located on one side that is of the second plate part 82 and that is close to the first plate part 81.

For example, the fourth plate part 84 is provided with a plurality of second elongated grooves 841. Openings of the plurality of second elongated grooves 841 are located on a bottom surface of the bearing plate 8. The plurality of second elongated grooves 841 are arranged at intervals in the fourth direction. The second elongated groove 841 extends in the third direction, and two ends of the second elongated groove 841 respectively extend to a bottom end surface and a top end surface of the fourth plate part 84. The plurality of second elongated grooves 841 are located on one side that is of the fourth plate part 84 and that is close to the fifth plate part 85.

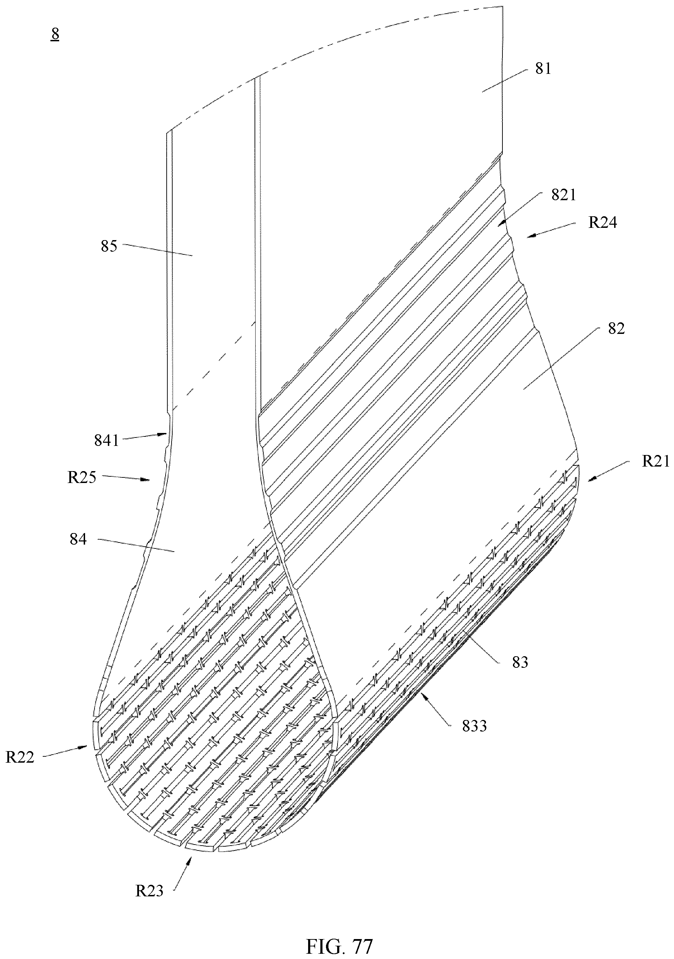

FIG. 77 is a schematic diagram of a structure of the bearing plate 8 shown in FIG. 76A in a closed state.

In some embodiments, when the bearing plate 8 is in the closed state, an end part that is of the third plate part 83 and that is close to the second plate part 82 forms a first arc section R21. The middle part of the third plate part 83 forms a second arc section R22. An end part that is of the third plate part 83 and that is close to the fourth plate part 84 forms a third arc section R23. An end part that is of the second plate part 82 and that is close to the first plate part 81 forms a fourth arc section R24. An end that is of the fourth plate part 84 and that is close to the fifth plate part 85 forms a fifth arc section R25. Refer to FIG. 69. The first arc section R21, the second arc section R22, the third arc section R23, the fourth arc section R24, and the fifth arc section R25 of the bearing plate 8 are respectively a part of each of the first arc section R11, the second arc section R12, the third arc section R13, the fourth arc section R14, and the fifth arc section R15 of the screen 200.

The plurality of elongated through hole groups 833 are arranged on the first arc section R21, the second arc section R22, and the third arc section R23 of the bearing plate 8. The plurality of first elongated grooves 821 are arranged on the fourth arc section R24 of the bearing plate 8. The plurality of second elongated grooves 841 are arranged on the fifth arc section R25 of the bearing plate 8.

In this application, the bearing plate 8 may be made of a material that has specific strength and hardness and that can be bent under an action of external force, to provide rigid support for the flexible display 7. In this embodiment, the through hole or groove structures are disposed on the arc sections of the bearing plate 8, to reduce stress applied to the arc sections of the bearing plate 8, that is, reduce bending stress of a bendable part of the bearing plate 8, so as to improve an elastic deformation capability of the bearing plate 8. In this way, the bearing plate 8 can better deform as the screen 200 is unfolded and folded, to reduce a risk that the screen 200 has a display problem, for example, a shadow, and improve reliability of the screen 200.

In addition, both a bending stress problem during folding and a flatness problem during unfolding can be considered by using a structural design of the groove at the second plate part 82, a structural design of the elongated through hole 8331 at the third plate part 83, and a structural design of the groove at the fourth plate part 84 of the bearing plate 8, to provide more reliable support for the flexible display 7, so that reliability of the screen 200 is higher. In addition, the first plate part 81 and the fifth plate part 85 may be complete plate members, to provide large-area and complete rigid support for a non-bendable part of the flexible display 7, so that reliability of the screen 200 is high.

In addition, the third plate part 83 is provided with at least two elongated through hole groups 833, and each elongated through hole group 833 includes a plurality of elongated through holes 8331, to avoid excessive stress concentration on the third plate part 83, so as to ensure that the third plate part 83 has better flexibility. In other words, in a process of unfolding or folding the electronic device 1000, because the third plate part 83 has better flexibility, impact of the third plate part 83 on bending of the flexible display 7 is small.

Refer to FIG. 76A. For example, a plurality of elongated through holes 8331 of two adjacent elongated through hole groups 833 are staggered. In some embodiments, an end part of the elongated through hole 8331 in one elongated through hole group 833 may be located between two adjacent elongated through holes 8331 in another elongated through hole group 833. To be specific, the two elongated through hole groups 833 may reuse a part of space in the third direction.

In this embodiment, when the bearing plate 8 is sectioned in the fourth direction, the third plate part 83 is divided into a plurality of parts by each of the elongated through holes 8331. In other words, the third plate part 83 has no continuous part. In this case, flexibility of the third plate part 83 is further improved. In this way, in the process of unfolding or folding the electronic device 1000, the third plate part 83 has better flexibility, and therefore impact of the third plate part 83 on bending of the flexible display 7 is small.

In some other embodiments, two adjacent elongated through hole groups 833 may be alternatively disposed at intervals in the third direction. In some other embodiments, a plurality of elongated through holes 8331 in two adjacent elongated through hole groups 833 may be alternatively arranged opposite to each other, partially arranged opposite to each other, or partially arranged in a staggered manner, or may be arranged in another manner.

For example, each elongated through hole 8331 includes a first end part, a middle part, and a second end part that are sequentially connected. In the fourth direction, a width of the first end part is greater than a width of the middle part, and a width of the second end part is greater than the width of the middle part. The width of the first end part may be the same as or different from the width of the second end part. In this case, the elongated through hole 8331 is approximately in a dumbbell shape.

Both the first end part and the second end part may be circular holes, and the middle part is a strip-shaped hole. In this case, a production technology of the elongated through hole 8331 is simple and is easy to operate. In some other embodiments, both the first end part and the second end part may be alternatively special-shaped holes, and the middle part may be alternatively a trapezoidal hole. This is not strictly limited in this application. In some other embodiments, the elongated through hole 8331 may be alternatively in another shape, for example, a rhombus, a square, a dumbbell, or a waist circle.

It may be understood that, when the elongated through hole 8331 is disposed in an approximate dumbbell shape, on one hand, because the width of the middle part of the elongated through hole 8331 is narrower, there is a larger quantity of remaining materials between two adjacent elongated through holes 8331 in the fourth direction. In this way, the third plate part 83 has sufficient strength. On another hand, because the width of the first end part and the width the second end part are wider, even if the width of the middle part is narrower, a volume of the elongated through hole 8331 is not reduced. In this way, when the third plate part 83 has sufficient strength, flexibility of the third plate part 83 is not significantly reduced. In other words, hardness of the third plate part 83 in this embodiment is moderate.

It may be understood that, when the electronic device 1000 is in an open state, the third plate part 83 has sufficient hardness to support a bendable part of the flexible display 7, to prevent the bendable part of the flexible display 7 from having a collapse problem or a screen push problem. To be specific, it is ensured that the flexible display 7 has better surface flatness, to avoid the flexible display 7 having a problem, for example, a block spot or a bright line. In a process of unfolding or folding the electronic device 1000, because the third plate part 83 has better flexibility, impact of the third plate part 83 on bending of the flexible display 7 is small.

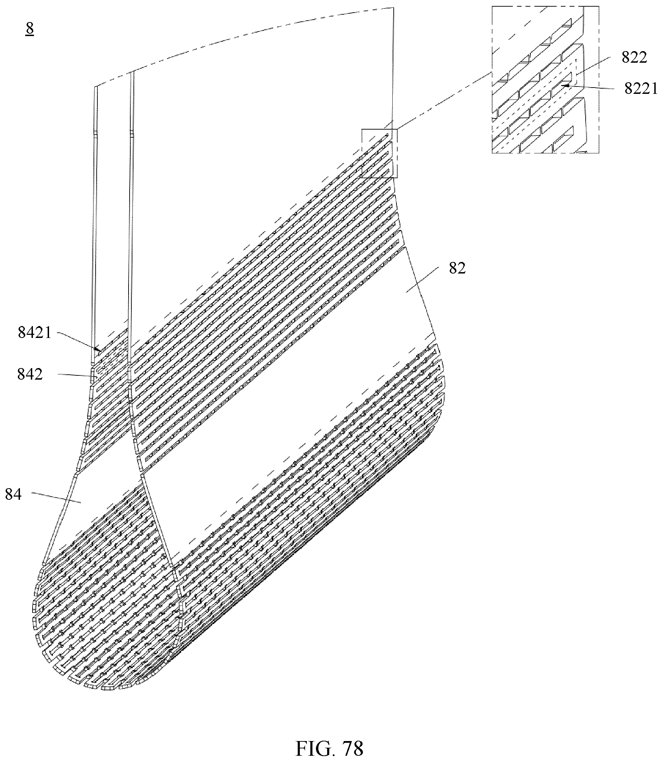

FIG. 78 is a schematic diagram of a structure of the bearing plate 8 shown in FIG. 72A in some other embodiments. The bearing plate 8 shown in FIG. 78 includes most technical features of the bearing plate 8 shown in FIG. 76A to FIG. 77. A main difference between the bearing plate 8 shown in FIG. 78 and the bearing plate 8 shown in FIG. 76A to FIG. 77 lies in that, in this embodiment, the plurality of first elongated grooves 821 in the foregoing embodiments are replaced with a plurality of first through hole groups 822, and the plurality of second elongated grooves 841 in the foregoing embodiments are replaced with a plurality of second through hole groups 842.

Specifically, the second plate part 82 includes a plurality of first through hole groups 822. Each first through hole group 822 includes a plurality of first through holes 8221 arranged at intervals. The plurality of first through hole groups 822 are arranged at intervals. An arrangement direction of the plurality of first through hole groups 822 is perpendicular to an arrangement direction of the plurality of first through holes 8221 in a single first through hole group 822. A plurality of first through holes 8221 in two adjacent first through hole groups 822 may be arranged opposite to each other, partially arranged opposite to each other, or partially arranged in a staggered manner.

The fourth plate part 84 includes a plurality of second through hole groups 842. Each second through hole group 842 includes a plurality of second through holes 8421 arranged at intervals. The plurality of second through hole groups 842 are arranged at intervals. An arrangement direction of the plurality of second through hole groups 842 is perpendicular to an arrangement direction of the plurality of second through holes 8421 in a single second through hole group 842. A plurality of second through holes 8421 in two adjacent second through hole groups 842 may be arranged opposite to each other, partially arranged opposite to each other, or partially arranged in a staggered manner.

In this embodiment, for positions of the plurality of first through hole groups 822 of the second plate part 82, refer to the positions of the plurality of first elongated grooves 821 in the foregoing embodiment, and for positions of the plurality of second through hole groups 842 of the fourth plate part 84, refer to the positions of the plurality of second elongated grooves 841 in the foregoing embodiment. For another technical feature of the bearing plate 8, refer to the foregoing embodiments. Details are not described herein again.

In this application, the bearing plate 8 may be made of a plurality of materials. The following provides an example for description.

In some embodiments, the bearing plate 8 may be made of a material, for example, a stainless steel material, an aluminum alloy, a magnesium alloy, a titanium alloy, or a copper alloy. For example, Table 1 is a List 1 of parameters of the materials of the bearing plate 8, including parameter descriptions of an aluminum alloy 6013, a magnesium alloy AZ31B, a titanium alloy TC4, stainless steel 316 3/4H, and a copper alloy C1940H. Certainly, the bearing plate 8 may be alternatively made of stainless steel SUS301, SUS304, or SUS316L, a titanium alloy TC4 or TA2, or the like.

**Table 1 List 1 of the parameters of the materials of the bearing plate 8**

| | Density (g/cm³) | Elastic modulus (GPa) | Yield strength (MPa) | Elongation rate (%) | Hardness (HV) | Thermal conductivity (W/(m·°C)) |
|---|---|---|---|---|---|---|
| Aluminum alloy 6013 | 2.69 | 69 | 370 | 8 | 130 | 160 |
| Magnesium alloy AZ31B | 1.8 | 42 | 150 | 5 | 70 | 80 |
| Titanium alloy TA4 | 4.5 | 110 | 600 | 20 | 300 | 6.8 |
| Stainless steel 316 3/4H | 7.9 | 193 | 665 | 3 | 310 | 16 |
| Copper alloy C1940H | 8.9 | 110 | 400 | 5 | 130 | 280 |

As shown in the foregoing table, the aluminum alloy and the magnesium alloy have better heat dissipation performance, but have smaller elastic moduli and poorer support performance. The stainless steel and the titanium alloy are materials with larger moduli, have better support performance, but have a poorer heat dissipation capability and a heavier weight. The copper alloy has better heat dissipation performance but has an excessively heavy weight. Requirements of the bearing plate 8 on a weight, an elastic modulus, strength, and heat conduction performance are balanced as much as possible through material selection and by using a structural design.

In addition, an embodiment of this application further provides a new material of the bearing plate 8, so that the weight, the elastic modulus, the strength, and the heat conduction performance of the bearing plate 8 are all considered by using a material design. In some embodiments, the material of the bearing plate 8 has density that is less than or equal to 4.0 g/cm³, and the material of the bearing plate 8 has an elastic modulus that is greater than or equal to 80 GPa, yield strength that is greater than or equal to 300 MPa, and a thermal conductivity that is greater than or equal to 90 W/(m·°C).

For example, the material of the bearing plate 8 is a metal matrix composite material, for example, may be an aluminum matrix or magnesium matrix composite material reinforced by particles made of silicon carbide, aluminum oxide, boron carbide, a carbon nanotube, graphene, chromium carbide, silicon boride, titanium boride, titanium carbide, or the like.

In some embodiments, the material of the bearing plate 8 may be the particle reinforced aluminum matrix composite material, for example, a SiC (silicon nitride) particle reinforcing phase with a mass fraction of 20% and a 6061 aluminum alloy matrix with a mass fraction of 80%, a SiC (silicon nitride) particle reinforcing phase with a mass fraction of 17% and a 6013 aluminum alloy matrix with a mass fraction of 83%, a CNT (carbon nanotube) particle reinforcing phase with a mass fraction of 15% and a 5052 aluminum alloy matrix with a mass fraction of 85%, or a graphene (graphene) particle reinforcing phase with a mass fraction of 25% and a 6063 aluminum alloy matrix with a mass fraction of 75%. Table 2 is a List 2 of parameters of the materials of the bearing plate 8. Table 2 includes comparison between density, elastic moduli, yield strength, and thermal conductivities of the several particle reinforced aluminum matrix composite materials enumerated above and the parameters of the materials of the bearing plate 8 mentioned above.

**Table 2 List 2 of the parameters of the materials of the bearing plate 8**

| | Density (g/cm³) | Elastic modulus (GPa) | Yield strength (MPa) | Thermal conductivity (W/(m·°C)) |
|---|---|---|---|---|
| 20% of SiC and 80% of 6061 | 2.8 | 103 | 400 | 150 |
| 17% of SiC and 83% of 6013 | 2.78 | 95 | 500 | 155 |
| 15% of CNT and 85% of 5052 | 2.73 | 80 | 350 | 130 |
| 25% of graphene and 75% of 6063 | 2.76 | 85 | 400 | 200 |
| Aluminum alloy 6013 | 2.69 | 69 | 370 | 160 |
| Magnesium alloy AZ31B | 1.8 | 42 | 150 | 80 |
| Titanium alloy TA4 | 4.5 | 110 | 600 | 6.8 |
| Stainless steel 316 1/2H | 7.92 | 193 | 470 | 15.9 |
| Copper alloy C1940H | 8.9 | 110 | 400 | 280 |

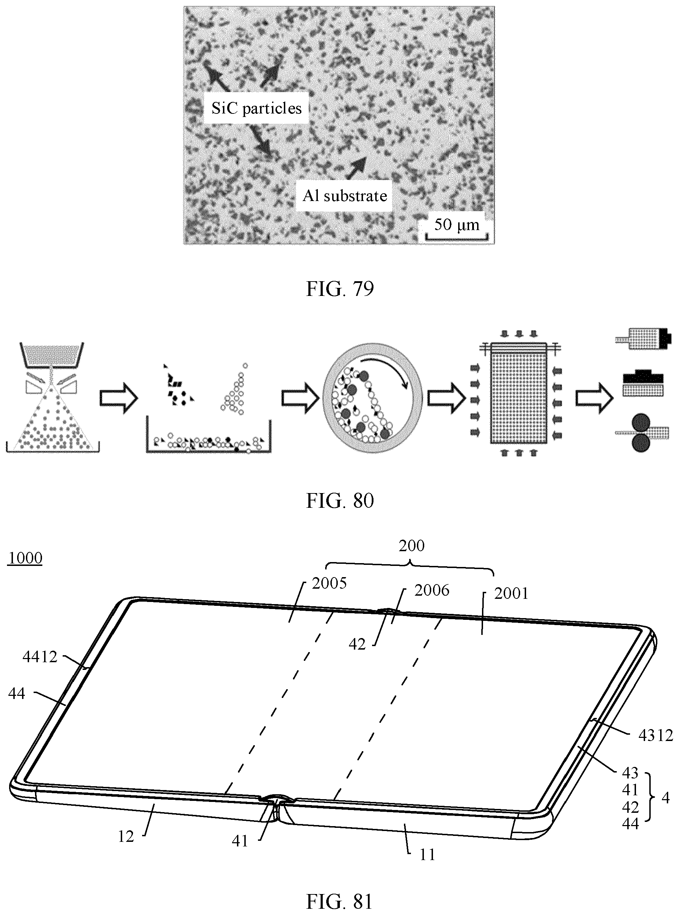

FIG. 79 is a partial scanning electron microscopy diagram of the bearing plate 8 according an embodiment of this application. In the figure, black particles are SiC particles, and remaining light-colored parts are an Al substrate. In FIG. 79, the SiC particles are dispersed in the Al substrate.

In some other embodiments, the material of the bearing plate 8 may be alternatively the particle reinforced magnesium matrix composite material, for example, a SiC (silicon nitride) particle reinforcing phase with a mass fraction of 20% and an AZ91 magnesium alloy matrix with a mass fraction of 80%, a SiC (silicon nitride) particle reinforcing phase with a mass fraction of 25% and a ZK60 magnesium alloy matrix with a mass fraction of 75%, or a CNT (carbon nanotube) particle reinforcing phase with a mass fraction of 30% and an AZ61 magnesium alloy matrix with a mass fraction of 70%. Table 3 is a List 3 of parameters of the materials of the bearing plate 8. Table 3 includes comparison between density, elastic moduli, yield strength, and thermal conductivities of the several particle reinforced aluminum matrix composite materials enumerated above and the parameters of the materials of the bearing plate 8 mentioned above.

**Table 3 List 3 of the parameters of the materials of the bearing plate 8**

| | Density (g/cm³) | Elastic modulus (GPa) | Yield strength (MPa) | Thermal conductivity (W/(m·°C)) |
|---|---|---|---|---|
| 20% of SiC and 80% of AZ91 | 1.9 | 80 | 300 | 80 |
| 25% of SiC and 75% of ZK60 | 2.0 | 83 | 400 | 83 |
| 30% of CNT and 70% of AZ61 | 2.0 | 90 | 350 | 95 |
| Aluminum alloy 6013 | 2.69 | 69 | 370 | 160 |
| Magnesium alloy AZ31B | 1.8 | 42 | 150 | 80 |
| Titanium alloy TA4 | 4.5 | 110 | 600 | 6.8 |
| Stainless steel 316 1/2H | 7.92 | 193 | 470 | 15.9 |
| Copper alloy C1940H | 8.9 | 110 | 400 | 280 |

FIG. 80 is a partial schematic flowchart of a production method of the bearing plate 8 according to an embodiment of this application.

In some embodiments, the metal matrix composite material may be made into a metal sheet by using technologies such as pulverization, batching, mixing, rough forming, and fine forming, and then a pattern is formed on the metal sheet by using a technology, for example, etching, to form the bearing plate 8. The pulverization, the batching, the mixing, the rough forming, and the fine forming respectively correspond to a first step to a fifth step in FIG. 80. A processing manner of the fine forming includes but is not limited to extrusion molding, forging forming, rolling forming (also referred to as calendering forming), die molding, and the like. For example, a thickness of the metal sheet may be within a range of 0.05 mm to 0.4 mm.

It may be understood that, in some other embodiments, the screen 200 may be alternatively provided with no structure of the bearing plate 8, and the screen 200 may alternatively obtain a supporting environment by using another structure, to ensure reliability of the screen 200. This is not strictly limited in this application.

The following describes a structure of a component of the protection assembly 4 of the electronic device 1000 and a connection structure between the protection assembly 4 and another component with reference to the accompanying drawings.

In some embodiments, as shown in FIG. 66, after the screen 200, the first housing 11, and the second housing 12 are assembled, an edge of the screen 200 is exposed. Both the bottom part and the top part of the hinge assembly 2 are partially exposed relative to the screen 200. An exposed part is provided with an installation structure. An edge of the first housing 11 is exposed relative to the screen 200, and the edge of the first housing 11 is provided with an installation structure. The installation structure may be, for example, embodied as a concave-convex structure. An edge of the second housing 12 is exposed relative to the screen 200, and the edge of the second housing 12 is provided with an installation structure. The installation structure may be, for example, embodied as a concave-convex structure.

Refer to FIG. 66 and FIG. 81. FIG. 81 is a schematic diagram of another structure of the electronic device 1000 shown in FIG. 1A.

In some embodiments, the first protector 41 can be installed on a bottom installation structure of the hinge assembly 2, and a part of a structure of the first protector 41 covers a part of a bottom edge of the bendable part 2006 of the screen 200. The second protector 42 can be installed on a top installation structure of the hinge assembly 2, and a part of a structure of the second protector 42 covers a part of a top edge of the bendable part 2006 of the screen 200. The first protection housing 43 can be installed on the installation structure of the first housing 11. A part of a structure of the first protection housing 43 continuously covers a part of the bottom edge of the bendable part 2006, an edge of the first non-bendable part 2001, a top edge of the bendable part 2006, and a part of a top edge of the fourth non-bendable part 2005. The second protection housing 44 can be installed on the installation structure of the second housing 12. A part of a structure of the second protection housing 44 continuously covers a part of the bottom edge of the bendable part 2006, an edge of the fourth non-bendable part 2005, the top edge of the bendable part 2006, and a part of the top edge of the fourth non-bendable part 2005.

In this embodiment, the first protector 41, the first protection housing 43, the second protector 42, and the second protection housing 44 of the protection assembly 4 continuously cover the edge of the screen 200, to prevent the edge of the screen 200 from being opened outside, so as to improve an appearance effect of the electronic device 1000, protect the edge of the screen 200, reduce damage, for example, a tilt of the screen 200, and improve reliability of the screen 200.

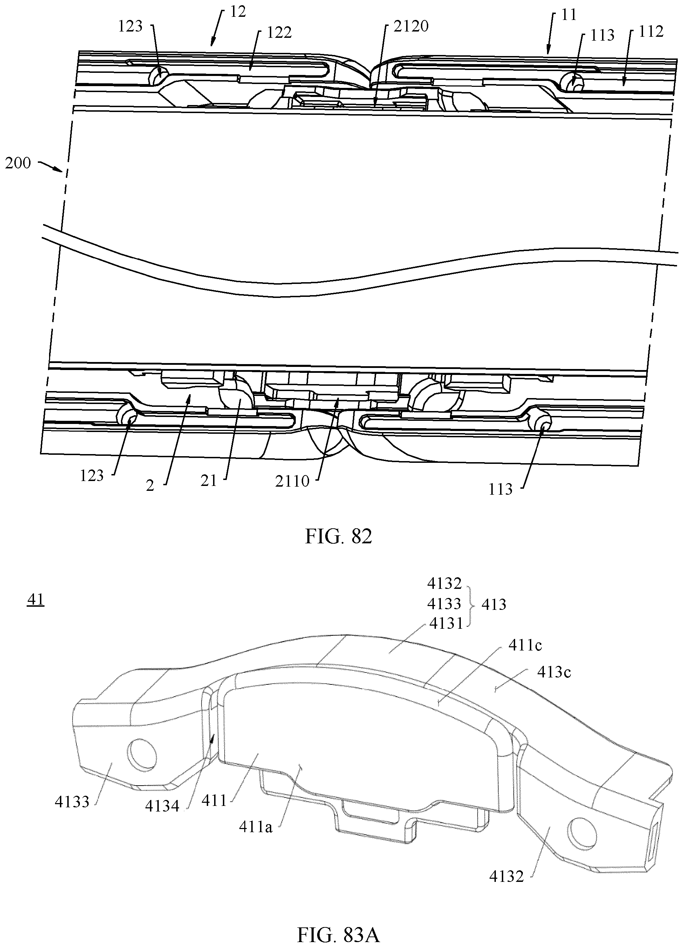

Refer to FIG. 81 and FIG. 82. FIG. 82 is a schematic diagram of a partial structure of the structure shown in FIG. 66.

In some embodiments, the first clamping slot 2110 at the bottom end and the second clamping slot 2120 at the top end of the shaft 21 of the hinge assembly 2 are exposed relative to the screen 200. The first clamping slot 2110 is configured to install the first protector 41. The second clamping slot 2120 is configured to install the second protector 42.

For example, the edge of the first housing 11 is provided with a first installation slot 112. The first installation slot 112 is configured to install the first protection housing 43. For example, the first installation slot 112 may be an elongated groove, and extends along the edge of the first housing 11 (refer to FIG. 66). One end of the first installation slot 112 may extend to the bottom side of the hinge assembly 2, and another end of the first installation slot 112 may extend to the top side of the hinge assembly 2. The elongated groove may be a continuous integrated groove, or may include a plurality of groove sections that are disconnected and arranged in an extension direction. This is not strictly limited in this embodiment of this application.

The first housing 11 may be further provided with a plurality of first positioning holes 113. The plurality of first positioning holes 113 are all located below the first installation slot 112 and connected to the first installation slot 112. To be specific, an opening of the first positioning hole 113 is located on a slot bottom wall of the first installation slot 112. At least two first positioning holes 113 are disposed respectively close to two ends of the first installation slot 112.

For example, the edge of the second housing 12 is provided with a second installation slot 122. The second installation slot 122 is configured to install the first protection housing 43. For example, the second installation slot 122 may be an elongated groove, and extends along the edge of the second housing 12 (refer to FIG. 66). One end of the second installation slot 122 may extend to the bottom side of the hinge assembly 2, and another end of the second installation slot 122 may extend to the top side of the hinge assembly 2. The elongated groove may be a continuous integrated groove, or may include a plurality of groove sections that are disconnected and arranged in an extension direction. This is not strictly limited in this embodiment of this application.

The second housing 12 may be further provided with a plurality of second positioning holes 123. The second positioning holes 123 are located below the second installation slot 122 and connected to the second installation slot 122. To be specific, an opening of the second positioning hole 123 is located on a slot bottom wall of the second installation slot 122. At least two second positioning holes 123 are disposed respectively close to two ends of the second installation slot 122.

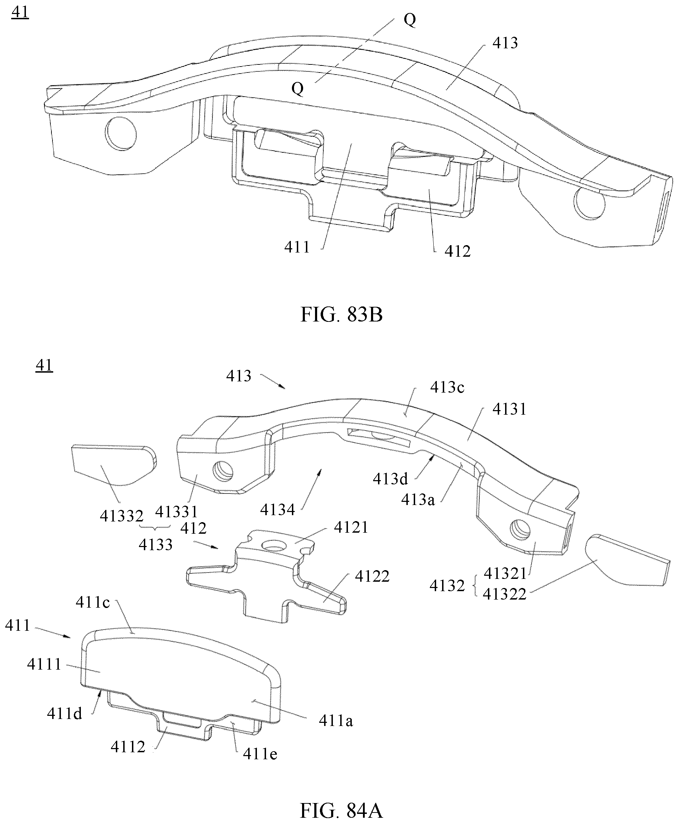

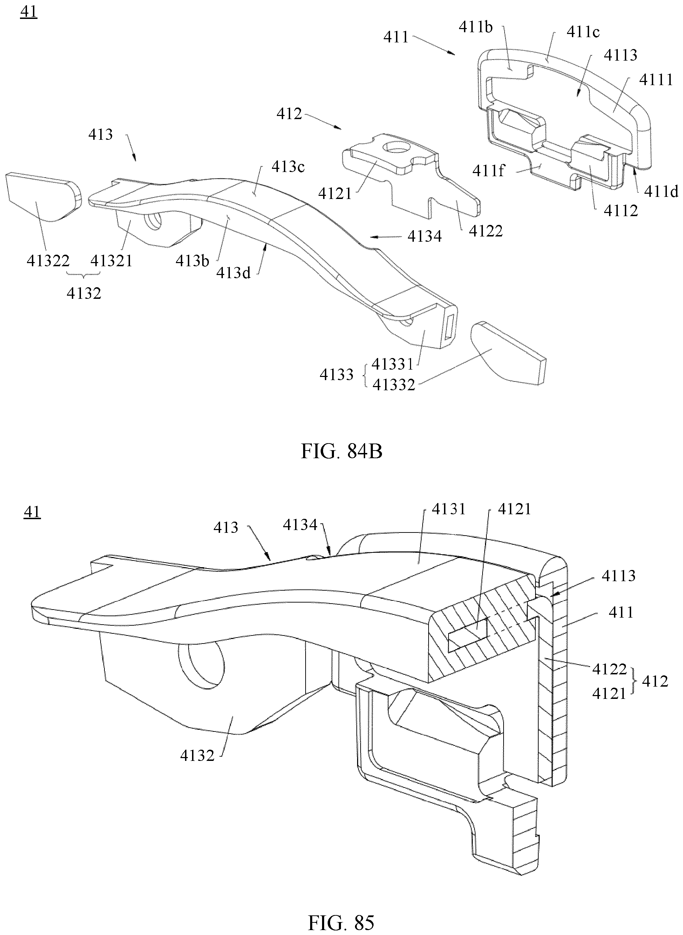

Refer to FIG. 83A, FIG. 83B, FIG. 84A, and FIG. 84B. FIG. 83A is a schematic diagram of a structure of the first protector 41 shown in FIG. 81 from another perspective. FIG. 83B is a schematic diagram of a structure of the first protector 41 shown in FIG. 83A from another perspective. FIG. 84A is a schematic diagram of a decomposition structure of the first protector 41 shown in FIG. 83A. FIG. 84B is a schematic diagram of a structure of the first protector 41 shown in FIG. 83A from another perspective.

In some embodiments, the first protector 41 includes a rigid member 411, a connector 412, and a soft rubber member 413. The rigid member 411 is connected to the soft rubber member 413 by using the connector 412. In this embodiment, rigidity of the rigid member 411 and the connector 412 is greater than rigidity of the soft rubber member 413. The soft rubber member 413 is an elastically deformable member. In other words, under an action of same external force, the soft rubber member 413 is more likely to deform, but the rigid member 411 and the connector 412 are less likely to deform.

For example, both the rigid member 411 and the connector 412 may be metal members, to have higher rigidity. For example, the rigid member 411 and the connector 412 may be made of various types of metal materials, such as stainless steel, cast iron, and aluminum, or alloy materials. It may be understood that, in another embodiment of this application, the rigid member 411 and the connector 412 may be alternatively mechanical members made of another type of material. For example, in some embodiments, the rigid member 411 or the connector 412 may be a ceramic member or a rigid plastic member. The material of the rigid member 411 may be the same as or different from the material of the connector 412. This is not strictly limited in this application.

The soft rubber member 413 is an elastically deformable member, and the soft rubber member 413 has lower rigidity and can be bent and deform. In some embodiments of this application, the soft rubber member 413 is made of an elastically deformable soft rubber material. For example, the soft rubber material for forming the soft rubber member 413 may be silica gel, TPE, TPU, polyvinyl chloride (polyvinyl chloride, PVC) soft rubber, or rubber (for example, silicone rubber, natural rubber, cis-1,4-polybutadiene rubber, styrene-butadiene rubber, or propylene rubber). It may be understood that the soft rubber member 413 in this application may be alternatively made of another material that can implement elastic deformation. The another material is not enumerated herein.

In some embodiments, as shown in FIG. 84A and FIG. 84B, the rigid member 411 includes a main body part 4111 and an insertion part 4112 connected to the main body part 4111. For example, the main body part 4111 of the rigid member 411 may be approximately of a plate-like structure. The main body part 4111 of the rigid member 411 includes a first surface 411a and a second surface 411b that are disposed backing onto each other. The first surface 411a is a part of an appearance surface of the first protector 41. The main body part 4111 of the rigid member 411 further includes an upper end surface 411c and a lower end surface 411d that are disposed backing onto each other. Both the upper end surface 411c and the lower end surface 411d are located between the first surface 411a and the second surface 411b. The middle part of the upper end surface 411c of the main body part 4111 may protrude relative to two sides of the upper end surface 411c. For example, the upper end surface 411c may be approximately arc-shaped. The middle part of the lower end surface 411d of the main body part 4111 may protrude relative to two sides of the lower end surface 411d.

For example, the upper end of the insertion part 4112 of the rigid member 411 is fixedly connected to the lower end of the main body part 4111. A step structure is formed at a joint between the upper end of the insertion part 4112 and the lower end of the main body part 4111. The lower end surface 411d of the main body part 4111 of the rigid member 411 forms a step surface.

For example, the insertion part 4112 of the rigid member 411 may be approximately of a plate-like structure. For example, the insertion part 4112 of the rigid member 411 may be approximately in a "T" shape. To be specific, the insertion part 4112 of the rigid member 411 includes a horizontal part and a vertical part. The horizontal part is located at the upper end of the insertion part 4112 and connected to the main body part 4111 of the rigid member 411, and the vertical part is located at the lower end of the insertion part 4112. The insertion part 4112 of the rigid member 411 includes a third surface 411e and a fourth surface 411f that are disposed backing onto each other. The third surface 411e and the first surface 411a face a same direction, and the fourth surface 411f and the second surface 411b face a same direction. The fourth surface 411f is located on one side that is of the second surface 411b and that backs onto the first surface 411a, and the third surface 411e is located on one side that is of the fourth surface 411f and that is close to the first surface 411a. The third surface 411e of the insertion part 4112 of the rigid member 411 is concave relative to the first surface 411a of the main body part 4111.

For example, the rigid member 411 is provided with an installation groove 4113. The installation groove 4113 is located at the main body part 4111 and the insertion part 4112. An opening of the installation groove 4113 is partially located on the second surface 411b and partially located on the fourth surface 411f. For example, the installation groove 4113 may be approximately in a "+" shape.

For example, a width of the insertion part 4112 of the rigid member 411 may be less than a width of the main body part 4111. Refer to FIG. 81. When the first protector 41 is used in the electronic device 1000, a width direction of the rigid member 411 is parallel to a direction from the first bendable part 2002 to the third bendable part 2004 of the screen 200.

For example, a width of the lower end of the insertion part 4112 of the rigid member 411 may be less than a width of the upper end of the insertion part 4112. In this embodiment, the upper end of the insertion part 4112 is configured to be mutually fastened to the main body part 4111. The larger thickness of the upper end of the insertion part 4112 helps improve structural strength of the rigid member 411. In addition, the lower end of the insertion part 4112 is configured to be inserted into another structure, and the smaller thickness helps reduce insertion difficulty. It may be understood that the lower end of the insertion part 4112 is slightly thin only relative to the upper end of the insertion part 4112, and the lower end of the insertion part 4112 is still thick enough to ensure connection strength between the first protector 41 and another structure.

For example, the rigid member 411 may be produced by using a metal injection molding machining technology, and the rigid member 411 is an integrated mechanical member. In this embodiment, the rigid member 411 with high dimensional precision can be obtained through metal injection molding, so that the first protector 41 fits another structure of the electronic device 1000. In addition, the rigid member 411 obtained through metal injection molding has uniform organization and high relative density at all positions, so that the rigid member 411 has high rigidity, to achieve a better protection effect on the edge of the screen 200. In addition, surface finish of the rigid member 411 is good, so that the electronic device 1000 can have a good appearance effect. It may be understood that, in another embodiment of this application, the rigid member 411 may be alternatively formed by using another technology, for example, formed in a manner, for example, CNC machining forming or die casting molding.

In some embodiments, as shown in FIG. 84A and FIG. 84B, the soft rubber member 413 includes a protection part 4131, a first position-limiting part 4132, and a second position-limiting part 4133. The first position-limiting part 4132 and the second position-limiting part 4133 are located on a same side of the protection part 4131. The first position-limiting part 4132 is connected to one end of the protection part 4131, and the second position-limiting part 4133 is connected to another end of the protection part 4131.

For example, the middle part of the protection part 4131 may protrude relative to two ends of the protection part 4131. In other words, the protection part 4131 is in a shape whose middle part is high and whose two ends are low. The protection part 4131 includes a first surface 413a and a second surface 413b that are disposed backing onto each other, and further includes an upper surface 413c and a lower surface 423d that are disposed backing onto each other. The upper surface 413c and the lower surface 423d are located between the first surface 411a and the second surface 411b. Both the upper surface 413c and the lower surface 423d are in a shape whose middle is high and whose two ends are low. The upper surface 413c is a smooth surface.

For example, the first position-limiting part 4132 and the second position-limiting part 4133 may be located on one side that is of the first surface 413a of the protection part 4131 and that backs onto the second surface 413b, and are fixedly connected to the first surface 413a. For example, the upper end of the first position-limiting part 4132 is connected to the first surface 413a. The first position-limiting part 4132 is bent relative to the protection part 4131 towards the lower part of the protection part 4131. An upper end surface of the first position-limiting part 4132 is smoothly connected to the upper surface 413c of the protection part 4131. The upper end of the second position-limiting part 4133 is connected to the first surface 413a. The second position-limiting part 4133 is bent relative to the protection part 4131 towards the lower part of the protection part 4131. An upper end surface of the second position-limiting part 4133 is smoothly connected to the upper surface 413c of the protection part 4131. The first position-limiting part 4132 and the second position-limiting part 4133 protrude relative to the first surface 413a. The first position-limiting part 4132, the first surface 413a, and the second position-limiting part 4133 jointly form recessed installation space 4134.

For example, the first position-limiting part 4132, the second position-limiting part 4133, and the protection part 4131 may be an integrated structure obtained through injection molding, so that the first position-limiting part 4132 and the second position-limiting part 4133 can be combined with the protection part 4131 more firmly. This avoids separation of the first position-limiting part 4132 and the second position-limiting part 4133 from the protection part 4131 in a folding process of the electronic device 1000, to ensure quality of the electronic device 1000. For example, it may be understood that, in some other embodiments of this application, the first position-limiting part 4132 and the second position-limiting part 4133 may be alternatively fastened to the protection part 4131 in another manner, for example, bonding.

For example, the first position-limiting part 4132 includes a first main body 41321 and a first stiffener 41322. The upper end of the first main body 41321 is connected to one end of the protection part 4131. The first stiffener 41322 is embedded into the first main body 41321. Rigidity of the first stiffener 41322 is greater than rigidity of the first main body 41321, so that rigidity of the first position-limiting part 4132 is high. This avoids obvious deformation of the first position-limiting part 4132, and helps improve rigidity of one end of the soft rubber member 413. A material of the first main body 41321 may be the same as a material of the protection part 4131. The first stiffener 41322 may be made of a rigid material, for example, a metal material, a ceramic material, or plastic. The first main body 41321 and the first stiffener 41322 may be integrated into an integrated structure by using a technology, for example, in-mold injection molding, or may be fastened to each other in a manner, for example, clamping or bonding. In some other embodiments, the first position-limiting part 4132 may be alternatively provided with no first stiffener 41322.

The second position-limiting part 4133 includes a second main body 41331 and a second stiffener 41332. The upper end of the second main body 41331 is connected to another end of the protection part 4131. The second stiffener 41332 is embedded into the second main body 41331. Rigidity of the second stiffener 41332 is greater than rigidity of the second main body 41331, so that rigidity of the second position-limiting part 4133 is high. This avoids obvious deformation of the second position-limiting part 4133, and helps improve rigidity of another end of the soft rubber member 413. A material of the second main body 41331 may be the same as the material of the protection part 4131. The second stiffener 41332 may be made of a rigid material, for example, a metal material, a ceramic material, or plastic. The second main body 41331 and the second stiffener 41332 may be integrated into an integrated structure by using a technology, for example, in-mold injection molding, or may be fastened to each other in a manner, for example, clamping or bonding. In some other embodiments, the second position-limiting part 4133 may be alternatively provided with no second stiffener 41332.

For example, the soft rubber member 413 may be of a symmetric structure. For example, the protection part 4131 of the soft rubber member 413 is of a symmetric structure, and the second position-limiting part 4133 and the first position-limiting part 4132 are of mutually symmetric structures. Certainly, the soft rubber member 413 may be alternatively of an asymmetric structure. This is not strictly limited in this application.

In some other embodiments, the soft rubber member 413 may alternatively have only the protection part 4131, and have no first insertion part 4112 and second insertion part 4112.

In some embodiments, as shown in FIG. 84A and FIG. 84B, the connector 412 includes a first part 4121 and a second part 4122. The upper end of the second part 4122 is connected to one side of the first part 4121, and the second part 4122 is bent relative to the first part 4121. The first part 4121 may be provided with a hole structure, for example, a through hole, notch, and/or groove structure. The second part 4122 may be approximately in a "+" shape.

For example, the connector 412 may be produced by using a metal injection molding machining technology, and the connector 412 is an integrated mechanical member. In this embodiment, the connector 412 with high dimensional precision can be obtained through metal injection molding, so that the connector 412 is connected to the rigid member 411 and the soft rubber member 413, to improve structural stability and reliability of the first protector 41. Certainly, the connector 412 may be alternatively formed by using another technology, for example, formed in a manner, for example, CNC machining forming or die casting molding.

Refer to FIG. 83A to FIG. 84B, and FIG. 85. FIG. 85 is a schematic diagram of a cross-sectional structure of the first protector 41 that is cut along a cross section Q-Q and that is shown in FIG. 83B.

In some embodiments, the first part 4121 of the connector 412 is embedded into the protection part 4131 of the soft rubber member 413. In this embodiment, the first part 4121 of the connector 412 and the soft rubber member 413 are of an integrated structure that can be obtained by using an integrated molding technology. For example, the first part 4121 of the connector 412 and the soft rubber member 413 are of the integrated structure obtained through injection molding. Specifically, the formed connector 412 is put into a mold, and then a fused soft rubber material is filled into the mold. After the fused soft rubber material is cooled and solidified, the soft rubber member 413 in this embodiment is formed. The first part 4121 of the connector 412 is embedded into the protection part 4131 of the soft rubber member 413, and forms an integrated structure with the protection part 4131 of the soft rubber member 413. In this embodiment, the soft rubber member 413 and the first part 4121 of the connector 412 are formed into the integrated structure, to ensure a stable connection effect between the soft rubber member 413 and the connector 412, and ensure quality of the first protector 41, so as to improve quality of the electronic device 1000.

In addition, when the first part 4121 of the connector 412 and the protection part 4131 of the soft rubber member 413 are formed into the integrated structure, the hole structure of the first part 4121 is also filled with a soft rubber material for forming the protection part 4131. To be specific, a contact area between the first part 4121 of the connector 412 and the protection part 4131 of the soft rubber member 413 can be increased by using the hole structure, to further improve stability of a connection between the first part 4121 of the connector 412 and the protection part 4131 of the soft rubber member 413.

It may be understood that, in another embodiment of this application, the soft rubber member 413 may be alternatively connected to the first part 4121 of the connector 412 by using another connection technology, for example, glue bonding or clamping. For example, in some other embodiments, the first surface 411a of the protection part 4131 of the soft rubber member 413 is provided with a groove that is concave toward the second surface 411b. The first part 4121 of the connector 412 is inserted into the groove, and the first part 4121 of the connector 412 is fastened to a groove wall of the groove by using viscose glue.

In some embodiments, the second part 4122 of the connector 412 is installed in the installation groove 4113 of the rigid member 411 and fixedly connected to the rigid member 411. The second part 4122 of the connector 412 and the rigid member 411 may be fastened to each other in a manner, for example, bonding, welding, a fastener connection, or clamping. In this embodiment, the connector 412 can firmly connect the soft rubber member 413 and the rigid member 411, so that a structure of the first protector 41 is stable and has high reliability. In some other embodiments, the rigid member 411 may be alternatively provided with no installation groove 4113. The second part 4122 of the connector 412 is located on one side of the second surface 411b of the rigid member 411 and fixedly connected to the second surface 411b of the rigid member 411.

In this embodiment, when the second part 4122 of the connector 412 is fixedly connected to the rigid member 411 through bonding, the second part 4122 of the connector 412 is installed in the installation groove 4113 of the rigid member 411, so that viscose glue used to glue the rigid member 411 and the connector 412 can be accommodated in a position of the installation groove 4113, and is unlikely to flow to another position that does not need to be connected to the second part 4122 of the connector 412. In this way, it can be ensured that the viscose glue can effectively bond and fasten the second part 4122 of the connector 412 to an inner wall of the installation groove 4113. In addition, the rigid member 411 is provided with the installation groove 4113, a shape of the second part 4122 of the connector 412 matches a shape of the installation groove 4113, and a groove wall of the installation groove 4113 can limit shaking of the second part 4122 of the connector 412 in all directions in the installation groove 4113, to reduce a problem that the second part 4122 may be separated from the rigid member 411 when the electronic device 1000 is collided.

For example, the rigid member 411 is embedded into the installation space 4134 of the soft rubber member 413, and the first position-limiting part 4132 and the second position-limiting part 4133 of the soft rubber member 413 can prevent the rigid member 411 from shaking relative to the soft rubber member 413, to ensure stability of a connection between the rigid member 411 and the soft rubber member 413. It may be understood that, in another embodiment of this application, there may be no installation space 4134 on the protection part 4131. The rigid member 411 is located on one side of the first surface 413a of the protection part 4131, and the second surface 411b of the rigid member 411 is in contact with the first surface 413a of the protection part 4131.

For example, as shown in FIG. 83A, bending shapes of the upper end surface 411c of the rigid member 411 and the upper end surface 413c of the protection part 4131 of the soft rubber member 413 are approximately the same, and the upper end surface 411c and the upper end surface 413c may be approximately in a flush position relationship, to improve aesthetics of the first protector 41. Herein, the bending shape of the upper end surface 413c of the protection part 4131 of the soft rubber member 413 is a shape of the upper end surface 413c when the electronic device 1000 is in an open state.

For example, as shown in FIG. 83A, surfaces that are of the first position-limiting part 4132 and the second position-limiting part 4133 of the soft rubber member 413 and that back onto the protection part 4131 may be flush with the first surface 411a of the rigid member 411. Certainly, the surfaces that are of the first position-limiting part 4132 and the second position-limiting part 4133 of the soft rubber member 413 and that back onto the protection part 4131 may alternatively have another position relationship with the first surface 411a of the rigid member 411. This is not strictly limited in this application.

It may be understood that, in some other embodiments, the second part 4122 of the connector 412 and the main body part 4111 of the rigid member 411 may be also of an integrated structure obtained in a manner of integrated molding, and the formed rigid member 411 or connector 412 does not need to be fastened together in a fastening manner, for example, glue bonding, welding, a screw, or a snap-fit, so that the rigid member 411 and the connector 412 can be connected more firmly. In this embodiment of this application, because the soft rubber member 413 and the first part 4121 of the connector 412 are also of the integrated structure obtained by using an integrated molding technology, the soft rubber member 413 and the rigid member 411 are more stably connected by using the connector 412.

Specifically, in this embodiment, the connector 412 and the rigid member 411 are made of a same type of metal material. The rigid member 411 and the connector 412 are obtained through integrated molding in a manner of metal injection molding, so that the connector 412 and the second part 4122 of the rigid member 411 are of an integrated structure, to connect the second part 4122 of the connector 412 to the main body part 4111 of the rigid member 411. In this case, the first part 4121 of the connector 412 protrudes from a surface of the rigid member 411. Then, the connector 412 and the rigid member 411 that are of an integrated structure are put into a mold, and a fused soft rubber material is filled in the mold. After the fused soft rubber material is cooled and solidified, the soft rubber member 413 in this embodiment is formed, and the first part 4121 of the connector 412 is embedded into the soft rubber member 413. The soft rubber member 413 and the first part 4121 of the connector 412 are formed into the integrated structure.

It should be noted that, in this embodiment, because the connector 412 and the rigid member 411 are of a structure made of the same material, the second part 4122 of the connector 412 and the rigid member 411 may form a whole when being integrated. In this case, the second part 4122 of the connector 412 and the rigid member 411 are manually divided for ease of understanding, and no actual division interface exists. It may be understood that, in another embodiment of this application, the integrated structure of the connector 412 and the rigid member 411 may be alternatively obtained in a manner, for example, numerical control machining molding or die casting molding.

In some embodiments of this application, surfaces of the rigid member 411 and the soft rubber member 413 each may be coated with a plating layer, to further improve an appearance effect of the first protector 41. For example, in some embodiments, a color or a color system of the plating layer on the surface of the rigid member 411 is the same as that of the first housing 11 and/or the second housing 12 of the electronic device 1000, so that appearance colors of the electronic device 1000 are unified, to have a better appearance effect. In some embodiments, the plating layer can further prevent corrosion of external water, oxygen, or the like on the rigid member 411, to improve quality of the electronic device 1000.

In this application, the plating layer may be formed through vapor deposition by using a vapor deposition technology, or may be formed through deposition in a manner, for example, vapor deposition. A manner of forming the plating layer is not specifically limited herein.

In this application, a structure and a material of the second protector 42 may be designed with reference to those of the first protector 41. For example, the second protector 42 and the first protector 41 are same mechanical members, to reduce a type of a material of the electronic device 1000, so as to reduce costs of the electronic device 1000. A specific structure of the second protector 42 is not described again in this embodiment of this application.

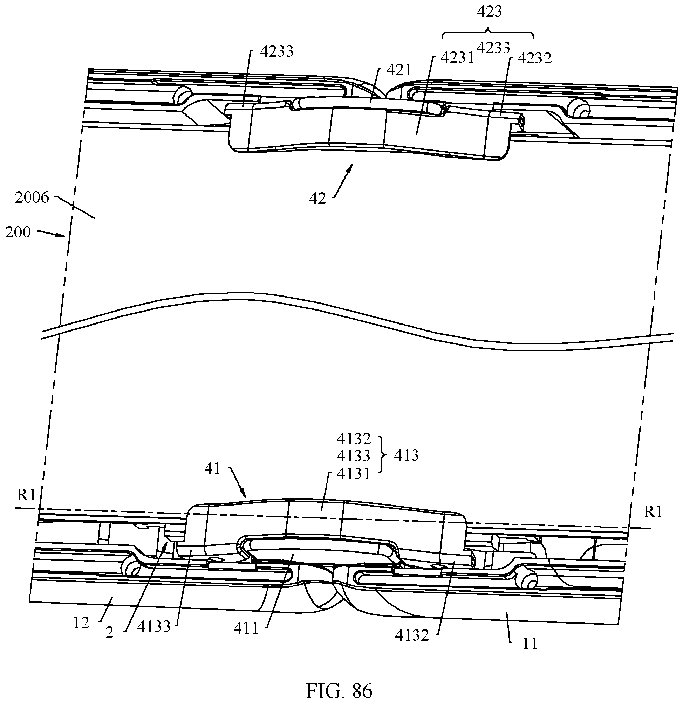

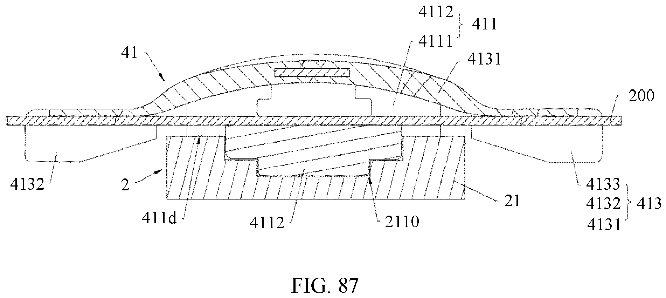

Refer to FIG. 82, FIG. 83A, FIG. 86, and FIG. 87. FIG. 86 is a schematic diagram of a partial structure of the electronic device 1000 shown in FIG. 1A. FIG. 87 is a schematic diagram of a cross-sectional structure of the structure that is cut along a cross section R1-R1 and that is shown in FIG. 86.

In some embodiments, the insertion part 4112 of the rigid member 411 of the first protector 41 is inserted into the first clamping slot 2110 of the shaft 21, and is fastened to the shaft 21. The protection part 4131 of the first protector 41 is located above a part of a bottom edge of the bendable part 2006 of the screen 200. The first position-limiting part 4132 of the first protector 41 is located between the hinge assembly 2 and the first housing 11. The second position-limiting part 4133 is located between the hinge assembly 2 and the second housing 12.

An insertion part of a rigid member 421 of the second protector 42 is inserted into the second clamping slot 2120 of the shaft 21, and is fastened to the shaft 21. A protection part 4231 of a soft rubber member 423 of the second protector 42 is located above a part of a top edge of the bendable part 2006 of the screen 200. A third position-limiting part 4232 of the second protector 42 is located between the hinge assembly 2 and the first housing 11. A fourth position-limiting part 4233 is located between the hinge assembly 2 and the second housing 12.

In this embodiment, the first protector 41 can block the part of the bottom edge of the bendable part 2006 of the screen 200, and the second protector 42 can block the part of the top edge of the bendable part 2006 of the screen 200. Therefore, the foregoing edges of the screen 200 can be prevented from being exposed outside, to improve an appearance effect, reduce a problem, for example, an edge tilt of the screen 200, and improve reliability of the screen 200 and the electronic device 1000.

In some embodiments of this application, there is a specific gap between the bottom edge of the bendable part 2006 of the screen 200 and the rigid member 411 of the first protector 41, and there is a specific gap between the top edge of the bendable part 2006 of the screen 200 and the rigid member 411 of the second protector 42. When the electronic device 1000 is collided, collision force acts on the rigid member 411, and is unlikely to be transferred to the screen 200 to damage the screen 200, to further improve reliability of the electronic device 1000.

For example, as shown in FIG. 87, the insertion part 4112 of the rigid member 411 of the first protector 41 may be fastened to a slot wall of the first clamping slot 2110 by using viscose glue. It may be understood that, in some other embodiments of this application, the rigid member 411 may be alternatively fastened to the shaft 21 in another manner. For example, the rigid member 411 may be fastened to the shaft 21 in various manners such as buckling and screw fastening. Details are not described herein.

For example, as shown in FIG. 87, the lower end surface 411d of the main body part 4111 of the rigid member 411 of the first protector 41 is in contact with a surface of the shaft 21, to ensure that the insertion part 4112 of the rigid member 411 can be more stable when being inserted into the shaft 21. A part that is of the main body part 4111 and that exceeds the insertion part 4112 in a width direction abuts against the surface of the shaft 21, to further ensure that the insertion part 4112 of the rigid member 411 can be more stable when being inserted into the first clamping slot 2110 of the shaft 21, and is unlikely to shake to fall off.

For example, as shown in FIG. 87, a gap is formed between the middle part of the soft rubber member 413 of the first protector 41 and the screen 200. Two ends of the soft rubber member 413 may be in contact with the screen 200, or may be close to but not in contact with the screen 200. This is not strictly limited in this application.

In some embodiments of this application, with reference to FIG. 86, a gap that is between the hinge assembly 2 and the first housing 11 and that is configured to install the first position-limiting part 4132 of the first protector 41 has a first size. The first size is greater than a thickness of the first position-limiting part 4132, so that the first position-limiting part 4132 is installed in the gap. In addition, the first size cannot be too large, to limit the first position-limiting part 4132 in specific space, and prevent the first position-limiting part 4132 from being stuck between the first housing 11 and the hinge assembly 2 due to deformation in a process of folding or unfolding the electronic device 1000. This ensures an appearance effect of the electronic device 1000 and a protection effect on an edge of the bendable part 2006 of the screen 200. In some embodiments of this application, the first size is less than twice the thickness of the first position-limiting part 4132. Similarly, a gap that is between the hinge assembly 2 and the second housing 12 and that is configured to install the second position-limiting part 4133 of the first protector 41 has a second size. The second size is greater than a thickness of the second position-limiting part 4133 and less than twice the thickness of the second position-limiting part 4133.

It should be understood that, for a position relationship, a connection relationship, and the like between the second protector 42, the hinge assembly 2, the screen 200, the first housing 11, and the second housing 12, refer to those of the first protector 41. Details are not described herein again.

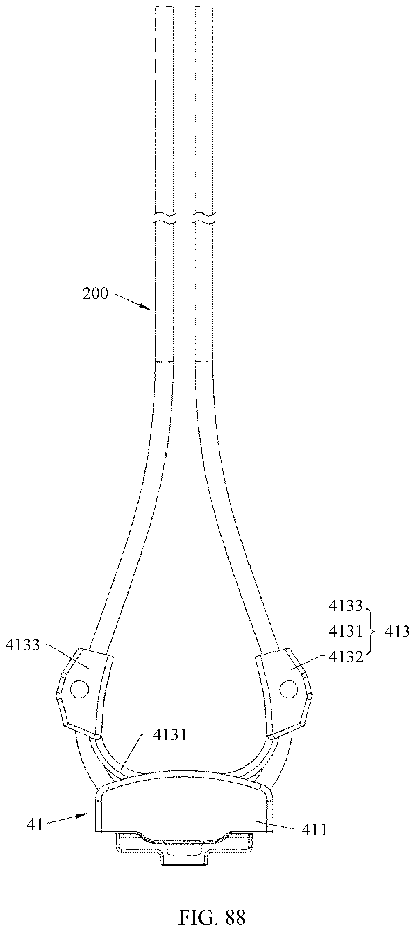

FIG. 88 is a schematic diagram of a structure when the screen 200 and the first protector 41 that are shown in FIG. 86 in a closed state.

In some embodiments, in the closed state, the screen 200 is bent, the protection part 4131 of the soft rubber member 413 of the first protector 41 is bent with the screen 200, two ends of the protection part 4131 are close to each other, and the first position-limiting part 4132 and the second position-limiting part 4133 are moved with the two ends of the protection part 4131 and are also close to each other. In this embodiment, in a process of folding the electronic device 1000, the rigid member 411 and the connector 412 (not shown in FIG. 88) of the first protector 41 do not deform, and the protection part 4131 of the first protector 41 is bent with the screen 200 due to stress of the screen 200 and/or stress of the housing, to still protect the edge of the screen 200 in the closed state. Similarly, in the closed state, the protection part 4131 of the second protector 42 can be also bent with the screen 200, and two ends of the protection part 4131 of the second protector 42 are closed to each other.

It may be understood that, after the protection part 4131 is bent with the screen 200 for a plurality of times, the protection part 4131 is likely to plastically deform, causing the two ends of the protection part 4131 to tilt in a direction away from the screen 200. In this embodiment of this application, the protection part 4131 is designed to be in a shape whose middle part protrudes relative to two sides, a gap is formed between the middle part of the protection part 4131 and the screen 200, and two sides of the protection part 4131 are in contact with the screen 200 or are close to the screen 200 relative to the middle part. In this way, the two sides of the protection part 4131 have initial deformation in a direction towards the screen 200, to partially neutralize deformation of the protection part 4131 after the plurality of times of bending, reduce a risk that two ends of the protection part 4131 tilt after the plurality of times of bending, and prolong a service life of the first protector 41. Therefore, reliability of the first protector 41 is better.

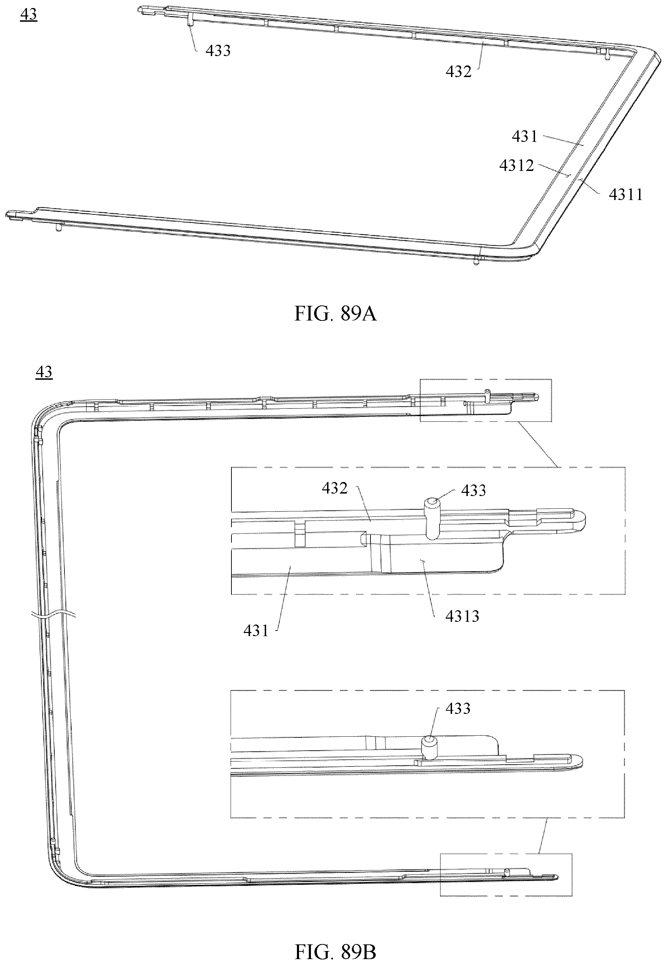

Refer to FIG. 89A and FIG. 89B. FIG. 89A is a schematic diagram of a structure of the first protection housing 43 shown in FIG. 2. FIG. 89B is a schematic diagram of a structure of the first protector 41 shown in FIG. 89A from another perspective.

In some embodiments, the first protection housing 43 includes a blocking frame part 431, an installation frame part 432, and a plurality of positioning parts 433. The blocking frame part 431 may be approximately of a bent strip-shaped structure, and the blocking frame part 431 may be bent into a "[" shape. The upper side of the blocking frame part 431 includes a first surface 4311 and a second surface 4312. The first surface 4311 extends from one end to another end of the blocking frame part 431. The second surface 4312 is located on an inner side of the first surface 4311 and connected to the first surface 4311. A lower surface 4313 of the blocking frame part 431 is disposed backing onto the first surface 4311 and the second surface 4312. The first surface 4311 and the second surface 4312 are away from each other in a direction close to the lower surface 4313. In other words, a cross-sectional shape of the blocking frame part 431 may be approximately triangular. The installation frame part 432 protrudes from the lower surface 4313 of the blocking frame part 431. The installation frame part 432 may be approximately of a bent protruding strip-shaped structure, and the installation frame part 432 extends from one end to the other end of the lower surface 4313 of the blocking frame part 431. The plurality of positioning parts 433 are fastened to a strip-shaped protrusion and protrude relative to the strip-shaped protrusion. The plurality of positioning parts 433 may be alternatively all fastened to the lower surface 4313 of the blocking frame part 431. Two ends of the installation frame part 432 each are provided with at least one positioning part 433. A structure of the positioning part 433 may be a positioning pin.

For example, the first protection housing 43 may be an integrated mechanical member. The first protection housing 43 may be made of a rigid material, for example, plastic. In this embodiment, a structure of the second protection housing 44 may be designed with reference to that of the first protection housing 43. Details are not described herein again.

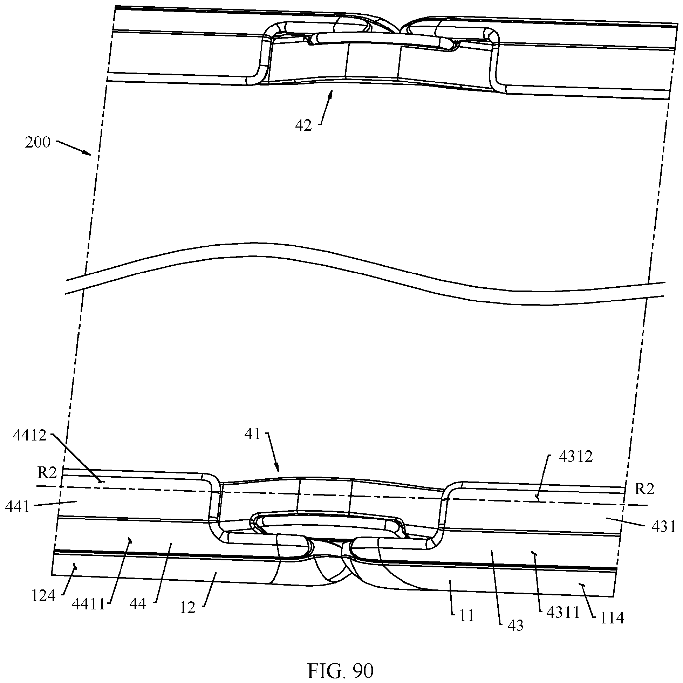

Refer to FIG. 86, FIG. 89A, and FIG. 90. FIG. 90 is a schematic diagram of a structure of the electronic device 1000 shown in FIG. 1A.

In some embodiments, the installation frame part 432 of the first protection housing 43 may be installed in the first installation slot 112 of the first housing 11. The plurality of positioning parts 433 of the first protection housing 43 are inserted into the plurality of first positioning holes 113 of the first housing 11 in a one-to-one correspondence. The blocking frame part 431 of the first protection housing 43 is located above the first housing 11, above a part of the edge of the screen 200, above one end of the first protector 41, and above one end of the second protector 42. The first surface 4311 of the first protection housing 43 may be smoothly transited to a side surface 114 of the first housing 11, to improve an appearance effect and a holding hand feeling of the electronic device 1000. Refer to FIG. 81. The second surface 4312 of the first protection housing 43 may block the bottom edge of the bendable part 2006, the edge of the first non-bendable part 2001, and a part of the top edge of the bendable part 2006 of the screen 200.

Similarly, an installation frame part of the second protection housing 44 may be installed in the second installation slot 122 of the second housing 12. A plurality of positioning parts of the second protection housing 44 are inserted into the plurality of second positioning holes 123 of the second housing 12 in a one-to-one correspondence. A blocking frame part 441 of the second protection housing 44 is located above the second housing 12, above a part of the edge of the screen 200, above another end of the first protector 41, and above another end of the second protector 42. A first surface 4411 of the second protection housing 44 may be smoothly transited to a side surface 124 of the first housing 11, to improve an appearance effect and a holding hand feeling of the electronic device 1000. Refer to FIG. 81. A second surface 4412 of the second protection housing 44 may block a part of the bottom edge of the bendable part 2006, the edge of the fourth non-bendable part 2005, and a part of the top edge of the bendable part 2006 of the screen 200.

For example, the installation frame part 432 of the first protection housing 43 and the first housing 11 may be fastened to each other through glue bonding or in another manner. The installation frame part of the second protection housing 44 and the second housing 12 may be fastened to each other through glue bonding or in another manner.

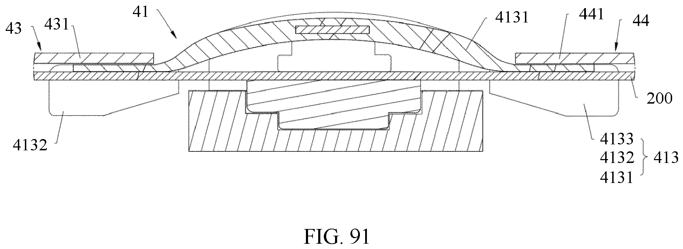

Refer to FIG. 90 and FIG. 91. FIG. 91 is a schematic diagram of a cross-sectional structure of the structure that is cut along a cross section R2-R2 and that is shown in FIG. 90. A position at which the cross section R2-R2 is located in FIG. 90 corresponds to a position at which the cross section R1-R1 is located in FIG. 86.

In some embodiments, one end of the protection part 4131 of the soft rubber member 413 of the first protector 41 is located between the screen 200 and the blocking frame part 431 of the first protection housing 43. The first position-limiting part 4132 is located below the blocking frame part 431 of the first protection housing 43. Another end of the protection part 4131 of the first protector 41 is located between the screen 200 and the blocking frame part 441 of the second protection housing 44. The second position-limiting part 4133 is located below the blocking frame part 441 of the second protection housing 44.

In this embodiment, one end of the protection part 4131 and the first position-limiting part 4132 of the soft rubber member 413 are pressed by the first protection housing 43, and another end of the protection part 4131 and the second position-limiting part 4133 are pressed by the second protection housing 44. Therefore, a problem that the protection part 4131 plastically deforms after being folded and unfolded with the screen 200 for a plurality of times, to tilt at the two ends can be avoided, so that reliability of the first protector 41 is high.

It should be understood that two ends of the second protector 42 are also respectively pressed by the first protection housing 43 and the second protection housing 44, and reliability of the second protector 42 is high.

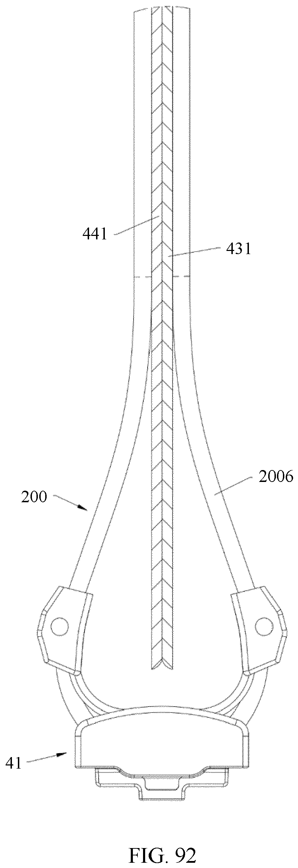

Refer to FIG. 91 and FIG. 92. FIG. 92 is a schematic diagram of a structure when the first protector 41, the first protection housing 43, the second protection housing 44, and the screen 200 that are shown in FIG. 91 are in a closed state.

In some embodiments, there is no direct fastening relationship, for example, bonding, between the blocking frame part 431 of the first protection housing 43 and the screen 200, and there is no direct fastening relationship, for example, bonding, between the blocking frame part 441 of the second protection housing 44 and the screen 200. In the closed state, the blocking frame part 431 of the first protection housing 43 and the blocking frame part 441 of the second protection housing 44 are close to each other, and the blocking frame part 431 and the blocking frame part 441 may be in contact with each other, abut against each other, or form a small gap. The bendable part 2006 of the screen 200 may be away from the blocking frame part 431 of the first protection housing 43 and the blocking frame part 441 of the second protection housing 44. The first protector 41 deforms with the screen 200, and is also away from the blocking frame part 431 of the first protection housing 43 and the blocking frame part 441 of the second protection housing 44.

The following describes several variant solutions of some components of the electronic device 1000 with reference to the accompanying drawings. It should be understood that features in the following embodiments may be mutually combined with features in the foregoing embodiments in a case of no conflict.

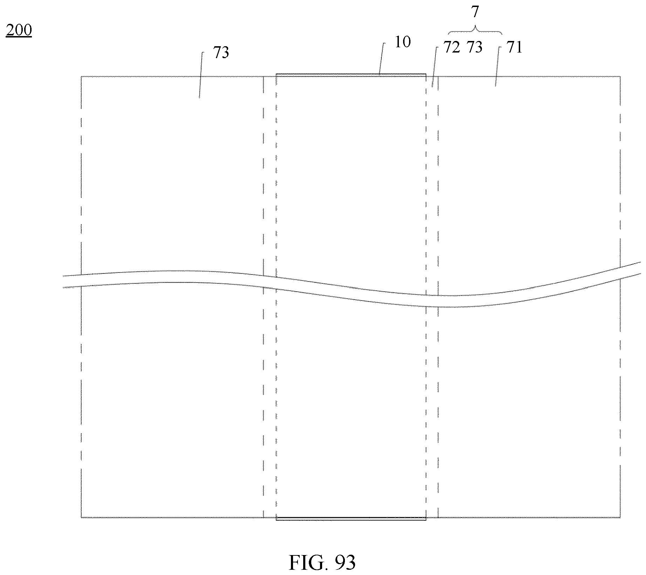

FIG. 93 is a schematic diagram of a structure of a screen 200 according to an embodiment of this application in some other embodiments. The screen 200 in this embodiment may include some features of the screen 200 in the foregoing embodiment.

In some embodiments, the screen 200 includes the flexible display 7 and the soft rubber support 10. The flexible display 7 includes a first non-bendable region 71, a bendable region 72, and a second non-bendable region 73 that are sequentially arranged. The first non-bendable region 71 of the flexible display 7 is located at the first non-bendable part of the screen 200. The bendable region 72 is located at a bendable part of the screen 200. The second non-bendable region 73 is located at the fourth non-bendable part of the screen 200. When the screen 200 is folded with the electronic device 1000, the first non-bendable region 71 and the second non-bendable region 73 of the flexible display 7 do not deform, and the bendable region 72 of the flexible display 7 deforms, for example, may be bent into a water drop shape. The soft rubber support 10 is located on a non-display side of the flexible display 7 and fastened to the bendable region 72 of the flexible display 7. The soft rubber support 10 is made of a deformable material. The soft rubber support 10 can elastically deform as the flexible display 7 is bent, to support the bendable region 72 of the flexible display 7 in real time. In this way, the flexible display 7 is unlikely to fail, and has high reliability.

For example, the soft rubber support 10 may be made of an elastic material, for example, silica gel, TPE, TPU, PVC soft rubber, or rubber. A material of the soft rubber support 10 is not strictly limited in this application. For example, the soft rubber support 10 may be integrated by using a technology, for example, injection molding.

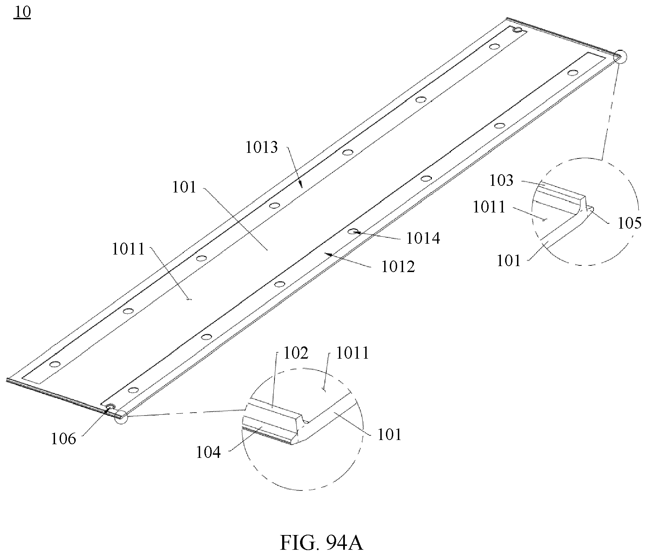

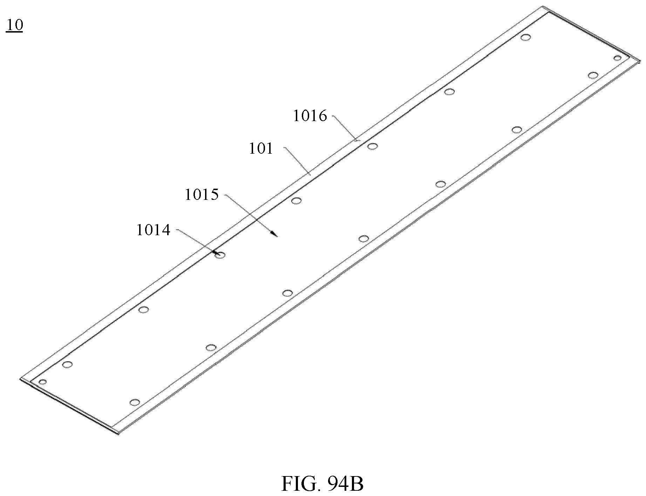

Refer to FIG. 94A and FIG. 94B. FIG. 94A is a schematic diagram of a structure of the soft rubber support 10 shown in FIG. 93. FIG. 94B is a schematic diagram of a structure of the soft rubber support 10 shown in FIG. 94A from another perspective.

In some embodiments, the soft rubber support 10 includes a body 101, a first side wall 102, a second side wall 103, a first flange 104, and a second flange 105. The body 101 may be approximately of an elongated plate-like structure. A direction from the top end to the bottom end of the body 101 is defined as an extension direction of the body 101. The first side wall 102 is located above a bottom edge of the body 101 and protrudes from an upper surface 1011 of the body 101. The first flange 104 protrudes from a bottom end surface of the body 101, and the first flange 104 protrudes relative to the first side wall 102. The second side wall 103 is located above a top edge of the body 101 and protrudes from the upper surface 1011 of the body 101. The second flange 105 protrudes from a top end surface of the body 101, and the second flange 105 protrudes relative to the second side wall 103.

For example, the body 101 is provided with a first elongated groove 1012 and a second elongated groove 1013. Openings of the first elongated groove 1012 and the second elongated groove 1013 are both located on the upper surface 1011 of the body 101. Extension directions of the first elongated groove 1012 and the second elongated groove 1013 are parallel to the extension direction of the body 101. The first elongated groove 1012 and the second elongated groove 1013 are arranged at an interval, and are arranged in a direction perpendicular to the extension direction of the body 101. The body 101 is further provided with a plurality of through holes 1014 arranged in a distributed manner. The through holes 1014 penetrate the body 101. The first elongated groove 1012 is connected to at least one through hole 1014, and the second elongated groove 1013 is connected to at least one through hole 1014.

In this embodiment, when the soft rubber support 10 is fastened to the flexible display 7, the soft rubber support 10 may be first aligned with the flexible display 7. A lower surface of the flexible display 7 is in contact with the upper surface 1011 of the body 101 of the soft rubber support 10. The flexible display 7 is located between the first side wall 102 and the second side wall 103 of the soft rubber support 10. Then, glue is dispensed in the plurality of through holes 1014, so that the glue spreads to the first elongated groove 1012 and the second elongated groove 1013, to bond the soft rubber support 10 and the flexible display 7. The soft rubber support 10 may further include a plurality of positioning holes 106, configured to assist alignment.

Certainly, the body 101 may be alternatively provided with more elongated grooves. This is not strictly limited in this application. In some other embodiments, the soft rubber support 10 and the flexible display 7 may be alternatively bonded to each other by using another adhesive layer (for example, a double-sided tape), or the soft rubber support 10 and the flexible display 7 may be alternatively fastened to each other in another connection manner.

For example, as shown in FIG. 94B, the body 101 of the soft rubber support 10 is further provided with a groove 1015. An opening of the groove 1015 is located on a lower surface 1016 of the body 101. In this embodiment, the groove 1015 is disposed, so that bendability of the soft rubber support 10 is better, and the soft rubber support 10 can be better bent with the flexible display 7, to provide a better support effect.

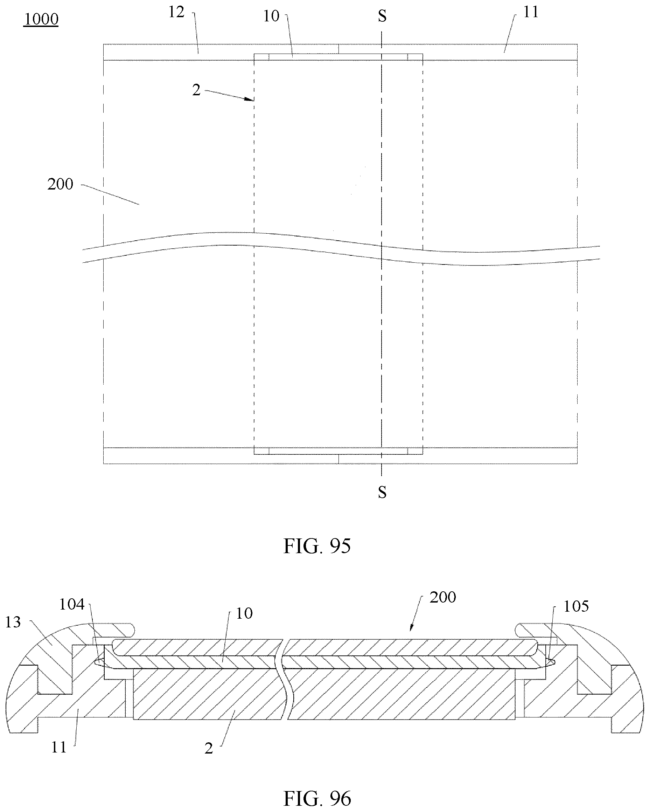

Refer to FIG. 95 and FIG. 96. FIG. 95 is a schematic diagram of a partial structure of an electronic device 1000 according to an embodiment of this application in some other embodiments. FIG. 96 is a schematic diagram of a cross-sectional structure of the electronic device 1000 that is cut along a cross section S-S and that is shown in FIG. 95. The electronic device 1000 in this embodiment may include some features of the electronic device 1000 in the foregoing embodiment.

In some embodiments, the first housing 11 of the electronic device 1000 is connected to the second housing 12 by using the hinge assembly 2. The screen 200 is located above the first housing 11, the hinge assembly 2, and the second housing 12. The soft rubber support 10 is located above the hinge assembly 2. Both the top end and the bottom end of the soft rubber support 10 abut against the first housing 11 and the second housing 12. The electronic device 1000 may block an edge of the screen 200 by using a protection housing 13 (not shown in FIG. 95) installed on the first housing 11 and the second housing 12, to protect the screen 200.

The first flange 104 of the soft rubber support 10 abuts against the first housing 11 and the second housing 12. Interference fit may be used between the first flange 104 and each of the first housing 11 and the second housing 12. The second flange 105 abuts against the first housing 11 and the second housing 12. Interference fit may be used between the second flange 105 and each of the first housing 11 and the second housing 12.

In this embodiment, the first flange 104 and the second flange 105 of the soft rubber support 10 can implement waterproof and dust-proof functions on a side surface of the screen 200, to reduce a risk that dust, water vapor, and the like outside the electronic device 1000 enter the electronic device 1000, and improve reliability of the electronic device 1000.

It may be understood that, in some other embodiments, the soft rubber support 10 may include a first part, a second part, and a third part that are sequentially connected. The first part is fastened to the first non-bendable region 71 of the flexible display 7. The second part is fastened to the bendable region 72 of the flexible display 7. The third part is fastened to the second non-bendable region 73 of the flexible display 7. In this embodiment, the soft rubber support 10 extends from the first non-bendable region 71 to the second non-bendable region 73 of the flexible display 7, and the soft rubber support 10 supports the bendable region 72 of the flexible display 7 more fully and reliably.

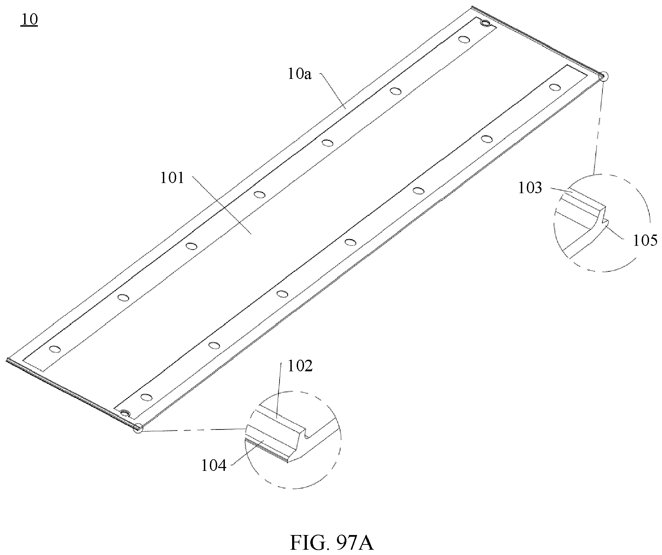

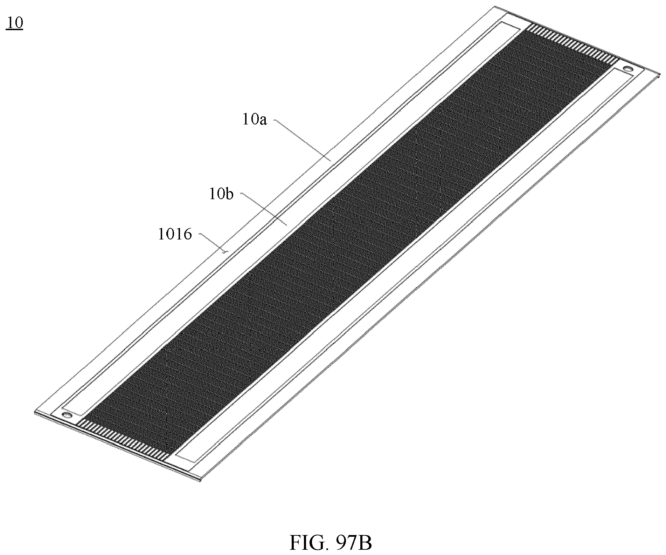

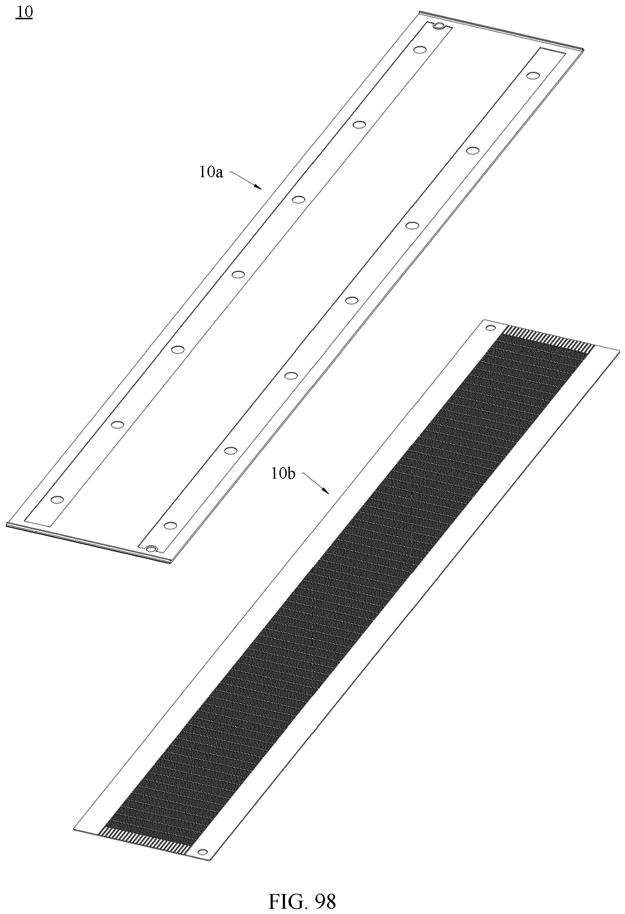

Refer to FIG. 97A, FIG. 97B, and FIG. 98. FIG. 97A is a schematic diagram of a structure of the soft rubber support 10 shown in FIG. 94A in some other embodiments. FIG. 97B is a schematic diagram of a structure of the soft rubber support 10 shown in FIG. 97A from another perspective. FIG. 98 is a schematic diagram of a decomposition structure of the soft rubber support 10 shown in FIG. 97A.

The soft rubber support 10 in this embodiment includes some features of the soft rubber support 10 in the foregoing embodiment. A main difference between the soft rubber support 10 in this embodiment and the soft rubber support 10 in the foregoing embodiment lies in that the soft rubber support 10 in this embodiment further includes a stiffener 10b.

For example, the soft rubber support 10 includes a soft rubber member 10a and a stiffener 10b. The soft rubber member 10a includes a body 101, a first side wall 102, a second side wall 103, a first flange 104, and a second flange 105. The stiffener 10b may be embedded into the body 101 of the soft rubber member 10a. Strength and hardness of the stiffener 10b are higher than those of the soft rubber member 10a. The soft rubber member 10a may be made of an elastic material, for example, silica gel, TPE, TPU, PVC soft rubber, or rubber. The stiffener 10b may be made of a material that has specific strength and hardness and that can be bent. For example, the stiffener 10b may be made of a stainless steel material, an aluminum alloy, a magnesium alloy, a titanium alloy, a copper alloy, a particle reinforced aluminum matrix composite material, a particle reinforced magnesium matrix composite material, or the like. A material of the stiffener 10b is not strictly limited in this embodiment of this application.

In this embodiment, the soft rubber member 10a and the stiffener 10b are integrated into the soft rubber support 10, so that the soft rubber support 10 is formed into a rigid-flexible structure. The soft rubber support 10 can be bent with the screen 200 to support the bendable part 2006 of the screen 200, and has better support performance, to help improve reliability of the screen 200.

The stiffener 10b may be exposed relative to a lower surface 1016 of the soft rubber member 10a. In some other embodiments, the stiffener 10b may be alternatively completely embedded into the soft rubber member 10a, that is, may be completely wrapped by the soft rubber member 10a.

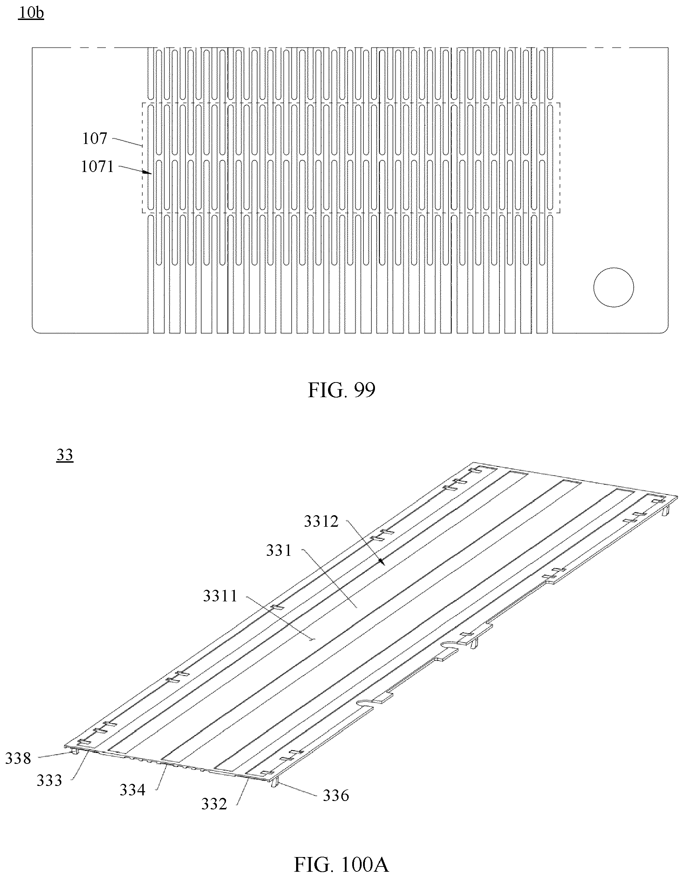

Refer to FIG. 98 and FIG. 99. FIG. 99 is a schematic diagram of a partial structure of the stiffener 10b shown in FIG. 98.

In some embodiments, the stiffener 10b includes a through hole, groove, and/or notch structure, to reduce rigidity of the stiffener 10b, so that the stiffener 10b and the soft rubber support 10 into which the stiffener 10b is embedded are more easily bent. A structure of the stiffener 10b may be designed with reference to a part of the structure of the bearing plate 8 of the screen 200 in the foregoing embodiment. For example, the stiffener 10b includes a plurality of elongated through hole groups 107. Each elongated through hole group 107 includes a plurality of elongated through holes 1071 arranged at intervals. The plurality of elongated through hole groups 107 are arranged at intervals. An arrangement direction of the plurality of elongated through hole groups 107 is perpendicular to an arrangement direction of the plurality of elongated through holes 1071 in a single elongated through hole group 107. A plurality of elongated through holes 1071 in two adjacent elongated through hole groups 107 may be arranged opposite to each other, partially arranged opposite to each other, or partially arranged in a staggered manner.

In some other embodiments, the stiffener 10b may be alternatively fastened to the lower surface 1016 of the body 101 of the soft rubber member 10a. The stiffener 10b and the body 101 may be fastened to each other in a connection manner, for example, bonding. This is not strictly limited in this application. The connection manner and a connection structure between the stiffener 10b and the soft rubber member 10a are not strictly limited in this embodiment of this application.

In some other embodiments, the stiffener 10b may alternatively include a plurality of reinforcing strips or reinforcing blocks disposed at intervals, to increase rigidity of the soft rubber support 10. In addition, bending performance of the soft rubber support 10 is still better. A specific structure of the stiffener 10b is not strictly limited in this embodiment of this application.

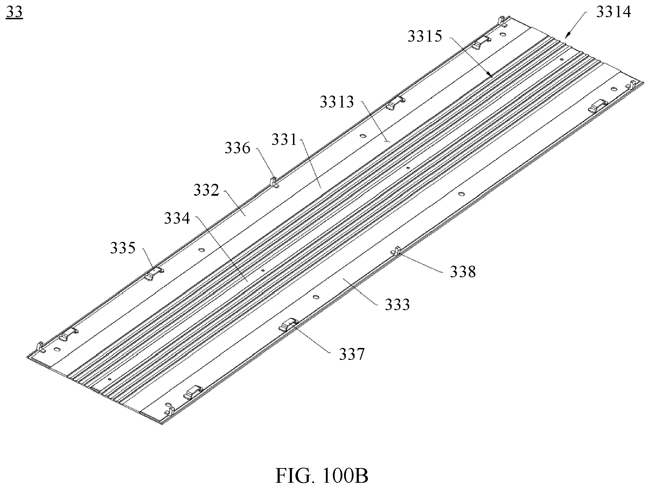

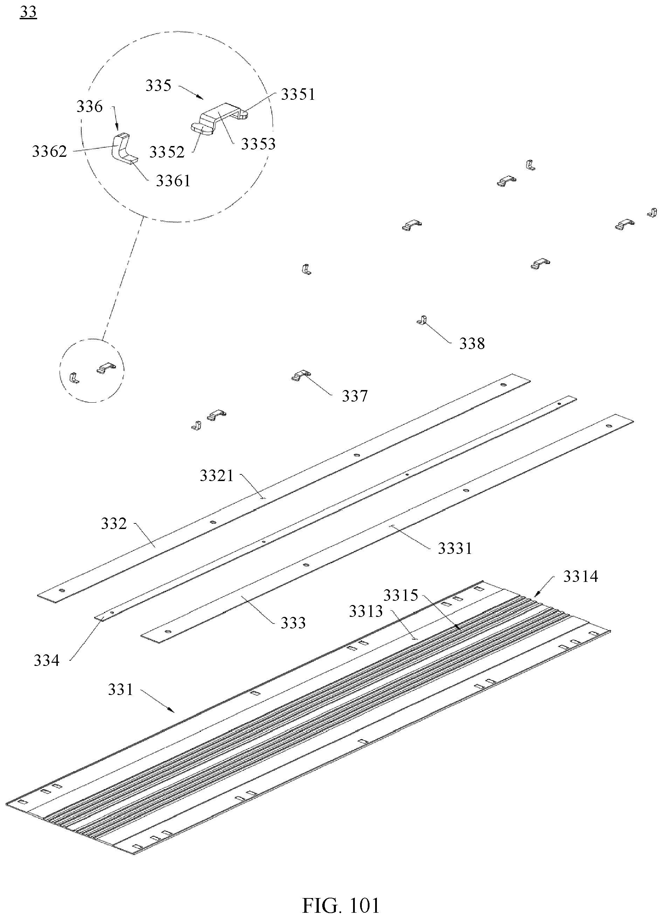

Refer to FIG. 100A, FIG. 100B, and FIG. 101. FIG. 100A is a schematic diagram of a structure of a rotating shaft connection assembly 33 according to an embodiment of this application in some other embodiments. FIG. 100B is a schematic diagram of the structure shown in FIG. 100A from another perspective. FIG. 101 is a schematic diagram of a decomposition structure of the rotating shaft connection assembly 33 shown in FIG. 100A.

In some embodiments, the rotating shaft connection assembly 33 is configured to connect the hinge assembly 2 to the bendable part 2006 of the screen 200 of the electronic device 1000. The rotating shaft connection assembly 33 may be approximately of an elongated plate body structure. A direction from the bottom end to the top end of the rotating shaft connection assembly 33 is defined as an extension direction of the rotating shaft connection assembly 33. The rotating shaft connection assembly 33 can be bent around the extension direction of the rotating shaft connection assembly 33.

For example, the rotating shaft connection assembly 33 includes a soft rubber member 331, a first rigid strip 332, a second rigid strip 333, a third rigid strip 334, a plurality of first drag hooks 335, a plurality of first sliding hooks 336, a plurality of second drag hooks 337, and a plurality of second sliding hooks 338.

For example, as a basic mechanical member of the rotating shaft connection assembly 33, the soft rubber member 331 has bending performance. In this way, the rotating shaft connection assembly 33 can be bent. The soft rubber member 331 is made of an elastically deformable soft rubber material. For example, the soft rubber material for forming the soft rubber member 331 may be silica gel, TPE, TPU, PVC soft rubber, or rubber (for example, silicone rubber, natural rubber, cis-1,4-polybutadiene rubber, styrene-butadiene rubber, or propylene rubber).

The soft rubber member 331 may be approximately of an elongated plate-like structure. An extension direction of the soft rubber member 331 is parallel to the extension direction of the rotating shaft connection assembly 33. An upper surface 3311 of the soft rubber member 331 has a plurality of first strip-shaped grooves 3312 spaced apart from each other. An arrangement direction of the plurality of first strip-shaped grooves 3312 is perpendicular to the extension direction of the rotating shaft connection assembly 33. An extension direction of the first strip-shaped groove 3312 is parallel to the extension direction of the rotating shaft connection assembly 33. In this embodiment, a design of the plurality of first strip-shaped grooves 3312 can improve elasticity of the soft rubber member 331. In this way, the rotating shaft connection assembly 33 is more easily bent, to better adapt to bending and deformation of the screen 200, and improve reliability of the screen 200.

A lower surface 3313 of the soft rubber member 331 has two second strip-shaped groove groups 3314 spaced apart from each other. An arrangement direction of the two second strip-shaped groove groups 3314 is perpendicular to the extension direction of the rotating shaft connection assembly 33. Each second strip-shaped groove group 3314 includes a plurality of second strip-shaped grooves 3315. An arrangement direction of the plurality of second strip-shaped grooves 3315 is perpendicular to the extension direction of the rotating shaft connection assembly 33. An extension direction of the second strip-shaped groove 3315 is parallel to the extension direction of the rotating shaft connection assembly 33. In this embodiment, a design of the second strip-shaped groove group 3314 can improve elasticity of the soft rubber member 331. In this way, the rotating shaft connection assembly 33 is more easily bent, to better adapt to bending and deformation of the screen 200, and improve reliability of the screen 200.

For example, rigidity of the first rigid strip 332, the second rigid strip 333, and the third rigid strip 334 is greater than rigidity of the soft rubber member 331. The first rigid strip 332, the second rigid strip 333, and the third rigid strip 334 are configured to increase rigidity of the rotating shaft connection assembly 33, so that the rotating shaft connection assembly 33 can better support the bendable part 2006 of the screen 200.

The first rigid strip 332, the second rigid strip 333, and the third rigid strip 334 may all be metal members, for example, may be made of various types of metal materials, such as stainless steel, cast iron, and aluminum, or alloy materials, to have high rigidity. It may be understood that, in another embodiment of this application, the first rigid strip 332, the second rigid strip 333, and the third rigid strip 334 may be alternatively made of a material, for example, ceramic or rigid plastic.

The first rigid strip 332, the second rigid strip 333, and the third rigid strip 334 are all located below the soft rubber member 331. The first rigid strip 332 is fastened to or embedded into one side of the lower surface 3313 of the soft rubber member 331. The second rigid strip 333 is fastened to or embedded into another side of the lower surface 3313 of the soft rubber member 331. The third rigid strip 334 is fastened to or embedded into the middle part of the lower surface 3313 of the soft rubber member 331. One second strip-shaped groove group 3314 of the soft rubber member 331 is located between the first rigid strip 332 and the third rigid strip 334, and the other second strip-shaped groove group 3314 is located between the third rigid strip 334 and the second rigid strip 333.

The first rigid strip 332 and the second rigid strip 333 each may be provided with a plurality of positioning holes.

In some other embodiments, the rotating shaft connection assembly 33 may be alternatively provided with no third rigid strip 334, or may be alternatively provided with more rigid strips.

For example, the plurality of first drag hooks 335 and the plurality of first sliding hooks 336 are all located below the first rigid strip 332 and fastened to a lower surface 3321 of the first rigid strip 332 at intervals. The plurality of first drag hooks 335 and the plurality of first sliding hooks 336 are configured to connect the hinge assembly 2. The plurality of first drag hooks 335 and the plurality of first sliding hooks 336 are rigid members, and may be made of various types of metal materials, such as stainless steel, cast iron, and aluminum, or alloy materials, or made of a material, for example, ceramic or rigid plastic.

The first drag hook 335 includes a first ear part 3351, a second ear part 3352, and a connection part 3353 connected between the first ear part 3351 and the second ear part 3352. The connection part 3353 protrudes towards a same side relative to the first ear part 3351 and the second ear part 3352. The first ear part 3351 and the second ear part 3352 are fixedly connected to the first rigid strip 332.

The first sliding hook 336 includes a fixed part 3361 and a sliding part 3362. One end of the sliding part 3362 is connected to one end of the fixed part 3361, and the sliding part 3362 is bent relative to the fixed part 3361. In this case, the first sliding hook 336 is approximately in an "L" shape. The fixed part 3361 of the first sliding hook 336 is fixedly connected to the first rigid strip 332. The fixed part 3361 and the first rigid strip 332 may be fastened to each other in a manner, for example, integrated molding, welding, bonding, or clamping.

For example, the plurality of second drag hooks 337 and the plurality of second sliding hooks 338 are all located below the second rigid strip 333 and fastened to a lower surface 3331 of the second rigid strip 333 at intervals. The plurality of second drag hooks 337 and the plurality of second sliding hooks 338 are configured to connect the hinge assembly 2. A material and a structure of the second drag hook 337 may be designed with reference to those of the first drag hook 335. The material and the structure of the first drag hook 335 may be designed with reference to those of the second drag hook 337. Details are not described herein again.

In some other embodiments, the rotating shaft connection assembly 33 may alternatively include a support sheet presenting a complete surface structure, and the support sheet may be a metal sheet, for example, an aluminum sheet or a stainless steel sheet, or a non-metal sheet. Two sides of the support sheet may be respectively slidably connected to the first support plate 22 and the second support plate 23. For a slidable connection structure, refer to the embodiments corresponding to FIG. 100A, FIG. 100B, and FIG. 101. Alternatively, another implementation structure may be used. This is not strictly limited in this application.

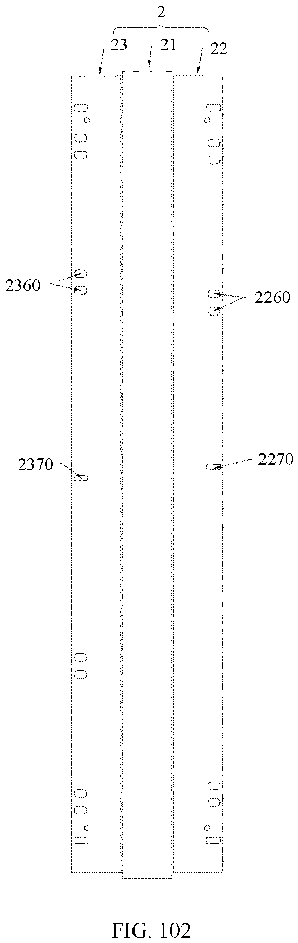

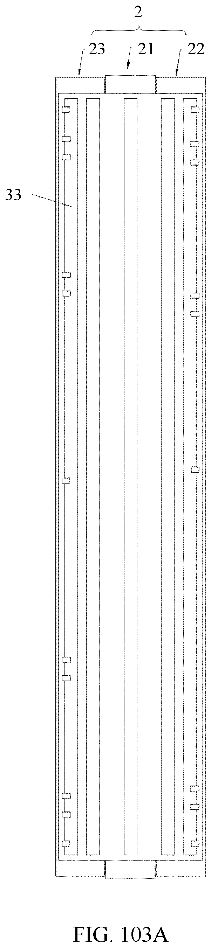

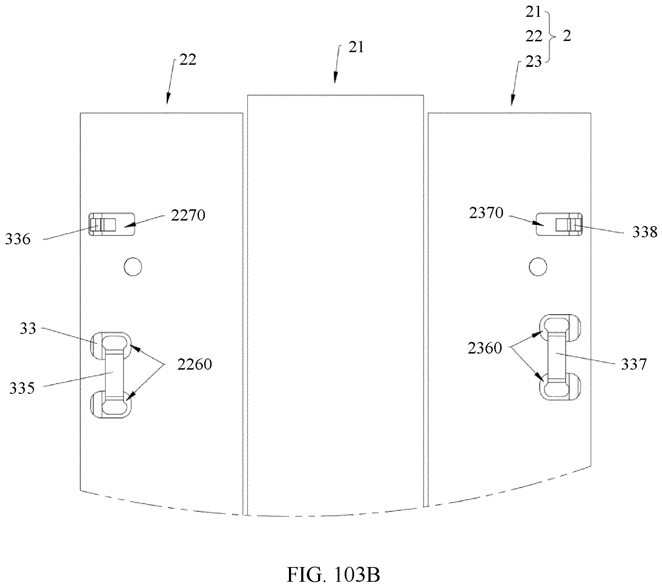

Refer to FIG. 102, FIG. 103A, and FIG. 103B. FIG. 102 is a schematic diagram of a partial structure of the hinge assembly 2 according to the embodiment of this application in some other embodiments. FIG. 103A is a schematic diagram of a connection structure of the rotating shaft connection assembly 33 shown in FIG. 100A and the hinge assembly 2 shown in FIG. 102. FIG. 103B is a schematic diagram of a partial structure of the structure shown in FIG. 103A from another perspective.

In some embodiments, the first support plate 22 and the second support plate 23 of the hinge assembly 2 are respectively located on two sides of the shaft 21. The first support plate 22 is provided with a plurality of first drag hook hole groups 2260 and a plurality of first sliding holes 2270 that are spaced apart from each other. Each first drag hook hole group 2260 includes two first drag hook holes spaced apart from each other. An extension direction of the first sliding hole 2270 is perpendicular to an extension direction of the first support plate 22. The second support plate 23 is provided with a plurality of second drag hook hole groups 2360 and a plurality of second sliding holes 2370 that are spaced apart from each other. Each second drag hook hole group 2360 includes two second drag hook holes spaced apart from each other. An extension direction of the second sliding hole 2370 is perpendicular to an extension direction of the second support plate 23. The extension direction of the first support plate 22 and the extension direction of the second support plate 23 are parallel to the extension direction of the shaft 21.

The rotating shaft connection assembly 33 is located above the first support plate 22, the shaft 21, and the second support plate 23. The rotating shaft connection assembly 33 is connected to the first support plate 22 by using the plurality of first drag hooks 335 and the plurality of first sliding hooks 336, and is connected to the second support plate 23 by using the plurality of second drag hooks 337 and the plurality of second sliding hooks 338. Specifically, the plurality of first drag hooks 335 are in a one-to-one correspondence with the plurality of first drag hook hole groups 2260. The first drag hook 335 passes through the two first drag hook holes of the corresponding first drag hook hole group 2260, so that one side of the rotating shaft connection assembly 33 is fastened to the first support plate 22 without separation in a thickness direction of the first support plate 22. The plurality of first sliding hooks 336 are in a one-to-one correspondence with the plurality of first sliding holes 2270. The first sliding hook 336 is installed in the corresponding first sliding hole 2270 and can be slid in the extension direction of the first sliding hole 2270, so that one side of the rotating shaft connection assembly 33 can be slid relative to the first support plate 22 in a direction perpendicular to the extension direction of the shaft 21.

The plurality of second drag hooks 337 are in a one-to-one correspondence with the plurality of second drag hook hole groups 2360. The second drag hook 337 passes through the two second drag hook holes of the corresponding second drag hook hole group 2360, so that the rotating shaft connection assembly 33 is fastened to the second support plate 23 without separation in a thickness direction of the second support plate 23. The plurality of second sliding hooks 338 are in a one-to-one correspondence with the plurality of second sliding holes 2370. The second sliding hook 338 is installed in the corresponding second sliding hole 2370 and can be slid in the extension direction of the second sliding hole 2370, so that another side of the rotating shaft connection assembly 33 can be slid relative to the second support plate 23 in the direction perpendicular to the extension direction of the shaft 21.

In this embodiment, the one side of the rotating shaft connection assembly 33 is fastened to the first support plate 22 in the thickness direction of the first support plate 22, and the another side of the rotating shaft connection assembly 33 is fastened to the second support plate 23 in the thickness direction of the second support plate 23. Therefore, the two sides of the rotating shaft connection assembly 33 can be bent with folding actions of the first support plate 22 and the second support plate 23, to drive the bendable part 2006 of the screen 200 to bend. In this way, the rotating shaft connection assembly 33 can protect and support the bendable part 2006 of the screen 200 in real time.

Because the one side of the rotating shaft connection assembly 33 can be slid relative to the first support plate 22 in the direction perpendicular to the extension direction of the shaft 21, and the another side of the rotating shaft connection assembly 33 can be slid relative to the second support plate 23 in the direction perpendicular to the extension direction of the shaft 21, relative displacement generated by the rotating shaft connection assembly 33 and the hinge assembly 2 in a rotation process can be released. In this way, a risk that the hinge assembly 2 pulls or squeezes the bendable part 2006 of the screen 200 by using the rotating shaft connection assembly 33 is reduced, and reliability of the screen 200 is higher. In this case, the screen 200 can maintain a natural water drop shape without undergoing a stress effect.

In addition, the first sliding hook 336 fits the first sliding hole 2270, so that the one side of the rotating shaft connection assembly 33 and the first support plate 22 are position-limited in the extension direction of the first support plate 22. The second sliding hook 338 fits the second sliding hole 2370, so that the another side of the rotating shaft connection assembly 33 and the second support plate 23 are position-limited in the extension direction of the second support plate 23. In this case, relative movement of the rotating shaft connection assembly 33 and the hinge assembly 2 in an extension direction of the rotating shaft are limited, so that the rotating shaft connection assembly 33 can be better moved with the hinge assembly 2, and movement stability of the rotating shaft connection assembly 33 is better, to better protect and support the bendable part 2006 of the screen 200.

It may be understood that, in some other embodiments, there may be one or more than three first drag hook holes in the first drag hook hole group 2260, and a quantity of first drag hook holes adapts to structures of the first drag hooks 335. For example, the first drag hook 335 is T-shaped. One end of a vertical part of the first drag hook 335 is connected to the first rigid strip 332, and a horizontal part of the first drag hook 335 is connected to another end of the vertical part, and is suspended relative to the first rigid strip 332. In this case, there may be one first drag hook hole. A specific structure of the first drag hook 335 and a specific quantity of first drag hook holes in the first drag hook hole group 2260 are not strictly limited in this application. Similarly, a specific structure of the second drag hook 337 and a specific quantity of second drag hook holes in the second drag hook hole group 2360 are also not strictly limited in this application.

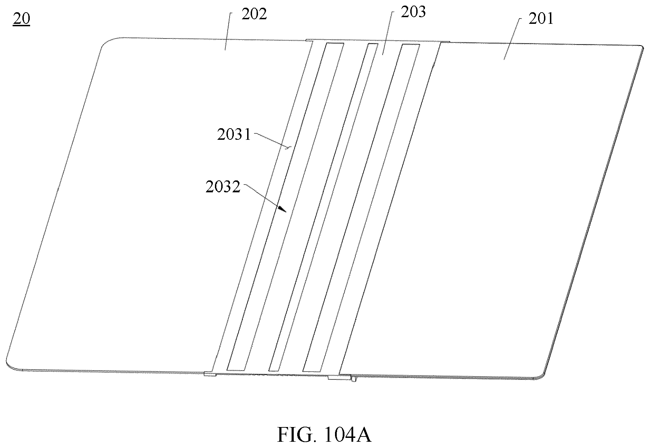

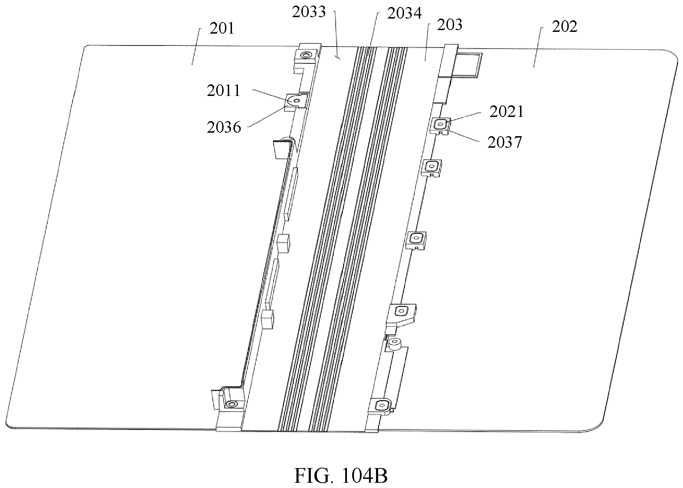

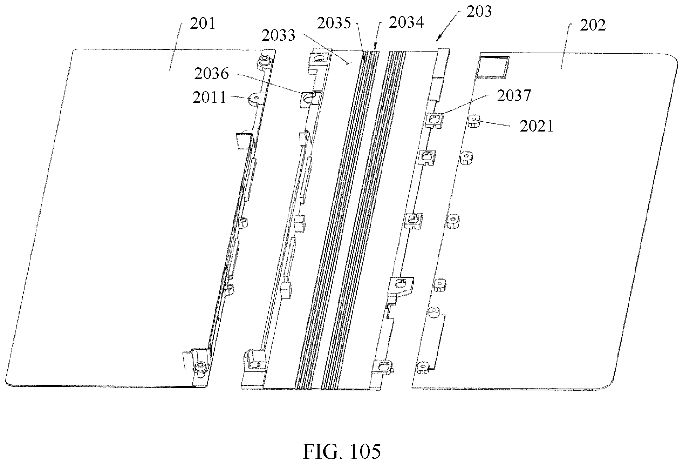

Refer to FIG. 104A, FIG. 104B, and FIG. 105. FIG. 104A shows a screen support 20 according to an embodiment of this application. FIG. 104B is a schematic diagram of a structure of the screen support 20 shown in FIG. 104A from another perspective. FIG. 105 is a schematic diagram of a decomposition structure of the screen support 20 shown in FIG. 104A.

In some embodiments, this embodiment of this application further provides the screen support 20. The screen support 20 is configured to fixedly connect the first housing 11 and the second housing 12 of the electronic device 1000. The screen support 20 may cover the hinge assembly 2 of the electronic device 1000. The screen support 20 is further configured to support the screen 200.

For example, the screen support 20 includes a first rigid plate 201, a second rigid plate 202, and a soft rubber member 203 connected between the first rigid plate 201 and the second rigid plate 202. Rigidity of the first rigid plate 201 and the second rigid plate 202 is greater than rigidity of the soft rubber member 203. The soft rubber member 203 is an elastically deformable member. In other words, under an action of same external force, the soft rubber member 203 is more likely to deform, but the first rigid plate 201 and the second rigid plate 202 are less likely to deform.

For example, the soft rubber member 203 may be made of an elastic material, for example, silica gel, TPE, TPU, PVC soft rubber, or rubber. The first rigid plate 201 and the second rigid plate 202 may be made of a light material that is easily connected to the soft rubber member 203, for example, a material, for example, a magnesium aluminum alloy.

The soft rubber member 203 may be approximately of an elongated plate-like structure. An upper surface 2031 of the soft rubber member 203 may have a plurality of first strip-shaped grooves 2032 spaced apart from each other. An arrangement direction of the plurality of first strip-shaped grooves 2032 is perpendicular to an extension direction of the soft rubber member 203. An extension direction of the first strip-shaped groove 2032 is parallel to the extension direction of the soft rubber member 203. In this embodiment, a design of the plurality of first strip-shaped grooves 2032 can improve elasticity of the soft rubber member 203. In this way, the screen support 20 is more easily bent, to better adapt to bending and deformation of the screen 200, and improve reliability of the screen 200.

A lower surface 2033 of the soft rubber member 203 has two second strip-shaped groove groups 2034 spaced apart from each other. An arrangement direction of the two second strip-shaped groove groups 2034 is perpendicular to the extension direction of the soft rubber member 203. Each second strip-shaped groove group 2034 includes a plurality of second strip-shaped grooves 2035. An arrangement direction of the plurality of second strip-shaped grooves 2035 is perpendicular to the extension direction of the soft rubber member 203. An extension direction of the second strip-shaped groove 2035 is parallel to the extension direction of the soft rubber member 203. In this embodiment, a design of the second strip-shaped groove group 2034 can improve elasticity of the soft rubber member 203. In this way, the screen support 20 is more easily bent, to better adapt to bending and deformation of the screen 200, and improve reliability of the screen 200.

For example, one side that is of the first rigid plate 201 and that is close to the soft rubber member 203 is provided with a plurality of first positioning block 2011, and one side that is of the second rigid plate 202 and that is close to the soft rubber member 203 is provided with a plurality of second positioning block 2021. One side of the soft rubber member 203 is provided with a plurality of first handle parts 2036 (also referred to as rubber embedment parts), and another side of the soft rubber member 203 is provided with a plurality of second handle parts 2037. The plurality of first positioning blocks 2011 are embedded into the first handle parts 2036, so that the first rigid plate 201 is firmly and reliably connected to the soft rubber member 203. The plurality of second positioning blocks 2021 are embedded into the second handle parts 2037, so that the second rigid plate 202 is firmly and reliably connected to the soft rubber member 203. Structures, positions, and the like of the first positioning block 2011, the second positioning block 2021, the first handle part 2036, and the second handle part 2037 are not strictly limited in this application.

For example, the screen support 20 may be produced into an integrated structure in a manner of in-mold injection molding, to improve overall structural strength. In addition, an intermediate assembly procedure and a material may be omitted, to reduce costs of the screen support 20.

In this embodiment, the first rigid plate 201 of the screen support 20 is fixedly connected to the first housing 11. The second rigid plate 202 is fixedly connected to the second housing 12. The soft rubber member 203 is correspondingly located above the hinge assembly 2. The screen 200 is fastened to one side that is of the screen support 20 and that backs onto the hinge assembly 2. Specifically, the first rigid plate 201 is configured to support the first non-bendable part 2001 of the screen 200. The soft rubber member 203 is configured to support the bendable part 2006 of the screen 200. The second rigid plate 202 is configured to support the fourth non-bendable part 2005 of the screen 200. The screen support 20 supports the screen 200, to improve reliability of the screen 200.

For example, the first rigid plate 201 may be provided with a plurality of installation structures. The plurality of installation structures can fit a structure of the first housing 11 to install another component of the electronic device 1000. Similarly, the second rigid plate 202 may be provided with a plurality of installation structures. The plurality of installation structures can fit a structure of the second housing 12 to install another component of the electronic device 1000.

In some other embodiments, one or more rigid members may be alternatively embedded into or fastened to the soft rubber member 203, to form a rigid-flexible structure. A specific structure of the soft rubber member 203 is not strictly limited in this application.

## Claims

1. A foldable electronic device, comprises a housing apparatus (100) and a screen (200);
the housing apparatus (100) comprises a first housing (11), a second housing (12), and a hinge assembly (2), the hinge assembly (2) is connected between the first housing (11) and the second housing (12);
wherein the hinge assembly (2) comprises a shaft (21), a first fixing bracket (241), a first connection arm (243), a first swing arm (245), a second fixing bracket (242), a second connection arm (244), and a second swing arm (246), a first support plate (22), and a second support plate (23);
the first fixing bracket (241) is fastened to the first housing (11), and the second fixing bracket (242) is fastened to the second housing (12);
a first end (2431) of the first connection arm (243) is rotatably connected to the shaft (21), the second end (2432) of the first connection arm (243) is rotatably connected to the first fixing bracket (241), the first swing arm (245) comprises a first rotating end (2451) and a first sliding end (2452), the first rotating end (2451) is rotatably connected to the shaft (21), and the first sliding end (2452) is slidably connected to the first fixing bracket (241);
a first end (2441) of the second connection arm (244) is rotatably connected to the shaft (21), a second end (2442) of the second connection arm (244) is rotatably connected to the second fixing bracket (242), the second swing arm (246) comprises a second rotating end (2461) and a second sliding end (2462), the second rotating end (2461) is rotatably connected to the shaft (21), and the second sliding end (2462) is slidably connected to the second fixing bracket (242);
the first support plate (22) is rotatably connected to the first fixing bracket (241), the second support plate (23) is rotatably connected to the second fixing bracket (242);
the first support plate (22) is slidably connected to the first sliding end (2452);
the second support plate (23) is slidably connected to the second sliding end (2462);
the screen (200) comprises a flexible display (7) and a bearing plate (8), the bearing plate (8) is fastened to a non-display side of the flexible display (7);
the bearing plate (8) comprises a first plate part (81), a second plate part (82), a third plate part (83), a fourth plate part (84), and a fifth plate part (85) that are sequentially arranged, the second plate part (82) comprises a first side close to the first plate part (81) and a second side close to the third plate part (83), and the fourth plate part (84) comprises a first side close to the third plate part (83) and a second side close to the fifth plate part (85);
a rigidity of the first side of the second plate part (82) is less than a rigidity of the first plate part (81), a rigidity of the first side of the second plate part (82) is less than a rigidity of the second side of the second plate part (82);
a rigidity of the third plate part (83) is less than the rigidity of the first plate part (81);
a rigidity of the second side of the fourth plate part (84) is less than the rigidity of the first plate part (81), a rigidity of the second side of the fourth plate part (84) is less than a rigidity of the first side of the fourth plate part (84);
a first part of the screen (200) corresponding to the first plate part (81) is fastened to the first housing (11), a second part of the screen (200) corresponding to the fifth plate part (85) is fastened to the second housing (12).

2. The foldable electronic device according to claim 1,
the first support plate (22) comprises a first support plate surface (2211) and a first fixing surface (2212) which is opposite to the first support plate surface (2211), the second support plate (23) comprises a second support plate surface (2311) and a second fixing surface (2312) which is opposite to the second support plate surface (2311) , wherein the first support plate surface (2211) and the second support plate surface (2311) are disposed toward the screen (200);
the hinge assembly (2) further comprises a first guide arm (2242) and a second guide arm (2342);
the first guide arm (2242) is disposed on the first fixing surface (2212), the first guide arm (2242) protrudes relative to the first fixing surface (2212), the first guide arm (2242) comprises a first guide chute (2243);
the second guide arm (2342) is disposed on the second fixing surface (2312), the second guide arm (2342) protrudes relative to the second fixing surface (2312), the second guide arm (2342) comprises a second guide chute (2343);
the first support plate (22) is slidably connected to the first sliding end (2452), comprising: the first support plate (22) is slidably connected to the first sliding end (2452) by using the first guide chute (2243);
the second support plate (23) is slidably connected to the second sliding end (2462) , comprising: the second support plate (23) is slidably connected to the second sliding end (2462) by using the second guide chute (2343).[

3. The foldable electronic device according to claim 2, a distance between a first end (2243a) of the first guide chute (2243) and the shaft (21) is less than a distance between a second end (2243b) of the first guide chute (2243) and the shaft (21), a distance between the first end (2243a) of the first guide chute (2243) and the first support plate (22) is less than a distance between the second end (2243b) of the first guide chute (2243) and the first support plate (22),
a distance between a first end (2343a) of the second guide chute (2343) and the shaft (21) is less than a distance between a second end (2343b) of the second guide chute (2343) and the shaft (21), a distance between the first end (2343a) of the second guide chute (2343) and the second support plate (23) is less than a distance between the second end (2343b) of the second guide chute (2343) and the second support plate (23).

4. The foldable electronic device according to any one of claims 1 to 3,
a third part of the screen (200) corresponding to a second side of the second plate part (82) is fastened to the first support plate (22), a fourth part of the screen (200) corresponding to a first side of the fourth plate part (84) is fastened to the second support plate (23).

5. The foldable electronic device according to any one of claims 1 to 4, wherein: the screen further comprises a fifth part, a sixth part, and a seventh part, wherein the fifth part of the screen is corresponding to the third plate part (83), the sixth part is corresponding to the first side of the second plate part (82), the seventh part is corresponding to the second side of the fourth plate part (84);
when the foldable electronic device is folded from an open state to a closed state, a first end part that is of the fifth part of the screen and that is connected to the third part of the screen forms a first arc section (R11), a second end part that is of the fifth part of the screen and that is connected to the fourth part of the screen forms a second arc section (R12), a middle part of the fifth part of the screen forms a third arc section (R13), wherein the first arc section (R11), the third arc section (R13), and the second arc section (R12) have circle centers which are located on an inner side of the screen 200, the sixth part of the screen forms a fourth arc section (R14), the seventh part of the screen forms a fifth arc section (R15), a circle center of the fourth arc section (R14) is located on an outer side of the screen, a circle center of the fifth arc section (R15) is located on the outer side of the screen, the circle center of the fourth arc section (R14) and the circle center of the fifth arc section (R15) are respectively located on two sides of the screen (200).

6. The foldable electronic device according to any one of claims 1 to 5, wherein:
the first end (2431) of the first connection arm (243) is rotatably connected to the shaft (21), comprising: the first end (2431) of the first connection arm (243) is rotatably connected to the shaft (21) via a first virtual shaft;
the first end (2441) of the second connection arm (244) is rotatably connected to the shaft (21) , comprising: the first end (2441) of the second connection arm (244) is rotatably connected to the shaft (21) via a second virtual shaft.

7. The foldable electronic device according to any one of claims 1 to 6, wherein:
when the foldable electronic device is folded to a closed state, a distance between end parts that are of the first support plate (22) and the second support plate (23) and that are close to the shaft (21) is a first distance, a distance between end parts that are of the first support plate (22) and the second support plate (23) and that are away from the shaft (21) is a second distance, the first distance is greater than the second distance, the first support plate (22), the shaft (21), and the second support plate (23) jointly form accommodation space (210), the screen (200) is partially located in the accommodation space (210).

8. The foldable electronic device according to any one of claims 1 to 7, wherein
the third plate part (83) is provided with a first through hole, and an extension direction of the first through hole is parallel to an extension direction of the shaft (21), or the third part (83) is provided with a first groove, and an extension direction of the first groove is parallel to an extension direction of the shaft (21);
the first side of the second plate part (82) is provided with a second through hole, and an extension direction of the second through hole is parallel to the extension direction of the shaft (21) , or the first side of the second part (82) is provided with a second groove, and an extension direction of the second groove is parallel to the extension direction of the shaft (21); and
the second side of the fourth plate part (84) is provided with a third through hole, and an extension direction of the third through hole on the second side of the fourth plate part (84) is parallel to the extension direction of the shaft (21), or the second side of the fourth part (84) is provided with a third groove, and an extension direction of the third groove on the second side of the fourth part (84) is parallel to the extension direction of the shaft (21).

9. The foldable electronic device according to any one of claims 1 to 8, wherein a first shaft (2483) is inserted into the first sliding end (2452), a second shaft (2484) is inserted into the second sliding end (2462);
wherein the first support plate (22) is slidably connected to the first sliding end (2452) by using the first guide chute (2243), comprises: the first shaft (2483) is slidably connected to the first guide chute (2243);
the second support plate (23) is slidably connected to the second sliding end (2462) through the second guide chute (2343) , comprises: the second shaft (2484) is slidably connected to the second guide chute (2343).

10. The foldable electronic device according to claim 9,
when the electronic device is in an open state, a distance between the first shaft (2483) and the second end (2243b) of the first guide chute (2243) is less than a distance between the first shaft (2483) and the first end (2243a) of the first guide chute (2243), a distance between the second shaft (2484) and the second end (2343b) of the second guide chute (2343) is less than a distance between the second shaft (2484) and the first end (2343a) of the second guide chute (2343); and
when the electronic device is in an closed state, a distance between the first shaft (2483) and the second end (2243b) of the first guide chute (2243) is greater than a distance between the first shaft (2483) and the first end (2243a) of the first guide chute (2243), a distance between the second shaft (2484) and the second end (2343b) of the second guide chute (2343) is greater than a distance between the second shaft (2484) and the first end (2343a) of the second guide chute (2343).

11. The foldable electronic device according to any one of claims 1 to 10, further comprises a plurality of synchronization gears (2473), and the first rotating end (2451) is engaged with the second rotating end (2461) by using the plurality of synchronization gears (2473).

12. The foldable electronic device according to any one of claims 1 to 11, wherein
the first swing arm (245) further comprises a first connection section (2453), and the first connection section (2453) is located between the first rotating end (2451) and the first sliding end (2452);
the second swing arm (246) further comprises a second connection section (2463), and the second connection section (2463) is located between the second rotating end (2461) and the second sliding end (2462); and
when the electronic device is in the closed state, the first support plate (22), the first connection section (2453), the shaft (21), the second connection section (2463), and the second support plate (23) jointly form the accommodation space (210), the screen (200) is partially located in the accommodation space (210).

13. The foldable electronic device according to any one of claims 1 to 12, wherein
the electronic device further comprises a back cover (5);
when the electronic device is in an open state, the first housing (11) and the second housing (12) block the back cover (5); and
when the electronic device is in a closed state, the back cover (5) is exposed relative to the first housing (11) and the second housing (12).

14. The foldable electronic device according to any one of claims 1 to 13, further comprises a protector (41), a first protection housing (43) and a second protection housing (44);
a clamping slot (2110) is disposed at an end of the shaft (21);
the protector (41) comprises a rigid member (411), a connector (412) and a soft rubber member (413), the rigid member (411) is connected to the soft rubber member (413) by using the connector (412);
the rigid member (411) is inserted into the clamping slot (2110);
the soft rubber member (413) is configured to cover a part of the edge of the screen (200).

15. The foldable electronic device according to claim 14, wherein:
the rigid member (411) is fixedly connected to the clamping slot (2110).

## Patentansprüche

1. Faltbare elektronische Vorrichtung, die eine Gehäusevorrichtung (100) und einen Bildschirm (200) umfasst;
wobei die Gehäusevorrichtung (100) ein erstes Gehäuse (11), ein zweites Gehäuse (12) und eine Scharnierbaugruppe (2) umfasst und die Scharnierbaugruppe (2) zwischen dem ersten Gehäuse (11) und dem zweiten Gehäuse (12) verbunden ist;
die Scharnierbaugruppe (2) eine Welle (21), eine erste Befestigungshalterung (241), einen ersten Verbindungsarm (243), einen ersten Schwenkarm (245), eine zweite Befestigungshalterung (242), einen zweiten Verbindungsarm (244) und einen zweiten Schwenkarm (246), eine erste Stützplatte (22) und eine zweite Stützplatte (23) umfasst;
die erste Befestigungshalterung (241) an dem ersten Gehäuse (11) befestigt ist und die zweite Befestigungshalterung (242) an dem zweiten Gehäuse (12) befestigt ist;
ein erstes Ende (2431) des ersten Verbindungsarms (243) drehbar mit der Welle (21) verbunden ist, das zweite Ende (2432) des ersten Verbindungsarms (243) drehbar mit der ersten Befestigungshalterung (241) verbunden ist, der erste Schwenkarm (245) ein erstes Drehende (2451) und ein erstes Gleitende (2452) umfasst, wobei das erste Drehende (2451) drehbar mit der Welle (21) verbunden ist und das erste Gleitende (2452) gleitbar mit der ersten Befestigungshalterung (241) verbunden ist;
ein erstes Ende (2441) des zweiten Verbindungsarms (244) drehbar mit der Welle (21) verbunden ist, ein zweites Ende (2442) des zweiten Verbindungsarms (244) drehbar mit der zweiten Befestigungshalterung (242) verbunden ist, der zweite Schwenkarm (246) ein zweites Drehende (2461) und ein zweites Gleitende (2462) umfasst, wobei das zweite Drehende (2461) drehbar mit der Welle (21) verbunden ist und das zweite Gleitende (2462) gleitbar mit der zweiten Befestigungshalterung (242) verbunden ist;
die erste Stützplatte (22) drehbar mit der ersten Befestigungshalterung (241) verbunden ist, die zweite Stützplatte (23) drehbar mit der zweiten Befestigungshalterung (242) verbunden ist;
die erste Stützplatte (22) gleitbar mit dem ersten Gleitende (2452) verbunden ist;
die zweite Stützplatte (23) gleitbar mit dem zweiten Gleitende (2462) verbunden ist;
der Bildschirm (200) ein flexibles Display (7) und eine Lagerplatte (8) umfasst, wobei die Lagerplatte (8) an einer Nicht-Display-Seite des flexiblen Displays (7) befestigt ist; die Lagerplatte (8) einen ersten Plattenteil (81), einen zweiten Plattenteil (82), einen dritten Plattenteil (83), einen vierten Plattenteil (84) und einen fünften Plattenteil (85) umfasst, die nacheinander angeordnet sind, wobei der zweite Plattenteil (82) eine erste Seite nahe dem ersten Plattenteil (81) und eine zweite Seite nahe dem dritten Plattenteil (83) umfasst und der vierte Plattenteil (84) eine erste Seite nahe dem dritten Plattenteil (83) und eine zweiten Seite nahe dem fünften Plattenteil (85) umfasst;
eine Steifigkeit der ersten Seite des zweiten Plattenteils (82) geringer ist als eine Steifigkeit des ersten Plattenteils (81), eine Steifigkeit der ersten Seite des zweiten Plattenteils (82) geringer ist als eine Steifigkeit der zweiten Seite des zweiten Plattenteils (82);
eine Steifigkeit des dritten Plattenteils (83) geringer ist als die Steifigkeit des ersten Plattenteils (81);
eine Steifigkeit der zweiten Seite des vierten Plattenteils (84) geringer ist als die Steifigkeit des ersten Plattenteils (81), eine Steifigkeit der zweiten Seite des vierten Plattenteils (84) geringer ist als eine Steifigkeit der ersten Seite des vierten Plattenteils (84);
ein erster Teil des Bildschirms (200), der dem ersten Plattenteil (81) entspricht, an dem ersten Gehäuse (11) befestigt ist, ein zweiter Teil des Bildschirms (200), der dem fünften Plattenteil (85) entspricht, an dem zweiten Gehäuse (12) befestigt ist.

2. Faltbare elektronische Vorrichtung nach Anspruch 1,
wobei die erste Stützplatte (22) eine erste Stützplattenoberfläche (2211) und eine erste Befestigungsoberfläche (2212) umfasst, die der ersten Stützplattenoberfläche (2211) gegenüberliegt, die zweite Stützplatte (23) eine zweite Stützplattenoberfläche (2311) und eine zweite Befestigungsoberfläche (2312) umfasst, die der zweiten Stützplattenoberfläche (2311) gegenüberliegt, wobei die erste Stützplattenoberfläche (2211) und die zweite Stützplattenoberfläche (2311) zu dem Bildschirm (200) hin angeordnet sind;
die Scharnierbaugruppe (2) ferner einen ersten Führungsarm (2242) und einen zweiten Führungsarm (2342) umfasst;
der erste Führungsarm (2242) an der ersten Befestigungsoberfläche (2212) angeordnet ist, der erste Führungsarm (2242) im Verhältnis zu der ersten Befestigungsoberfläche (2212) hervorsteht, und der erste Führungsarm (2242) einen ersten Führungsschacht (2243) umfasst; der zweite Führungsarm (2342) an der zweiten Befestigungsoberfläche (2312) angeordnet ist, der zweite Führungsarm (2342) im Verhältnis zu der zweiten Befestigungsoberfläche (2312) hervorsteht, und der zweite Führungsarm (2342) einen zweiten Führungsschacht (2343) umfasst; die erste Stützplatte (22) gleitbar mit dem ersten Gleitende (2452) verbunden ist, umfassend: die erste Stützplatte (22) ist unter Verwendung des ersten Führungsschachts (2243) gleitbar mit dem ersten Gleitende (2452) verbunden;
die zweite Stützplatte (23) gleitbar mit dem zweiten Gleitende (2462) verbunden ist, umfassend: die zweite Stützplatte (23) ist unter Verwendung des zweiten Führungsschachts (2343) gleitbar mit dem zweiten Gleitende (2462) verbunden.

3. Faltbare elektronische Vorrichtung nach Anspruch 2, wobei ein Abstand zwischen einem ersten Ende (2243a) des ersten Führungsschachts (2243) und der Welle (21) geringer ist als ein Abstand zwischen einem zweiten Ende (2243b) des ersten Führungsschachts (2243) und der Welle (21), ein Abstand zwischen dem ersten Ende (2243a) des ersten Führungsschachts (2243) und der ersten Stützplatte (22) geringer ist als ein Abstand zwischen dem zweiten Ende (2243b) des erste Führungsschachts (2243) und der ersten Stützplatte (22),
ein Abstand zwischen einem ersten Ende (2343a) des zweiten Führungsschachts (2343) und der Welle (21) geringer ist als ein Abstand zwischen einem zweiten Ende (2343b) des zweiten Führungsschachts (2343) und der Welle (21), und ein Abstand zwischen dem ersten Ende (2343a) des zweiten Führungsschachts (2343) und der zweiten Stützplatte (23) geringer ist als ein Abstand zwischen dem zweiten Ende (2343b) des zweiten Führungsschachts (2343) und der zweiten Stützplatte (23).

4. Faltbare elektronische Vorrichtung nach einem der Ansprüche 1 bis 3,
wobei ein dritter Teil des Bildschirms (200), der einer zweiten Seite des zweiten Plattenteils (82) entspricht, an der ersten Stützplatte (22) befestigt ist, und ein vierter Teil des Bildschirms (200), der einer ersten Seite des vierten Plattenteils (84) entspricht, an der zweiten Stützplatte (23) befestigt ist.

5. Faltbare elektronische Vorrichtung nach einem der Ansprüche 1 bis 4, wobei: der Bildschirm ferner einen fünften Teil, einen sechsten Teil und einen siebten Teil umfasst, wobei der fünfte Teil des Bildschirms dem dritten Plattenteil (83) entspricht, der sechste Teil der ersten Seite des zweiten Plattenteils (82) entspricht und der siebte Teil der zweiten Seite des vierten Plattenteils (84) entspricht;
wobei wenn die faltbare elektronische Vorrichtung von einem offenen Zustand in einen geschlossenen Zustand gefaltet wird, ein erster Endteil, der zu dem fünften Teil des Bildschirms gehört und mit dem dritten Teil des Bildschirms verbunden ist, einen ersten Bogenabschnitt (R11) bildet, ein zweiter Endteil, der zu dem fünften Teil des Bildschirms gehört und mit dem vierten Teil des Bildschirms verbunden ist, einen zweiten Bogenabschnitt (R12) bildet, ein mittlerer Teil des fünften Teils des Bildschirms einen dritten Bogenabschnitt (R13) bildet, wobei der erste Bogenabschnitt (R11), der dritte Bogenabschnitt (R13) und der zweite Bogenabschnitt (R12) Kreismittelpunkte haben, die auf einer Innenseite des Bildschirms (200) liegen, der sechste Teil des Bildschirms einen vierten Bogenabschnitt (R14) bildet, der siebte Teil des Bildschirms einen fünften Bogenabschnitt (R15) bildet, ein Kreismittelpunkt des vierten Bogenabschnitts (R14) auf einer Außenseite des Bildschirms liegt, ein Kreismittelpunkt des fünften Bogenabschnitts (R15) auf der Außenseite des Bildschirms liegt und der Kreismittelpunkt des vierten Bogenabschnitts (R14) und der Kreismittelpunkt des fünften Bogenabschnitts (R15) jeweils auf zwei Seiten des Bildschirms (200) liegen.

6. Faltbare elektronische Vorrichtung nach einem der Ansprüche 1 bis 5, wobei:
das erste Ende (2431) des ersten Verbindungsarms (243) drehbar mit der Welle (21) verbunden ist, umfassend: das erste Ende (2431) des ersten Verbindungsarms (243) ist über einen ersten virtuellen Schacht drehbar mit der Welle (21) verbunden;
das erste Ende (2441) des zweiten Verbindungsarms (244) drehbar mit der Welle (21) verbunden ist, umfassend: das erste Ende (2441) des zweiten Verbindungsarms (244) ist über einen zweiten virtuellen Schacht drehbar mit der Welle (21) verbunden.

7. Faltbare elektronische Vorrichtung nach einem der Ansprüche 1 bis 6, wobei:
wenn sich die faltbare elektronische Vorrichtung in einem gefalteten Zustand befindet, ein Abstand zwischen den Endteilen der ersten Stützplatte (22) und der zweiten Stützplatte (23), die nahe der Welle (21) liegen, ein erster Abstand ist, und ein Abstand zwischen den Endteilen der ersten Stützplatte (22) und der zweiten Stützplatte (23), die von der Welle (21) entfernt liegen, ein zweiter Abstand ist, wobei der erste Abstand größer ist als der zweite Abstand, die erste Stützplatte (22), die Welle (21) und die zweite Stützplatte (23) gemeinsam einen Aufnahmeraum (210) bilden, und der Bildschirm (200) teilweise im Aufnahmeraum (210) liegt.

8. Faltbare elektronische Vorrichtung nach einem der Ansprüche 1 bis 7, wobei
der dritte Plattenteil (83) mit einem ersten Durchgangsloch versehen ist und eine Erstreckungsrichtung des ersten Durchgangslochs parallel zu einer Erstreckungsrichtung der Welle (21) verläuft oder der dritte Teil (83) mit einer ersten Nut versehen ist und eine Erstreckungsrichtung der ersten Nut parallel zu einer Erstreckungsrichtung der Welle (21) verläuft; die erste Seite des zweiten Plattenteils (82) mit einem zweiten Durchgangsloch versehen ist und eine Erstreckungsrichtung des zweiten Durchgangslochs parallel zu der Erstreckungsrichtung der Welle (21) verläuft oder die erste Seite des zweiten Teils (82) mit einer zweiten Nut versehen ist und eine Erstreckungsrichtung der zweiten Nut parallel zu der Erstreckungsrichtung der Welle (21) verläuft; und
die zweite Seite des vierten Plattenteils (84) mit einem dritten Durchgangsloch versehen ist und eine Erstreckungsrichtung des dritten Durchgangslochs auf der zweiten Seite des vierten Plattenteils (84) parallel zu der Erstreckungsrichtung der Welle (21) verläuft oder die zweite Seite des vierten Teils (84) mit einer dritten Nut versehen ist und eine Erstreckungsrichtung der dritten Nut auf der zweiten Seite des vierten Teils (84) parallel zu der Erstreckungsrichtung der Welle (21) verläuft.

9. Faltbare elektronische Vorrichtung nach einem der Ansprüche 1 bis 8, wobei eine erste Welle (2483) in das erste Gleitende (2452) eingeführt wird und eine zweite Welle (2484) in das zweite Gleitende (2462) eingeführt wird;
wobei die erste Stützplatte (22) unter Verwendung des ersten Führungsschachts (2243) gleitbar mit dem ersten Gleitende (2452) verbunden ist, umfassend: die erste Welle (2483) ist gleitbar mit dem ersten Führungsschacht (2243) verbunden;
die zweite Stützplatte (23) durch den zweiten Führungsschacht (2343) gleitbar mit dem zweiten Gleitende (2462) verbunden ist, umfassend: die zweite Welle (2484) ist gleitbar mit dem zweiten Führungsschacht (2343) verbunden.

10. Faltbare elektronische Vorrichtung nach Anspruch 9,
wobei, wenn sich die elektronische Vorrichtung in einem geöffneten Zustand befindet, ein Abstand zwischen der ersten Welle (2483) und dem zweiten Ende (2243b) des ersten Führungsschachts (2243) geringer ist als ein Abstand zwischen der ersten Welle (2483) und dem ersten Ende (2243a) des ersten Führungsschachts (2243), ein Abstand zwischen der zweiten Welle (2484) und dem zweiten Ende (2343b) des zweiten Führungsschachts (2343) geringer ist als ein Abstand zwischen der zweiten Welle (2484) und dem erstes Ende (2343a) des zweiten Führungsschachts (2343); und
wenn sich die elektronische Vorrichtung in einem gefalteten Zustand befindet, ein Abstand zwischen der ersten Welle (2483) und dem zweiten Ende (2243b) des ersten Führungsschachts (2243) größer ist als ein Abstand zwischen der ersten Welle (2483) und dem ersten Ende (2243a) des ersten Führungsschachts (2243), ein Abstand zwischen der zweiten Welle (2484) und dem zweiten Ende (2343b) des zweiten Führungsschachts (2343) größer ist als ein Abstand zwischen der zweiten Welle (2484) und dem erstes Ende (2343a) des zweiten Führungsschachts (2343).

11. Faltbare elektronische Vorrichtung nach einem der Ansprüche 1 bis 10, ferner umfassend eine Vielzahl von Synchronisierungszahnrädern (2473), wobei das erste Drehende (2451) unter Verwendung der Vielzahl von Synchronisierungszahnrädern (2473) mit dem zweiten Drehende (2461) in Eingriff steht.

12. Faltbare elektronische Vorrichtung nach einem der Ansprüche 1 bis 11, wobei
der erste Schwenkarm (245) ferner einen ersten Verbindungsabschnitt (2453) umfasst und der erste Verbindungsabschnitt (2453) zwischen dem ersten Drehende (2451) und dem ersten Gleitende (2452) liegt;
der zweite Schwenkarm (246) ferner einen zweiten Verbindungsabschnitt (2463) umfasst und der zweite Verbindungsabschnitt (2463) zwischen dem zweiten Drehende (2461) und dem zweiten Gleitende (2462) liegt; und
wenn sich die elektronische Vorrichtung in einem gefalteten Zustand befindet, die erste Stützplatte (22), der erste Verbindungsabschnitt (2453), die Welle (21), der zweite Verbindungsabschnitt (2463) und die zweite Stützplatte (23) gemeinsam den Aufnahmeraum (210) bilden und der Bildschirm (200) teilweise im Aufnahmeraum (210) liegt.

13. Faltbare elektronische Vorrichtung nach einem der Ansprüche 1 bis 12, wobei
die elektronische Vorrichtung ferner eine hintere Abdeckung (5) umfasst;
wobei, wenn sich die elektronische Vorrichtung in einem geöffneten Zustand befindet, das erste Gehäuse (11) und das zweite Gehäuse (12) die hintere Abdeckung (5) blockieren; und wenn sich die elektronische Vorrichtung in einem gefalteten Zustand befindet, die hintere Abdeckung (5) im Verhältnis zu dem ersten Gehäuse (11) und dem zweiten Gehäuse (12) freigelegt ist.

14. Faltbare elektronische Vorrichtung nach einem der Ansprüche 1 bis 13, die ferner einen Schutz (41), ein erstes Schutzgehäuse (43) und ein zweites Schutzgehäuse (44) umfasst; wobei ein Klemmschlitz (2110) an einem Ende der Welle (21) angeordnet ist;
der Schutz (41) ein starres Element (411), ein Verbindungselement (412) und ein weiches Gummielement (413) umfasst und das starre Element (411) mittels dem Verbindungselement (412) mit dem weichen Gummielement (413) verbunden ist;
das starre Element (411) in den Klemmschlitz (2110) eingeführt ist;
das weiche Gummielement (413) dazu konfiguriert ist, einen Teil der Kante des Bildschirms (200) zu bedecken.

15. Faltbare elektronische Vorrichtung nach Anspruch 14, wobei:
das starre Element (411) fest mit dem Klemmschlitz (2110) verbunden ist.

## Revendications

1. Dispositif électronique pliable, comprend un appareil de boîtier (100) et un écran (200) ;
l'appareil de boîtier (100) comprend un premier boîtier (11), un second boîtier (12) et un ensemble charnière (2), l'ensemble charnière (2) est connecté entre le premier boîtier (11) et le second boîtier (12) ;
dans lequel l'ensemble charnière (2) comprend un arbre (21), un premier support de fixation (241), un premier bras de connexion (243), un premier bras oscillant (245), un second support de fixation (242), un second bras de connexion (244), et un second bras oscillant (246), une première plaque de support (22) et une seconde plaque de support (23) ;
le premier support de fixation (241) est fixé au premier boîtier (11), et le second support de fixation (242) est fixé au second boîtier (12) ;
une première extrémité (2431) du premier bras de connexion (243) est connectée de manière rotative à l'arbre (21), la seconde extrémité (2432) du premier bras de connexion (243) est connecté de manière rotative au premier support de fixation (241), le premier bras oscillant (245) comprend une première extrémité rotative (2451) et une première extrémité coulissante (2452), la première extrémité rotative (2451) est connectée de manière rotative à l'arbre (21), et la première extrémité coulissante (2452) est connectée de manière coulissante au premier support de fixation (241) ;
une première extrémité (2441) du second bras de connexion (244) est connectée de manière rotative à l'arbre (21), une seconde extrémité (2442) du second bras de connexion (244) est connectée de manière rotative au second support de fixation (242), le second bras oscillant (246) comprend une seconde extrémité rotative (2461) et une seconde extrémité coulissante (2462), la seconde extrémité rotative (2461) est connectée de manière rotative à l'arbre (21), et la seconde extrémité coulissante (2462) est connectée de manière coulissante au second support de fixation (242) ;
la première plaque de support (22) est connectée de manière rotative au premier support de fixation (241), la seconde plaque de support (23) est connectée de manière rotative au second support de fixation (242) ;
la première plaque de support (22) est connectée de manière coulissante à la première extrémité coulissante (2452) ;
la seconde plaque de support (23) est connectée de manière coulissante à la seconde extrémité coulissante (2462) ;
l'écran (200) comprend un affichage flexible (7) et une plaque d'appui (8), la plaque d'appui (8) est fixée à un côté de non-affichage de l'affichage flexible (7) ;
la plaque d'appui (8) comprend une première partie de plaque (81), une deuxième partie de plaque (82), une troisième partie de plaque (83), une quatrième partie de plaque (84) et une cinquième partie de plaque (85) qui sont séquentiellement disposées, la deuxième partie de plaque (82) comprend un premier côté proche de la première partie de plaque (81) et un second côté proche de la troisième partie de plaque (83), et la quatrième partie de plaque (84) comprend un premier côté proche de la troisième partie de plaque (83) et un second côté proche de la cinquième partie de plaque (85) ;
une rigidité du premier côté de la deuxième partie de plaque (82) est inférieure à une rigidité de la première partie de plaque (81), une rigidité du premier côté de la deuxième partie de plaque (82) est inférieure à une rigidité du second côté de la deuxième partie de plaque (82) ;
une rigidité de la troisième partie de plaque (83) est inférieure à la rigidité de la première partie de plaque (81) ;
une rigidité du second côté de la quatrième partie de plaque (84) est inférieure à la rigidité de la première partie de plaque (81), une rigidité du second côté de la quatrième partie de plaque (84) est inférieure à une rigidité du premier côté de la quatrième partie de plaque (84) ;
une première partie de l'écran (200) correspondant à la première partie de plaque (81) est fixée au premier boîtier (11), une deuxième partie de l'écran (200) correspondant à la cinquième partie de plaque (85) est fixée au second boîtier (12).

2. Dispositif électronique pliable selon la revendication 1,
la première plaque de support (22) comprend une première surface de plaque de support (2211) et une première surface de fixation (2212) qui est opposée à la première surface de plaque de support (2211), la seconde plaque de support (23) comprend une seconde surface de plaque de support (2311) et une seconde surface de fixation (2312) qui est opposée à la seconde surface de plaque de support (2311), dans lequel la première surface de plaque de support (2211) et la seconde surface de plaque de support (2311) sont disposées vers l'écran (200) ;
l'ensemble charnière (2) comprend en outre un premier bras de guidage (2242) et un second bras de guidage (2342) ;
le premier bras de guidage (2242) est disposé sur la première surface de fixation (2212), le premier bras de guidage (2242) fait saillie par rapport à la première surface de fixation (2212), le premier bras de guidage (2242) comprend une première goulotte de guidage (2243) ;
le second bras de guidage (2342) est disposé sur la seconde surface de fixation (2312), le second bras de guidage (2342) fait saillie par rapport à la seconde surface de fixation (2312), le second bras de guidage (2342) comprend une seconde goulotte de guidage (2343) ;
la première plaque de support (22) est connectée de manière coulissante à la première extrémité coulissante (2452), comprenant : la première plaque de support (22) est connectée de manière coulissante à la première extrémité coulissante (2452) à l'aide de la première goulotte de guidage (2243) ;
la seconde plaque de support (23) est connectée de manière coulissante à la seconde extrémité coulissante (2462), comprenant : la seconde plaque de support (23) est connectée de manière coulissante à la seconde extrémité coulissante (2462) à l'aide de la seconde goulotte de guidage (2343).

3. Dispositif électronique pliable selon la revendication 2, une distance entre une première extrémité (2243a) de la première goulotte de guidage (2243) et l'arbre (21) est inférieure à une distance entre une seconde extrémité (2243b) de la première goulotte de guidage (2243) et l'arbre (21), une distance entre la première extrémité (2243a) de la première goulotte de guidage (2243) et la première plaque de support (22) est inférieure à une distance entre la seconde extrémité (2243b) de la première goulotte de guidage (2243) et la première plaque support (22), une distance entre une première extrémité (2343a) de la seconde goulotte de guidage (2343) et l'arbre (21) est inférieure à une distance entre une seconde extrémité (2343b) de la seconde goulotte de guidage (2343) et l'arbre (21), une distance entre la première extrémité (2343a) de la seconde goulotte de guidage (2343) et la seconde plaque de support (23) est inférieure à une distance entre la seconde extrémité (2343b) de la seconde goulotte de guidage (2343) et la seconde plaque de support (23).

4. Dispositif électronique pliable selon l'une quelconque des revendications 1 à 3,
une troisième partie de l'écran (200) correspondant à un second côté de la deuxième partie de plaque (82) est fixée à la première plaque de support (22), une quatrième partie de l'écran (200) correspondant à un premier côté de la quatrième partie de plaque (84) est fixée à la seconde plaque de support (23).

5. Dispositif électronique pliable selon l'une quelconque des revendications 1 à 4, dans lequel : l'écran comprend en outre une cinquième partie, une sixième partie et une septième partie, dans lequel la cinquième partie de l'écran correspond à la troisième partie de plaque (83), la sixième partie correspond au premier côté de la deuxième partie de plaque (82), la septième partie correspond au second côté de la quatrième partie de plaque (84) ;
lorsque le dispositif électronique pliable est plié d'un état ouvert à un état fermé, une première partie d'extrémité qui appartient à la cinquième partie de l'écran et qui est connectée à la troisième partie de l'écran forme une première section d'arc (R11), une seconde partie d'extrémité qui appartient à la cinquième partie de l'écran et qui est connectée à la quatrième partie de l'écran forme une deuxième section d'arc (R12), une partie médiane de la cinquième partie de l'écran forme une troisième section d'arc (R13), dans lequel la première section n arc (R11), la troisième section d'arc (R13) et la deuxième section d'arc (R12) ont des centres de cercle qui sont situés sur un côté interne de l'écran 200, la sixième partie de l'écran forme une quatrième section d'arc (R14), la septième partie de l'écran forme une cinquième section d'arc (R15), un centre de cercle de la quatrième section d'arc (R14) est situé sur un côté externe de l'écran, un centre de cercle de la cinquième section d'arc (R15) est situé sur le côté externe de l'écran, le centre de cercle de la quatrième section d'arc (R14) et le centre de cercle de la cinquième section d'arc (R15) sont respectivement situés sur deux côtés de l'écran (200).

6. Dispositif électronique pliable selon l'une quelconque des revendications 1 à 5, dans lequel :
la première extrémité (2431) du premier bras de connexion (243) est connectée de manière rotative à l'arbre (21), comprenant :
la première extrémité (2431) du premier bras de connexion (243) est connectée de manière rotative à l'arbre (21) via un premier arbre virtuel ;
la première extrémité (2441) du second bras de connexion (244) est connectée de manière rotative à l'arbre (21), comprenant :
la première extrémité (2441) du second bras de connexion (244) est connectée de manière rotative à l'arbre (21) via un second arbre virtuel.

7. Dispositif électronique pliable selon l'une quelconque des revendications 1 à 6, dans lequel :
lorsque le dispositif électronique pliable est plié dans un état fermé, une distance entre des parties d'extrémité qui appartiennent à la première plaque de support (22) et à la seconde plaque de support (23) et qui sont proches de l'arbre (21) est une première distance, une distance entre des parties d'extrémité qui appartiennent à la première plaque de support (22) et à la seconde plaque de support (23) et qui sont éloignées de l'arbre (21) est une seconde distance, la première distance est supérieure à la seconde distance, la première plaque de support (22), l'arbre (21) et la seconde plaque de support (23) forment conjointement un espace de logement (210), l'écran (200) est partiellement situé dans l'espace de logement (210).

8. Dispositif électronique pliable selon l'une quelconque des revendications 1 à 7, dans lequel
la troisième partie de plaque (83) est pourvue d'un premier trou traversant, et une direction d'extension du premier trou traversant est parallèle à une direction d'extension de l'arbre (21), ou la troisième partie (83) est pourvue d'une première rainure, et une direction d'extension de la première rainure est parallèle à une direction d'extension de l'arbre (21) ;
le premier côté de la deuxième partie de plaque (82) est pourvu d'un deuxième trou traversant, et une direction d'extension du deuxième trou traversant est parallèle à la direction d'extension de l'arbre (21), ou le premier côté de la deuxième partie (82) est pourvu d'une deuxième rainure, et une direction d'extension de la deuxième rainure est parallèle à la direction d'extension de l'arbre (21) ; et
le second côté de la quatrième partie de plaque (84) est pourvu d'un troisième trou traversant, et une direction d'extension du troisième trou traversant sur le second côté de la quatrième partie de plaque (84) est parallèle à la direction d'extension de l'arbre (21), ou le second côté de la quatrième partie (84) est pourvu d'une troisième rainure, et une direction d'extension de la troisième rainure sur le second côté de la quatrième partie (84) est parallèle à la direction d'extension de l'arbre (21).

9. Dispositif électronique pliable selon l'une quelconque des revendications 1 à 8, dans lequel un premier arbre (2483) est inséré dans la première extrémité coulissante (2452), un second arbre (2484) est inséré dans la seconde extrémité coulissante (2462) ;
dans lequel la première plaque de support (22) est connectée de manière coulissante à la première extrémité coulissante (2452) à l'aide de la première goulotte de guidage (2243), comprend : le premier arbre (2483) est connecté de manière coulissante à la première goulotte de guidage (2243) ;
la seconde plaque de support (23) est connectée de manière coulissante à la seconde extrémité coulissante (2462) à travers la seconde goulotte de guidage (2343), comprend : le second arbre (2484) est connecté de manière coulissante à la seconde goulotte de guidage (2343).

10. Dispositif électronique pliable selon la revendication 9,
lorsque le dispositif électronique est dans un état ouvert, une distance entre le premier arbre (2483) et la seconde extrémité (2243b) de la première goulotte de guidage (2243) est inférieure à une distance entre le premier arbre (2483) et la première extrémité (2243a) de la première goulotte de guidage (2243), une distance entre le second arbre (2484) et la seconde extrémité (2343b) de la seconde goulotte de guidage (2343) est inférieure à une distance entre le second arbre (2484) et la première extrémité (2343a) de la seconde goulotte de guidage (2343) ; et lorsque le dispositif électronique est dans un état fermé, une distance entre le premier arbre (2483) et la seconde extrémité (2243b) de la première goulotte de guidage (2243) est supérieure à une distance entre le premier arbre (2483) et la première extrémité (2243a) de la première goulotte de guidage (2243), une distance entre le second arbre (2484) et la seconde extrémité (2343b) de la seconde goulotte de guidage (2343) est supérieure à une distance entre le second arbre (2484) et la première extrémité (2343a) de la seconde goulotte de guidage (2343).

11. Dispositif électronique pliable selon l'une quelconque des revendications 1 à 10, comprend en outre une pluralité d'engrenages de synchronisation (2473), et la première extrémité rotative (2451) est en prise avec la seconde extrémité rotative (2461) à l'aide de la pluralité d'engrenages de synchronisation (2473) .

12. Dispositif électronique pliable selon l'une quelconque des revendications 1 à 11, dans lequel
le premier bras oscillant (245) comprend en outre une première section de connexion (2453), et la première section de connexion (2453) est située entre la première extrémité rotative (2451) et la première extrémité coulissante (2452) ;
le second bras oscillant (246) comprend en outre une seconde section de connexion (2463), et la seconde section de connexion (2463) est située entre la seconde extrémité rotative (2461) et la seconde extrémité coulissante (2462) ; et
lorsque le dispositif électronique est dans l'état fermé, la première plaque de support (22), la première section de connexion (2453), l'arbre (21), la seconde section de connexion (2463) et la seconde plaque de support (23) forment conjointement l'espace de logement (210), l'écran (200) est partiellement situé dans l'espace de logement (210).

13. Dispositif électronique pliable selon l'une quelconque des revendications 1 à 12, dans lequel
le dispositif électronique comprend en outre un couvercle arrière (5) ;
lorsque le dispositif électronique est dans un état ouvert, le premier boîtier (11) et le second boîtier (12) bloquent le couvercle arrière (5) ; et
lorsque le dispositif électronique est dans un état fermé, le couvercle arrière (5) est exposé par rapport au premier boîtier (11) et au second boîtier (12).

14. Dispositif électronique pliable selon l'une quelconque des revendications 1 à 13, comprend en outre un protecteur (41), un premier boîtier de protection (43) et un second boîtier de protection (44) ;
une fente de serrage (2110) est disposée au niveau d'une extrémité de l'arbre (21) ;
le protecteur (41) comprend un élément rigide (411), un connecteur (412) et un élément en caoutchouc souple (413), l'élément rigide (411) est connecté à l'élément en caoutchouc souple (413) à l'aide du connecteur (412) ;
l'élément rigide (411) est inséré dans la fente de serrage (2110) ;
l'élément en caoutchouc souple (413) est configuré pour recouvrir une partie du bord de l'écran (200).

15. Dispositif électronique pliable selon la revendication 14, dans lequel :
l'élément rigide (411) est connecté de manière fixe à la fente de serrage (2110).
